(19) Europäisches Patentamt
European Patent Office
Office européen des brevets

(11) EP 4 631 984 A1

(12) EUROPEAN PATENT APPLICATION
published in accordance with Art. 153(4) EPC

(43) Date of publication:
**15.10.2025 Bulletin 2025/42**

(21) Application number: **23907194.7**

(22) Date of filing: **22.12.2023**

(51) International Patent Classification (IPC):
***C08F 220/20*** (2006.01) ***C08F 220/18*** (2006.01)
***G02B 5/30*** (2006.01)

(52) Cooperative Patent Classification (CPC):
**C08F 220/18; C08F 220/20; G02B 5/30**

(86) International application number:
**PCT/JP2023/046189**

(87) International publication number:
**WO 2024/135834 (27.06.2024 Gazette 2024/26)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **22.12.2022 JP 2022205905**

(71) Applicant: **Dexerials Corporation**
**Shimotsuke-shi, Tochigi 323-0194 (JP)**

(72) Inventors:
- **NAKANISHI, Daichi**
  **Shimotsuke-shi, Tochigi 323-0194 (JP)**
- **NAKAZAWA, Yutaka**
  **Shimotsuke-shi, Tochigi 323-0194 (JP)**
- **SASAKI, Koji**
  **Shimotsuke-shi, Tochigi 323-0194 (JP)**

(74) Representative: **Müller-Boré & Partner Patentanwälte PartG mbB**
**Friedenheimer Brücke 21**
**80639 München (DE)**

# (54) PHOTOCURABLE ACRYLIC RESIN FOR IMPRINTING

(57) Provided is a light curing acrylic resin for imprinting in which an uncured resin composition has a low viscosity and in which a resin composition after curing is excellent in heat tolerance. The light curing acrylic resin for imprinting is a light curing acrylic resin for imprinting containing a photopolymerization component. The photopolymerization component contains a resin (A), and resin (B). The resin (A) is (octahydro-4,7-methano-1H-indenediyl)bis(methylene) diacrylate. The resin (B) is a bifunctional acrylate monomer having a viscosity of less than or equal to 10 mPa•s at 25°C. A content of the resin (A) in a whole of the photopolymerization component is more than or equal to 20 mass % and less than or equal to 40 mass %. A total content of the resin (A) and the resin (B) in the whole of the photopolymerization component is less than or equal to 70 mass %.

EP 4 631 984 A1

## Description

### Technical Field

The present invention relates to a light curing acrylic resin to be used for imprinting molding.

### Background Art

As a technology for manufacturing an optical member made of resin having a micro concave-convex structure, imprinting molding of an uncured resin layer composed of an uncured resin composition is widely utilized. In imprinting molding, a micro concave-convex shape of a master is pressed against an uncured resin layer formed on a substrate, the uncured resin layer is cured in that state, and the master is peeled to shape the micro concave-convex shape on the substrate.

When a thickness (layer thickness) of the uncured resin layer when the master is pressed thereagainst in imprinting molding is non-uniform, a peel force applied when the master is peeled from the resin layer after curing (hereinafter referred to as a "cured resin layer") is non-uniform in the plane of the cured resin layer. Then, part of the cured resin layer might be peeled from the substrate. In addition, the cured resin layer peeled from the substrate is left on the master, which makes it impossible to repeatedly utilize the master. Further, when the master is peeled, the micro concave-convex shape transferred to the cured resin layer might be deformed to cause the optical properties derived from the micro concave-convex structure to decrease.

In addition, if followability of the uncured resin composition to the micro concave-convex shape is low when the master is pressed in imprinting molding, the micro concave-convex shape of the master is not partially transferred to the uncured resin layer.

Thus, in order to make the layer thickness of the uncured resin layer when the master is pressed thereagainst uniform and to improve the followability of the uncured resin composition to the micro concave-convex shape, a technology for reducing the viscosity of the uncured resin composition has been developed (for example, Patent Literatures 1 and 2).

### Citation List

#### Patent Literature

| | |
|---|---|
| Patent Literature 1: | JP 2018-125559A |
| Patent Literature 2: | JP 4824068B |

### Summary of Invention

#### Technical Problem

In order to lower the viscosity of the uncured resin composition, it is conceivable to increase the content of a monofunctional monomer and a low-viscosity bifunctional monomer in the resin composition.

However, increasing the content of the monofunctional monomer and the low-viscosity bifunctional monomer raises a problem in that the heat tolerance of the resin layer after curing decreases.

The present invention was therefore made in view of such circumstances, and has an object to provide a light curing acrylic resin for imprinting in which an uncured resin composition has a low viscosity and in which a resin composition after curing is excellent in heat tolerance.

#### Solution to Problem

In order to solve the above-described problems, according to an aspect of the present invention, there is provided a light curing acrylic resin for imprinting, containing a photopolymerization component.

The photopolymerization component contains

a resin (A), and
a resin (B).

The resin (A) is (octahydro-4,7-methano-1H-indenediyl)bis(methylene) diacrylate.

The resin (B) is a bifunctional acrylate monomer having a viscosity of less than or equal to 10 mPa•s at 25°C.

A content of the resin (A) in a whole of the photopolymerization component is more than or equal to 20 mass % and less than or equal to 40 mass %.

A total content of the resin (A) and the resin (B) in the whole of the photopolymerization component is less than or equal to 70 mass %.

A viscosity of the light curing acrylic resin for imprinting at 25°C may be less than or equal to 35 mPa•s.

The photopolymerization component may further contain a resin (C).

The resin (C) may be an acrylate monomer having a viscosity of less than or equal to 10 mPa•s at 25°C.

A total content of the resin (B) and the resin (C) in the whole of the photopolymerization component may be more than or equal to 50 mass % and less than or equal to 70 mass %.

The resin (C) may be a monofunctional acrylate monomer.

The resin (C) may be isobornyl acrylate.

The photopolymerization component may further contain a resin (D).

The resin (D) may be an acrylate monomer having three or more functional groups.

A content of the resin (D) in the whole of the photopolymerization component may be more than 0 mass % and less than or equal to 20 mass %.

The resin (D) may be one or more selected from the group consisting of trimethylolpropane triacrylate, dipentaerythritol hexaacrylate, and polyfunctional polyester acrylate.

The resin (B) may be a bifunctional acrylate monomer with an acryloyl group combined with each of opposite ends of a straight-chain structure composed of a hydrocarbon group or a bifunctional acrylate monomer with an acryloyl group combined with each of opposite ends of a straight-chain structure having an ether bond.

The resin (B) may be a bifunctional acrylate monomer expressed by a chemical Formula (I) below, and in the chemical Formula (I), n may be an integer of more than or equal to 1 and less than or equal to 9:

$$CH_2 = CHCOO(CH_2)_nOOCCH = CH_2 \ldots \qquad (I).$$

In the chemical Formula (I), n may be an integer of more than or equal to 6 and less than or equal to 9.

In the chemical Formula (I), n may be 6 or 9.

After a cured product of the light curing acrylic resin for imprinting is held at 120°C for 500 hours, a YI value of the cured product may be less than or equal to 3.

A storage elastic modulus at 30°C of the cured product of the light curing acrylic resin for imprinting may be more than or equal to $1.6 \times 10^9$ Pa.

A storage elastic modulus at 120°C of the cured product may be more than or equal to $3.9 \times 10^8$ Pa.

After the cured product of the light curing acrylic resin for imprinting is held at 120°C for 500 hours,

an average transmittance of the cured product for light in a wavelength range of more than or equal to 430 nm and less than or equal to 680 nm may be more than or equal to 91%, and
an average transmittance of the cured product for light in a wavelength range of more than or equal to 430 nm and less than or equal to 510 nm may be more than or equal to 90%.

The light curing acrylic resin for imprinting may further contain a photopolymerization initiator for polymerizing the photopolymerization component.

## Advantageous Effects of Invention

According to the present invention, a light curing acrylic resin for imprinting in which an uncured resin composition has a low viscosity and in which a resin composition after curing is excellent in heat tolerance can be provided.

## Brief Description of Drawings

[FIG. 1] FIG. 1 is a sectional view schematically showing a wire grid polarizing element according to an embodiment of the present invention.
[FIG. 2] FIG. 2 is a plan view schematically showing the wire grid polarizing element according to the embodiment.
[FIG. 3] FIG. 3 is a sectional view schematically showing specific examples of an upward narrowing shape of ridge portions of a grid structural body according to the embodiment.

[FIG. 4] FIG. 4 is a sectional view schematically showing specific examples of a shape of concavities of the grid structural body according to the embodiment.
[FIG. 5] FIG. 5 is a sectional view schematically showing the wire grid polarizing element according to the embodiment.
[FIG. 6] FIG. 6 is a sectional view schematically showing specific examples of a shape of a reflection film according to the embodiment.
[FIG. 7] FIG. 7 is a sectional view schematically showing a polarizing element covered by a protection film according to the embodiment.
[FIG. 8] FIG. 8 is a sectional view schematically showing a modification of the polarizing element covered by the protection film according to the embodiment.
[FIG. 9] FIG. 9 is a perspective view schematically showing a polarizing element including a heat dissipation member according to the embodiment.
[FIG. 10] FIG. 10 is a photograph showing an actual grid structural body and an actual reflection film according to the embodiment.
[FIG. 11] FIG. 11 is a process diagram showing a method for manufacturing the wire grid polarizing element according to the embodiment.
[FIG. 12] FIG. 12 is a process diagram showing a method for manufacturing a conventional wire grid polarizing element.
[FIG. 13] FIG. 13 is a process diagram showing a method for manufacturing a master according to the embodiment.
[FIG. 14] FIG. 14 is a schematic diagram showing a head-up display device which is an example of a projection display device according to the embodiment.
[FIG. 15] FIG. 15 is a schematic diagram showing a first specific example of the projection display device according to the embodiment.
[FIG. 16] FIG. 16 is a schematic diagram showing a second specific example of the projection display device according to the embodiment.
[FIG. 17] FIG. 17 is a schematic diagram showing a third specific example of the projection display device according to the embodiment.
[FIG. 18] FIG. 18 is an explanatory diagram of a polarizing element according to Conventional Example 1.
[FIG. 19] FIG. 19 is an explanatory diagram of a polarizing element according to Conventional Example 2.
[FIG. 20] FIG. 20 is an explanatory diagram of a polarizing element according to Conventional Example 3.
[FIG. 21] FIG. 21 is an explanatory diagram of a polarizing element according to Example 1.
[FIG. 22] FIG. 22 is an explanatory diagram of a result of comparison between Example 1 and Conventional Example 2.
[FIG. 23] FIG. 23 is an explanatory diagram of a polarizing element according to Example 2.
[FIG. 24] FIG. 24 is an explanatory diagram of a polarizing element according to Example 3.
[FIG. 25] FIG. 25 is an explanatory diagram of a polarizing element according to Example 4.
[FIG. 26] FIG. 26 is an explanatory diagram of a polarizing element according to Example 5.
[FIG. 27] FIG. 27 is an explanatory diagram of a polarizing element according to Example 6.
[FIG. 28] FIG. 28 is an explanatory diagram of a polarizing element according to Example 7.
[FIG. 29] FIG. 29 is an explanatory diagram of a polarizing element according to Example 8.
[FIG. 30] FIG. 30 is an explanatory diagram of a result of comparison between Example 9 and Conventional Example 4.
[FIG. 31] FIG. 31 is an explanatory diagram of the result of comparison between Example 9 and Conventional Example 4.
[FIG. 32] FIG. 32 is a graph showing a relationship between wavelength and luminous efficiency function.

## Description of Embodiments

Hereinafter, preferred embodiments of the present invention will be described in detail with reference to the appended drawings. Note that in the present specification and the drawings, structural elements that have substantially the same function and structure are denoted with the same reference numerals, and repeated description is omitted. Note that for convenience of description, the state of each member disclosed in the following drawings may be schematically represented in a scale and shape different from actual ones.

### <1. Overview of Wire Grid Polarizing Element>

First, an overview of a wire grid polarizing element 1 according to an embodiment of the present invention will be described with reference to FIG. 1 and FIG. 2, and the like. FIG. 1 is a sectional view schematically showing the wire grid polarizing element 1 according to the present embodiment. FIG. 2 is a plan view schematically showing the wire grid

polarizing element 1 according to the present embodiment.

The wire grid polarizing element 1 according to the present embodiment is a polarizing element of a reflection type and is a polarizing element of a wire grid type. The wire grid polarizing element 1 may be a plate-shaped wire grid polarizing plate, for example. The wire grid polarizing plate is a polarizing plate of a wire grid type having a plate shape. The wire grid polarizing plate may be flat plate-shaped, or may be curved plate-shaped, for example. That is, a surface of the wire grid polarizing element 1 (a surface on which light is incident) may be a flat surface or may be curvilinear. Hereinafter, an example in which the wire grid polarizing element 1 according to the present embodiment is a flat plate-shaped wire grid polarizing plate will be described, whilst the wire grid polarizing element of the present invention is not limited to such an example, and can have any shape depending on its application, functions, and the like.

Note that the wire grid polarizing element of the present invention may be used as a polarizer that transmits only light that vibrates in a specific direction, or may be used as a polarizing beam splitter that splits incident light into first polarized light (s-polarized light) and second polarized light (p-polarized light), for example. Hereinafter, the example in which the wire grid polarizing element 1 according to the present embodiment is used as the polarizing beam splitter will be mainly described.

As shown in FIG. 1 and FIG. 2, the wire grid polarizing element 1 (hereinafter abbreviated to a "polarizing element 1" in some cases) includes a transparent substrate 10, a transparent grid structural body 20, and an opaque functional film (for example, a reflection film 30).

Note that "transparent" in the present specification means that light having a wavelength $\lambda$ belonging to a used band (such as, for example, the band of visible light, the band of infrared light, or the band of visible light and infrared light) has high transmittance, and means that the transmittance for the light is more than or equal to 70%, for example. The wavelength band of visible light is more than or equal to 360 nm and less than or equal to 830 nm, for example. The wavelength band of infrared light (infrared rays) is larger than the wavelength band of visible light, and is more than or equal to 830 nm, for example. From the perspective of a suitable wavelength range of visible light to be projected as a displayed image, the wavelength $\lambda$ in the used band in the polarizing element 1 according to the present embodiment preferably is more than or equal to 400 nm and less than or equal to 800 nm, for example, and more preferably is more than or equal to 420 nm and less than or equal to 680 nm. The polarizing element 1 according to the present embodiment is formed of a material transparent to light in the used band, so that the polarization properties, light transmissivity, and the like of the polarizing element 1 will not be affected adversely.

The substrate 10 is made of a transparent inorganic material such as glass. The substrate 10 is a flat plate-shaped substrate having a predetermined thickness TS.

The grid structural body 20 is made of a transparent organic material, for example, an organic resin material such as an ultraviolet curable resin or a thermosetting resin excellent in heat tolerance. The grid structural body 20 has a concave-convex structure for achieving the polarizing function of the polarizing element 1. Specifically, the grid structural body 20 has a base part 21 provided along a surface of the substrate 10, and a plurality of ridge portions 22 protruding from the base part 21 in a grid shape. The base part 21 and the plurality of ridge portions 22 of the grid structural body 20 are integrally formed using an identical organic material.

The base part 21 is a thin film having a predetermined thickness TB, and is stacked across the entire principal surface (an X-Y plane shown in FIG. 1 and FIG. 2) of the substrate 10. The thickness TB of the base part 21 preferably is a substantially identical thickness across the entire principal surface of the substrate 10, but may not be an exactly identical thickness, and may vary by a certain amount of error with respect to a reference thickness of TB. For example, TB may vary within approximately $\pm 3$ $\mu$m with respect to a reference thickness of 6 $\mu$m. In this manner, the thickness TB of the base part 21 is determined allowing a molding error when molding the base part 21 by imprinting or the like.

The plurality of ridge portions 22 are arrayed on the base part 21 at regular intervals at a predetermined pitch P in the X direction. Note that the pitch P is an interval at which the plurality of ridge portions 22 arrayed in the X direction of the polarizing element 1 are formed. The plurality of ridge portions 22 are arranged in a grid shape so as to extend in the Y direction in parallel to each other. A predetermined gap is formed between two of the ridge portions 22 adjacent to each other in the X direction. This gap serves as an approach route of incident light. Each of the ridge portions 22 is a wall-like convexity formed in a protruding manner so as to extend elongatedly in a predetermined direction (the Y direction shown in FIG. 1 and FIG. 2). The plurality of ridge portions 22 are substantially identical to each other in a height (H) in the Z direction and widths ($W_T$, $W_B$) in the X direction. The longitudinal direction (the Y direction) of the ridge portions 22 is the direction of a reflection axis of the polarizing element 1, and the width direction (the X direction) of the ridge portions 22 is the direction of a transmission axis of the polarizing element 1.

The functional film is a film for providing a predetermined function for the grid structural body 20 of the polarizing element 1. The functional film is made of an opaque metal material, for example, and is provided to cover part of the ridge portion 22 of the grid structural body 20. The functional film may be the reflection film 30 having a function of reflecting incident light incident on the polarizing element 1, or may be an absorbing film (not shown) having a function of absorbing the incident light, or may be a film having another function, for example. Although an example in which the functional film is the reflection film 30 will be described in the present embodiment, the functional film of the present invention is not limited to

the example of the reflection film 30.

The reflection film 30 is a thin film made of a metal material (such as metal or metal oxide) of aluminum, silver, or the like, for example. The reflection film 30 is formed to cover at least the top of the ridge portion 22. The reflection film 30 may be implemented by a metal film that functions as a fine metal wire of the wire grid. The reflection film 30 has the function of reflecting incident light incident on the grid structural body 20.

The ridge portions 22 of the grid structural body 20 and the reflection film 30 constitute a grid of the wire grid polarizing element 1. The pitch P in the X direction of the plurality of ridge portions 22 in the grid structural body 20 (that is, an array pitch of the grid) is set at a pitch smaller than (for example, less than or equal to a half of) the wavelength $\lambda$ of incident light (for example, visible light). This enables the polarizing element 1 to reflect most of light (s-polarized light) of an electric field vector component that vibrates in a direction (a reflection axis direction: the Y direction) parallel to the reflection film 30 (a conductive wire) extending in the Y direction, and to transmit most of light (p-polarized light) of an electric field vector component that vibrates in a direction (a transmission axis direction: the X direction) perpendicular to the reflection film 30 (the conductive wire).

As described above, the wire grid polarizing element 1 according to the present embodiment achieves the polarizing function by a combination of the grid structural body 20 having a micro concave-convex structure and the functional film (for example, the reflection film 30) selectively added to the ridge portions 22 of the grid structural body 20. The substrate 10 of the wire grid polarizing element 1 is made of an inorganic material very excellent in heat tolerance, such as glass, and the grid structural body 20 is made of an organic resin material having heat tolerance. In this manner, the wire grid polarizing element 1 according to the present embodiment is a polarizing element of a hybrid type in which the organic material and the inorganic material are combined. Consequently, heat can be efficiently released from the grid structural body 20 having a small thermal resistance R [$m^2$•K/W] to the substrate 10, resulting in excellent heat dissipation. Consequently, the wire grid polarizing element 1 of the hybrid type according to the present embodiment is superior in heat tolerance and heat dissipation to conventional polarizing elements of a film type (heat tolerance: approximately 100°C) only made of an organic material, and has heat tolerance under a high-temperature environment up to approximately 200°C, for example. Thus, a favorable heat dissipation effect can be maintained while achieving excellent polarization properties.

Further, the wire grid polarizing element 1 according to the present embodiment may include a protection film 40 (see FIG. 7 and FIG. 8) covering the surface of the grid structural body 20. The protection film 40 is made of an inorganic material, for example, a dielectric material such as $SiO_2$. This protection film 40 may be stacked on the entire surface of the wire grid polarizing element 1 so as to cover all the surfaces of the base part 21 and the ridge portions 22 of the grid structural body 20 as well as the reflection film 30 (see FIG. 7). By providing this protection film 40, an advantageous effect that the thermal resistance R of the polarizing element 1 can be reduced further is obtained. Thus, a more favorable heat dissipation effect can be maintained while achieving excellent polarization properties.

In addition, the micro concave-convex structure can be achieved by a simple manufacturing process because the grid structural body 20 in which the base part 21 and the ridge portions 22 are integrally configured can be manufactured using a printing technology such as nano-imprinting as described above. Consequently, cost and labor required for manufacturing the grid structural body 20 can be reduced as compared with the case of manufacturing the grid structural body 20 using the photolithography technology or etching technology. Thus, the polarizing element 1 of the hybrid type according to the present embodiment is advantageous in that the manufacturing cost can be reduced considerably and the product unit price of the wire grid polarizing element 1 can be made inexpensive as compared with conventional polarizing elements only made of an inorganic material.

On the other hand, the conventional organic polarizing plates of the film type use many organic materials, and a substrate (base film), a double-faced tape (OCA: optically clear adhesive), and the grid structural body have large thicknesses. Thus, it is considered that the conventional organic polarizing plates of the film type are inferior in heat dissipation and heat tolerance to the polarizing element 1 of the hybrid type according to the present embodiment.

In addition, in the wire grid polarizing element 1 according to the present embodiment, a grid portion composed of the ridge portion 22 of the grid structural body 20 and the reflection film 30 has a special tree shape (details of which will be described later) as shown in FIG. 1 and the like. This can restrain the transmittance (that is, transmission axis transmittance Tp) for the second polarized light (p-polarized light) transmitted through the polarizing element 1 from decreasing depending on the incident angle $\theta$ of oblique incident light even in the case where light is incident in an oblique direction on the polarizing element 1 at the wide-range and large incident angle $\theta$ (for example, 30 to 60°). Consequently, the product ($Tp \times Rs$) of the reflectance for the first polarized light (s-polarized light) reflected by the wire grid polarizing element 1 (that is, the reflection axis reflectance Rs) and the transmission axis transmittance Tp can be maintained at a high value of more than or equal to 70%, for example. Consequently, the polarizing element 1 according to the present embodiment is excellent in polarization splitting properties expressed by the $Tp \times Rs$, and can polarize the oblique incident light to be suitably split into the s-polarized light (reflected light) and the p-polarized light (transmitted light). Thus, the polarizing element 1 according to the present embodiment can obtain sufficient transmissivity and polarization splitting properties even for oblique incident light at the incident angle $\theta$ in the large and wide range.

As described above, the wire grid polarizing element 1 according to the present embodiment is excellent in heat tolerance and heat dissipation, can be reduced in manufacturing cost, and is also excellent in transmissivity and polarization splitting properties for oblique incident light at the wide-range and large incident angle θ. Thus, the wire grid polarizing element 1 according to the present embodiment can suitably be applied as various parts of various products. For example, the polarizing element 1 can be applied to a polarizing beam splitter installed in a smart display, and the like. The polarizing element 1 can also be applied to a polarizing element which is installed in a head-up display (HUD) and in which measures against solar light have been taken, a polarizing element in which measures against heat from an LED light source have been taken, a polarizing reflection mirror, and the like. Further, the polarizing element 1 can also be applied to a polarizing beam splitter installed in a headlight such as an adaptive driving beam (ADB), and the like. The polarizing element 1 can also be applied to a lens-integrated phase difference element, a lens-integrated polarizing element, and the like installed in various devices for augmented reality (AR) or virtual reality (VR).

<2. Constituent Members of Wire Grid Polarizing Element>

Next, constituent members of the wire grid polarizing element 1 according to the present embodiment will be described in detail with reference to FIG. 1 and FIG. 2, and the like.

<2.1. Substrate>

As shown in FIG. 1, the wire grid polarizing element 1 according to the present embodiment includes the transparent substrate 10. The substrate 10 is made of an inorganic material which is transparent and has a certain degree of strength.

From the perspective of obtaining more excellent heat dissipation and heat tolerance, the material of the substrate 10 preferably is an inorganic material such as various types of glass, quartz, crystal, or sapphire, for example, more preferably is an inorganic material having a thermal conductivity of more than or equal to 1.0 W/m•K, and further preferably is an inorganic material having a thermal conductivity of more than or equal to 8.0 W/m•K.

In addition, the shape of the substrate 10 is not particularly limited, and can be selected as appropriate in accordance with performance and the like required of the polarizing element 1. For example, the substrate 10 can be configured to have a plate shape or a curvilinear surface. In addition, from the perspective of not affecting the polarization properties of the polarizing element 1, the surface of the substrate 10 can be a flat surface. Further, the thickness TS of the substrate 10 is neither particularly limited, and can fall within a range of 0.02 to 10.0 mm, for example.

<2.2. Grid Structural Body>

As shown in FIG. 1 and FIG. 2, the polarizing element 1 according to the present embodiment includes the grid structural body 20 having the base part 21 and the grid-shaped ridge portions 22 described above on the substrate 10. The grid structural body 20 can obtain desired polarization properties when the reflection film 30 which will be described later is provided on the ridge portions 22.

When light is incident on the polarizing element 1 from a surface side on which the grid structural body 20 is formed, part of the incident light is reflected by the reflection film 30. In the light incident on the reflection film 30, light having an electric field component in a direction (that is, the width direction of the ridge portions 22 = the transmission axis direction: the X direction) orthogonal to the longitudinal direction of the ridge portions 22 (that is, the direction in which the ridge portions 22 extend = the reflection axis direction: the Y direction) is transmitted through the polarizing element 1 at high transmittance. On the other hand, in the light incident on the reflection film 30, a large part of light having an electric field component in a direction parallel to the longitudinal direction of the ridge portions 22 (that is, the direction in which the ridge portions 22 extend = the reflection axis direction: the Y direction) is reflected by the reflection film 30. Thus, in the present embodiment, the polarizing element 1 can create single polarized light by including the grid structural body 20 partially covered by the reflection film 30. Note that a similar polarization effect can also be obtained for light incident from the rear surface side of the substrate 10.

The grid structural body 20 has the base part 21 as shown in FIG. 1. The base part 21 is a thin film provided along the surface of the substrate 10, and is a portion for supporting the ridge portions 22. In the case of forming the concave-convex structure (the ridge portions 22) of the grid structural body 20 by nano-imprinting or the like, the base part 21 is inevitably formed. The base part 21 and the ridge portions 22 are integrally formed of an identical material. In addition, because the grid structural body 20 has the base part 21, the ridge portions 22 can have higher strength than in a case of forming the ridge portions 22 directly on the substrate 10. This can increase durability of the grid structural body 20. Further, peel resistance of the grid structural body 20 can be increased because the base part 21 is in close contact with the substrate 10 by the entire surface.

Note that the thickness TB of the base part 21 is not particularly limited, and from the perspective in which the

ridge portions 22 can be supported more reliably and from the perspective of easily performing imprinting molding, preferably is more than or equal to 1 nm, and more preferably is more than or equal to 10 nm. In addition, from the perspective of ensuring favorable heat dissipation, the thickness TB of the base part 21 preferably is less than or equal to 50 μm, and more preferably is less than or equal to 30 μm.

In addition, with the polarizing element 1 according to the present embodiment, the base part 21 and the plurality of ridge portions 22 of the grid structural body 20 are formed directly on the substrate 10, which can reduce the thickness TB of the base part 21. Herein, in order to improve heat dissipation from the grid structural body 20 to the substrate 10, a temperature difference ΔT [°C] between a front surface and a rear surface of the base part 21 preferably is made smaller by reducing the thickness TB of the base part 21. Note that the temperature difference ΔT is a temperature difference between a temperature T1 [°C] of the frontmost surface of the base part 21 (roots of the plurality of ridge portions 22) and a temperature T2 [°C] of the base part 21 at the interface between the base part 21 and the substrate 10 (ΔT = T1-T2).

Consequently, the thickness TB of the base part 21 preferably is less than or equal to 0.15 mm. This enables heat of the grid structural body 20 made of an organic material to be quickly conveyed to the substrate 10 made of an inorganic material and to be efficiently released from the substrate 10 to the outside of the polarizing element 1 to achieve heat dissipation. Thus, the temperature difference ΔT can be made less than or equal to 32°C, for example. Further, the thickness TB of the base part 21 more preferably is less than or equal to 0.09 mm. This enables the temperature difference ΔT to be made less than or equal to 20°C, for example. Further, the thickness TB of the base part 21 more preferably is less than or equal to 0.045 mm. This enables the temperature difference ΔT to be made less than or equal to 10°C, for example. Further, the thickness TB of the base part 21 particularly preferably is less than or equal to 0.02 mm. This enables the temperature difference ΔT to be made less than or equal to 5°C, for example. In this manner, heat dissipation from the grid structural body 20 to the outside via the substrate 10 can be improved by reducing the thickness TB of the base part 21. This can improve heat dissipation and heat tolerance of the polarizing element 1.

Further, the grid structural body 20 has the plurality of ridge portions 22 protruding from the base part 21 as shown in FIG. 1 and FIG. 2. The ridge portions 22 extend with their longitudinal direction being the reflection axis direction (the Y direction) of the polarizing element 1 according to the present embodiment. The grid-shaped concave-convex structure is formed by arraying the plurality of ridge portions 22 at a predetermined pitch in the X direction and away from each other at a predetermined interval.

Herein, as shown in FIG. 1, the pitch P of the ridge portions 22 in the transmission axis direction (the X direction) is required to be shorter than the wavelength of light in the used band in a vertical section (an X-Z section) orthogonal to the reflection axis direction (the Y direction) of the polarizing element 1. The reason for this is to obtain the polarizing effect described above. More specifically, from the perspective of achieving both ease of manufacturing of the ridge portions 22 and polarization properties, the pitch P of the ridge portions 22 preferably is 50 to 300 nm, more preferably is 100 to 200 nm, and particularly preferably is 100 to 150 nm.

In addition, as shown in FIG. 1 and FIG. 2, a bottom width $W_B$ of the ridge portion 22 in the above-described vertical section (the X-Z section) is not particularly limited, and from the perspective of achieving both ease of manufacturing and polarization properties, preferably is approximately 10 to 150 nm, and more preferably is approximately 10 to 100 nm. In addition, a top width $W_T$ of the ridge portion 22 is not particularly limited, and from the perspective of achieving both ease of manufacturing and polarization properties, preferably is approximately 5 to 60 nm, and more preferably is approximately 10 to 30 nm.

Note that the bottom width $W_B$ and the top width $W_T$ of the ridge portion 22 can be measured by observation with a scanning electron microscope or a transmission electron microscope. For example, the section (the X-Z section) orthogonal to an absorption axis direction or the reflection axis direction of the polarizing element 1 is observed using a scanning electron microscope or a transmission electron microscope. For the ridge portions 22 at any four places, the width of the ridge portion 22 at a height position of 20% of the height H of the ridge portion 22 upward from the bottom of the ridge portion 22 is measured, and their arithmetic mean value can be used as the bottom width $W_B$ of the ridge portion 22. In addition, for the ridge portions 22 at any four places, the width of the ridge portion 22 at a height position of 20% of the height H of the ridge portion 22 downward from a leading end 22a of the ridge portion 22 is measured, and their arithmetic mean value can be used as the top width $W_T$ of the ridge portion 22.

In addition, as shown in FIG. 1, the height H of the ridge portion 22 in the above-described vertical section (the X-Z section) is not particularly limited, and from the perspective of achieving both ease of manufacturing and polarization properties, preferably is approximately 50 to 350 nm, and more preferably is approximately 100 to 300 nm. Note that the height H of the ridge portion 22 can be measured by observation with a scanning electron microscope or a transmission electron microscope. For example, the section orthogonal to the absorption axis direction or the reflection axis direction of the polarizing element 1 is observed using a scanning electron microscope or a transmission electron microscope. For the ridge portions 22 at any four places, the height of the ridge portion 22 at a central position in the width direction of the ridge portion 22 is measured, and their arithmetic mean value can be used as the height H of the ridge portion 22.

The shape of the ridge portion 22 of the grid structural body 20 preferably is an upward narrowing shape in order to obtain favorable polarization splitting properties for oblique incident light. Herein, the upward narrowing shape is such a

shape that the width W of the ridge portion 22 (the width in the X direction in the X-Z section) gradually narrows with distance from the base part 21, in other words, such a shape that the width W of the ridge portion 22 gradually narrows from the bottom to the top of the ridge portion 22. Consequently, in the case where the ridge portion 22 has the upward narrowing shape, the top width $W_T$ of the ridge portion 22 is smaller than the bottom width $W_B$ of the ridge portion 22 ($W_T < W_B$).

FIG. 3 shows specific examples of the upward narrowing shape of the ridge portion 22 according to the present embodiment. As shown in FIG. 3, the sectional shape of the ridge portion 22 in the above-described vertical section (the X-Z section) may be various shapes such as a trapezoidal shape, a triangular shape, a hanging bell shape, an elliptical shape, or a rounded wedge shape that narrow in the width W with distance from the base part 21 if they are upward narrowing shapes as described above. For example, the sectional shape of a ridge portion 22A shown in FIG. 3 is a trapezoidal shape (a tapered shape), the sectional shape of a ridge portion 22B is a triangular shape, the sectional shape of a ridge portion 22C is a hanging bell shape, and the sectional shape of a ridge portion 22D is a wedge shape having rounded top and bottom. In this manner, when the ridge portion 22 has the upward narrowing shape, the reflection film 30 covering the leading end 22a and part of side surfaces 22b of the ridge portion 22 is easy to form, and polarization properties can be provided for the polarizing element 1. The upward narrowing shape can also be formed by nano-imprinting, which is also advantageous in terms of ease of manufacturing.

In addition, when the ridge portion 22 has the upward narrowing shape such as a tapered shape, the refractive index of the grid structural body 20 gradually changes. Consequently, an effect of preventing reflection of incident light because of the physical change in refractive index of the grid structural body 20 is obtained similarly to a moth-eye structure. This also enables the effects that the reflectance at the surface of the ridge portion 22 of the grid structural body 20 can be reduced and the transmissivity of the grid structural body 20 can be improved to be expected.

In addition, FIG. 4 shows specific examples of the shape of a concavity 24 formed between the ridge portions 22, 22 adjacent to each other. The concavity 24 is a groove extending in the longitudinal direction (the Y direction) of the ridge portions 22. As shown in FIG. 4, the sectional shape of the concavity 24 in the above-described vertical section (the X-Z section) may be various shapes that narrows in width toward the bottom of the concavity 24. For example, the sectional shape of a concavity 24A shown in FIG. 4 is a trapezoidal shape (a tapered shape), the sectional shape of a concavity 24B is a triangular shape (a V-shape), the sectional shape of a concavity 24C is a substantially rectangular shape with a flat bottom, and the sectional shape of a concavity 24D is a U-shape with a rounded bottom. An optimum shape can be selected as appropriate as the shape of these concavities 24 in consideration of productivity such as releasability when forming the concavities 24 by nano-imprinting.

In addition, the material constituting the grid structural body 20 is not particularly limited if it is a transparent organic material, and a publicly-known organic material can be used. For example, from the perspectives of ensuring transparency and excellent ease of manufacturing, various thermosetting resins, various ultraviolet curable resins, or the like preferably are used as the material of the grid structural body 20.

Further, from the perspectives of ease of manufacturing and manufacturing cost, a material different from the material of the substrate 10 preferably is used as the material constituting the grid structural body 20. In addition, in the case where the materials of the grid structural body 20 and the substrate 10 are different, their refractive indexes are different. Therefore, in a case where the refractive index of the entire polarizing element 1 is affected, a refractive index adjustment layer may be provided as appropriate between the grid structural body 20 and the substrate 10.

For example, as the material constituting the grid structural body 20, a curable resin such as a polymerizable epoxy compound or a polymerizable acrylic compound can be used. A polymerizable epoxy compound is a monomer, oligomer, or prepolymer having one or multiple epoxy groups in the molecule. Examples of polymerizable epoxy compounds include various bisphenol epoxy resins (such as bisphenol A and F), novolac epoxy resin, various modified epoxy resins such as rubber or urethane, naphthalene epoxy resin, biphenyl epoxy resin, phenol novolac epoxy resin, stilbene epoxy resin, triphenol methane epoxy resin, dicyclopentadiene epoxy resin, triphenyl methane epoxy resin, and prepolymers of the above.

A polymerizable acrylic compound is a monomer, oligomer, or prepolymer having one or multiple acrylic groups in the molecule. Herein, monomers are further classified into monofunctional monomers having one acrylic group in the molecule, bifunctional monomers having two acrylic groups in the molecule, and multifunctional monomers having three or more acrylic groups in the molecule.

Examples of "monofunctional monomers" include carboxylic acids (such as acrylic acids), hydroxy monomers (2-hydroxyethyl acrylate, 2-hydroxypropyl acrylate, 4-hydroxybutyl acrylate), alkyl or alicyclic monomers (isobutyl acrylate, t-butyl acrylate, isooctyl acrylate, lauryl acrylate, stearyl acrylate, isobornyl acrylate, cyclohexyl acrylate), other functional monomers (2-methoxyethyl acrylate, methoxyethylene glycol acrylate, 2-ethoxyethyl acrylate, tetrahydrofurfuryl acrylate, benzyl acrylate, ethyl carbitol acrylate, phenoxyethyl acrylate, N,N-dimethylamino ethyl acrylate, N,N-dimethylamino propyl acrylamide, N,N-dimethyl acrylamide, acryloyl morpholine, N-isopropyl acrylamide, N,N-diethyl acrylamide, 2-(perfluorooctyl)ethyl acrylate, 3-perfluorohexyl-2-hydroxypropyl acrylate, 3-perfluorooctyl-2-hydroxypropyl-acrylate, 2-(perfluorodecyl)ethyl-acrylate, 2-(perfluoro-3-methylbutyl)ethyl acrylate), 2,4,6-tribromophenol acrylate, 2,4,6-tribromophenol methacrylate, 2-(2,4,6-tribromophenoxy)ethyl acrylate), and 2-ethylhexyl acrylate.

Examples of "bifunctional monomers" include tri(propylene glycol) di-acrylate, trimethylolpropane-diaryl ether, and urethane diacrylate.

Examples of "multifunctional monomers" include trimethylolpropane tri-acrylate, dipentaerythritol penta- and hexa-acrylate, and ditrimethylolpropane tetra-acylate.

Examples other than the polymerizable acrylic compounds listed above include acrylmorpholine, glycerol acrylate, polyether acrylates, N-vinylformamide, N-vinylcaprolactam, ethoxy diethylene glycol acrylate, methoxy triethylene glycol acrylate, polyethylene glycol acrylate, ethoxylated trimethylolpropane tri-acrylate, ethoxylated bisphenol A diacrylate, aliphatic urethane oligomers, and polyester oligomers.

In addition, examples of curing initiators for curable resins described above include thermal curing initiators and light curing initiators. A curing initiator may be cured with some energy beam (for example, an electron beam) or the like other than heat and light. In a case where the curing initiator is a thermal curing initiator, a curable resin is a thermosetting resin, and in a case where the curing initiator is a light curing initiator, a curable resin is a light curing resin.

Among them, an ultraviolet-curing initiator preferably is used as the curing initiator. The ultraviolet-curing initiator is a type of light curing initiators. Examples of ultraviolet-curing initiators include 2,2-dimethoxy-1,2-diphenylethane-1-one, 1-hydroxy-cyclohexyl phenyl ketone, and 2-hydroxy-2-methyl-1-phenyl propane-1-one. Consequently, the curable resin preferably is an ultraviolet curable resin. In addition, from the perspective of transparency, the curable resin more preferably is an ultraviolet curable acrylic resin.

Note that a method for forming the grid structural body 20 is not particularly limited if it is a method in which the base part 21 and the ridge portions 22 described above can be formed. For example, a concavity-convexity forming method by a technology such as photolithography or imprinting can be used. Among them, the base part 21 and the ridge portions 22 of the grid structural body 20 preferably are formed by imprinting from the perspective that a concave-convex pattern can be formed in a short time and easily, and further, the base part 21 can be formed reliably.

In the case of forming the base part 21 and the ridge portions 22 of the grid structural body 20 by nano-imprinting, the substrate 10 is coated with a material (a grid structural body material) for forming the grid structural body 20, then a master with concavities and convexities formed thereon is pressed against the grid structural body material, and ultraviolet rays are radiated or heat is applied in that state, so that the grid structural body material can be cured, for example. The grid structural body 20 having the base part 21 and the ridge portions 22 can thereby be formed.

<2.3. Reflection Film (Functional Film)>

The polarizing element 1 according to the present embodiment includes the reflection film 30 formed on the ridge portions 22 of the grid structural body 20 as shown in FIG. 1 and FIG. 2.

As shown in FIG. 1, the reflection film 30 is formed to cover and wrap the leading end 22a and part of the side surfaces 22b of the ridge portion 22 of the grid structural body 20. Then, as shown in FIG. 1, the reflection film 30 is formed to extend in the longitudinal direction (the Y direction) of the ridge portions 22 of the grid structural body 20. This enables the reflection film 30 to reflect light having an electric field component in a direction (the reflection axis direction: the Y direction) parallel to the longitudinal direction of the ridge portions 22, in light incident on the polarizing element 1.

The material constituting the reflection film 30 is not particularly limited if it is a material having reflectiveness for light in the used band. Examples of the material include a single metal element such as Al, Ag, Cu, Mo, Cr, Ti, Ni, W, Fe, Si, Ge, or Te and a metal material such as an alloy containing one or more kinds of these elements.

Note that the reflection film 30 may be a single-layer film made of metal described above, or may be a multi-layer film made of a plurality of metal films. In addition, the reflection film 30 may include another layer such as a dielectric film according to necessity if it has the reflective function. The dielectric film is a thin film made of a dielectric. As the material of the dielectric film, a common material such as $SiO_2$, $Al_2O_3$, $MgF_2$, or $TiO_2$ can be used. In addition, the dielectric film preferably has a refractive index of more than 1.0 and less than or equal to 2.5. Note that because optical properties of the reflection film 30 are influenced by surrounding refractive indexes as well, polarization properties may be controlled by the material of the dielectric film.

<2.4. Special Shape of Ridge Portion and Reflection Film>

Herein, the special shape of the ridge portion 22 of the grid structural body 20 and the reflection film 30 in the polarizing element 1 according to the present embodiment will be described in detail.

In the polarizing element 1 according to the present embodiment, the reflection film 30 is formed to cover and wrap the leading end 22a and the upper side of at least one of the side surfaces 22b of the ridge portion 22 of the grid structural body 20 and not to cover the lower side of both the side surfaces 22b of the ridge portion 22 and the base part 21, as shown in FIG. 1 and FIG. 5. Note that in the example shown in FIG. 1 and FIG. 5, the reflection film 30 covers the upper side of both the side surfaces 22b of the ridge portion 22, but may cover the upper side of only one of the side surfaces 22b of the ridge portion 22.

Herein, "the state in which the reflection film 30 covers and wraps the leading end 22a and the upper side of at least one of the side surfaces 22b of the ridge portion 22 of the grid structural body 20" is a state in which "the leading end 22a of the ridge portion 22" and "the upper side of the side surfaces 22b connecting the leading end 22a of the ridge portion 22 and the base part 21" are both continuously covered by the reflection film 30, and "the lower side of the side surfaces 22b" and "the base part 21" are exposed without being covered by the reflection film 30, as shown in FIG. 1 and FIG. 5, for example. In this state, the reflection film 30 does not cover the entirety of the side surfaces 22b of the ridge portion 22 (the entire side surfaces 22b from the leading end 22a of the ridge portion 22 to the base part 21).

Further, the surface of the reflection film 30 covering and wrapping the leading end 22a and the upper side of at least one of the side surfaces 22b of the ridge portion 22 (hereinafter referred to as "the top of the ridge portion 22" in some cases) has a rounded, curved shape (for example, a vertically long, substantially elliptical shape), and bulges in the width direction (the X direction) of the ridge portion 22. In this manner, the surface of the reflection film 30 has a rounded, smoothly curved curvilinear shape, and does not have any angulated corner portion or stepped portion. A maximum width $W_{MAX}$ of the reflection film 30 covering and wrapping the top of the ridge portion 22 in this manner is more than or equal to the bottom width $W_B$ of the ridge portion 22. Further, $W_{MAX}$ preferably is larger than $W_B$.

Herein, the maximum width $W_{MAX}$ of the reflection film 30 covering and wrapping the ridge portion 22 is a maximum horizontal width among horizontal widths of both-side outermost surfaces of the reflection film 30 in the width direction (the X direction) of the ridge portion 22. As shown in FIG. 1 and FIG. 5, and the like, the horizontal widths (the widths in the X direction) of the both-side outermost surfaces of the reflection film 30 covering and wrapping the ridge portion 22 vary depending on a height position (a height in the Z direction) of the reflection film 30, and the maximum value of these horizontal widths is the maximum width $W_{MAX}$. In other words, the maximum width $W_{MAX}$ is a maximum value of the total width of thicknesses of the reflection film 30 on both the sides, Ds $\times$ 2, and the horizontal width W of the ridge portion 22. For example, in a case where light is incident on the grid structural body 20 in a front direction (the Z direction) (in a case where the incident angle $\theta = 0°$), $W_{MAX}$ is equivalent to an effective grid width of the reflection film 30.

The bottom width $W_B$ of the ridge portion 22 is the horizontal width of the ridge portion 22 (the width in the X direction) at a height position (a height in the Z direction) of 20% of the height H of the ridge portion 22 upward from the lowermost part of the ridge portion 22 (the upper surface of the base part 21) as shown in FIG. 1 and FIG. 3. That is, the bottom width $W_B$ of the ridge portion 22 is the horizontal width of the ridge portion 22 at a height position of $0.2 \times H$ upward from the upper surface of the base part 21.

In addition, the top width $W_T$ of the ridge portion 22 is a horizontal width of the ridge portion 22 (a width in the X direction) at a height position (a height in the Z direction) of 20% of the height H of the ridge portion 22 downward from the leading end 22a of the ridge portion 22 as shown in FIG. 1 and FIG. 3. That is, the top width $W_T$ of the ridge portion 22 is a horizontal width of the ridge portion 22 at a height position of $0.8 \times H$ upward from the upper surface of the base part 21 (that is, a height position of $0.2 \times H$ downward from the leading end 22a of the ridge portion 22).

Note that in the following description, a protruding structural body combining the ridge portion 22 and the reflection film 30 is referred to as a "grid portion" and the height of the protruding structural body (that is, the grid portion) combining the ridge portion 22 and the reflection film 30 is referred to as a "grid height" in some cases. In addition, the maximum width $W_{MAX}$ of the reflection film 30 covering and wrapping the ridge portion 22 is referred to as the "grid maximum width $W_{MAX}$" and the bottom width $W_B$ of the ridge portion 22 is referred to as the "grid bottom width $W_B$" in some cases. In addition, the top width $W_T$ of the ridge portion 22 is referred to as the "ridge portion top width $W_T$" and the width of the ridge portion 22 at the central position in the height direction is referred to as a "ridge portion central width" in some cases.

In this manner, in the present embodiment, the horizontal width of the ridge portion 22 at the height position of 20% upward from the lowermost part (bottom) of the ridge portion 22 is used as the bottom width $W_B$ of the ridge portion 22, and the horizontal width of the ridge portion 22 at the height position of 20% downward from the leading end 22a of the ridge portion 22 is used as the top width $W_T$ of the ridge portion 22. This is because the width of the lowermost part of the ridge portion 22 on the upper surface of the base part 21 and the width of the leading end 22a of the ridge portion 22 fluctuate significantly depending on manufacturing conditions of the grid structural body 20 and the like, and thus, these widths are difficult to measure precisely.

As described above, in the grid structural body 20 according to the present embodiment, the ridge portions 22 having the upward narrowing shape as well as the reflection film 30 covering and wrapping the leading end 22a and only the upper side of the side surfaces 22b of the ridge portion 22 are formed. Then, the lower side of the side surfaces 22b of the ridge portion 22 is open without being covered by the reflection film 30.

As a result, the sectional shape of the ridge portion 22 covered and wrapped by the curved reflection film 30 (that is, the sectional shape of the grid portion) has a special sectional shape as will be described below. In other words, as shown in FIG. 1 and FIG. 5, and the like, the horizontal width of a portion on the upper side of the ridge portion 22 where the reflection film 30 is present (for example, the grid maximum width $W_{MAX}$) is large, and the horizontal width of a portion ranging from an exposed central part of the ridge portion 22 not covered by the reflection film 30 toward the bottom side (for example, the bottom width $W_B$ of the ridge portion 22 as exposed) is small. Then, the sectional shape of the entire

protruding structural body (that is, the "grid portion") composed of the ridge portion 22 and the curved reflection film 30 has a constricted portion that constricts to the inner side and has a narrow width in the X direction at a position immediately under the curved lower end of the reflection film 30. Such a special sectional shape of the grid portion can be compared to a tree shape. Specifically, a leaf portion of a roundly and widely spreading tree is equivalent to a portion of the reflection film 30 that covers and wraps the top of the ridge portion 22. A trunk portion of the tree is equivalent to the lower side portion of the ridge portion 22 that is not covered by the reflection film 30. A ground portion where the tree grows is equivalent to the base part 21. Thus, in the following description, the special sectional shape of the grid portion composed of the ridge portion 22 of the grid structural body 20 and the reflection film 30 as described above will be referred to as a "special tree shape".

The grid portion of the grid structural body 20 of the polarizing element 1 according to the present embodiment has the special tree shape as described above. An effective grid width $W_A$ decreases and a gap width $W_G$ increases accordingly in a case where incident light is incident on the polarizing element 1 in an oblique direction as shown in FIG. 31 which will be described later, for example. Herein, the effective grid width $W_A$ is the width of the reflection film 30 in a direction perpendicular to the oblique incident light. The gap width $W_G$ is the width of a gap between the reflection films 30, 30 of mutually adjacent two grid portions, which is a gap in the direction perpendicular to the oblique incident light. As the effective grid width $W_A$ is larger, the oblique incident light is more likely to be reflected by the reflection film 30 and less likely to reach the transparent ridge portions 22 and the base part 21. Consequently, the transmittance for the oblique incident light decreases in the polarizing element 1. On the other hand, as the gap width $W_G$ is larger, the oblique incident light is more likely to pass through the gap between the mutually adjacent two reflection films 30, 30 to reach the transparent ridge portions 22 and the base part 21. Thus, the transmittance for the oblique incident light can be raised.

Hence, the gap width $W_G$ for oblique incident light increases, and the oblique incident light is likely to pass through the gap between the rounded reflection films 30, 30 to reach the transparent grid structural body 20 to be transmitted because the grid portion of the polarizing element 1 according to the present embodiment has the above-described special tree shape. Consequently, the transmission axis transmittance Tp for oblique incident light is high, and thus, transmissivity for oblique incident light and the polarization splitting properties (Tp $\times$ Rs properties) are very excellent. Further, the reflective function for oblique incident light exerted by the reflection film 30 and the transmission function for oblique incident light exerted by the grid structural body 20 can be achieved in a balanced way, and the polarization splitting properties for oblique incident light can be improved further.

<2.5. Method for Forming Reflection Film and Specific Examples>

Herein, a method for forming the reflection film 30 will be described with reference to FIG. 5.

As a method for forming the reflection film 30 such that the reflection film 30 covers the leading end 22a and part of both the side surfaces 22b of the ridge portion 22 of the grid structural body 20, the reflection film 30 preferably is formed by performing sputtering or vapor deposition alternately on the ridge portions 22 of the grid structural body 20 in an oblique direction (at a deposition incident angle $\phi$) as shown in FIG. 5. This can form the reflection film 30 so as to cover and wrap the leading end 22a and the upper side of both the side surfaces 22b of the ridge portion 22. Note that the deposition incident angle $\phi$ for forming the reflection film 30 by sputtering or vapor deposition is not particularly limited, and can be set at approximately 5 to 70° with respect to the surface of the substrate 10, for example.

In this manner, in the present embodiment, the reflection film 30 made of a metal material is formed by a sputtering or vapor deposition method after the grid structural body 20 made of a transparent material is formed. This enables the deposition conditions, material, and film thickness of the reflection film 30 to be easily modified. In addition, the case where the reflection film 30 is made of a multi-layer film can also be easily dealt with. Therefore, a film design through use of an interference effect can be made by combining metal, semiconductor, and dielectric, and it is not necessary to consider a material constitution that can be etched and the like when forming the reflection film 30 by etching as in the conventional technology. This also facilitates adjusting the reflectance for a polarization wave parallel to the grid structural body 20 and adjusting the transmittance (a transmitted amount) for polarized light in the direction perpendicular to the grid. In addition, depositing the reflection film 30 after forming the grid structural body 20 eliminates the need for a facility such as a vacuum dry etching device or the like, and eliminates the need for preparing gas, a safety device such as a pretreatment device, and the like in conformity to a complicated process and an etching material. Thus, running cost for facility investment, maintenance, and the like can be saved, so that a cost advantage can also be obtained.

Note that a thickness Dt of the reflection film 30 covering the leading end 22a of the ridge portion 22 and a thickness Ds of the reflection film 30 covering the side surfaces 22b of the ridge portion 22 shown in FIG. 5 are not particularly limited, and can be modified as appropriate in accordance with the shape of the ridge portion 22 of the grid structural body 20, performance required of the reflection film 30, or the like. From the perspective of obtaining more excellent reflection performance, for example, the thicknesses Dt and Ds of the reflection film 30 preferably are set at 2 to 200 nm, more preferably are set at 5 to 150 nm, further preferably are set at 10 to 100 nm, and particularly preferably are set at 15 to 80 nm. Note that the thickness Ds of the reflection film 30 is the thickness of the thickest portion of the reflection film

30 covering the side surfaces 22b of the ridge portion 22 as shown in FIG. 5.

In addition, the shape of the reflection film 30 is not particularly limited if it is a shape that can form the special tree shape described above, and can be selected as appropriate in accordance with conditions of a device for forming the reflection film 30 or performance required of the reflection film 30.

FIG. 6 is a sectional view schematically showing specific examples of the shape of the reflection film 30. As shown in FIG. 6, the reflection film 30 may have various shapes if they are curved shapes so as to enfold the top of the ridge portion 22 (the leading end 22a and the upper side of the side surfaces 22b).

For example, a reflection film 30A shown in FIG. 6 covers the tops of ridge portions 22A, 22B, and 22C having various sectional shapes in a roundly enfolding manner, and has a substantially elliptical shape greatly bulging in the width direction of the ridge portions 22. In addition, a reflection film 30B has a curved shape that covers the top of a substantially wedge-like ridge portion 22D in an enfolding manner. In addition, a reflection film 30C has a curved shape that covers the top of the trapezoidal ridge portion 22A in an enfolding manner. A coverage rate Rc of one of the side surfaces 22b of the ridge portion 22 and the coverage rate Rc of the other side surface 22b obtained by these reflection films 30B and 30C are substantially identical.

In addition, a reflection film 30D covers the top of the substantially wedge-like ridge portion 22D in an enfolding manner, but is unevenly located on the side of one of the side surfaces 22b (the left side surface 22b shown in FIG. 6) of the ridge portion 22. Specifically, the reflection film 30D covers a wide range of the left side surface 22b of the ridge portion 22, and the coverage rate Rc thereof is approximately 80%. On the other hand, the reflection film 30D only covers a narrow range on the upper side of the right side surface 22b, and the coverage rate Rc thereof is approximately 25%. In this manner, the coverage rate Rc obtained by the reflection film 30D may be different between one of the side surfaces 22b and the other side surface 22b of the ridge portion 22.

<2.6. Suitable Range of Coverage Rate Rc of Ridge Portion Achieved by Reflection Film>

Next, a suitable range of the coverage rate Rc of the side surface 22b of the ridge portion 22 obtained by the reflection film 30 according to the present embodiment will be described.

The coverage rate Rc preferably is more than or equal to 25% and less than or equal to 80%. Herein, the coverage rate Rc is a proportion of a height (Hx) of a portion of the side surfaces 22b of the ridge portion 22 covered by the reflection film 30 to the height (H) of the ridge portion 22 shown in FIG. 1 and FIG. 5. The coverage rate Rc is expressed by Equation (1) below.

$$Rc\ [\%] = (Hx/H) \times 100 \qquad \ldots (1)$$

H: height in the Z direction of the ridge portion 22

Hx: height in the Z direction of the portion of the side surfaces 22b of the ridge portion 22 covered by the reflection film 30

In addition, an open rate Rr is a proportion of a height (H-Hx) of a portion of the side surfaces 22b of the ridge portion 22 that is not covered by the reflection film 30 to the height (H) of the ridge portion 22 shown in FIG. 1 and FIG. 5. The open rate Rr is expressed by Equation (2) below.

$$Rr\ [\%] = ((H\text{-}Hx)/H) \times 100 \qquad \ldots (2)$$

From the above definitions, Rr = 100-Rc holds. Thus, in the case where the coverage rate Rc of the side surfaces 22b of the ridge portion 22 obtained by the reflection film 30 is more than or equal to 25% and less than or equal to 80%, the open rate Rr of the side surfaces 22b of the ridge portion 22 obtained by the reflection film 30 is more than or equal to 20% and less than or equal to 75%.

As described above, in the polarizing element 1 according to the present embodiment, the coverage rate Rc of the side surfaces 22b of the ridge portion 22 obtained by the reflection film 30 preferably is more than or equal to 25% and less than or equal to 80% (that is, the open rate Rr is more than or equal to 20% and less than or equal to 75%). In detail, in the present embodiment, the reflection film 30 is formed to cover the leading end 22a and the upper side of both the side surfaces 22b of the ridge portion 22 and not to cover but open the lower side of both the side surfaces 22b. Then, the coverage rate Rc preferably is more than or equal to 25% and less than or equal to 80%, more preferably is more than or equal to 30% and less than or equal to 70%, and still more preferably is more than or equal to 40% and less than or equal to 50%.

Such a configuration enables the polarizing element 1 according to the present embodiment to exert sufficient transmissivity even for oblique incident light at a large incident angle θ (for example, 45 to 60°). For example, when oblique

incident light is split by the polarizing element 1 into the s-polarized light (reflected light) and the p-polarized light (transmitted light), the transmittance Tp for the p-polarized light (transmitted light) transmitted through the polarizing element 1 can be maintained at a high value irrespective of the incident angle θ of the oblique incident light. In addition, setting the coverage rate Rc at more than or equal to 25% and less than or equal to 80% enables the reflection function obtained by the reflection film 30 described above to be more reliably exerted without depending on the incident angle θ while maintaining a contrast (CR = Tp/Ts) which is a ratio of the transmission axis transmittance (Tp) to transmission axis reflectance (Ts) at a favorable level. Consequently, high transmissivity for transmitted light can be ensured and the polarization splitting properties can be improved irrespective of the incident angle θ of oblique incident light.

In contrast to this, in a case where the reflection film 30 is formed to cover only the leading end 22a of the ridge portion 22 of the grid structural body 20 and in a case where the reflection film 30 is formed to cover the leading end 22a and the entirety of the side surface 22b on one side of the ridge portion 22 (for example, see FIG. 18) as comparative examples, it is considered that the transmittance Tp fluctuates greatly depending on the incident angle θ of oblique incident light, and sufficient transmissivity cannot be obtained for oblique incident light at the large incident angle θ. In addition, in a case where the reflection film 30 covers the leading end 22a and the entirety of both the side surfaces 22b of the ridge portion 22 of the grid structural body 20 (in a case where the coverage rate Rc is 100%) as a comparative example, the transmissivity decreases considerably when the incident angle θ of oblique incident light is large.

Thus, from the perspective of improving the transmissivity for transmitted light and the polarization splitting properties without depending on the incident angle θ of oblique incident light, the leading end 22a and part of at least one of the side surfaces 22b (the upper side of the side surface 22b) of the ridge portion 22 preferably are covered by the reflection film 30 as in the polarizing element 1 according to the present embodiment.

Further, from the perspective of the Tp × Rs properties required as the polarizing beam splitter (PBS), the coverage rate Rc of the side surfaces 22b of the ridge portion 22 obtained by the reflection film 30 preferably is more than or equal to 25% and less than or equal to 80% in the polarizing element 1 according to the present embodiment (for example, see FIG. 27).

In a case where the coverage rate Rc is less than 25%, the transmission axis transmittance Tp for the p-polarized light transmitted through the polarizing element 1 decreases, and the transmittance Tp fluctuates depending on the incident angle θ, so that a sufficiently high value of Tp × Rs cannot be obtained. Therefore, sufficient transmissivity for transmitted light and the polarization splitting properties expressed as Tp × Rs cannot be obtained for oblique incident light at the large incident angle θ. On the other hand, in a case where the coverage rate Rc exceeds 80% (for example, see FIG. 20), the transmission axis transmittance Tp decreases as the incident angle θ of oblique incident light is larger (for example, 45 to 60°) similarly to the case where the leading end 22a and the entirety of both the side surfaces 22b of the ridge portion 22 of the grid structural body 20 are covered. Thus, the transmittance Tp fluctuates greatly depending on the incident angle θ.

Consequently, the coverage rate Rc of the side surfaces 22b of the ridge portion 22 obtained by the reflection film 30 preferably is more than or equal to 25% and less than or equal to 80% (for example, see FIG. 27). The transmission axis transmittance Tp for the second polarized light (p-polarized light) transmitted through the polarizing element 1 can thereby be more than or equal to 75% in the case where light is incident on the polarizing element 1 in an oblique direction at the incident angle θ of 45°, for example. As a result, Tp × Rs can be more than or equal to 70%. Thus, even in a case where wide-range oblique incident light is incident at the large incident angle θ, the transmissivity for the second polarized light (p-polarized light) in the transmission axis direction of the polarizing element 1 can be increased to improve the polarization splitting properties of the polarizing element 1, so that oblique incident light can be suitably split by the polarizing element 1 into the first polarized light (s-polarized light) and the second polarized light (p-polarized light).

From a similar perspective, the coverage rate Rc more preferably is more than or equal to 30% and less than or equal to 70% (that is, the open rate Rr is more than or equal to 30% and less than or equal to 70%). High transmittance Tp of more than or equal to 80% can thereby be obtained in the case of the above-described oblique incident conditions, so that high Tp × Rs of more than or equal to 72% can be obtained. In addition, the coverage rate Rc more preferably is more than or equal to 30% and less than or equal to 60% (that is, the open rate Rr is more than or equal to 40% and less than or equal to 70%). High transmittance Tp of more than or equal to 83% can thereby be obtained in the case of the above-described oblique incident conditions, so that high Tp × Rs of more than or equal to 75% can be obtained. Further, the coverage rate Rc still more preferably is more than or equal to 40% and less than or equal to 50% (that is, the open rate Rr is more than or equal to 50% and less than or equal to 60%). Very high transmittance Tp of more than or equal to 85% can thereby be obtained in the case of the above-described oblique incident conditions, so that very high Tp × Rs of more than or equal to 77% can be obtained.

In addition, as to the reflection axis reflectance Rs, the coverage rate Rc preferably is more than or equal to 20%. High reflectance Rs of more than or equal to 85% is thereby obtained in the case of the above-described oblique incident conditions.

In addition, as to the contrast CR (CR = Tp/Ts) of the transmitted light, sufficient contrast CR is obtained if the coverage rate Rc is more than or equal to 20%. As the coverage rate Rc is higher, higher contrast CR is obtained.

<2.7. Suitable Range of Tp × Rs>

Next, a suitable range of "Tp × Rs" which is an index representing the polarization splitting properties of the wire grid polarizing element 1 according to the present embodiment will be described.

Tp × Rs [%] represents the product of the transmission axis transmittance (Tp) and the reflection axis reflectance (Rs) in percentage. This Tp × Rs serves as the index representing the polarization splitting properties of the wire grid polarizing element 1.

$$Tp \times Rs\,[\%] = (Tp\,[\%]/100) \times (Rs\,[\%]/100) \times 100$$

Note that as described above, the transmission axis transmittance (Tp) is the transmittance for the second polarized light (p-polarized light) having an electric field component parallel to the transmission axis (the X direction) of the polarizing element 1. The reflection axis reflectance (Rs) is the reflectance for the first polarized light (s-polarized light) having an electric field component parallel to the reflection axis (the Y direction) of the polarizing element 1.

In the case of splitting incident light into the s-polarized light and the p-polarized light using the wire grid polarizing element 1 according to the present embodiment as a polarizing beam splitter (see FIG. 15 to FIG. 17), the polarizing element 1 is arranged at an inclination by a predetermined angle (for example, 45°) with respect to incident light from a light source. For example, when incident light from the light source is incident on the polarizing element 1 obliquely at the incident angle θ of approximately 45°, the incident light is split by the polarizing element 1 into the first polarized light (s-polarized light: reflected light) and the second polarized light (p-polarized light: transmitted light). In the incident light, the s-polarized light is light having an electric field component in the direction parallel to the longitudinal direction (the reflection axis direction shown in FIG. 2: the Y direction) of the ridge portions 22 of the grid structural body 20. On the other hand, in the incident light, the p-polarized light is light having an electric field component in the direction parallel to the width direction (the transmission axis direction shown in FIG. 2: the X direction) of the ridge portions 22 of the grid structural body 20.

The s-polarized light in the reflection axis direction mainly becomes reflected light reflected by the reflection film 30 of the polarizing element 1. The reflectance [%] for the s-polarized light at this time is the reflection axis reflectance (Rs). The reflection axis reflectance (Rs) represents the proportion of the s-polarized light reflected by the polarizing element 1 in the s-polarized light incident on the polarizing element 1. Note that reflection axis transmittance (Rp) represents the proportion of the s-polarized light transmitted through the polarizing element 1 in the s-polarized light incident on the polarizing element 1.

On the other hand, the p-polarized light in the transmission axis direction mainly becomes transmitted light transmitted through the grid structural body 20 and the substrate 10 of the polarizing element 1 which are transparent. The transmittance [%] for the p-polarized light at this time is the transmission axis transmittance (Tp). The transmission axis transmittance (Tp) represents the proportion of the p-polarized light transmitted through the polarizing element 1 in the p-polarized light incident on the polarizing element 1. Note that the transmission axis reflectance (Ts) represents the proportion of the p-polarized light reflected by the polarizing element 1 in the p-polarized light incident on the polarizing element 1.

Consequently, this means that as the transmission axis transmittance Tp is higher, the p-polarized light in the transmission axis direction can efficiently be transmitted. This also means that as the reflection axis reflectance Rs is higher, the s-polarized light in the reflection axis direction can efficiently be reflected. Thus, as the value of Tp × Rs which is the product of Tp and Rs is higher, both the transmissivity for the p-polarized light (transmitted light) and the reflectiveness for the s-polarized light (reflected light) will be high, so that the polarizing element 1 will be excellent in polarization splitting properties as the polarizing beam splitter.

Herein, the suitable range of the value of Tp × Rs according to the present embodiment will be described. A case where light having a wavelength in a predetermined range (for example, 430 to 680 nm) is incident on the polarizing element 1 according to the present embodiment at a predetermined incident angle θ (for example, 45°) in an oblique direction and the light is split into the p-polarized light (transmitted light) and the s-polarized light (reflected light) is considered. In the case of such oblique incident conditions, Tp × Rs preferably is more than or equal to 70% from the perspective of favorable polarization splitting properties of the polarizing element 1.

When Tp × Rs is less than 70%, a display device to which the polarizing element is applied has poor light utilization efficiency to be deficient in brightness of a displayed image and inferior in visibility. In contrast to this, when Tp × Rs is more than or equal to 70%, a display device to which the polarizing element 1 is applied can be increased in light utilization efficiency to ensure sufficient brightness of a displayed image and improve visibility.

Further, Tp × Rs more preferably is more than or equal to 72%, still more preferably is more than or equal to 75%, and particularly preferably is more than or equal to 80%. This enables the light utilization efficiency, the brightness of a displayed image, and the visibility as described above to be further improved.

<2.8. Suitable Range of Height H of Ridge Portions>

In a case where incident light is incident on the polarizing element 1 according to the present embodiment at a relatively large incident angle θ (for example, 45°), the height H (see FIG. 1, FIG. 3, and the like) of the ridge portion 22 of the grid structural body 20 preferably is more than or equal to 160 nm, more preferably is more than or equal to 180 nm, and particularly preferably is more than or equal to 220 nm (see FIG. 24). This enables high transmission axis transmittance Tp, excellent Tp × Rs properties, and high contrast CR of transmitted light to be obtained.
Specifically, as to the transmittance, when the height H of the ridge portion 22 is more than or equal to 160 nm, the transmission axis transmittance Tp for oblique incident light becomes more than or equal to 80%, so that high transmittance is obtained. Further, when H is more than or equal to 180 nm, Tp of more than or equal to 85% is obtained, which is more preferable. In addition, when H is more than or equal to 220 nm, Tp of more than or equal to 87% is obtained, which is particularly preferable.
In addition, as to the Tp × Rs properties required as the polarizing beam splitter (PBS), when the height H of the ridge portion 22 is more than or equal to 160 nm, excellent Tp × Rs of more than or equal to 70% is obtained. Further, when H is more than or equal to 180 nm, Tp × Rs of more than or equal to 75% is obtained, which is more preferable. In addition, when H is more than or equal to 220 nm, Tp × Rs of more than or equal to 77% is obtained, which is particularly preferable.
In addition, as to the contrast CR (CR = Tp/Ts) of the transmitted light, the height H of the ridge portion 22 should only be more than or equal to 100 nm, and when H is more than or equal to 160 nm, excellent contrast CR of more than or equal to 150 is obtained. Further, when H is more than or equal to 180 nm, excellent CR of more than or equal to 250 is obtained, which is more preferable. In addition, when H is more than or equal to 220 nm, excellent CR of more than or equal to 500 is obtained, which is particularly preferable.
As described above, it is understood that in order to obtain favorable various properties (Tp, Tp × Rs, and CR), particularly Tp, of the polarizing element 1, the height H of the ridge portion 22 preferably is greater. The following is considered to be the reason for this. In other words, in a case where the deposition incident angle ϕ (see FIG. 5) when depositing the reflection film 30 on the ridge portions 22 by sputtering, vapor deposition, or the like is identical, the coverage rate Rc obtained by the reflection film 30 increases as the height H of the ridge portion 22 is smaller. When the coverage rate Rc increases, the range of the ridge portion 22 covered by the reflection film 30 is wider, which makes the p-polarized light less likely to be transmitted through the grid structural body 20, resulting in decreased transmittance Tp. Consequently, it can be said that under the condition that the deposition incident angle ϕ is identical, it is preferable to reduce the coverage rate Rc by making the height H of the ridge portion 22 greater to raise the transmittance Tp.

<2.9. Suitable Range of Leading End Thickness Dt of Functional Film (Reflection Film)>

In a case where incident light is incident on the polarizing element 1 according to the present embodiment at a relatively large incident angle θ (for example, 45°), the thickness Dt of the reflection film 30 (the leading end thickness Dt of the reflection film 30: see FIG. 5) covering the leading end 22a of the ridge portion 22 of the grid structural body 20 preferably is more than or equal to 5 nm, and more preferably is more than or equal to 15 nm (for example, see FIG. 25).
When the leading end thickness Dt of the reflection film 30 is more than or equal to 5 nm, both the reflection axis reflectance Rs and the transmission axis transmittance Tp for oblique incident light become more than or equal to 85%, so that high transmittance is obtained. Further, in a case of considering Tp properties and the Tp × Rs properties required as the polarizing beam splitter, Dt more preferably is more than or equal to 15 nm.

<2.10. Suitable Range of Side Surface Thickness Ds of Functional Film (Reflection Film)>

In addition, the thickness Ds of the reflection film 30 (the side surface thickness Ds of the reflection film 30: see FIG. 5) covering the side surfaces 22b of the ridge portion 22 of the grid structural body 20 preferably is more than or equal to 10 nm and less than or equal to 30 nm, more preferably is more than or equal to 12.5 nm and less than or equal to 25 nm, and particularly preferably is more than or equal to 15 nm and less than or equal to 25 nm (for example, see FIG. 26). This enables high transmission axis transmittance Tp, excellent Tp × Rs properties, and high contrast CR of transmitted light to be obtained.
Specifically, as to the transmittance, when the side surface thickness Ds of the reflection film 30 is more than or equal to 10 nm and less than or equal to 30 nm, the transmission axis transmittance Tp for oblique incident light becomes more than or equal to 80%, so that high transmittance is obtained. Further, when Ds is more than or equal to 12.5 nm and less than or equal to 25 nm, Tp of more than or equal to 85% is obtained, which is more preferable.
In addition, as to the reflectance, when the side surface thickness Ds of the reflection film 30 is more than or equal to 10 nm, the reflection axis reflectance Rs of oblique incident light becomes more than or equal to 80%, so that high reflectance is obtained. Further, when Ds is more than or equal to 12.5 nm, Rs of more than or equal to 85% is obtained, which is more preferable.

In addition, as to the Tp × Rs properties required as the polarizing beam splitter (PBS), when the side surface thickness Ds of the reflection film 30 is more than or equal to 12.5 nm and less than or equal to 30 nm, excellent Tp × Rs of more than or equal to 70% is obtained. Further, when Ds is more than or equal to 15 nm and less than or equal to 25 nm, Tp × Rs of more than or equal to 76% is obtained, which is more preferable.
In addition, as to the contrast CR (CR = Tp/Ts) of the transmitted light, the side surface thickness Ds of the reflection film 30 should only be more than or equal to 10 nm, and when Ds is more than or equal to 12.5 nm, excellent contrast CR of more than or equal to 50 is obtained. Further, when Ds is more than or equal to 15 nm, CR of more than or equal to 100 is obtained, which is more preferable.

<2.11. Uneven Location of Reflection Film>

In addition, in the polarizing element 1 according to the present embodiment, the reflection film 30 covering the ridge portion 22 may be unevenly located on one side of the ridge portion 22 to present a bilaterally asymmetric shape in the width direction (the X direction) of the ridge portion 22 (for example, see FIG. 29). Specifically, the side surface thickness Ds, the coverage rate Rc, and the like of the reflection film 30 may be changed between one of the side surfaces 22b and the other side surface 22b of the ridge portion 22 to unevenly locate the reflection film 30 on the one of the side surfaces 22b of the ridge portion 22. That is, the reflection film 30 may cover the one of the side surfaces 22b of the ridge portion 22 thickly and widely, and may cover the other side surface 22b thinly and narrowly.
In the case of unevenly locating the reflection film 30 on the one side of the ridge portion 22 in this manner, a difference between the transmission axis transmittance Tp (+) for incident light on the polarizing element 1 at an incident angle of +θ (+30° to +60°) and the transmission axis transmittance Tp (-) for incident light at an incident angle of -θ (-30° to -60°) preferably is within 3%. Then, the thickness Ds and the coverage rate Rc of the reflection film 30 covering each of the one of the side surfaces 22b and the other side surface 22b of the ridge portion 22 preferably are adjusted such that the difference between Tp (+) and Tp (-) falls within 3%, thereby unevenly locating the reflection film 30 on the one side of the ridge portion 22 in an appropriate manner.
Note that the incident angle of +θ means that oblique incident light is incident on the ridge portion 22 in a direction inclined to one side in the X direction (the width direction of the ridge portion 22). On the other hand, the incident angle of -θ means that oblique incident light is incident on the ridge portion 22 in a direction inclined to the other side in the X direction (for example, see FIG. 29).
As described above, in the case of unevenly locating the reflection film 30 on the one side of the ridge portion 22, the difference between Tp (+) and Tp (-) preferably falls within 3%. This enables high transmission axis transmittance Tp, excellent Tp × Rs properties, and high contrast CR of transmitted light to be obtained even in the case where the reflection film 30 is unevenly located on the one side of the ridge portion 22.
Specifically, as to the transmittance, the transmission axis transmittance Tp for oblique incident light at the incident angles θ of +45° and -45° becomes more than or equal to 85% even in the case where the reflection film 30 is unevenly located on the one side, so that high transmittance is obtained.
In addition, as to the reflectance, the reflection axis reflectance Rs of oblique incident light at the incident angles θ of +45° and -45° becomes more than or equal to 85% even in the case where the reflection film 30 is unevenly located on the one side, so that high reflectance is obtained.
In addition, as to the Tp × Rs properties required as the polarizing beam splitter (PBS), Tp × Rs of oblique incident light at the incident angle θ of 45° becomes more than or equal to 75% even in the case where the reflection film 30 is unevenly located on the one side, so that excellent Tp × Rs properties are obtained.
In addition, as to the contrast CR (CR = Tp/Ts) of the transmitted light, excellent contrast CR is obtained even in the case where the reflection film 30 is unevenly located on the one side. Further, from the perspective of improving the contrast, of the thicknesses Ds of the reflection film 30 covering each of one of the side surfaces 22b and the other side surface 22b of the ridge portion 22, a thinner one of the thicknesses Ds preferably is more than or equal to 5 nm (the coverage rate Rc thereof is more than or equal to 22%), and the thinner one of the thicknesses Ds of the reflection film 30 more preferably is more than or equal to 10 nm (the coverage rate Rc thereof is more than or equal to 33%).

<2.12. Other Constituent Members>

The polarizing element 1 according to the present embodiment can further include constituent members other than the substrate 10, the grid structural body 20, and the reflection film 30 described above.
For example, the polarizing element 1 preferably further includes the protection film 40 formed to cover at least the surface of the reflection film 30 as shown in FIG. 7. In detail, the protection film 40 more preferably covers the entire surface of the grid structural body 20 as shown in FIG. 7. That is, the protection film 40 more preferably is formed to entirely cover the side surfaces 22b of the ridge portion 22 and the surface of the base part 21 of the grid structural body 20 as well as the surface of the reflection film 30. Forming this protection film 40 can further increase abrasion resistance, antifouling

property, and waterproofness of the polarizing element 1.

In addition, the protection film 40 more preferably further includes a water-repellent coating or an oleophobic coating. This can further increase the antifouling property and waterproofness of the polarizing element 1.

The material constituting the protection film 40 is not particularly limited if it can increase the abrasion resistance, antifouling property, and waterproofness of the polarizing element 1. Examples of the material constituting the protection film 40 include a film made of a dielectric material, and more specifically include inorganic oxides, silane-based water-repellent materials, and the like. Inorganic oxides include Si oxides, Hf oxides, and the like. Silane-based water-repellent materials may contain fluorinated silane compounds such as perfluorodecyltriethoxysilane (FDTS), or may contain non-fluorinated silane compounds such as octadecyl trichlorosilane (OTS).

Among these materials, the protection film 40 more preferably contains at least one of an inorganic oxide and a fluorinated water-repellent material. When the protection film 40 contains an inorganic oxide, the scratch resistance of the polarizing element can be increased further. When the protection film 40 contains a fluorinated water-repellent material, the antifouling property and waterproofness of the polarizing element can be increased further.

Note that the protection film 40 should only be formed to cover at least the surface of the reflection film 30, and more preferably is formed to cover the entire surfaces of the grid structural body 20 and the reflection film 30, as shown in FIG. 7. In this case, for example, the protection film 40 may cover end surfaces of the grid structural body 20 (end surfaces of the base part 21) as shown in the upper diagram in FIG. 7, or the protection film 40 may not cover the end surfaces of the grid structural body 20 (the end surfaces of the base part 21) as shown in the lower diagram in FIG. 7. Alternatively, as shown in FIG. 8, the protection film 40 can also be formed to cover the entire polarizing element 1 including the surface of the substrate 10 in addition to the surfaces of the grid structural body 20 and the reflection film 30. In this manner, covering the outermost surface of the grid structural body 20 or the polarizing element 1 with the protection film 40 made of an inorganic oxide enables the thermal resistance R of the entire polarizing element 1 to be reduced further, so that the heat dissipation of the polarizing element 1 is improved further.

Further, the polarizing element 1 according to the present embodiment preferably is provided with a heat dissipation member 50 in a manner surrounding the substrate 10, as shown in FIG. 9. This heat dissipation member 50 enables heat conveyed from the substrate 10 to be discharged more efficiently. Herein, the heat dissipation member 50 is not particularly limited if it is a member having a high heat dissipation effect. The heat dissipation member 50 may be a radiator, a heatsink, a heat spreader, a die pad, a heat pipe, a metal cover, an enclosure, or the like, for example.

<2.13. Image of Actual Grid Structural Body>

Next, an example of the polarizing element 1 according to the present embodiment actually produced and photographed under magnification using a scanning electron microscope (SEM) will be described with reference to FIG. 10. FIG. 10A is an SEM image of the grid structural body 20 before being covered by the reflection film 30, as seen in an oblique direction. FIG. 10B is an SEM image showing a section of the ridge portions 22 of the grid structural body 20 before being covered by the reflection film 30. FIG. 10C is an SEM image showing a section of the ridge portions 22 of the grid structural body 20 covered by the reflection film 30.

As shown in FIG. 10A and FIG. 10B, the base part 21 provided along the surface of the substrate 10 and the ridge portions 22 protruding from the base part 21 are formed in the grid structural body 20. The plurality of ridge portions 22 are arrayed at an almost equal pitch P. Each of the ridge portions 22 has an upward narrowing shape that narrows in width with distance from the base part 21. The top width $W_T$ of the ridge portion 22 is narrower than the bottom width $W_B$ of the ridge portion 22. The pitch P is sufficiently larger than the bottom width $W_B$ of the ridge portion 22. The height H of the ridge portion 22 is greater than the pitch P. In the example of FIG. 10, P = 140 nm, $W_T$ = 10 nm, $W_B$ = 30 nm, and H= 220 nm hold. In addition, as shown in FIG. 10C, the reflection film 30 is formed to cover and wrap the leading end 22a and both the side surfaces 22b of the ridge portion 22. The outer surface of the reflection film 30 is rounded and curved, and bulges in the width direction of the ridge portion 22.

<3. Method for Manufacturing Polarizing Element>

Next, a method for manufacturing the wire grid polarizing element 1 according to the present embodiment will be described with reference to FIG. 11. FIG. 11 is a process diagram showing the method for manufacturing the wire grid polarizing element 1 according to the present embodiment.

As described above, the polarizing element 1 according to the present embodiment is the wire grid polarizing element 1 of the hybrid type made of an inorganic material (the substrate 10) and an organic material (the grid structural body 20). Hereinafter, the method for manufacturing the wire grid polarizing element 1 of the hybrid type will be described.

As shown in FIG. 11, the method for manufacturing the wire grid polarizing element 1 according to the present embodiment includes a grid structural body material forming step (S10), a nano-imprinting step (S12), a grid structural body forming step (S14), and a reflection film forming step (S16).

Grid Structural Body Material Forming Step (S10)

First, in S10, a grid structural body material 23 made of a transparent organic material (for example, an ultraviolet curable resin or a thermosetting resin) is stacked on the substrate 10 made of a transparent inorganic material (for example, glass) by coating or the like. Note that various materials described above can be used as the inorganic material of the substrate 10. In addition, various materials described above can be used as the organic material of the grid structural body 20. Further, the film thickness of the grid structural body material 23 should only be adjusted as appropriate in accordance with the dimensions of the base part 21 and the ridge portions 22 of the grid structural body 20 formed by nano-imprinting in S20.

Nano-Imprinting Step (S12) and Grid Structural Body Forming Step (S14)

Then, the grid structural body material 23 is subjected to nano-imprinting in S12 to form the grid structural body 20 on the substrate 10 in S14. The grid structural body 20 is a micro concave-convex structural body in which the base part 21 provided on the substrate 10 and the plurality of ridge portions 22 protruding from the base part 21 are integrally formed. The micro concave-convex structural body is a structural body having micro convexities and concavities on the order of several nanometers to several tens of nanometers, for example.

In the nano-imprinting step in S12, a master 60 on which a reversed shape of the micro concave-convex shape of the grid structural body 20 has been formed is used to transfer the micro concave-convex shape of the master 60 to a surface of the grid structural body material 23 (S12). A concave-convex pattern composed of the base part 21, the ridge portions 22, and the concavities 24 described above are thereby formed on the grid structural body material 23. Further, in the nano-imprinting step, an energy beam is radiated to the grid structural body material 23 along with the transfer of the above-described concave-convex pattern to cure the grid structural body material 23 to which the concave-convex pattern has been transferred, thereby forming the grid structural body 20 (S14). For example, in the case where the grid structural body material 23 is made of an ultraviolet curable resin, the ultraviolet curable resin to which the concave-convex pattern has been transferred may be cured by radiating ultraviolet rays to the grid structural body material 23 using an ultraviolet radiation device 66. Alternatively, in the case where the grid structural body material 23 is made of a thermosetting resin, the thermosetting resin to which the concave-convex pattern has been transferred may be cured by heating the grid structural body material 23 using a heating device 68 such as a heater.

In the above-described steps S12 and S14, the ridge portions 22 each having the upward narrowing shape that narrows in width with distance from the base part 21 are formed as the ridge portions 22 of the grid structural body 20. The ridge portions 22 in the example of FIG. 11 have a trapezoidal shape (a tapered shape), but may have other various upward narrowing shapes as shown in FIG. 3.

In this manner, the present embodiment enables the master 60 to easily be peeled from the grid structural body material 23 because the ridge portions 22 each having the upward narrowing shape are imprinted in the nano-imprinting step S12, resulting in excellent mold releasability. In addition, the ridge portions 22 of the grid structural body 20 can be correctly molded into a desired shape without losing their shape.

Reflection Film Forming Step (S16)

Then, in S16, the reflection film 30 covering part of the ridge portion 22 of the grid structural body 20 is formed using a metal material such as Al or Ag. The reflection film 30 is an example of a functional film that provides the polarizing element 1 with a predetermined function. The reflection film 30 is a metal thin film (a grid of fine metal wires) for reflecting incident light incident on the grid structural body 20 of the polarizing element 1.

In this reflection film forming step S16, the reflection film 30 is formed as will be described below. In other words, the reflection film 30 is formed such that the reflection film 30 covers and wraps the leading end 22a and the upper side of at least one of the side surfaces 22b of the ridge portion 22 and does not cover the lower side of both the side surfaces 22b of the ridge portion 22 and the base part 21. Further, the reflection film 30 is formed such that the surface of the reflection film 30 covering and wrapping the ridge portion 22 is rounded and bulges in the width direction of the ridge portion 22. In addition, the reflection film 30 is formed such that the maximum width $W_{MAX}$ (the grid maximum width $W_{MAX}$) of the reflection film 30 covering and wrapping the ridge portion 22 is more than or equal to the aforementioned bottom width $W_B$ (the grid bottom width $W_B$) of the ridge portion.

As a method for forming this reflection film 30, the sputtering or vapor deposition method can be used as shown in FIG. 5, for example. A metal material is sputtered or vapor-deposited on the ridge portions 22 of the grid structural body 20 alternately in oblique directions to deposit the reflection film 30. This enables the reflection film 30 having a desired shape to be suitably formed so as to roundly cover and wrap the top of the ridge portion 22.

By forming the reflection film 30 in this manner, the ridge portion 22 of the grid structural body 20 and the reflection film 30 become to have the special tree shape described above. Even in the case where light is incident on the polarizing

element 1 in an oblique direction at a relatively large and wide-range incident angle θ (for example, 30 to 60°) as described earlier, the transmission axis transmittance Tp for the p-polarized light included in the oblique incident light can thereby be maintained at a high value, so that the transmissivity for the p-polarized light (transmitted light) can be ensured. Thus, the value of Tp × Rs can be maintained at a high value (for example, more than or equal to 70%), which can improve the polarization splitting properties of the polarizing element 1 for oblique incident light.

Note that the method for manufacturing the polarizing element 1 according to the present embodiment may include a step (a protection film forming step) of forming the protection film 40 that covers the surface of the polarizing element 1 according to necessity after the reflection film forming step S16 shown in FIG. 11. The protection film 40 preferably is formed to cover the entire surfaces of the grid structural body 20 and the reflection film 30. Various materials described above can be used as the material of the protection film 40.

The method for manufacturing the polarizing element 1 according to the present embodiment has been described above. Use of the steps described above enables the polarizing element 1 excellent in polarization properties and heat dissipation to be manufactured without causing elevated manufacturing cost and complicated manufacturing of the polarizing element 1.

Herein, a conventional method for manufacturing a wire grid polarizing element will be briefly described with reference to FIG. 12 for comparison with the manufacturing method according to the present embodiment.

As shown in FIG. 12, in the conventional method for manufacturing a wire grid polarizing element, a metal film 80 is first deposited on the substrate 10 in order to produce a convex grid shape (S20). In this S20, a reflection film made of a material that reflects light in the used band, or the like, for example, the metal film 80 of aluminum or the like, is deposited on the substrate 10 made of an inorganic material such as glass using sputtering, vapor deposition, or the like.

Then, a resist mask 70 is patterned on the metal film 80 using the photolithography technology (S22). Thereafter, the metal film 80 is subjected to etching using a vacuum dry etching device or the like to form a convex shape made of the metal film 80 (S24). For example, in a case where an etch selectivity between the resist mask 70 and the metal film 80 cannot be achieved at this time, an oxide film of $SiO_2$ or the like is further deposited on the metal film 80 by sputtering or the like, and the resist mask 70 is formed thereon by the photolithography technology. Thereafter, the resist mask 70 is peeled from the metal film 80 (S26), then, the protection film 40 made of an $SiO_2$ film or the like is deposited by CVD or the like, and water repellent/oleophobic coating treatment is also performed according to necessity (S28).

Note that although a process of producing a reflection-type wire grid polarizing element having a basic configuration is shown in steps S20 to S28 of the above-described conventional manufacturing method, a further complicated process is required when considering a case where the metal film 80 is a multi-layer film. Thus, the conventional wire grid polarizing element produced by the process as shown in S20 to S28 of FIG. 12 is presumed to be expensive in manufacturing cost and require a long manufacturing time. In addition, in a case of mass-producing polarizing elements, a plurality of accurate, expensive etching devices and photolithography devices need to be prepared in accordance with the production volume in order to form a micro convex shape smaller than the wavelength of light, so that facility investment is also predicted to be more expensive.

In contrast to this, by molding the grid structural body 20 using an imprinting technology such as nano-imprinting, the method for manufacturing the polarizing element 1 according to the present embodiment (see FIG. 11) enables the manufacturing cost, manufacturing time, and facility investment to be reduced considerably as compared with the above-described conventional manufacturing method (see FIG. 12).

The method for manufacturing the polarizing element 1 according to the present embodiment is not particularly limited in nano-imprinting conditions while the grid structural body material 23 is subjected to nano-imprinting (S12 in FIG. 11). As shown in S12 in FIG. 11, for example, nano-imprinting is performed using a replica master (which may be a proper type master) as the master 60, and UV radiation, heating, or the like is performed on the grid structural body material 23, thereby curing the grid structural body material 23 in a state where the concave-convex pattern has been imprinted. Thereafter, the master 60 is released from the grid structural body material 23 having been cured. This enables the grid structural body 20 in which the base part 21 and the ridge portions 22 have been formed to be molded by transfer.

Note that the master 60 used in the nano-imprinting step S12 (FIG. 11) in the method for manufacturing the polarizing element 1 according to the present embodiment can be produced by the photolithography technology as shown in FIG. 13, for example. FIG. 13 is a process diagram showing a method for manufacturing the master 60 according to the present embodiment.

As shown in FIG. 13, a master metal film 62 is first deposited on a master base material 61 (S30), and then the resist mask 70 is formed on the master metal film 62 (S32). Then, the master metal film 62 is etched using the resist mask 70, and concave grooves 65 corresponding to the ridge portions 22 of the above-described grid structural body 20 are formed in the master metal film 62 having been etched (S34).

Thereafter, the resist mask 70 is peeled from the master metal film 62, thereby obtaining the master 60 (S36). The master 60 has a micro concave-convex structure composed of a plurality of the convexities 63 and concave grooves 65 molded on the master base material 61. The micro concave-convex structure on the surface of the master 60 has an inverted shape of the micro concave-convex structure on the surface of the above-described grid structural body 20 of the

polarizing element 1. The concave groove 65 in the master 60 has an inverted shape of the ridge portion 22 of the grid structural body 20, and the convexity 63 of the master 60 has an inverted shape of the concavity 24 between the ridge portions 22, 22 of the grid structural body 20.

Further, the manufacturing method according to the present embodiment may include a step of forming a release film coating 64 on the surface of the micro concave-convex structure of the master 60 according to necessity (S38). By providing the release film coating 64 on the surface of the master 60, the master 60 can easily be peeled from the grid structural body material 23 after subjecting the grid structural body material 23 to nano-imprinting in the nano-imprinting step (S12) shown in FIG. 11 described above, which can further improve the releasability.

## <4. Projection Display Device>

Next, a projection display device to which the wire grid polarizing element 1 according to the present embodiment is applied will be described with reference to FIG. 14.

The projection display device according to the present embodiment includes the wire grid polarizing element 1 according to the present embodiment described above. When the projection display device according to the present embodiment includes the polarizing element 1, excellent polarization properties as well as heat tolerance and heat dissipation of the polarizing element 1, and the like can be achieved.

Herein, the projection display device is a device that projects light toward a target, and radiates the light having been projected (projected light) to a to-be-displayed surface (projection surface) of the target, thereby displaying a virtual image such as an image or video. Examples of types of projection display devices include a head-up display device (HUD), a projector device, and the like.

### <4.1. Head-Up Display Device>

First, a head-up display device 100 including the wire grid polarizing element 1 according to the present embodiment will be described with reference to FIG. 14. FIG. 14 is a schematic diagram showing an example of the head-up display device 100 according to the present embodiment.

As shown in FIG. 14, the head-up display device 100 according to the present embodiment includes the wire grid polarizing element 1 according to the present embodiment described above. Because the head-up display device 100 includes the polarizing element 1, the polarization properties, heat tolerance, and heat dissipation can be improved. A head-up display with a conventional polarizing element incorporated therein is inferior in heat dissipation, and thus, it is considered that heat tolerance is not sufficient in consideration of a long-term use and response to future increase in luminance and magnified display.

As shown in FIG. 14, the head-up display device 100 includes a light source 2, a display element 3 that outputs a displayed image, a reflector 4 that reflects the displayed image to a display surface 5, and a cover portion 6 provided at an opening of a housing 7. In the head-up display device 100, arrangement of the polarizing element 1 is not particularly limited. For example, the polarizing element 1 can be arranged between the display element 3 and the reflector 4 as shown in FIG. 14.

Herein, the head-up display device 100 may be a vehicle head-up display device provided for a vehicle. The vehicle head-up display device displays video on a semi-transmissive plate (equivalent to "the display surface 5") such as a front glass or a combiner of the vehicle. The vehicle head-up display device is, for example, a video display device disposed on the dashboard of the vehicle to project video light to the front glass (the display surface 5) and display driving information as a virtual image.

The head-up display device 100 is configured to output a displayed image toward the front glass surface (the display surface 5) from below. Therefore, solar light enters the head-up display device 100 oppositely to the output direction of the displayed image and is incident on the display element 3 in some cases. The head-up display device 100 according to the present embodiment is provided with the reflector 4 for reflecting and magnifying a displayed image for the purpose of meeting the request for size reduction and magnifying the displayed image. In such a case, in the conventional head-up display device, solar light incident on the reflector from the outside concentrates on the vicinity of the display element, which might cause degradation or failure of the display element by heat.

In contrast to this, the head-up display device 100 according to the present embodiment is provided with the polarizing element 1 of the hybrid type excellent in heat dissipation and heat tolerance as described above for the purpose of preventing solar light from being incident on the display element 3. This polarizing element 1 can stably exert the polarizing function even at a high temperature of approximately 200°C, for example. Consequently, even under a high-temperature environment such as the inside of a vehicle in the summer, for example, solar light incident on the reflector 4 from the outside can be shielded by the polarizing element 1 to be prevented from reaching the display element 3. This can restrain degradation or failure of the display element 3.

Note that the constituent members of the head-up display device 100 shown in FIG. 14 are an example of basic

constituent members, and the constituent members of the projection display device are not limited to those in the example of FIG. 14. The head-up display device 100 can include other constituent members as appropriate in accordance with required performance or the like.

In addition, by using the polarizing element 1 as a pre-polarizing plate arranged in front of the display element 3, the polarizing element 1 can restrain solar light from being incident on the display element 3 while transmitting a displayed image output from the display element 3. Consequently, heat tolerance and durability of the head-up display device 100 can be increased further.

In addition, the arrangement of the wire grid polarizing element in the projection display device is not limited to the example of arrangement of the polarizing element 1 in the head-up display device 100 shown in FIG. 14, and can be selected and modified as appropriate in accordance with the configuration of the projection display device, required performance, or the like. For example, the polarizing element 1 can be arranged between the display element 3 and the light source 2 although not shown. Alternatively, the polarizing element 1 can also be incorporated in the reflector 4 although not shown. Further, the cover portion 6 provided in the head-up display device 100 shown in FIG. 14 can also be implemented by the polarizing element 1.

In addition, the heat dissipation member 50 (see FIG. 9) may be provided around the polarizing element 1 installed in the head-up display device 100 although not shown. This heat dissipation member 50 can further improve heat dissipation of the polarizing element 1, which can further improve the polarization properties and heat tolerance of the polarizing element 1.

<4.2. Projection Display Device Including Polarizing Beam Splitter>

Next, a projection display device in which the reflection-type wire grid polarizing element 1 according to the present embodiment is used as a polarizing beam splitter 230 will be described with reference to FIG. 15 to FIG. 17. Hereinafter, first, matters common to three specific examples of projection display devices 200A, 200B, and 200C (hereinafter collectively referred to as a "projection display device 200" in some cases) shown in FIG. 15 to FIG. 17 will be described comprehensively. Thereafter, the respective specific examples shown in FIG. 15 to FIG. 17 will be described individually.

As shown in FIG. 15 to FIG. 17, the projection display device 200 includes a light source 210, a PS converter 220, the polarizing beam splitter 230, a reflection-type liquid crystal display element 240, and a lens 250. Note that a phase-difference compensating plate (not shown) may be installed between the polarizing beam splitter 230 and the reflection-type liquid crystal display element 240.

The light source 210 may be a point light source having a single light emitting unit, or may be a light source having a plurality of light emitting units such as LEDs. In addition, light output from the light source 210 may be parallel light, or may be diffused light. Consequently, light of the light source 210 is incident in some cases on the polarizing beam splitter 230 (a reflection-type wire grid polarizing plate) at the incident angle $\theta$ in a predetermined range (for example, a range of 45° $\pm$ 15°) centering on 45°, for example.

The PS converter 220 is a polarization conversion element for converting light from the light source 210 into specific polarized light (for example, the p-polarized light or the s-polarized light). The PS converter 220 may convert light from the light source 210 into the p-polarized light or into the s-polarized light.

The polarizing beam splitter 230 is implemented by the reflection-type wire grid polarizing plate. The reflection-type wire grid polarizing plate is an example of the wire grid polarizing element 1 according to the present embodiment. The polarizing beam splitter 230 is arranged such that light from the light source 210 is incident at the incident angle $\theta$ in the predetermined range including 45°. This incident angle $\theta$ in the predetermined range is, for example, 45° $\pm$ 15° described above, that is, more than or equal to 30° and less than or equal to 60°.

For example, in FIG. 15 to FIG. 17, the polarizing beam splitter 230 is arranged at an inclination of 45° with respect to an incident direction of incident light such that the incident light from the light source 210 is incident on the polarizing beam splitter 230 at the incident angle $\theta$ of mainly 45°. In addition, the polarizing beam splitter 230 is arranged at an inclination of 45° with respect to the reflection-type liquid crystal display element 240 such that incident light from the reflection-type liquid crystal display element 240 is incident on the polarizing beam splitter 230 at the incident angle $\theta$ of mainly 45°.

The polarizing beam splitter 230 splits incident light into the first polarized light (s-polarized light) and the second polarized light (p-polarized light). For example, the polarizing beam splitter 230 may split the incident light into the s-polarized light and the p-polarized light by reflecting the first polarized light (s-polarized light) in the incident light and transmitting the second polarized light (p-polarized light). To the contrary, the polarizing beam splitter 230 may split the incident light into the s-polarized light and the p-polarized light by reflecting the second polarized light (p-polarized light) in the incident light and transmitting the first polarized light (s-polarized light).

In a case where desired polarized light is reflected by the polarizing beam splitter 230, the polarizing beam splitter 230 is arranged such that light including the polarized light to be reflected is incident on the surface of the polarizing beam

splitter 230 (that is, the concave-convex surface on the side where the grid structural body 20 of the polarizing element 1 is formed). For example, in the case where the s-polarized light incident from the PS converter 220 is reflected by the polarizing beam splitter 230 as shown in FIG. 15, the surface of the polarizing beam splitter 230 should only be oriented toward the PS converter 220 that outputs the s-polarized light. On the other hand, in the case where the s-polarized light incident from the reflection-type liquid crystal display element 240 is reflected by the polarizing beam splitter 230 as shown in FIG. 16, the surface of the polarizing beam splitter 230 should only be oriented toward the reflection-type liquid crystal display element 240 that outputs the s-polarized light.

The reflection-type liquid crystal display element 240 is a display element that reflects incident light to output light representing a displayed image. As shown in FIG. 15 and FIG. 17, the reflection-type liquid crystal display element 240 may be arranged such that the first polarized light (s-polarized light) reflected by the polarizing beam splitter 230 is incident on the surface of the reflection-type liquid crystal display element 240. Alternatively, as shown in FIG. 16, the reflection-type liquid crystal display element 240 may be arranged such that the second polarized light (p-polarized light) transmitted through the polarizing beam splitter 230 is incident on the surface of the reflection-type liquid crystal display element 240.

In addition, the reflection-type liquid crystal display element 240 reflects and modulates the incident first polarized light (s-polarized light) to output the second polarized light (p-polarized light) representing a displayed image as shown in FIG. 15 and FIG. 17. However, the reflection-type liquid crystal display element 240 is not limited to such an example, and may reflect and modulate the incident second polarized light (p-polarized light) to output the first polarized light (s-polarized light) representing a displayed image as shown in FIG. 16.

The lens 250 magnifies light representing a displayed image output from the reflection-type liquid crystal display element 240 for output to the outside. The lens 250 is arranged such that the light representing a displayed image output from the reflection-type liquid crystal display element 240 is incident through the polarizing beam splitter 230. For example, as shown in FIG. 15 and FIG. 17, the lens 250 may be arranged such that the second polarized light (p-polarized light) reflected and modified by the reflection-type liquid crystal display element 240 is transmitted through the polarizing beam splitter 230 to be incident on the lens 250. Alternatively, as shown in FIG. 16, the lens 250 may be arranged such that the first polarized light (s-polarized light) reflected and modified by the reflection-type liquid crystal display element 240 is reflected by the polarizing beam splitter 230 to be incident on the lens 250.

As described above, the projection display device 200 according to the present embodiment uses the aforementioned wire grid polarizing element 1 according to the present embodiment as the polarizing beam splitter 230. Consequently, the polarizing beam splitter 230 is excellent in reflectiveness for the s-polarized light, transmissivity for the p-polarized light, and the Tp $\times$ Rs properties for oblique incident light at the incident angle $\theta$ in a relatively large and wide range (for example, 30 to 60°), and excellent in properties of splitting the oblique incident light into the p-polarized light and the s-polarized light.

Next, the respective specific examples of the projection display devices 200A, 200B, and 200C shown in FIG. 15 to FIG. 17 will be described individually.

As shown in FIG. 15, the projection display device 200A according to the first specific example of the present embodiment includes the light source 210, the PS converter 220, the polarizing beam splitter 230, the reflection-type liquid crystal display element 240, and the lens 250.

Light output from the light source 210 is unpolarized light, and the light includes a p-polarized light component and an s-polarized light component in an identical proportion. Therefore, when only one of the polarized lights is selected and extracted by the polarizing beam splitter 230 implemented by the polarizing element 1, the light volume will decrease to about a half. Thus, the light output from the light source 210 is converted by the PS converter 220 into either the first polarized light (s-polarized light) or the second polarized light (p-polarized light). This can restrain the light volume of polarized light extracted by the polarizing beam splitter 230 from decreasing to improve the light use efficiency. For example, the PS converter 220 shown in FIG. 15 converts light from the light source 210 into the first polarized light (s-polarized light).

The light converted by the PS converter 220 into the s-polarized light is incident on the polarizing beam splitter 230 arranged at an inclination obliquely at approximately 45°. The polarizing beam splitter 230 reflects the first polarized light (s-polarized light) for output toward the reflection-type liquid crystal display element 240 at an output angle of 45°. The reflection-type liquid crystal display element 240 modulates and reflects the first polarized light (s-polarized light) to generate the second polarized light (p-polarized light) representing a displayed image, and outputs the second polarized light (p-polarized light) toward the polarizing beam splitter 230. The second polarized light (p-polarized light) is transmitted through the polarizing beam splitter 230, magnified by the lens 250, and then projected on the display surface not shown, so that the displayed image is displayed.

The projection display device 200A having the above configuration includes a reflection-type wire grid polarizing plate implemented by the wire grid polarizing element 1 according to the present embodiment as the polarizing beam splitter 230. This can improve the polarization splitting properties of the polarizing beam splitter 230 for oblique incident light and incident light at the wide incident angle $\theta$, and can improve heat dissipation and heat tolerance of the polarizing beam splitter 230 and the projection display device 200A.

In contrast to this, a projection display device (not shown) including a conventional polarizing element as a polarizing beam splitter is inferior in heat dissipation of the polarizing element. Therefore, it is considered that heat tolerance is not sufficient from the perspectives of a long-term use and response to increase in luminance and magnified display. In addition, the incident angle θ of light incident on the polarizing beam splitter is not only 45°, but also every angle within a predetermined range (for example, approximately 45° ± 15°) centering on 45°. In this manner, even in the case where oblique incident light at the large and wide-range incident angle θ is incident on the polarizing beam splitter, the polarizing beam splitter is required to have performance capable of suitably splitting oblique incident light into the s-polarized light and the p-polarized light irrespective of the incident angle θ. However, the polarizing beam splitter including the conventional polarizing element raises problems of deterioration of the light utilization efficiency and an adverse influence on the image quality of the displayed image, such as uneven luminance, because of poor polarization splitting properties for the above-described oblique incident light.

In this respect, the polarizing beam splitter 230 of the projection display device 200A according to the first specific example of the present embodiment is superior in polarization splitting properties for oblique incident light at the large and wide-range incident angle θ as described above. Consequently, the light utilization efficiency can be improved in the projection display device 200A, and uneven luminance and the like can be reduced to improve the image quality of the displayed image.

In addition, the projection display device is not limited to the example of the projection display device 200A shown in FIG. 15 described above, and the constituent members and arrangement of the projection display device can be modified as appropriate as in the projection display device 200B shown in FIG. 16, the projection display device 200C shown in FIG. 17, or the like, for example.

As shown in FIG. 16, the projection display device 200B according to the second specific example of the present embodiment includes the light source 210, the PS converter 220, the polarizing beam splitter 230, the reflection-type liquid crystal display element 240, and the lens 250.

In the projection display device 200B, the PS converter 220 converts light from the light source 210 into the second polarized light (p-polarized light). The light converted by the PS converter 220 into the p-polarized light is transmitted through the polarizing beam splitter 230 arranged at an inclination obliquely at approximately 45° to be incident on the reflection-type liquid crystal display element 240. The reflection-type liquid crystal display element 240 modulates and reflects the second polarized light (p-polarized light) to generate the first polarized light (s-polarized light) representing a displayed image, and outputs the first polarized light (s-polarized light) toward the polarizing beam splitter 230. The polarizing beam splitter 230 reflects the first polarized light (s-polarized light) for output toward the lens 25 at the output angle of 45°. The first polarized light (s-polarized light) is magnified by the lens 250 and then projected on the display surface not shown, so that the displayed image is displayed.

The projection display device 200B having the above configuration is excellent in polarization splitting properties for oblique incident light, the light utilization efficiency can be improved, and uneven luminance and the like can be reduced to improve the image quality of the displayed image, similarly to the projection display device 200A described above (see FIG. 15).

In addition, as shown in FIG. 17, the projection display device 200C according to the third specific example of the present embodiment includes the light source 210, the polarizing beam splitter 230, the reflection-type liquid crystal display element 240, the lens 250, and a light absorber 260, but does not include the above-described PS converter 220.

In the projection display device 200C, unpolarized light output from the light source 210 is directly incident on the polarizing beam splitter 230 arranged at an inclination obliquely at approximately 45°. The polarizing beam splitter 230 reflects a component of the first polarized light (s-polarized light) in unpolarized light for output toward the reflection-type liquid crystal display element 240 at the output angle of 45°. On the other hand, in the unpolarized light incident on the polarizing beam splitter 230, a component of the second polarized light (p-polarized light) is transmitted through the polarizing beam splitter 230 to be incident on the light absorber 260. Most of this component of the second polarized light (p-polarized light) is absorbed into the light absorber 260. This can restrain the unnecessary second polarized light (p-polarized light) from being incident on another optical system in the projection display device 200C.

The reflection-type liquid crystal display element 240 modulates and reflects the component of the first polarized light (s-polarized light) incident from the polarizing beam splitter 230 to generate the second polarized light (p-polarized light) representing a displayed image, and outputs the second polarized light (p-polarized light) toward the polarizing beam splitter 230. The second polarized light (p-polarized light) is transmitted through the polarizing beam splitter 230, magnified by the lens 250, and then projected on the display surface not shown, so that the displayed image is displayed.

Because the PS converter 220 is not installed in the projection display device 200C having the above configuration, the component of the second polarized light (p-polarized light) in the unpolarized light output from the light source 210 is absorbed into the light absorber 260 and is not utilized for displaying the displayed image. Therefore, the light volume of the displayed image is reduced to about a half. However, cost and installation space required for the PS converter 220 can be saved, and the number of parts of the projection display device 200C can be reduced. This brings about advantages that the projection display device 200C can be reduced in cost and the projection display device 200C

can be reduced in size.

The specific examples of the projection display device 200 in which the reflection-type wire grid polarizing element 1 according to the present embodiment is used as the polarizing beam splitter 230 have been described above. Note that the projection display device is not limited to the specific examples of the projection display device 200 shown in FIG. 15 to FIG. 17, but the constituent members and arrangement of the projection display device may be modified as appropriate, or another constituent member may be provided as appropriate, in accordance with required performance or the like.

<5. Vehicle>

Next, a vehicle including the video display device according to the present embodiment will be described.

The vehicle (not shown) according to the present embodiment includes the projection display device having the wire grid polarizing element 1 according to the present embodiment described above. Note that the vehicle may be various automobiles such as a standard motor vehicle, a light motor vehicle, a bus, a truck, a racing car, a construction-use vehicle, and other large-sized vehicles, for example, or besides may be various rides such as a two-wheeled motor vehicle, a train, a linear motor car, and an attraction vehicle if it is a vehicle in which the projection display device can be installed.

The vehicle according to the present embodiment can project and display a displayed image on a display surface (for example, the display surface 5 shown in FIG. 14) provided for the vehicle by means of the polarizing element 1 and the projection display device described above. The display surface preferably is a semi-transmissive plate such as a front glass, side glass, rear glass, or combiner of the vehicle, for example. However, the display surface is not limited to such an example, and may be a surface of various parts, members, on-vehicle equipment, or the like provided for the vehicle if it is a surface of a target on which the displayed image can be projected.

The projection display device provided for the vehicle according to the present embodiment is, for example, the head-up display device 100 shown in FIG. 14, the projection display device 200 having the polarizing beam splitter 130 shown in FIG. 15 to FIG. 17, or the like. However, the projection display device is not limited to such an example, and may be various image display devices such as a projector, a car navigation device, and a terminal device having an image display function mounted on the vehicle if it is a device that can project or display an image.

As described above, in the head-up display device 100, solar light is transmitted through the front glass (the display surface 5) from the outside of the vehicle to enter the head-up display device 100 in some cases, as shown in FIG. 14. Heat of this solar light and the like might cause degradation or failure of the display element 3. Therefore, for the purpose of preventing solar light from being incident on the display element 3, the wire grid polarizing element 1 of the hybrid type described above is provided in the head-up display device 100. This polarizing element 1 is excellent in heat dissipation and heat tolerance because of the hybrid structure having high thermal conductivity. Consequently, solar light incident on the head-up display device 100 from the outside can be shielded by the polarizing element 1 to be prevented from reaching the display element 3, which can prevent failure and breakage of the display element 3. Further, the polarizing element 1 can also prevent breakage of the polarizing element 1 itself because of the excellent heat dissipation and heat tolerance.

Similarly, even in the case where the projection display device 200 shown in FIG. 15 to FIG. 17 is installed in the vehicle, failure and breakage of another part such as the reflection-type liquid crystal display element 240 can be prevented because the polarizing element 1 used as the polarizing beam splitter 230 can shield solar light from the outside. Further, breakage of the polarizing element 1 itself excellent in heat dissipation and heat tolerance can also be prevented.

In the projection display device provided in the vehicle according to the present embodiment as described above, excellent polarization properties (such as solar light shielding performance and polarization splitting properties) are obtained by the polarizing element 1, and excellent heat tolerance and durability of the projection display device can also be achieved.

Note that the vehicle is not particularly limited if it includes the projection display device and the polarizing element described above, and other conditions can be set and modified as appropriate in accordance with performance required of the vehicle.

<6. Organic Material (Light Curing Acrylic Resin for Imprinting) Constituting Grid Structural Body>

Next, an organic material (light curing acrylic resin for imprinting) constituting the grid structural body 20 according to the present embodiment will be described.

As a technology for manufacturing an optical member made of resin having a micro concave-convex structure, imprinting molding of an uncured resin layer composed of an uncured resin composition is widely utilized. In imprinting molding, a micro concave-convex shape of a master is pressed against an uncured resin layer formed on a substrate, the uncured resin layer is cured in that state, and the master is peeled to shape the micro concave-convex shape on the substrate.

When a thickness (layer thickness) of the uncured resin layer when the master is pressed thereagainst in imprinting molding is non-uniform, a peel force applied when the master is peeled from the resin layer after curing (hereinafter referred to as a "cured resin layer") is non-uniform in the plane of the cured resin layer. Then, part of the cured resin layer might be peeled from the substrate. In addition, the cured resin layer peeled from the substrate is left on the master, which makes it impossible to repeatedly utilize the master. Further, when the master is peeled, the micro concave-convex shape transferred to the cured resin layer might be deformed to cause the optical properties derived from the micro concave-convex structure to decrease.

In addition, if followability of the uncured resin composition to the micro concave-convex shape is low when the master is pressed in imprinting molding, the micro concave-convex shape of the master is not partially transferred to the uncured resin layer.

Thus, in order to make the layer thickness of the uncured resin layer when the master is pressed thereagainst uniform and to improve the followability of the uncured resin composition to the micro concave-convex shape, a technology for reducing the viscosity of the uncured resin composition has been developed (as described in JP 2018-125559A and JP 4824068B, for example).

In order to lower the viscosity of the uncured resin composition, it is conceivable to increase the content of a monofunctional monomer and a low-viscosity bifunctional monomer in the resin composition.

However, increasing the content of the monofunctional monomer and the low-viscosity bifunctional monomer raises a problem in that the heat tolerance of the resin layer after curing decreases.

Thus, the present embodiment has an object to provide a light curing acrylic resin for imprinting in which an uncured resin composition has a low viscosity and a resin composition after curing is excellent in heat tolerance.

The light curing acrylic resin for imprinting according to the present embodiment is an uncured resin composition. The light curing acrylic resin for imprinting according to the present embodiment is composed of a photopolymerization component and a photopolymerization initiator. The photopolymerization component according to the present embodiment is a kind of the above-described acrylic polymerization compound. In addition, the photopolymerization initiator according to the present embodiment is a material for polymerizing the photopolymerization component and corresponds to the above-described light curing initiator.

<6.1. Composition of Photopolymerization Component>

Next, a composition of the photopolymerization component of the light curing acrylic resin for imprinting according to the present embodiment will be described. The photopolymerization component according to the present embodiment at least contains a resin (A) and a resin (B). In addition, the photopolymerization component according to the present embodiment may contain one or both of a resin (C) and a resin (D) in addition to the resin (A) and the resin (B). In addition, the photopolymerization component according to the present embodiment may be composed only of the resin (A) and the resin (B), may be composed only of the resin (A), the resin (B), and the resin (C), may be composed only of the resin (A), the resin (B), and the resin (D), or may be composed only of the resin (A), the resin (B), the resin (C), and the resin (D). Hereinafter, the resins (A) to (D) will be described.

The resin (A) is (octahydro-4,7-methano-1H-indenediyl)bis(methylene) diacrylate. In other words, the resin (A) is a bifunctional acrylate monomer shown by Chemical Formula (II) below. For example, "KAYARAD R-684" available from Nippon Kayaku Co.,Ltd. can be used as the resin (A).

[Chemical Formula 1]

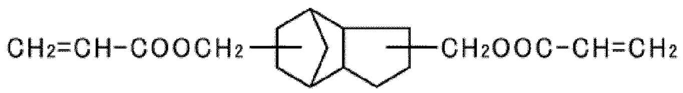
··· (II)

The resin (A) has a viscosity of more than or equal to 100 mPa•s and less than or equal to 250 mPa•s at 25°C. Note that the viscosity is the viscosity of a liquid measured using a rotary viscometer and a vibratory viscometer in compliance with JIS Z8803. The viscosity is measured using a cone plate in a Brookfield Viscometer made by EKO INSTRUMENTS CO.,LTD., for example.

The resin (B) is a bifunctional acrylate monomer having a viscosity of less than or equal to 10 mPa•s at 25°C. The resin (B) preferably is a bifunctional acrylate monomer having a viscosity of more than or equal to 3 mPa•s at 25°C. In addition, the resin (B) is a structurally flexible bifunctional acrylate monomer. Herein, being structurally flexible refers to having a structure in which molecules are easy to move when heated and which is easy to bend and easy to expand/shrink. The resin (B) may be a bifunctional acrylate monomer with an acryloyl group combined with each of opposite ends of a straight-chain structure composed of a hydrocarbon group or a bifunctional acrylate monomer with an acryloyl group combined with each of opposite ends of a straight-chain structure having an ether bond. Herein, the hydrocarbon group is one or more selected from the group consisting of an alkyl group, an alkylene group, and an alkynyl group, for example.

The bifunctional acrylate monomer with an acryloyl group combined with each of the opposite ends of the

straight-chain structure composed of the hydrocarbon group may be a bifunctional acrylate monomer expressed by Chemical Formula (I) below, for example. In Chemical Formula (I), n preferably is an integer of more than or equal to 1 and less than or equal to 9, more preferably is an integer of more than or equal to 6 and less than or equal to 9, and still more preferably is 6 or 9.

$$CH_2 = CHCOO(CH_2)_nOOCCH = CH_2 \ldots \quad (I)$$

In the case where n is 6 in Chemical Formula (I) above, that is, in the case where the resin (B) is 1,6-hexanediol diacrylate, the resin (B) has a viscosity of 6.5 mPa•s at 25°C. In addition, in the case where n is 9 in Chemical Formula (I) above, that is, in the case where the resin (B) is 1,9-nonanediol diacrylate, the resin (B) has a viscosity of 8 mPa•s at 25°C.

The bifunctional acrylate monomer with an acryloyl group combined with each of the opposite ends of the straight-chain structure having an ether bond may be dipropylene glycol diacrylate (DPGDA), for example.

The resin (C) preferably is an acrylate monomer having a viscosity of less than or equal to 10 mPa•s at 25°C. The resin (C) preferably is an acrylate monomer having a viscosity of more than or equal to 1 mPa•s at 25°C. In addition, the resin (C) preferably is a structurally rigid acrylate monomer. Herein, being structurally rigid refers to having a structure in which molecules are difficult to move when heated and which is difficult to bend and difficult to expand/shrink. The resin (C) may be an acrylate monomer having one or both of cyclic structures of a cyclic structure composed only of a single bond and a cyclic structure (for example, a benzene ring) composed of a single bond and a multiple bond, for example. Note that the number of acryloyl groups of the resin (C) is not particularly limited, and the resin (C) is a monofunctional acrylate monomer, for example.

The resin (C) may be isobornyl acrylate, for example.

In the case where the resin (C) is isobornyl acrylate, the resin (C) has a viscosity of 9.5 mPa•s at 25°C.

The resin (D) preferably is an acrylate monomer having three or more functional groups. The resin (D) preferably is an acrylate monomer having six or less functional groups. The resin (D) preferably is an acrylate monomer having three or more and six or less functional groups. The resin (D) may be one or more selected from the group consisting of trimethylolpropane triacrylate (TMPTA), dipentaerythritol hexaacrylate (DPHA), and polyfunctional polyester acrylate, for example. For example, "M-9050" made by TOAGOSEI CO., LTD. can be used as the polyfunctional polyester acrylate.

In the case where the resin (D) is trimethylolpropane triacrylate (TMPTA), the resin (D) has a viscosity of more than or equal to 70 mPa•s and less than or equal to 80 mPa•s at 25°C. In the case where the resin (D) is dipentaerythritol hexaacrylate (DPHA), the resin (D) has a viscosity of more than or equal to 5000 mPa•s and less than or equal to 10000 mPa•s. In the case where the resin (D) is "M-9050", the resin (D) has a viscosity of more than or equal to 6000 mPa•s and less than or equal to 14000 mPa•s.

<6.2. Content of Each Resin in Entire Photopolymerization Component>

Next, the content of each resin in a whole of the photopolymerization component according to the present embodiment will be described. In the present embodiment, the content of the resin (A) in the whole of the photopolymerization component is more than or equal to 20 mass % and less than or equal to 40 mass %. In addition, the total content of the resin (A) and the resin (B) in the whole of the photopolymerization component preferably is more than or equal to 50 mass %, and more preferably is more than or equal to 60 mass %. The total content of the resin (A) and the resin (B) in the whole of the photopolymerization component is less than or equal to 70 mass %. The total content of the resin (A) and the resin (B) in the whole of the photopolymerization component preferably is more than or equal to 50 mass % and less than or equal to 70 mass %, and more preferably is more than or equal to 60 mass % and less than or equal to 70 mass %.

In addition, the total content of the resin (B) and the resin (C) in the whole of the photopolymerization component preferably is more than or equal to 40 mass %, more preferably is more than or equal to 50 mass %, and still more preferably is more than or equal to 59 mass %. The total content of the resin (B) and the resin (C) in the whole of the photopolymerization component preferably is less than or equal to 70 mass %. The total content of the resin (B) and the resin (C) in the whole of the photopolymerization component may be more than or equal to 40 mass % and less than or equal to 70 mass %, preferably is more than or equal to 50 mass % and less than or equal to 70 mass %, and still more preferably is more than or equal to 59 mass % and less than or equal to 70 mass %.

In addition, the content of the resin (D) in the whole of the photopolymerization component preferably is more than 0 mass %, and more preferably is more than 1 mass %. The content of the resin (D) in the whole of the photopolymerization component preferably is less than or equal to 20 mass %, and more preferably is less than or equal to 10 mass %. The content of the resin (D) in the whole of the photopolymerization component may be more than 0 mass % and less than or equal to 20 mass %, preferably is more than 1 mass % and less than or equal to 20 mass %, and still more preferably is more than 1 mass % and less than or equal to 10 mass %.

<6.3. Photopolymerization Initiator>

Next, the photopolymerization initiator according to the present embodiment will be described. The photopolymerization initiator according to the present embodiment is an acylphosphine oxide-based photopolymerization initiator or an alkylphenone-based photopolymerization initiator, for example. For example, "Irgacure 819" made by IGM Resins B.V. can be used as the photopolymerization initiator.

In a case where the entire content of the photopolymerization component is 100 mass % in the light curing acrylic resin for imprinting, the content of the photopolymerization initiator preferably is more than or equal to 0.5 mass %, and more preferably is more than or equal to 1 mass %. In the case where the entire content of the photopolymerization component is 100 mass % in the light curing acrylic resin for imprinting, the content of the photopolymerization initiator preferably is less than or equal to 3 mass %. In the case where the entire content of the photopolymerization component is 100 mass % in the light curing acrylic resin for imprinting, the content of the photopolymerization initiator preferably is more than or equal to 0.5 mass % and less than or equal to 3 mass %, and more preferably is more than or equal to 1 mass % and less than or equal to 3 mass %.

<6.4. Viscosity of Light Curing Acrylic Resin for Imprinting>

Next, the viscosity of the light curing acrylic resin for imprinting according to the present embodiment will be described. Based on the relationship among the contents of the resin (A), the resin (B), the resin (C), and the resin (D) as described in 6.2. above, the viscosity of the light curing acrylic resin for imprinting at 25°C preferably is more than or equal to 5 mPa•s. The viscosity of the light curing acrylic resin for imprinting at 25°C may be less than or equal to 35 mPa•s, preferably is less than or equal to 25 mPa•s, and still more preferably is less than or equal to 20 mPa•s. The viscosity of the light curing acrylic resin for imprinting at 25°C may be more than or equal to 5 mPa•s and less than or equal to 35 mPa•s, preferably is more than or equal to 5 mPa•s and less than or equal to 25 mPa•s, and still more preferably is more than or equal to 5 mPa•s and less than or equal to 20 mPa•s.

<6.5. YI Value of Cured Product of Light Curing Acrylic Resin for Imprinting>

Next, a YI (Yellow Index) value of a cured product obtained by irradiating the light curing acrylic resin for imprinting according to the present embodiment with light (for example, UV rays) will be described. The YI value is calculated based on JIS K 7373:2006 "Plastics- Determination of yellowness index and change of yellowness index". The YI value is calculated from a measurement result obtained by using a spectrophotometer V-770 made by JASCO Corporation, for example. Specifically, a transmittance of the cured product for light in the wavelength range of 380 nm to 800 nm when incident at 0° is measured with the spectrophotometer V-770 using a D65 light source. Then, the measurement result is subjected to a hue calculation by software to calculate X, Y, and Z in the XYZ color system. The calculated X, Y, and Z in the XYZ color system are substituted in Equation (3) below shown in JIS K 7373:2006 to calculate the YI value.

$$YI = 100 \times (1.2985X-1.1335Z) / Y \qquad \dots (3)$$

After the cured product of the light curing acrylic resin for imprinting according to the present embodiment is held at 120°C for 500 hours, the YI value of the cured product preferably is more than or equal to 0. After the cured product of the light curing acrylic resin for imprinting is held at 120°C for 500 hours, the YI value of the cured product may be less than or equal to 3, preferably is less than or equal to 2.5, and still more preferably is less than or equal to 2. After the cured product of the light curing acrylic resin for imprinting is held at 120°C for 500 hours, the YI value of the cured product may be more than or equal to 0 and less than or equal to 3, preferably is more than or equal to 0 and less than or equal to 2.5, and still more preferably is more than or equal to 0 and less than or equal to 2.

<6.6. Average Transmittance of Cured Product of Light Curing Acrylic Resin for Imprinting>

Next, an average transmittance of the cured product of the light curing acrylic resin for imprinting according to the present embodiment for light will be described. The average transmittance is calculated by measuring the transmittance every 1 nm in a wavelength range of more than or equal to 430 nm and less than or equal to 680 nm and simply averaging 251 pieces of measurement data as obtained. The transmittance is measured by using the spectrophotometer V-770 made by JASCO Corporation, for example.

After the cured product of the light curing acrylic resin for imprinting according to the present embodiment is held at 120°C for 500 hours, the average transmittance of the cured product for light in the wavelength range of more than or equal to 430 nm and less than or equal to 680 nm may be more than or equal to 91% and preferably is more than or equal to

92%. After the cured product of the light curing acrylic resin for imprinting is held at 120°C for 500 hours, the average transmittance of the cured product for light in the wavelength range of more than or equal to 430 nm and less than or equal to 680 nm may be less than or equal to 94%. After the cured product of the light curing acrylic resin for imprinting is held at 120°C for 500 hours, the average transmittance of the cured product for light in the wavelength range of more than or equal to 430 nm and less than or equal to 680 nm may be more than or equal to 91% and less than or equal to 94% and preferably is more than or equal to 92% and less than or equal to 94%.

In addition, a difference in average transmittance of the cured product for light in the wavelength range of more than or equal to 430 nm and less than or equal to 680 nm before and after the cured product of the light curing acrylic resin for imprinting according to the present embodiment is held at 120°C for 500 hours (|the average transmittance before holding - the average transmittance after holding |) may be more than or equal to 0.0%. The difference in average transmittance of the cured product for light in the wavelength range of more than or equal to 430 nm and less than or equal to 680 nm before and after the cured product of the light curing acrylic resin for imprinting is held at 120°C for 500 hours (|the average transmittance before holding - the average transmittance after holding |) may be less than or equal to 0.5%, preferably is less than or equal to 0.3%, and more preferably is less than or equal to 0.2%. The difference in average transmittance of the cured product for light in the wavelength range of more than or equal to 430 nm and less than or equal to 680 nm before and after the cured product of the light curing acrylic resin for imprinting is held at 120°C for 500 hours (|the average transmittance before holding - the average transmittance after holding |) may be more than or equal to 0.0% and less than or equal to 0.5%, preferably is more than or equal to 0.0% and less than or equal to 0.3%, and more preferably is more than or equal to 0.0% and less than or equal to 0.2%.

After the cured product of the light curing acrylic resin for imprinting according to the present embodiment is held at 120°C for 500 hours, the average transmittance of the cured product for light in the wavelength range of more than or equal to 430 nm and less than or equal to 510 nm may be more than or equal to 90% and preferably is more than or equal to 91%. After the cured product of the light curing acrylic resin for imprinting is held at 120°C for 500 hours, the average transmittance of the cured product for light in the wavelength range of more than or equal to 430 nm and less than or equal to 510 nm may be less than or equal to 94%. After the cured product of the light curing acrylic resin for imprinting is held at 120°C for 500 hours, the average transmittance of the cured product for light in the wavelength range of more than or equal to 430 nm and less than or equal to 510 nm may be more than or equal to 90% and less than or equal to 94%, and preferably is more than or equal to 91% and less than or equal to 94%.

**In** addition, the difference in average transmittance of the cured product for light in the wavelength range of more than or equal to 430 nm and less than or equal to 510 nm before and after the cured product of the light curing acrylic resin for imprinting according to the present embodiment is held at 120°C for 500 hours (|the average transmittance before holding - the average transmittance after holding |) may be more than or equal to 0.0%. The difference in average transmittance of the cured product for light in the wavelength range of more than or equal to 430 nm and less than or equal to 510 nm before and after the cured product of the light curing acrylic resin for imprinting is held at 120°C for 500 hours (|the average transmittance before holding - the average transmittance after holding |) may be less than or equal to 1.2%, preferably is less than or equal to 0.7%, and more preferably is less than or equal to 0.5%. The difference in average transmittance of the cured product for light in the wavelength range of more than or equal to 430 nm and less than or equal to 510 nm before and after the cured product of the light curing acrylic resin for imprinting is held at 120°C for 500 hours (|the average transmittance before holding - the average transmittance after holding |) may be more than or equal to 0.0% and less than or equal to 1.2%, preferably is more than or equal to 0.0% and less than or equal to 0.7%, and more preferably is more than or equal to 0.0% and less than or equal to 0.5%.

<6.7. Storage Elastic Modulus of Cured Product of Light Curing Acrylic Resin for Imprinting>

Next, a storage elastic modulus of the cured product of the light curing acrylic resin for imprinting will be described. The storage elastic modulus refers to a component of energy produced by external force and strain, the component being stored in an object. In other words, the storage elastic modulus indicates hardness of the cured product. As the storage elastic modulus is larger, the cured product is harder. The storage elastic modulus can be measured using DMA7100 made by Hitachi High-Tech Corporation, for example. For example, a sheet of the cured product is cut into 20 mm in length and 3 mm in width and is raised in temperature at 5°C/min in a tensile mode at a certain frequency (1 Hz), so that the storage elastic modulus at 25°C to 300°C can be measured.

The storage elastic modulus at 30°C of the cured product of the light curing acrylic resin for imprinting according to the present embodiment may be more than or equal to $1.6 \times 10^9$ Pa, preferably is more than or equal to $2.0 \times 10^9$ Pa, and still more preferably is more than or equal to $2.2 \times 10^9$ Pa. The storage elastic modulus at 30°C of the cured product of the light curing acrylic resin for imprinting may be less than or equal to $2.5 \times 10^9$ Pa. The storage elastic modulus at 30°C of the cured product of the light curing acrylic resin for imprinting may be more than or equal to $1.6 \times 10^9$ Pa and less than or equal to $2.5 \times 10^9$ Pa, preferably is more than or equal to $2.0 \times 10^9$ Pa and less than or equal to $2.5 \times 10^9$ Pa, and still more preferably is more than or equal to $2.2 \times 10^9$ Pa and less than or equal to $2.5 \times 10^9$ Pa.

The storage elastic modulus at 120°C of the cured product of the light curing acrylic resin for imprinting according to the present embodiment may be more than or equal to $3.9 \times 10^8$ Pa, preferably is more than or equal to $6.0 \times 10^8$ Pa, and still more preferably is more than or equal to $7.0 \times 10^8$ Pa. The storage elastic modulus at 120°C of the cured product of the light curing acrylic resin for imprinting may be less than or equal to $2.5 \times 10^9$ Pa. The storage elastic modulus at 120°C of the cured product of the light curing acrylic resin for imprinting may be more than or equal to $3.9 \times 10^8$ Pa and less than or equal to $2.5 \times 10^9$ Pa, preferably is more than or equal to $6.0 \times 10^8$ Pa and less than or equal to $2.5 \times 10^9$ Pa, and still more preferably is more than or equal to $7.0 \times 10^8$ Pa and less than or equal to $2.5 \times 10^9$ Pa.

The storage elastic modulus at 130°C of the cured product of the light curing acrylic resin for imprinting according to the present embodiment may be more than or equal to $3.1 \times 10^8$ Pa, preferably is more than or equal to $5.5 \times 10^8$ Pa, and still more preferably is more than or equal to $7.0 \times 10^8$ Pa. The storage elastic modulus at 130°C of the cured product of the light curing acrylic resin for imprinting may be less than or equal to $2.5 \times 10^9$ Pa. The storage elastic modulus at 130°C of the cured product of the light curing acrylic resin for imprinting may be more than or equal to $3.1 \times 10^8$ Pa and less than or equal to $2.5 \times 10^9$ Pa, preferably is more than or equal to $5.5 \times 10^8$ Pa and less than or equal to $2.5 \times 10^9$ Pa, and still more preferably is more than or equal to $7.0 \times 10^8$ Pa and less than or equal to $2.5 \times 10^9$ Pa.

The storage elastic modulus at 140°C of the cured product of the light curing acrylic resin for imprinting according to the present embodiment may be more than or equal to $2.6 \times 10^8$ Pa, preferably is more than or equal to $5.0 \times 10^8$ Pa, and still more preferably is more than or equal to $6.0 \times 10^8$ Pa. The storage elastic modulus at 140°C of the cured product of the light curing acrylic resin for imprinting may be less than or equal to $2.5 \times 10^9$ Pa. The storage elastic modulus at 140°C of the cured product of the light curing acrylic resin for imprinting may be more than or equal to $2.6 \times 10^8$ Pa and less than or equal to $2.5 \times 10^9$ Pa, preferably is more than or equal to $5.0 \times 10^8$ Pa and less than or equal to $2.5 \times 10^9$ Pa, and still more preferably is more than or equal to $6.0 \times 10^8$ Pa and less than or equal to $2.5 \times 10^9$ Pa.

**In** addition, a rate of change of the storage elastic modulus at 120°C of the cured product with respect to the storage elastic modulus at 30°C of the cured product (the storage elastic modulus at 120°C / the storage elastic modulus at 30°C $\times$ 100%) may be more than or equal to 17%, preferably is more than or equal to 30%, and more preferably is more than or equal to 40%. The rate of change of the storage elastic modulus at 120°C of the cured product with respect to the storage elastic modulus at 30°C of the cured product (the storage elastic modulus at 120°C / the storage elastic modulus at 30°C $\times$ 100%) may be less than or equal to 100%. The rate of change of the storage elastic modulus at 120°C of the cured product with respect to the storage elastic modulus at 30°C of the cured product (the storage elastic modulus at 120°C / the storage elastic modulus at 30°C $\times$ 100%) may be more than or equal to 17% and less than or equal to 100%, preferably is more than or equal to 30% and less than or equal to 100%, and more preferably is more than or equal to 40% and less than or equal to 100%.

The rate of change of the storage elastic modulus at 130°C of the cured product with respect to the storage elastic modulus at 30°C of the cured product (the storage elastic modulus at 130°C / the storage elastic modulus at 30°C $\times$ 100%) may be more than or equal to 14%, preferably is more than or equal to 27%, and more preferably is more than or equal to 33%. The rate of change of the storage elastic modulus at 130°C of the cured product with respect to the storage elastic modulus at 30°C of the cured product (the storage elastic modulus at 130°C / the storage elastic modulus at 30°C $\times$ 100%) may be less than or equal to 100%. The rate of change of the storage elastic modulus at 130°C of the cured product with respect to the storage elastic modulus at 30°C of the cured product (the storage elastic modulus at 130°C / the storage elastic modulus at 30°C $\times$ 100%) may be more than or equal to 14% and less than or equal to 100%, preferably is more than or equal to 27% and less than or equal to 100%, and more preferably is more than or equal to 33% and less than or equal to 100%.

The rate of change of the storage elastic modulus at 140°C of the cured product with respect to the storage elastic modulus at 30°C of the cured product (the storage elastic modulus at 140°C / the storage elastic modulus at 30°C $\times$ 100%) may be more than or equal to 11%, preferably is more than or equal to 25%, and more preferably is more than or equal to 30%. The rate of change of the storage elastic modulus at 140°C of the cured product with respect to the storage elastic modulus at 30°C of the cured product (the storage elastic modulus at 140°C / the storage elastic modulus at 30°C $\times$ 100%) may be less than or equal to 100%. The rate of change of the storage elastic modulus at 140°C of the cured product with respect to the storage elastic modulus at 30°C of the cured product (the storage elastic modulus at 140°C / the storage elastic modulus at 30°C $\times$ 100%) may be more than or equal to 11% and less than or equal to 100%, preferably is more than or equal to 25% and less than or equal to 100%, and more preferably is more than or equal to 30% and less than or equal to 100%.

<6.8. Glass Transition Temperature Tg of Cured Product of Light Curing Acrylic Resin for Imprinting>

Next, a glass transition temperature Tg of the cured product of the light curing acrylic resin for imprinting will be described. The glass transition temperature Tg can be measured using DMA7100 made by Hitachi High-Tech Corporation, for example. The glass transition temperature Tg can be measured by, for example, cutting a sheet of the cured product into 20 mm in length and 3 mm in width, raising the temperature at 5°C/min in a tensile mode at a certain frequency

(1 Hz), and confirming the maximum value of a loss tangent tanδ at 25°C to 300°C.

The glass transition temperature Tg of the cured product of the light curing acrylic resin for imprinting according to the present embodiment may be more than or equal to 115°C, preferably is more than or equal to 140°C, and still more preferably is more than or equal to 170°C. The glass transition temperature Tg of the cured product of the light curing acrylic resin for imprinting may be less than or equal to 185°C. The glass transition temperature Tg of the cured product of the light curing acrylic resin for imprinting may be more than or equal to 115°C and less than or equal to 185°C, preferably is more than or equal to 140°C and less than or equal to 185°C, and still more preferably is more than or equal to 170°C and less than or equal to 185°C.

<6.9. Effects of Light Curing Acrylic Resin for Imprinting>

As described above, the light curing acrylic resin for imprinting according to the present embodiment contains the resin (A). The light curing acrylic resin for imprinting according to the present embodiment can thereby improve the heat tolerance of the cured product of the light curing acrylic resin for imprinting.

The light curing acrylic resin for imprinting according to the present embodiment contains the resin (B) having a viscosity of less than or equal to 10 mPa•s at 25°C. This enables the viscosity of the light curing acrylic resin for imprinting according to the present embodiment to be made lower. In addition, the resin (B) preferably is a bifunctional acrylate monomer with an acryloyl group combined with each of opposite ends of a straight-chain structure composed of a hydrocarbon group or a bifunctional acrylate monomer with an acryloyl group combined with each of opposite ends of a straight-chain structure having an ether bond. This enables the viscosity of the light curing acrylic resin for imprinting to be made still lower. In addition, the resin (B) is the bifunctional acrylate monomer expressed by Chemical Formula (I) above, and n preferably is an integer of more than or equal to 1 and less than or equal to 9 in Chemical Formula (I). This enables the viscosity of the light curing acrylic resin for imprinting to be made still lower. In addition, the resin (B) is the bifunctional acrylate monomer expressed by Chemical Formula (I) above, and n preferably is an integer of more than or equal to 6 and less than or equal to 9 in Chemical Formula (I). This enables the viscosity of the light curing acrylic resin for imprinting to be made still lower. In addition, the resin (B) is the bifunctional acrylate monomer expressed by Chemical Formula (I) above, and n preferably is an integer of 6 or 9 in Chemical Formula (I). This enables the viscosity of the light curing acrylic resin for imprinting to be made still lower.

The light curing acrylic resin for imprinting according to the present embodiment preferably further contains the resin (C) having a viscosity of less than or equal to 10 mPa•s at 25°C. This enables the viscosity of the light curing acrylic resin for imprinting according to the present embodiment to be made still lower. In addition, in the present embodiment, the resin (C) preferably is an acrylate monomer having a viscosity of less than or equal to 10 mPa•s at 25°C and being structurally rigid. This enables the viscosity of the light curing acrylic resin for imprinting according to the present embodiment to be made still lower and the heat tolerance of the cured product of the light curing acrylic resin for imprinting to be improved further. In addition, the resin (C) preferably is a monofunctional acrylate monomer. In a polymerization reaction (curing reaction) of the light curing acrylic resin for imprinting, the reaction at the end of polymer can thereby be terminated. Consequently, degradation from the end group of the cured product (polymer) of the light curing acrylic resin for imprinting can be restrained. In addition, the resin (C) preferably is isobornyl acrylate. This enables the viscosity of the light curing acrylic resin for imprinting according to the present embodiment to be made still lower and the heat tolerance of the cured product of the light curing acrylic resin for imprinting to be improved further.

The light curing acrylic resin for imprinting according to the present embodiment preferably further contains the resin (D) which is an acrylate monomer having three or more functional groups. This enables the light curing acrylic resin for imprinting according to the present embodiment to be increased in cross-linking density during curing, enables the heat tolerance of the cured product of the light curing acrylic resin for imprinting to be improved further, and can restrain the storage elastic modulus from decreasing at high temperatures. In addition, the resin (D) preferably is one or more selected from the group consisting of trimethylolpropane triacrylate, dipentaerythritol hexaacrylate, and polyfunctional polyester acrylate. This enables the heat tolerance of the cured product of the light curing acrylic resin for imprinting to be improved further.

In addition, as described above, in the light curing acrylic resin for imprinting according to the present embodiment, the content of the resin (A) in the whole of the photopolymerization component is more than or equal to 20 mass % and less than or equal to 40 mass %, and the total content of the resin (A) and the resin (B) in the whole of the photopolymerization component is less than or equal to 70 mass %. This enables the light curing acrylic resin for imprinting according to the present embodiment to achieve both a low viscosity and an improved heat tolerance of the cured product.

Since the light curing acrylic resin for imprinting according to the present embodiment has a low viscosity, the thickness of a layer (layer thickness) of the light curing acrylic resin for imprinting when a master 60 is pressed against the light curing acrylic resin for imprinting (organic material) in the above-described nano-imprinting step S12 (FIG. 11) can be made uniform. This enables a peel force applied when the master 60 is peeled from the layer of the cured light curing acrylic resin for imprinting to be uniform within a plane. Consequently, a situation in which the layer of the cured light curing acrylic

resin for imprinting is peeled from the substrate 10 can be avoided. Thus, the layer of the cured light curing acrylic resin for imprinting can be restrained from being left on the master 60, enabling repeated use of the master 60. In addition, since the above-described peel force can be made uniform within the plane, a situation in which the micro concave-convex shape transferred to the layer of the cured light curing acrylic resin for imprinting is deformed when the master 60 is peeled can be avoided. This can restrain the optical properties derived from the micro concave-convex shape of the cured product of the light curing acrylic resin for imprinting from decreasing. Consequently, in the case where the grid structural body 20 is manufactured from the cured product of the light curing acrylic resin for imprinting, the polarization properties of the grid structural body 20 can be restrained from decreasing.

In addition, since the light curing acrylic resin for imprinting according to the present embodiment has a low viscosity, the followability of the light curing acrylic resin for imprinting to the micro concave-convex shape of the master 60 when the master 60 is pressed against the light curing acrylic resin for imprinting in the above-described nano-imprinting step S12 can be improved. Consequently, the micro concave-convex shape of the master 60 can be transferred evenly to the layer of light curing acrylic resin for imprinting in the above-described nano-imprinting step S12.

In addition, since the light curing acrylic resin for imprinting according to the present embodiment has a low viscosity, air bubbles can be restrained from being mixed into the light curing acrylic resin for imprinting in the above-described nano-imprinting step S12. This can avoid a situation in which the micro concave-convex shape is partially broken by air bubbles in the cured product of the light curing acrylic resin for imprinting. Consequently, in the case where the grid structural body 20 is manufactured from the cured product of the light curing acrylic resin for imprinting, disconnection of the ridge portions 22 of the grid structural body 20 can be restrained.

The cured product of the light curing acrylic resin for imprinting according to the present embodiment is excellent in heat tolerance. Consequently, in a case where an optical material (for example, the grid structural body 20 of the above-described wire grid polarizing element 1) is manufactured from the cured product of the light curing acrylic resin for imprinting, the optical properties of the optical material can be restrained from decreasing even in a case where the optical material is further subjected to heating treatment such as vapor deposition.

For example, since the cured product of the light curing acrylic resin for imprinting according to the present embodiment is excellent in heat tolerance, the YI value of the cured product is less than or equal to 3 after the cured product of the light curing acrylic resin for imprinting is held at 120°C for 500 hours. Consequently, by manufacturing the optical material from the cured product of the light curing acrylic resin for imprinting, yellowing of the optical material can be restrained even in the case where the optical material is further subjected to heating treatment such as vapor deposition, and transparency can be maintained.

In addition, since the cured product of the light curing acrylic resin for imprinting according to the present embodiment is excellent in heat tolerance, the average transmittance of the cured product for light in the wavelength range of more than or equal to 430 nm and less than or equal to 680 nm is more than or equal to 91% after the cured product of the light curing acrylic resin for imprinting is held at 120°C for 500 hours. Consequently, by manufacturing the optical material from the cured product of the light curing acrylic resin for imprinting, the average transmittance of the optical material for light in the above-described wavelength range can be maintained high even in the case where the optical material is further subjected to heating treatment such as vapor deposition.

In addition, since the cured product of the light curing acrylic resin for imprinting according to the present embodiment is excellent in heat tolerance, the average transmittance of the cured product for light in the wavelength range of more than or equal to 430 nm and less than or equal to 510 nm is more than or equal to 90% after the cured product of the light curing acrylic resin for imprinting is held at 120°C for 500 hours. Consequently, by manufacturing the optical material from the cured product of the light curing acrylic resin for imprinting, the average transmittance of the optical material for light in the above-described wavelength range can be maintained high even in the case where the optical material is further subjected to heating treatment such as vapor deposition.

In addition, the storage elastic modulus at 30°C of the cured product of the light curing acrylic resin for imprinting preferably is more than or equal to $1.6 \times 10^9$ Pa. This can further avoid the situation in which the micro concave-convex shape transferred to the layer of the cured light curing acrylic resin for imprinting is deformed when the master 60 is peeled in the above-described nano-imprinting step S12 (FIG. 11). This can further restrain the optical properties derived from the micro concave-convex shape of the cured product of the light curing acrylic resin for imprinting from decreasing. Consequently, in the case where the grid structural body 20 is manufactured from the cured product of the light curing acrylic resin for imprinting, the polarization properties of the grid structural body 20 can be restrained further from decreasing.

In addition, since the cured product of the light curing acrylic resin for imprinting according to the present embodiment is excellent in heat tolerance, the storage elastic modulus at 120°C of the cured product is more than or equal to $3.9 \times 10^8$ Pa. Consequently, by manufacturing the optical material from the cured product of the light curing acrylic resin for imprinting, deformation of the optical material can be restrained further even in the case where the optical material is further subjected to heating treatment such as vapor deposition. Thus, the optical properties of the optical material can be restrained further from decreasing.

In addition, as described above, the reflection film 30 is vapor-deposited on the grid structural body 20 when the wire grid polarizing element 1 is manufactured. During this vapor deposition of the reflection film 30, the grid structural body 20 is heated. Herein, if the heat tolerance of the grid structural body 20 is low, a problem arises in that the grid structural body 20 is deformed during the vapor deposition of the reflection film 30, resulting in decrease in polarization properties.

However, the cured product of the light curing acrylic resin for imprinting according to the present embodiment is excellent in heat tolerance. Consequently, by manufacturing the grid structural body 20 from the cured product of the light curing acrylic resin for imprinting, yellowing of the grid structural body 20 and deformation of the grid structural body 20 can be restrained even when the reflection film 30 is vapor-deposited, and the average transmittance of the grid structural body 20 for light in the wavelength range of more than or equal to 430 nm and less than or equal to 680 nm and light in the wavelength range of more than or equal to 430 nm and less than or equal to 510 nm can be maintained high. Thus, the polarization properties of the grid structural body 20 can be restrained further from decreasing.

In addition, as described above, the viscosity of the photopolymerization component of the light curing acrylic resin for imprinting at 25°C preferably is less than or equal to 35 mPa•s. The thickness of the layer of light curing acrylic resin for imprinting when the master 60 is pressed against the light curing acrylic resin for imprinting in the above-described nano-imprinting step S12 can thereby be made more uniform, and the followability of the light curing acrylic resin for imprinting to the micro concave-convex shape of the master 60 can be improved further, which can further restrain air bubbles from being mixed into the light curing acrylic resin for imprinting.

In addition, as described above, the total content of the resin (B) and the resin (C) in the whole of the photopolymerization component in the light curing acrylic resin for imprinting according to the present embodiment preferably is more than or equal to 50 mass % and less than or equal to 70 mass %. This enables the viscosity of the light curing acrylic resin for imprinting according to the present embodiment to be made still lower. For example, when the total content of the resin (B) and the resin (C) in the whole of the photopolymerization component is more than or equal to 59 mass % and less than or equal to 70 mass %, the viscosity of the photopolymerization component of the light curing acrylic resin for imprinting at 25°C can be made less than or equal to 25 mPa•s.

In addition, as described above, the content of the resin (D) in the whole of the photopolymerization component in the light curing acrylic resin for imprinting according to the present embodiment preferably is more than 0 mass % and less than or equal to 20 mass %. This enables the heat tolerance of the light curing acrylic resin for imprinting according to the present embodiment to be improved further. For example, the storage elastic modulus at 120°C of the cured product of the light curing acrylic resin for imprinting can be made more than or equal to $6.2 \times 10^8$ Pa, the storage elastic modulus at 130°C of the cured product of the light curing acrylic resin for imprinting can be made more than or equal to $5.5 \times 10^8$ Pa, and the storage elastic modulus at 140°C of the cured product of the light curing acrylic resin for imprinting can be made more than or equal to $5.0 \times 10^8$ Pa. In addition, the rate of change of the storage elastic modulus at 120°C of the cured product with respect to the storage elastic modulus at 30°C of the cured product can be made more than or equal to 30%, the rate of change of the storage elastic modulus at 130°C of the cured product with respect to the storage elastic modulus at 30°C of the cured product can be made more than or equal to 27%, and the rate of change of the storage elastic modulus at 140°C of the cured product with respect to the storage elastic modulus at 30°C of the cured product can be made more than or equal to 23%. In addition, the glass transition temperature of the cured product of the light curing acrylic resin for imprinting can be made more than or equal to 125°C.

<6.10. Other Components>

Other components (additives) may be contained in the light curing acrylic resin for imprinting within a range not impairing the effects described in 6.9. above. Examples of the other components include an antioxidant, a phosphor, a plasticizer, an ultraviolet absorber, an anti-foaming agent, a thixotropic agent, a polymerization inhibitor, a mold release agent, and particles of a metal oxide.

[Examples]

Next, examples of the present invention will be described. However, the examples which will be described below are specific examples illustrated for describing the configuration, effects, and the like of the polarizing element 1 according to the present embodiment described above, and the present invention is not limited to the following examples.

<1. Result of Evaluation of Transmissivity and Polarization Splitting Properties for Oblique Incident Light>

As the examples of the present invention, models of the wire grid polarizing element 1 according to the present embodiment described above were produced, and their various properties were simulated to evaluate the wire grid polarizing element 1. In addition, for comparison with the examples of the present invention, models of a wire grid polarizing element according to conventional examples were created, and simulation and evaluation were performed similarly. Note

that hereinafter, reference characters representing the constituent members (such as the substrate 10, the grid structural body 20, the base part 21, the ridge portions 22, and the reflection film 30) of the polarizing element and notations representing various dimensions of these constituent members are denoted by identical reference characters and notations both in the examples and the conventional examples for convenience of description.

Note that notations representing various dimensions and the like of the polarizing element 1 which will be used in the following description are described below.

P: pitch of the ridge portions 22
$W_T$: top width of the ridge portion 22 (ridge portion top width)
$W_M$: width of the ridge portion 22 at the central position in the height direction (ridge portion central width)
$W_B$: bottom width of the ridge portion 22 (grid bottom width)
$W_{MAX}$: maximum width of the reflection film 30 covering and wrapping the ridge portion 22 (grid maximum width)
H: height of the ridge portion 22
Hx: height of a portion of the side surfaces 22b of the ridge portion 22 covered by the reflection film 30
Dt: thickness of the reflection film 30 covering the leading end 22a of the ridge portion 22 (leading end thickness of the reflection film 30)
Ds: thickness of the reflection film 30 covering the side surfaces 22b of the ridge portion 22 (side surface thickness of the reflection film 30)
Rc: coverage rate of the side surfaces 22b of the ridge portion 22 obtained by the reflection film 30
Rr: open rate of the side surfaces 22b of the ridge portion 22 obtained by the reflection film 30
$\theta$: incident angle of incident light
$\lambda$: wavelength of incident light

(Conventional Example 1)

First, Conventional Example 1 will be described with reference to FIG. 18.

As shown in FIG. 18(a), a model of the polarizing element 1 according to Conventional Example 1 was produced. The polarizing element 1 according to Conventional Example 1 included the substrate 10 made of glass and the grid structural body 20 made of an ultraviolet curable resin (an acrylic resin). The grid structural body 20 had the base part 21 provided along the surface of the substrate 10 and the plurality of ridge portions 22 formed to protrude from the base part 21 in a grid shape. The sectional shape of the ridge portion 22 was a rectangular shape rather than the upward narrowing shape. The reflection film 30 covering the ridge portions 22 was an Al film. The reflection film 30 was formed to cover the leading end 22a and one of the side surfaces 22b as a whole of the ridge portion 22 as well as part of the base part 21. However, the reflection film 30 did not cover the other side surface 22b of the ridge portion 22 at all. In this manner, the reflection film 30 of Conventional Example 1 was formed to be unevenly located only on one side of the ridge portion 22, and the other side of the ridge portion 22 was open without being covered by the reflection film 30.

The respective portions of the model of the polarizing element 1 according to Conventional Example 1 had the following dimensions and shapes.

P: 144 nm
$W_T$: 32.5 nm
$W_B$: 32.5 nm
$W_{MAX}$: 55 nm
H: 220 nm
Hx: 220 nm (one side), 0 nm (the other side)
Dt: 35 nm
Ds: 22.5 nm (maximum value)
Rc: 100% (one side), 0% (the other side)
Rr: 0% (one side), 100% (the other side)
$\theta$: 0° to +60°
$\lambda$: 430 to 680 nm

Thereafter, simulation was performed for the model of the polarizing element 1 according to Conventional Example 1 produced as described above while changing the incident angle $\theta$ to calculate the transmission axis transmittance (Tp), the reflection axis reflectance (Rs), and Tp $\times$ Rs required as the polarizing beam splitter (PBS), respectively. The incident angle $\theta$ was set at 0° to +60°. Note that the wavelength $\lambda$ of incident light was changed in a range of 430 to 680 nm, and average values of a plurality of values of Tp and Rs calculated for incident light having each of the wavelengths $\lambda$ were used as the values of Tp and Rs. A relationship between each of Tp, Rs, and Tp $\times$ Rs calculated as

described above and θ is shown in each of graphs of FIG. 18(b) to (d).

In Conventional Example 1, the reflection film 30 was unevenly located on one side of the ridge portion 22 and the coverage rate Rc of the one side was 100% as shown in FIG. 18. Therefore, as the incident angle θ increased, Rs was gradually raised but Tp decreased significantly, so that Tp × Rs also decreased significantly. For example, in a range where θ > 45°, Tp decreased to less than or equal to 76%, and Tp × Rs decreased to less than or equal to 68%. Consequently, it is understood that in the case of using the polarizing element 1 according to Conventional Example 1 as the polarizing beam splitter, problems arose in that the polarization splitting properties (the Tp × Rs properties) were poor particularly for oblique incident light at a large incident angle θ of more than or equal to 45°, so that the Tp × Rs properties required of the polarizing beam splitter failed to be obtained.

(Conventional Example 2)

Next, Conventional Example 2 will be described with reference to FIG. 19.

As shown in FIG. 19(a), a model of the polarizing element 1 according to Conventional Example 2 was produced. The model of Conventional Example 2 was similar to the model of Conventional Example 1 described above. However, in Conventional Example 2, two directions of an incident angle (θ = 0° to +60°) in the positive direction incident on one side of the ridge portion 22 in an oblique direction and an incident angle (θ = 0° to -60°) in the negative direction incident on the other side of the ridge portion 22 in an oblique direction were used as the incident angle θ.

The respective portions of the model of the polarizing element 1 according to Conventional Example 2 had the following dimensions and shapes.

P: 144 nm
$W_T$: 32.5 nm
$W_B$: 32.5 nm
$W_{MAX}$: 55 nm
H: 220 nm
Hx: 220 nm (one side), 0 nm (the other side)
Dt: 35 nm
Ds: 22.5 nm (maximum value)
Rc: 100% (one side), 0% (the other side)
Rr: 0% (one side), 100% (the other side)
θ: 0° to +60°, 0° to -60°
λ: 430 to 680 nm

Thereafter, simulation was performed for the model of the polarizing element 1 according to Conventional Example 2 produced as described above while changing the incident angle θ to calculate the transmission axis transmittance (Tp), the reflection axis reflectance (Rs), and Tp × Rs required as the polarizing beam splitter (PBS), respectively. On this occasion, Tp, Rs, and Tp × Rs were calculated for each of the case where the incident angle θ is in the positive direction and the case where the incident angle θ is in the negative direction. Note that the wavelength λ of incident light was changed in the range of 430 to 680 nm, and average values of a plurality of values of Tp and Rs calculated for incident light having each of the wavelengths were used as the values of Tp and Rs. A relationship between each of Tp, Rs, and Tp × Rs calculated as described above and θ is shown in each of graphs of FIG. 19(b) to (d).

As shown in FIG. 19, in Conventional Example 2, the reflection film 30 was unevenly located on one side of the ridge portion 22, and the coverage rate Rc of the one side was 100%, similarly to Conventional Example 1 described above. As a result, in Conventional Example 2, in relation to incidence of oblique incident light in the positive direction, Tp (+) decreased significantly as the incident angle θ increased as shown in FIG. 19(b), similarly to Conventional Example 1 described above. Further, in Conventional Example 2, also in relation to incidence of oblique incident light in the negative direction, Tp (-) decreased as the absolute value of a negative incident angle θ increased, but it can be confirmed that the degree of decrease in Tp (-) was smaller than the degree of decrease in Tp (+).

Specifically, in Conventional Example 2, the difference between Tp (+) and Tp (-) was more than or equal to 5% and the difference between Tp × Rs (+) and Tp × Rs (-) was more than or equal to 4% in the range where the absolute value of θ was 30° to 60°. It was confirmed from this result that in Conventional Example 2, bilateral asymmetry was present in the polarization properties of the polarizing element 1 depending on whether the incident direction of oblique incident light was the positive direction or the negative direction.

It is understood that problems arose in that when the difference in Tp due to the difference in incident direction of oblique incident light (for example, the difference between +45° and -45°) increased as in Conventional Example 2 above, the difference in brightness of a displayed image was recognizable to an observer, and a video state became inappropriate. In addition, it is understood that in the case of using the polarizing element 1 according to Conventional Example 2 as

the polarizing beam splitter, problems arose in that the polarization splitting properties (the Tp × Rs properties) were poor for oblique incident light particularly at the large incident angle θ of more than or equal to 45°, so that the Tp × Rs properties required of the polarizing beam splitter failed to be obtained.

(Conventional Example 3)

Next, Conventional Example 3 will be described with reference to FIG. 20.

As shown in FIG. 20(a), a model of the polarizing element 1 according to Conventional Example 3 was produced. The polarizing element 1 according to Conventional Example 3 included the substrate 10 made of glass and the grid structural body 20 made of an ultraviolet curable resin (an acrylic resin). The grid structural body 20 had the base part 21 provided along the surface of the substrate 10, and the plurality of ridge portions 22 formed to protrude from the base part 21 in a grid shape. The sectional shape of the ridge portion 22 was a rectangular shape rather than the upward narrowing shape. The reflection film 30 covering the ridge portions 22 was an Al film. The reflection film 30 was formed to cover the leading end 22a and a large part of both the side surfaces 22b (about 85%) of the ridge portion 22. In this manner, the reflection film 30 of Conventional Example 3 covered the leading end 22a and a large part of both the side surfaces 22b of the ridge portion 22. In addition, the reflection film 30 of Conventional Example 3 was rectangular-shaped, and had two angulated corner portions on both left and right ends of the top of the reflection film 30, which was different from a rounded bulging shape like the reflection film 30 of the polarizing element 1 according to the present embodiment described above.

The respective portions of the model of the polarizing element 1 according to Conventional Example 3 had the following dimensions and shapes.

P: 140 nm
$W_T$: 35 nm
$W_B$: 35 nm
$W_{MAX}$: 65 nm
H: 230 nm
Hx: 196 nm
Dt: 30 nm
Ds: 15 nm (maximum value)
Rc: 85%
Rr: 15%
θ: 0° to +60°
λ: 430 to 680 nm

Thereafter, simulation was performed for the model of the polarizing element 1 according to Conventional Example 3 produced as described above while changing the incident angle θ to calculate Tp, Rs, and Tp × Rs, respectively, similarly to Conventional Example 1 described above. The incident angle θ was set at 0° to +60°. A relationship between each of Tp, Rs, and Tp × Rs calculated in this manner and θ is shown in each of graphs of FIG. 20(b) to (d).

As shown in FIG. 20, Conventional Example 3 was different in covering mode from Conventional Example 1 described above, but the reflection film 30 covered a large part of both the side surfaces 22b of the ridge portion 22, and the coverage rate Rc was as large as 85%. Therefore, in Conventional Example 3, Rs was gradually raised but Tp decreased significantly as the incident angle θ increased, so that Tp × Rs also decreased significantly, similarly to Conventional Example 1 described above. For example, in the range where θ > 45°, Tp decreased to less than or equal to 73%, and Tp × Rs decreased to less than or equal to 65%. Consequently, it is understood that in the case of using the polarizing element 1 according to Conventional Example 3 as the polarizing beam splitter, problems arose in that the polarization splitting properties (the Tp × Rs properties) were poor for oblique incident light particularly at the large incident angle θ of more than or equal to 45°, so that the Tp × Rs properties required of the polarizing beam splitter failed to be obtained.

(Example 1)

Next, Example 1 of the present invention will be described with reference to FIG. 21 and FIG. 22.

As shown in FIG. 21(a), a model of the polarizing element 1 according to Example 1 was produced. The polarizing element 1 according to Example 1 included the substrate 10 made of glass and the grid structural body 20 made of an ultraviolet curable resin (an acrylic resin). The grid structural body 20 had the base part 21 provided along the surface of the substrate 10, and the plurality of ridge portions 22 formed to protrude from the base part 21 in a grid shape. The sectional shape of the ridge portion 22 was a trapezoidal shape and an upward narrowing shape that narrowed toward the leading end 22a of the ridge portion 22.

The reflection film 30 covering the ridge portions 22 of Example 1 was an Al film. The reflection film 30 was formed to cover the leading end 22a and the upper side of both the side surfaces 22b of the ridge portion 22. However, the reflection film 30 did not cover the lower side of both the side surfaces 22b of the ridge portion 22 and the base part 21. The coverage rate Rc of both the side surfaces 22b of the ridge portion 22 obtained by the reflection film 30 was 40%. In this manner, the reflection film 30 of Example 1 roundly covered and wrapped the top of the ridge portion 22 (the leading end 22a and the upper side of the side surfaces 22b). The surface of the reflection film 30 had a substantially elliptical shape having such roundness that expanded to the outside, and bulged in the width direction (the X direction) of the ridge portion 22.

As a result, the grid portion (the structural body combining the ridge portion 22 and the reflection film 30) according to Example 1 had the special tree shape described above. The grid maximum width $W_{MAX}$ of the special tree shape (the width of the grid at a portion where the reflection film 30 bulged most) was more than or equal to the bottom width $W_B$ of the ridge portion 22 (the width of the ridge portion 22 at a height position of 20% upward from the bottom of the ridge portion 22).

The respective portions of the model of the polarizing element 1 according to Example 1 had the following dimensions and shapes.

P: 144 nm
$W_T$: 19 nm
$W_M$: 32.5 nm
$W_B$: 46nm
$W_{MAX}$: 55 nm
H: 220 nm
Hx: 99 nm
Dt: 35 nm (maximum value)
Ds: 22.5 nm (maximum value)
Rc: 40%
Rr: 60%
$\theta$: 0° to +60°
$\lambda$: 430 to 680 nm

Thereafter, simulation was performed for the model of the polarizing element 1 according to Example 1 produced as described above while changing the incident angle $\theta$ to calculate the transmission axis transmittance (Tp), the transmission axis reflectance (Ts), the reflection axis transmittance (Rp), the reflection axis reflectance (Rs), and Tp $\times$ Rs required as the polarizing beam splitter (PBS), respectively. The incident angle $\theta$ was set at 0° to +60°. Note that the wavelength $\lambda$ of incident light was changed in the range of 430 to 680 nm, and average values of a plurality of values of Tp, Ts, Rp, and Rs calculated for incident light having each of the wavelengths $\lambda$ were used as values of Tp, Rs, Ts, and Rp. In addition, by dividing the transmission axis transmittance (Tp) by the transmission axis reflectance (Ts), the contrast (CR) (CR = Tp/Ts) of transmitted light was also calculated.

A relationship between each of Tp, Rs, Ts, Rp, CR, and Tp $\times$ Rs calculated as described above and $\lambda$ is shown in a table of FIG. 21(b) and each of graphs of FIG. 21(c) to (d). In addition, a relationship between each of Tp, Rs, and Tp $\times$ Rs calculated as described above and $\theta$ is shown in each of graphs of FIG. 22(a) to (c).

Note that the table of FIG. 21(b) shows average values of values of the respective properties (Tp, Rs, Ts, Rp, CR, and Tp $\times$ Rs) separately for a plurality of wavelength bands (430 to 510 nm, 520 to 590 nm, and 600 to 680 nm) of incident light and the entire wavelength band (430 to 680 nm) of the incident light. The graphs of FIG. 21(c) to (d) and the graphs of FIG. 22(a) to (c) show average values of values of the respective properties (Tp, Rs, Ts, Rp, CR, and Tp $\times$ Rs) in the entire wavelength band (430 to 680 nm) of the incident light. In addition, the graphs of FIG. 22(a) to (c) also show values of the properties (Tp (+), Tp (-), Rs (+), Rs (-), Tp $\times$ Rs (+), and Tp $\times$ Rs (-)) of Conventional Example 2 described above for comparison with Example 1.

As shown in FIG. 21(a), in the model of the polarizing element 1 of Example 1, the reflection film 30 covered the top of the ridge portion 22 and opened the bottom of the ridge portion 22, and the coverage rate Rc was 40%. Therefore, the grid portion (the structural body combining the ridge portion 22 and the reflection film 30) of Example 1 had the special tree shape described above. The grid portion having the special tree structure of such Example 1 was excellent in transmissivity and polarization splitting properties for oblique incident light at the incident angle $\theta$ in a large and wide range.

Consequently, it is understood that in Example 1, Tp was more than or equal to 80% and Rs was more than or equal to 90% irrespective of the wavelength $\lambda$ as shown in FIG. 21, so that high Tp and Rs were obtained. As a result, it is understood that Tp $\times$ Rs also became more than or equal to 72%, so that excellent Tp $\times$ Rs properties were obtained. It is also understood that as to the contrast CR, excellent contrast of more than or equal to 100 was obtained irrespective of the wavelength $\lambda$. Consequently, it is understood that in Example 1, favorable polarization properties were obtained for oblique incident light as compared with Conventional Examples 1 and 2 described above.

Further, as shown in FIG. 22, Example 1 ensured Tp having a very high value of more than or equal to 78% at the incident angle θ in the wide range of 0° to 60°. As a result, it is understood that high Tp × Rs of more than or equal to 73% was able to be ensured for oblique incident light at the incident angle θ in a large and wide range (30° to 60°), and Example 1 had excellent polarization splitting properties (the Tp × Rs properties). Particularly in a case where θ = 45°, Tp had a very high value of 87%, and the value of Tp × Rs was also a very high value of 78%. Thus, it is understood that the polarizing element 1 of Example 1 was able to exert significantly excellent transmissivity and polarization splitting properties for oblique incident light at the incident angle θ of and around 45°.

Further, as is understood from the result of comparison between Example 1 and Conventional Example 2 shown in FIG. 22, Tp and Tp × Rs decreased as the incident angle θ increased, and Tp and Tp × Rs sharply decreased particularly in the range where θ > 45° in Conventional Example 2. In contrast to this, in Example 1, Tp and Tp × Rs were restrained from decreasing even if θ increased, and were able to be maintained at high values. Particularly in the case where θ = 45°, Example 1 was able to obtain Tp and Tp × Rs higher than in the case of incidence in the positive direction in Conventional Example 2 even by more than or equal to 6%, and Tp and Tp × Rs higher than in the case of incidence in the negative direction in Conventional Example 2 even by more than or equal to 10%. In this manner, Example 1 was able to obtain the highest transmissivity (transmittance Tp) and Tp × Rs properties in the case where θ = 45°.

In addition, as to the reflection axis reflectance Rs, Example 1 was able to obtain high reflectance having no significant difference from Conventional Examples 1 and 2.

In addition, as to the Tp × Rs properties required as the polarizing beam splitter (PBS), Example 1 was superior to Conventional Examples 1 and 2, and the highest Tp × Rs properties were obtained in the case where the incident angle θ = 45°. In addition, also in the range where the incident angle θ = 30° to 60°, Example 1 was able to obtain more favorable properties than in Conventional Examples 1 and 2, and was superior to Conventional Examples 1 and 2 in the Tp × Rs properties for oblique incident light at the incident angle θ in the large and wide range. Further, in Example 1, the Tp × Rs properties were in good balance for oblique incident light at the incident angle θ in the range of 45° ± 15°. Therefore, in a case of projecting an image using the polarizing element 1 according to Example 1 as the polarizing beam splitter, the brightness of the displayed image is in good balance when seen from the observer, and the video state also becomes favorable.

In this manner, it is understood that in the case of using the polarizing element 1 according to Example 1 as the polarizing beam splitter, the transmissivity (transmittance Tp) for the p-polarized light and the polarization splitting properties (the Tp × Rs properties) were significantly excellent for oblique incident light at the incident angle θ in the large and wide range of 30° to 60°, particularly for oblique incident light at 45°. Thus, it can be said that the polarization splitting properties required of the polarizing beam splitter were able to be sufficiently satisfied for the oblique incident light.

In addition, as to the contrast CR (CR = Tp/Ts) of transmitted light, it is understood that excellent contrast CR of more than or equal to 100 was obtained in Example 1.

(Example 2)

Next, Example 2 of the present invention will be described with reference to FIG. 23.

As shown in FIG. 23(a), a model of the polarizing element 1 according to Example 2 was produced. The model of Example 2 was different from the model of Example 1 described above in the shape of the ridge portion 22 and the covering mode by the reflection film 30. The sectional shape of the ridge portion 22 of Example 2 was a triangular shape and an upward narrowing shape that narrowed toward the leading end 22a of the ridge portion 22.

The reflection film 30 covering the ridge portions 22 of Example 2 was an Al film. The reflection film 30 was formed to cover the leading end 22a and the upper side of both the side surfaces 22b of the ridge portion 22. However, the reflection film 30 did not cover the lower side of both the side surfaces 22b of the ridge portion 22 and the base part 21. The coverage rate Rc of both the side surfaces 22b of the ridge portion 22 obtained by the reflection film 30 was 45%. In this manner, the reflection film 30 of Example 2 roundly covered and wrapped the top of the ridge portion 22 (the leading end 22a and the upper side of the side surfaces 22b). The surface of the reflection film 30 had a substantially elliptical shape having such roundness that expanded to the outside, and bulged in the width direction (the X direction) of the ridge portion 22. In this manner, the grid portion (the structural body combining the ridge portion 22 and the reflection film 30) according to Example 2 had the special tree shape described above similarly to the grid portion of Example 1.

The respective portions of the model of the polarizing element 1 according to Example 2 had the following dimensions and shapes.

P: 140 nm
$W_T$: 10 nm
$W_B$: 40 nm
$W_{MAX}$: 41nm
H: 230 nm

Hx: 103.5 nm
Dt: 50 nm (maximum value)
Ds: 17 nm (maximum value)
Rc: 45%
Rr: 55%
$\theta$: 0° to +60°
$\lambda$: 430 to 680 nm

Thereafter, simulation was performed for the model of the polarizing element 1 according to Example 2 produced as described above while changing the incident angle $\theta$ to calculate the transmission axis transmittance (Tp), the reflection axis reflectance (Rs), and Tp $\times$ Rs required as the polarizing beam splitter (PBS), respectively. Note that the wavelength $\lambda$ of incident light was changed in the range of 430 to 680 nm, and average values of a plurality of values of Tp and Rs calculated for incident light having each of the wavelengths were used as the values of Tp and Rs. A relationship between each of Tp, Rs, and Tp $\times$ Rs calculated as described above and $\theta$ is shown in each of graphs of FIG. 23(b) to (d).
As shown in FIG. 23(a), Example 2 was excellent in transmissivity and polarization splitting properties for oblique incident light at the incident angle $\theta$ in the large and wide range because the grid portion (the structural body combining the ridge portion 22 and the reflection film 30) of Example 2 had the special tree shape described above similarly to the grid portion of Example 1.
Consequently, as shown in FIG. 23, Example 2 ensured Tp having a high value of more than or equal to 74% at the incident angle $\theta$ in the wide range of 0° to 45°. It is understood that particularly in the cases where $\theta$ = 30° and 45°, Example 2 was able to ensure high Tp of more than or equal to 88%, ensured high Tp $\times$ Rs of more than or equal to 74%, and had excellent polarization splitting properties (the Tp $\times$ Rs properties). Thus, it is understood that the polarizing element 1 of Example 2 was able to exert significantly excellent transmissivity and polarization splitting properties for oblique incident light at the incident angle $\theta$ of 30° to 45°.
It is understood that even in the case where the shape of the ridge portion 22 of the grid structural body 20 was different from that of Example 1 as in Example 2 described above, favorable transmissivity and polarization splitting properties as compared with Conventional Examples 1 to 3 were able to be obtained. However, in a case where the incident angle $\theta$ was 60°, Example 1 was superior to Example 2 in Tp and Tp $\times$ Rs properties.

(Example 3)

Next, Example 3 of the present invention will be described with reference to FIG. 24. In Example 3, a relationship between the height H of the ridge portion 22 and the polarization properties of the polarizing element 1 was inspected.
As shown in FIG. 24(a), a model of the polarizing element 1 according to Example 3 was produced. The model of Example 3 was similar to the model of Example 1 described above. The sectional shape of the ridge portion 22 was a trapezoidal shape and an upward narrowing shape that narrowed toward the leading end 22a of the ridge portion 22. The grid portion (the structural body combining the ridge portion 22 and the reflection film 30) of Example 3 had the special tree shape described above similarly to the grid portion of Example 1. In Example 3, the height H of the ridge portion 22 was changed in a range of 100 to 220 nm while maintaining the coverage rate Rc at 45%.
The respective portions of the model of the polarizing element 1 according to Example 3 had the following dimensions and shapes.

P: 144 nm
$W_T$: 19 nm
$W_M$: 32.5 nm
$W_B$: 46nm
$W_{MAX}$: 55 nm
H: 100 to 220 nm
Hx: 45 to 99 nm
Dt: 35 nm (maximum value)
Ds: 22.5 nm (maximum value)
Rc: 45%
Rr: 55%
$\theta$: +45°
$\lambda$: 430 to 680 nm

Thereafter, simulation was performed for the model of the polarizing element 1 according to Example 3 produced as described above while changing the height H of the ridge portion 22 to calculate Tp, Rs, and Tp $\times$ Rs, respectively. The

incident angle θ was set at +45°. Note that the wavelength λ of incident light was changed in the range of 430 to 680 nm, and average values of a plurality of values of Tp and Rs calculated for incident light having each of the wavelengths λ were used as the values of Tp and Rs. In addition, the contrast CR of transmitted light was also calculated by dividing Tp by Ts.

A relationship between each of Tp, Rs, Tp × Rs, and CR calculated as described above and H is shown in each of graphs of FIG. 24(b) to (e).

As shown in FIG. 24, it is understood that in order to obtain favorable various properties (Tp, Tp × Rs, and CR) of the polarizing element 1 for oblique incident light at 45°, the height H of the ridge portion 22 preferably is more than or equal to 160 nm, more preferably is more than or equal to 180 nm, and particularly preferably is more than or equal to 220 nm.

Specifically, as to Tp, when H was more than or equal to 160 nm, Tp was more than or equal to 80% as shown in FIG. 24(b), so that high transmittance was obtained, which is preferable. Further, when H was more than or equal to 180 nm, Tp of more than or equal to 85% was obtained, which is more preferable. In addition, when H was more than or equal to 220 nm, Tp of more than or equal to 87% was obtained, which is particularly preferable.

In addition, as to the Tp × Rs properties, when H was more than or equal to 160 nm, excellent Tp × Rs of more than or equal to 70% was obtained as shown in FIG. 24(d), which is preferable. Further, when H was more than or equal to 180 nm, Tp × Rs of more than or equal to 75% was obtained, which is more preferable. In addition, when H was more than or equal to 220 nm, Tp × Rs of more than or equal to 77% was obtained, which is particularly preferable.

In addition, as to the contrast CR, H should only be more than or equal to 100 nm as shown in FIG. 24(e), and CR of more than or equal to 40 was thereby obtained. When H was more than or equal to 160 nm, excellent CR of more than or equal to 150 was obtained, which is preferable. Further, when H was more than or equal to 180 nm, excellent CR of more than or equal to 250 was obtained, which is more preferable. In addition, when H was more than or equal to 220 nm, excellent CR of more than or equal to 500 was obtained, which is particularly preferable.

(Example 4)

Next, Example 4 of the present invention will be described with reference to FIG. 25. In Example 4, a relationship between the thickness Dt of the reflection film 30 covering the leading end 22a of the ridge portion 22 (the leading end thickness Dt of the reflection film 30) and the polarization properties of the polarizing element 1 was inspected.

As shown in FIG. 25(a), a model of the polarizing element 1 according to Example 4 was produced. The model of Example 4 was similar to the model of Example 1 described above. The sectional shape of the ridge portion 22 was a trapezoidal shape and an upward narrowing shape that narrowed toward the leading end 22a of the ridge portion 22. The grid portion (the structural body combining the ridge portion 22 and the reflection film 30) of Example 4 had the special tree shape described above similarly to the grid portion of Example 1. In Example 4, the leading end thickness Dt of the reflection film 30 was changed stepwise in a range of 5 to 35 nm.

The respective portions of the model of the polarizing element 1 according to Example 4 had the following dimensions and shapes.

P: 144 nm
$W_T$: 19 nm
$W_M$: 32.5 nm
$W_B$: 46nm
$W_{MAX}$: 55 nm
H: 220 nm
Hx: 99 nm
Dt: 5 to 35 nm (maximum value)
Ds: 22.5 nm (maximum value)
Rc: 45%
Rr: 55%
θ: +45°
λ: 430 to 680 nm

Thereafter, simulation was performed for the model of the polarizing element 1 according to Example 4 produced as described above while changing the leading end thickness Dt of the reflection film 30 to calculate Tp, Rs, Tp × Rs, and CR, respectively. The incident angle θ was set at +45°. A relationship between each of Tp, Rs, Tp × Rs, and CR calculated as described above and Dt is shown in each of graphs of FIG. 25(b) to (e).

As shown in FIG. 25, it is understood that in order to obtain favorable various properties (Tp, Tp × Rs, and CR) of the polarizing element 1 for oblique incident light at 45°, the leading end thickness Dt of the reflection film 30 preferably is more than or equal to 5 nm, and more preferably is more than or equal to 15 nm.

Specifically, as to Tp, when Dt was more than or equal to 5 nm, Tp was more than or equal to 85% as shown in FIG.

25(b), so that high transmittance was obtained, which is preferable. In addition, as to Rs, when Dt was more than or equal to 5 nm, Rs was more than or equal to 85% as shown in FIG. 25(c), so that high reflectance was obtained, which is preferable.

In addition, as to the Tp × Rs properties, when Dt was more than or equal to 15 nm, excellent Tp × Rs of more than or equal to 78% was obtained as shown in FIG. 25(d), which is more preferable.

In addition, as to the contrast CR, when Dt was more than or equal to 5 nm, excellent CR of more than or equal to 100 was obtained as shown in FIG. 25(e), which is preferable. Further, when Dt was more than or equal to 15 nm, excellent CR of more than or equal to 250 was obtained, which is more preferable.

(Example 5)

Next, Example 5 of the present invention will be described with reference to FIG. 26. In Example 5, a relationship between the thickness Ds of the reflection film 30 covering the side surface 22b of the ridge portion 22 (the side surface thickness Ds of the reflection film 30) and the polarization properties of the polarizing element 1 was inspected.

As shown in FIG. 26(a), a model of the polarizing element 1 according to Example 5 was produced. The model of Example 5 was similar to the model of Example 1 described above. The sectional shape of the ridge portion 22 was a trapezoidal shape and an upward narrowing shape that narrowed toward the leading end 22a of the ridge portion 22. The grid portion (the structural body combining the ridge portion 22 and the reflection film 30) of Example 5 had the special tree shape described above similarly to the grid portion of Example 1. In Example 5, the side surface thickness Ds of the reflection film 30 was changed stepwise in the range of 5 to 35 nm.

The respective portions of the model of the polarizing element 1 according to Example 5 had the following dimensions and shapes.

P: 144 nm
$W_T$: 19 nm
$W_M$: 32.5 nm
$W_B$: 46nm
$W_{MAX}$: 20 to 80 nm
H: 220 nm
Hx: 99 nm
Dt: 35 nm (maximum value)
Ds :5 to 35 nm (maximum value)
Rc: 45%
Rr: 55%
$\theta$: +45°
$\lambda$: 430 to 680 nm

Thereafter, simulation was performed for the model of the polarizing element 1 according to Example 5 produced as described above while changing the side surface thickness Ds of the reflection film 30 to calculate Tp, Rs, Tp × Rs, and CR, respectively. The incident angle $\theta$ was set at +45°. A relationship between each of Tp, Rs, Tp × Rs, and CR calculated as described above and Dt is shown in each of graphs of FIG. 26(b) to (e).

As shown in FIG. 26, it is understood that in order to obtain favorable various properties (Tp, Tp × Rs, and CR) of the polarizing element 1 for oblique incident light at 45°, the side surface thickness Ds of the reflection film 30 preferably is more than or equal to 10 nm and less than or equal to 30 nm, more preferably is more than or equal to 12.5 nm and less than or equal to 25 nm, and particularly preferably is more than or equal to 15 nm and less than or equal to 25 nm.

Specifically, as to Tp, when Ds was more than or equal to 10 nm and less than or equal to 30 nm, Tp was more than or equal to 80% as shown in FIG. 26(b), so that high transmittance was obtained, which is preferable. Further, when Ds was more than or equal to 12.5 nm and less than or equal to 25 nm, Tp was more than or equal to 85%, so that higher transmittance was obtained, which is more preferable. Further, when Ds was more than or equal to 15 nm and less than or equal to 20 nm, Tp was more than or equal to 87%, so that higher transmittance was obtained, which is particularly preferable.

In addition, as to Rs, when Ds was more than or equal to 10 nm, Rs was more than or equal to 80% as shown in FIG. 26(c), so that high reflectance was obtained, which is preferable. Further, when Ds was more than or equal to 12.5 nm, Rs was more than or equal to 85%, so that higher reflectance was obtained, which is more preferable. Further, when Ds was more than or equal to 15 nm, Rs was more than or equal to 87%, so that higher reflectance was obtained, which is particularly preferable.

In addition, as to the Tp × Rs properties, when Ds was more than or equal to 12.5 nm and less than or equal to 30 nm, excellent Tp × Rs of more than or equal to 70% was obtained as shown in FIG. 26(d), which is preferable. Further, when Ds was more than or equal to 15 nm and less than or equal to 25 nm, excellent Tp × Rs of more than or equal to 76%

was obtained, which is more preferable.

In addition, as to the contrast CR, Ds should only be more than or equal to 10 nm, and when Ds was more than or equal to 12.5 nm, excellent CR of more than or equal to 50 was obtained as shown in FIG. 26(e), which is preferable. Further, when Ds was more than or equal to 15 nm, excellent CR of more than or equal to 100 was obtained, which is more preferable.

(Example 6)

Next, Example 6 of the present invention will be described with reference to FIG. 27. In Example 6, a relationship between the coverage rate Rc of the side surfaces 22b of the ridge portion 22 obtained by the reflection film 30 and the polarization properties of the polarizing element 1 was inspected.

As shown in FIG. 27(a), a model of the polarizing element 1 according to Example 6 was produced. The model of Example 6 was similar to the model of Example 1 described above. The sectional shape of the ridge portion 22 was a trapezoidal shape and an upward narrowing shape that narrowed toward the leading end 22a of the ridge portion 22. The grid portion (the structural body combining the ridge portion 22 and the reflection film 30) of Example 6 had the special tree shape described above similarly to the grid portion of Example 1. In Example 6, by changing a height Hx of a range of the side surfaces 22b of the ridge portion 22 covered by the reflection film 30, the coverage rate Rc was changed stepwise in a range of 20 to 90%.

The respective portions of the model of the polarizing element 1 according to Example 6 had the following dimensions and shapes.

P: 144 nm
$W_T$: 19 nm
$W_M$: 32.5 nm
$W_B$: 46nm
$W_{MAX}$: 55 nm
H: 220 nm
Hx: 44 to 198 nm
Dt: 35 nm (maximum value)
Ds: 22.5 nm (maximum value)
Rc: 20 to 90%
Rr: 80 to 10%
$\theta$: +45°
$\lambda$: 430 to 680 nm

Thereafter, simulation was performed for the model of the polarizing element 1 according to Example 6 produced as described above while changing the coverage rate Rc to calculate Tp, Rs, Tp × Rs, and CR, respectively. The incident angle $\theta$ was set at +45°. A relationship between each of Tp, Rs, Tp × Rs, and CR calculated as described above and Dt is shown in each of graphs of FIG. 27(b) to (e).

As shown in FIG. 27, it is understood that in order to obtain favorable various properties (Tp, Tp × Rs, and CR) of the polarizing element 1 for oblique incident light at 45°, the coverage rate Rc preferably is more than or equal to 25% and less than or equal to 80%, more preferably is more than or equal to 30% and less than or equal to 70%, more preferably is more than or equal to 30% and less than or equal to 60%, and particularly preferably is more than or equal to 40% and less than or equal to 50%.

Specifically, as to Tp, when Rc was more than or equal to 25% and less than or equal to 80%, Tp was more than or equal to 75% as shown in FIG. 27(b), so that high transmittance was obtained, which is preferable. Further, when Rc was more than or equal to 30% and less than or equal to 70%, Tp was more than or equal to 80%, so that higher transmittance was obtained, which is more preferable. Further, when Rc was more than or equal to 40% and less than or equal to 50%, Tp was more than or equal to 85%, so that higher transmittance was obtained, which is particularly preferable.

In addition, as to Rs, when Rc was more than or equal to 20%, Rs was more than or equal to 85% as shown in FIG. 27(c), so that high reflectance was obtained, which is preferable.

In addition, as to the Tp × Rs properties, when Rc was more than or equal to 25% and less than or equal to 80%, Tp × Rs was more than or equal to 70% as shown in FIG. 27(d), so that excellent Tp × Rs properties were obtained, which is preferable. Further, when Rc was more than or equal to 30% and less than or equal to 70%, Tp × Rs was more than or equal to 72%, and when Rc was more than or equal to 30% and less than or equal to 60%, Tp × Rs was more than or equal to 75%, so that more excellent Tp × Rs properties were obtained, which is more preferable. Further, when Rc was more than or equal to 40% and less than or equal to 50%, Tp × Rs was more than or equal to 77%, so that more excellent Tp × Rs properties were obtained, which is particularly preferable.

In addition, as to the contrast CR, Rc should only be more than or equal to 20% as shown in FIG. 27(e), and when Rc was more than or equal to 30%, excellent CR of more than or equal to 100 was obtained, which is preferable. Further, when Rc was more than or equal to 40%, excellent CR of more than or equal to 200 was obtained, which is more preferable.

(Example 7)

Next, Example 7 of the present invention will be described with reference to FIG. 28. In Example 7, a relationship among the thickness Ds of the reflection film 30 covering the side surface 22b of the ridge portion 22 (the side surface thickness Ds of the reflection film 30), the incident angle θ, and the polarization properties of the polarizing element 1 was inspected.

As shown in FIG. 28(a), a model of the polarizing element 1 according to Example 7 was produced. The model of Example 7 was similar to the model of Example 1 described above. The sectional shape of the ridge portion 22 was a trapezoidal shape and an upward narrowing shape that narrowed toward the leading end 22a of the ridge portion 22. The grid portion (the structural body combining the ridge portion 22 and the reflection film 30) of Example 7 had the special tree shape described above similarly to the grid portion of Example 1. In Example 7, the incident angle θ was changed stepwise in a range of 0 to 60° while changing the side surface thickness Ds of the reflection film 30 stepwise in a range of 17.5 to 25 nm.

The respective portions of the model of the polarizing element 1 according to Example 7 had the following dimensions and shapes.

P: 144 nm
$W_T$: 19 nm
$W_M$: 32.5 nm
$W_B$: 46nm
$W_{MAX}$: 45 nm, 55 nm, 60 nm
H: 220 nm
Hx: 99 nm
Dt: 35 nm (maximum value)
Ds :17.5 nm, 22.5 nm, 25 nm (maximum value)
Rc: 45%
Rr: 55%
θ: 0 to +60°
λ: 430 to 680 nm

Thereafter, simulation was performed for the model of the polarizing element 1 according to Example 7 produced as described above while changing the side surface thickness Ds of the reflection film 30 and the incident angle θ to calculate Tp, Rs, and Tp × Rs, respectively. The incident angle θ was changed stepwise every 15° in the range of 0 to +60°. A relationship between each of Tp, Rs, and Tp × Rs calculated as described above and Dt is shown in each of graphs of FIG. 28(b) to (d).

As shown in FIG. 28, it is understood that the polarizing element 1 had favorable polarization properties (Tp, Rs, and Tp × Rs) for oblique incident light at the wide incident angle θ of 0° to +60° even in the case of changing the side surface thickness Ds of the reflection film 30 stepwise in the range of 17.5 to 25 nm. It is understood that the polarizing element 1 exerts very excellent polarization properties particularly for oblique incident light at the incident angle θ of +45°.

Specifically, as to Tp, when θ fell within the range of +30° to +60° even when Ds was changed in the range of 17.5 to 25 nm, Tp was more than or equal to 75% as shown in FIG. 28(b), so that high transmittance was obtained, which is preferable. Further, when θ was +45°, Tp was more than or equal to 85%, so that the highest transmittance was obtained, which is more preferable.

In addition, as to Rs, Rs was more than or equal to 85% in the range of the wide incident angle θ of 0° to +60° as shown in FIG. 28(c), so that high reflectance was obtained, which is preferable.

In addition, as to the Tp × Rs properties, when θ fell within the range of +30° to +60° even when Ds was changed in the range of 17.5 to 25 nm, Tp × Rs was more than or equal to 70% as shown in FIG. 28(d), so that excellent Tp × Rs properties were obtained, which is preferable. Further, when θ was +45°, Tp × Rs was more than or equal to 76%, so that the most excellent Tp × Rs properties were obtained, which is more preferable. In addition, the Tp × Rs properties were in good balance for oblique incident light at the incident angle θ in the range of 45° ± 15°. Therefore, in a case of projecting an image using the polarizing element 1 according to Example 7 as the polarizing beam splitter, the brightness of the displayed image was in good balance when seen from the observer, and the video state also became favorable.

(Example 8)

Next, Example 8 of the present invention will be described with reference to FIG. 29. In Example 8, a relationship between an uneven locating rate obtained when the reflection film 30 covering the ridge portion 22 was unevenly located on one side and the polarization properties of the polarizing element 1 was inspected.

As shown in FIG. 29(a), a model of the polarizing element 1 according to Example 8 was produced. The model of Example 8 was similar to the model of Example 1 described above except a point that the reflection film 30 was unevenly located on one side of the ridge portion 22. The sectional shape of the ridge portion 22 was a trapezoidal shape and an upward narrowing shape that narrowed toward the leading end 22a of the ridge portion 22. The grid portion (the structural body combining the ridge portion 22 and the reflection film 30) of Example 8 had the special tree shape described above similarly to the grid portion of Example 1.

In Example 8, as to the left side surface 22b of the ridge portion 22, the side surface thickness Ds (left side) of the reflection film 30 covering the side surface 22b was fixed at 22.5 nm, the height Hx (left side) of the covered range was fixed at 99 nm, and the coverage rate Rc (left side) was fixed at 45%. On the other hand, the side surface thickness Ds (right side) of the reflection film 30 covering the right side surface 22b of the ridge portion 22 was changed stepwise in a range of 0 to 22.5 nm. At the same time, as to the right side surface 22b of the ridge portion 22, the height Hx (right side) of the covered range of the right side surface 22b was changed stepwise in a range of 0 to 99 nm, and the coverage rate Rc (right side) was changed stepwise in a range of 0 to 45%. As a result, the grid maximum width $W_{MAX}$ changed stepwise in a range of 32.5 to 55 nm.

In addition, in Example 8, two directions of an incident angle ($\theta$ = 0° to +60°) in the positive direction incident on the left side of the ridge portion 22 in an oblique direction and an incident angle ($\theta$ = 0° to -60°) in the negative direction incident on the right side of the ridge portion 22 in an oblique direction were used for the incident angle $\theta$.

The respective portions of the model of the polarizing element 1 according to Example 8 had the following dimensions and shapes.

P: 144 nm
$W_T$: 19 nm
$W_M$: 32.5 nm
$W_B$: 46nm
$W_{MAX}$: 32.5 nm, 37.5 nm, 47.5 nm, 55 nm
H: 220 nm
Hx (left side): 99 nm
Hx (right side): 0 to 99 nm
Dt: 35 nm (maximum value)
Ds (left side): 22.5 nm (maximum value)
Ds (right side): 0 nm, 5 nm, 10 nm, 22.5 nm (maximum value)
Rc (left side): 45%
Rc (right side): 0%, 22%, 33%, 45%,
Rr (left side): 55%
Rc (right side): 100%, 78%, 67%, 55%
$\theta$ (left side): 0 to +60°
$\theta$ (right side): 0 to -60°
$\lambda$: 430 to 680 nm

Thereafter, simulation was performed for the model of the polarizing element 1 according to Example 8 produced as described above while changing Ds (right side) and Rc (right side) for the left side surface 22b of the reflection film 30 to calculate Tp, Rs, Tp × Rs, and CR, respectively. The incident angle $\theta$ was changed stepwise every 15° in the range of 0 to +60°. A relationship between each of Tp, Rs, Tp × Rs, and CR calculated as described above and Dt is shown in each of graphs of FIG. 29(b) to (e).

As shown in FIG. 29, it is understood that even in the case where the reflection film 30 was unevenly located on one side of the ridge portion 22, that is, even in the case where the grid portion was bilaterally asymmetric, the polarizing element 1 had favorable polarization properties (Tp, Rs, Tp × Rs, and CR).

Specifically, as to Tp, even in a case where oblique incident light was incident in either the positive direction or the negative direction on the grid portion in which the reflection film 30 was unevenly located, both Tp (+) and Tp (-) were more than or equal to 85% as shown in FIG. 29(b), so that high transmittance was obtained on both sides of the grid portion. In this case, it was confirmed that the difference between Tp (+) and Tp (-) was less than or equal to 3%, so that no significant difference occurred between Tp (+) and Tp (-) depending on the incident direction of oblique incident light.

In addition, as to Rs as well, even in the case where oblique incident light was incident in either the positive

direction or the negative direction on the grid portion in which the reflection film 30 was unevenly located, both Rs (+) and Rs (-) were more than or equal to 85% as shown in FIG. 29(c), so that high reflectance was obtained on both the sides of the grid portion.

In addition, as to the Tp × Rs properties as well, even in the case where oblique incident light was incident in either the positive direction or the negative direction on the grid portion in which the reflection film 30 was unevenly located, Tp × Rs was more than or equal to 75% as shown in FIG. 29(d), so that excellent Tp × Rs properties were obtained.

In addition, as to the contrast CR as well, even in the case where oblique incident light was incident in either the positive direction or the negative direction on the grid portion in which the reflection film 30 was unevenly located, excellent CR was obtained as shown in FIG. 29(e). Further, Ds (right side) preferably was more than or equal to 5 nm, and the coverage rate (left side) preferably was more than or equal to 22%. Excellent CR of more than or equal to 100 was thereby obtained. In addition, Ds (right side) more preferably was more than or equal to 10 nm, and the coverage rate (left side) more preferably was more than or equal to 33%. More excellent CR of more than or equal to 150 was thereby obtained.

(Result of Inspection of Shape of Reflection Film: Example 9 and Conventional Example 4)

Next, a result of comparison between Example 9 of the present invention (in which the reflection film 30 was round-shaped) and Conventional Example 4 (in which the reflection film 30 was rectangular-shaped) and inspection of a relationship between the shape of the reflection film 30 covering the ridge portion 22 and the polarization properties of the polarizing element 1 will be described with reference to FIG. 30 and FIG. 31.

As shown in FIG. 30 and FIG. 31, a model of the polarizing element 1 according to Example 9 and a model of the polarizing element 1 according to Conventional Example 4 were produced.

The model of the polarizing element 1 according to Example 9 had the special tree shape described above similarly to the model of Example 1 (see FIG. 21 and the like). A grid portion of the polarizing element 1 according to Example 9 had the base part 21, the ridge portion 22 having a trapezoidal sectional shape, and the reflection film 30 covering the top of the ridge portion 22 (the leading end 22a and the upper side of the side surfaces 22b). However, the model of the polarizing element 1 according to Example 9 was different from the model of Example 1 described above in terms of the coverage rate Rc of both the side surfaces 22b of the ridge portion 22 obtained by the reflection film 30, and the coverage rate Rc of Example 9 was 45%. The reflection film 30 of Example 9 had a shape that roundly covered and wrapped the top of the ridge portion 22. The surface of the reflection film 30 of Example 9 had a substantially elliptical shape having such roundness that expanded to the outside, and bulged in the width direction (the X direction) of the ridge portion 22. The surface of the reflection film 30 of such Example 9 had a roundly and smoothly curved curvilinear shape, and did not have any angulated corner portion or stepped portion. Hereinafter, the reflection film 30 of Example 9 will be referred to as a round-shaped reflection film.

On the other hand, the model of the polarizing element 1 according to Conventional Example 4 was different from the model of Example 9 in terms of the shape of the reflection film 30. The reflection film 30 of Conventional Example 4 was rectangular-shaped and had two angulated corner portions on both the left and right ends of the top of the reflection film 30, which was different from a rounded bulging shape (the round-shaped reflection film) like the reflection film 30 of Example 9 described above. Hereinafter, the reflection film 30 of this Conventional Example 4 will be referred to as a rectangular-shaped reflection film. Note that the model of the polarizing element 1 of this Conventional Example 4 is equivalent to the wire grid-type polarizer disclosed in Patent Literature 7 described above.

In this manner, Conventional Example 4 was different from Example 9 in terms of the shape of the reflection film 30, but was identical to Example 9 in terms of other requirements.

The respective portions common to the models of the polarizing elements 1 of Example 9 and Conventional Example 4 had the following dimensions and shapes.

P: 144 nm
$W_T$: 19 nm
$W_M$: 32.5 nm
$W_B$: 46nm
$W_{MAX}$: 55 nm
H: 220 nm
Hx: 99 nm
Dt: 35 nm (maximum value)
Ds: 22.5 nm (maximum value)
Rc: 45%
Rr: 55%
$\theta$: 0° to +60°
$\lambda$: 430 to 680 nm

Simulation was performed for the models of the polarizing element 1 of Example 9 and Conventional Example 4 produced as described above while changing the incident angle θ to calculate Tp, Rs, and Tp × Rs, respectively. The incident angle θ was set at 0° to +60°.

A relationship between each of Tp, Rs, and Tp × Rs calculated as described above and θ is shown in each of graphs of FIG. 30(b) to (d).

As shown in FIG. 30, Example 9 ensured Tp having a very high value of more than or equal to 78% at the incident angle θ in the wide range of 0° to 60°. As a result, it is understood that Example 9 was able to ensure high Tp × Rs of more than or equal to 73% for oblique incident light at the incident angle θ in a large and wide range (30° to 60°) and had excellent polarization splitting properties (the Tp × Rs properties). Particularly in the case where θ = 45°, Tp had a very high value of 87%, and the value of Tp × Rs was also a very high value of 78%. Thus, it is understood that the polarizing element 1 of Example 9 was able to exert significantly excellent transmissivity and polarization splitting properties for oblique incident light at the incident angle θ of and around 45°.

Further, in Conventional Example 4, Tp and Tp × Rs decreased as the incident angle θ increased in a range where θ > 30°, and Tp and Tp × Rs sharply decreased particularly in a range where θ > 45°, as is understood from the result of comparison between Example 9 and Conventional Example 4 shown in FIG. 30.

In contrast to this, in Example 9, Tp and Tp × Rs rather rose as θ increased in a range where 0° ≤ θ ≤ 45°, so that high values of Tp and Tp × Rs were able to be maintained. Further, in Example 9, the degree of decrease in Tp and Tp × Rs was restrained considerably as compared with Conventional Example 4 even when θ increased in a range where 45° < θ ≤ 60°, so that high values of Tp and Tp × Rs were able to be maintained. Particularly in the case where θ = 45°, Example 9 was able to obtain Tp and Tp × Rs higher than in the case of Conventional Example 4 even by more than or equal to 5%. In addition, in the case where θ = 60°, Example 9 was able to obtain Tp and Tp × Rs higher than in the case of Conventional Example 4 even by more than or equal to 7%. In this manner, in Example 9, significantly excellent transmissivity (transmittance Tp) and Tp × Rs properties were obtained in the large and wide range of the incident angle θ (30° to 60°, particularly 45° to 60°).

In addition, as to Rs, Example 9 was able to obtain high reflectance having no significant difference as compared with Conventional Example 4.

In addition, as to the Tp × Rs properties required as the polarizing beam splitter (PBS), Example 9 was superior to Conventional Example 4, and in the case where the incident angle θ = 45°, the highest Tp × Rs properties were obtained. In addition, Example 9 was also able to obtain more favorable properties than in Conventional Example 4 in the range where the incident angle θ = 30° to 60°, and was superior to Conventional Example 4 in the Tp × Rs properties for oblique incident light at the incident angle θ in the large and wide range. Further, in Example 9, the Tp × Rs properties were in good balance for oblique incident light at the incident angle θ in the range of 45° ± 15°. Therefore, in a case of projecting an image using the polarizing element 1 according to Example 9 as the polarizing beam splitter, the brightness of the displayed image was in good balance when seen from the observer, and the video state also became favorable.

In this manner, it is understood that in the case of using the polarizing element 1 as the polarizing beam splitter, Example 9 was significantly superior to Conventional Example 4 in the transmissivity (transmittance Tp) for the p-polarized light and the polarization splitting properties (the Tp × Rs properties) for oblique incident light at the incident angle θ in the large and wide range of 30° to 60°, particularly for oblique incident light at 45°. Thus, it can be said that the polarization splitting properties required of the polarizing beam splitter were able to be sufficiently satisfied for the oblique incident light.

As described above, Example 9 having the round-shaped reflection film 30 was less dependent on the incident angle θ of oblique incident light than Conventional Example 4 having the rectangular-shaped reflection film 30, and was superior in the transmissivity for oblique incident light and the polarization splitting properties (the Tp × Rs properties) as the polarizing beam splitter. The reason will be described below with reference to FIG. 31.

As shown in FIG. 31, the transmittance for incident light in the wire grid polarizing element 1 is basically determined by a ratio between the effective grid width $W_A$ and the gap width $W_G$ ($W_G/W_A$). The grid width $W_A$ is the width of a single reflection film 30 in a direction perpendicular to a traveling direction of incident light, and the gap width $W_G$ is the width of a gap between mutually adjacent two reflection films 30 in the direction perpendicular to the traveling direction of incident light. As the width of the reflection film 30 (the width of the metal grid portion) that occupies a single pitch of the grid structural body 20 is smaller, incident light reflected by the reflection film 30 having the smaller width decreases, so that the transmittance for incident light increases.

Herein, as shown in FIG. 31, a case where incident light was incident on the polarizing element 1 in an oblique direction (that is, a case where θ > 0°) is considered. In this case, in Example 9 in which the reflection film 30 was round-shaped, the effective grid width $W_A$ as seen in the oblique direction was smaller and the gap width $W_G$ as seen in the oblique direction was larger than in Conventional Example 4 in which the reflection film 30 was rectangular-shaped. Consequently, in the case where oblique incident light was incident on the polarizing element 1, the transmittance Tp of Example 9 was higher than the transmittance Tp of Conventional Example 4. As a result, the Tp × Rs properties of Example 9 were superior to Conventional Example 4. For example, it is understood that in the case where the incident angle θ of oblique incident light was 45°, the transmittance Tp and Tp × Rs of Example 9 were each higher than in Conventional Example 4 by

about 5%, and in the case where θ was 60°, the transmittance Tp and Tp × Rs of Example 9 were each higher than in Conventional Example 4 by about 7% (see FIG. 30(b)(d)).

From the above reason, it can be said that Example 9 having the round-shaped reflection film 30 was less dependent on the incident angle θ of oblique incident light than Conventional Example 4 having the rectangular-shaped reflection film 30, and was superior to Conventional Example 4 in the transmissivity for oblique incident light and the polarization splitting properties (the Tp × Rs properties) as the polarizing beam splitter.

<2. Result of Inspection of Heat Dissipation>

Next, a result of comparison between the wire grid polarizing element 1 of the hybrid type made of an inorganic material and an organic material according to the examples of the present invention and a wire grid polarizing element of a film type made of an organic material according to a conventional example and inspection of heat dissipation of the polarizing element 1 will be described.

As described above, in the wire grid polarizing element 1 according to the present embodiment described above, the substrate 10 was made of an inorganic material very excellent in heat tolerance, such as glass. Further, the base part 21 and the plurality of ridge portions 22 of the grid structural body 20 provided on the substrate 10 were integrally formed of an organic material having heat tolerance. In this manner, the wire grid polarizing element 1 according to the present embodiment was the polarizing element of the hybrid type in which an organic material and an inorganic material were combined. Consequently, it is considered that the thermal resistance R [$m^2$•K/W] of the entire polarizing element 1 was small, and heat was able to be efficiently released from the grid structural body 20 to the substrate 10, resulting in excellent heat dissipation.

On the other hand, the wire grid polarizing element of the film type of the conventional example was mainly made of an organic material, and had low heat tolerance (approximately 100°C). In addition, it is considered that because of an increased total thickness of an organic material layer composed of a substrate (base film), a double-faced tape (OCA), and a grid structural body, the thermal resistance R of the organic material layer also increased.

Consequently, the wire grid polarizing element 1 of the hybrid type according to the present embodiment was superior in heat tolerance and heat dissipation to the conventional polarizing element of the film type (heat tolerance: approximately 100°C) made of an organic material, and had heat tolerance under a high-temperature environment up to approximately 200°C, for example. Thus, it is considered that the wire grid polarizing element 1 of the hybrid type according to the present embodiment was able to exert favorable heat dissipation properties while achieving excellent polarization properties.

Thus, an example of the wire grid polarizing element of the hybrid type of the present invention and the wire grid polarizing element of the film type of the conventional example were actually produced, and the thermal resistance R and heat dissipation thereof were inspected.

Table 1 shows types of materials of common base materials and thermal conductivity λ [W/m•K]. Table 2 shows the thickness of each layer made of an organic material (PMMA), the thickness (a total thickness $D_{ALL}$) of all of a plurality of layers made of an organic material (PMMA), and the thermal resistance R [$m^2$•K/W] for the wire grid polarizing element 1 of the hybrid type according to the example of the present invention and the wire grid polarizing element of the film type according to the conventional example.

[Table 1]

Table 1

| Material of Common Base Material | | Thermal Conductivity λ [W/m•K] |
|---|---|---|
| Organic Material | PVC | 0.16-0.17 |
| | PMMA | 0.21 |
| | PC | 0.19 |
| | PET | 0.14-0.33 |
| | Polyimide | 0.16 |

(continued)

| Material of Common Base Material | | Thermal Conductivity λ [W/m•K] |
|---|---|---|
| Inorganic Material | Glass BK7 | 1.13 |
| | Glass B270 | 1.1 |
| | Synthetic Quartz | 1.28 |
| | Crystal | 8 |
| | Sapphire | 42 |

[Table 2]

Table 2

| | Example Hybrid Type | Conventional Example Film Type |
|---|---|---|
| Thermal Conductivity λ of PMMA [W/m•K] | 0.21 | 0.21 |
| Thickness of Substrate [mm] | - | 0.200000 |
| Thickness of Double-Faced Tape (OCA) [mm] | - | 0.025000 |
| Thickness TB of Base Part [mm] | 0.030000 | 0.030000 |
| Height H of Ridge Portion [mm] | 0.000200 | 0.000200 |
| Total Thickness $D_{ALL}$ as PMMA material [mm] | 0.030200 | 0.255200 |
| Thermal Resistance R [$m^2$•K/W] | 0.000144 | 0.001215 |

In the polarizing element 1 of the hybrid type according to the example as shown in Table 2, the base part 21 and the ridge portions 22 constituting the grid structural body 20 were formed of an organic material, and the substrate 10 was formed of an inorganic material. On the other hand, in the polarizing element of the film type according to the conventional example, the substrate, the base part constituting the grid structural body, and the double-faced tape for bonding the base part and the substrate were entirely formed of an organic material. Herein, PMMA (Poly Methyl Methacrylate) was used as the organic material. As a result, the total thickness $D_{ALL}$ of the PMMA material of the polarizing element 1 of the hybrid type according to the example was 0.0302 [mm]. On the other hand, the total thickness $D_{ALL}$ of the PMMA material of the polarizing element of the film type according to the conventional example was 0.2552 [mm], which is considerably larger than $D_{ALL}$ in the example.

As shown in Table 1, the thermal conductivity λ of PMMA was 0.21 [W/m•K]. The thermal resistance R [$m^2$•K/W] was obtained by dividing "the thickness $D_{ALL}$ of material [mm]" by "the thermal conductivity λ [W/m•K]" ($R = (D_{ALL}/1000)/\lambda$). Thus, the thermal resistance R of the grid structural body 20 of the polarizing element 1 of the hybrid type according to the example was 0.000144 [$m^2$•K/W]. On the other hand, the thermal resistance R of the polarizing element of the film type according to the conventional example was 0.001215 [$m^2$•K/W].

Consequently, use of the polarizing element 1 of the hybrid type according to the example of the present invention enabled the value of the thermal resistance R of the grid structural body 20 made of the PMMA material to be reduced to about 1/8.4 as compared with the polarizing element of the film type according to the conventional example. Thus, the polarizing element 1 of the hybrid type according to the example of the present invention enabled heat of the grid structural body 20 made of an organic material (for example, PMMA) to be efficiently released to the outside for heat dissipation via the substrate 10 made of an inorganic material superior in heat tolerance and heat dissipation to the organic material. Hence, the polarizing element 1 of the hybrid type according to the example of the present invention had very excellent heat tolerance and heat dissipation as compared with the conventional example.

In addition, in a case where the polarizing element 1 was mounted on a projection display device such as a projector and was irradiated with light of approximately 5000 [lm (lumen)], for example, a relationship between the thickness TB of the base part 21 of the grid structural body 20 directly provided on the substrate 10 and the temperature difference ΔT between the front and rear surfaces of the base part 21 was inspected. A result of this inspection will be described below. Note that the temperature difference ΔT is a temperature difference between the temperature T1 of the frontmost surface of the base part 21 (bases of the plurality of ridge portions 22) and the temperature T2 of the base part 21 at the interface between the base part 21 and the substrate 10 ($\Delta T = T1 - T2$).

FIG. 32 is a graph showing a relationship between wavelength of light at a bright place and a dark place and luminous efficiency function. A spectral luminous efficasy K numerically represents an intensity at which human eyes sense brightness of each wavelength of light. In other words, the spectral luminous efficacy K represents a luminous flux [lm] that human eyes sense per radiation flux of 1 W of light (electromagnetic waves). The unit of the radiation flux is [W], the unit of the luminous flux (photometric quantity) is [1m], and the unit of the spectral luminous efficacy K is [1m/W]. The spectral luminous efficacy K varies depending on the wavelength of light (electromagnetic waves), and when the wavelength of light is 555 nm, the spectral luminous efficacy is the highest. The spectral luminous efficacy K at this time is up to 683 [lm/W]. This 683 [lm/W] is called a maximum spectral luminous efficacy $K_m$. In addition, a luminous efficiency function V represents the spectral luminous efficacy K at a certain wavelength by a ratio to the maximum spectral luminous efficacy $K_m$ (= 683 [lm/W]) ($V = K/K_m$). The luminous efficiency function V is a numeric value of 0 to 1.0 and has no unit.

As shown in FIG. 32, brightness (the spectral luminous efficacy K, the luminous efficiency function V) that human eyes sense is significantly different depending on the wavelength of light. It is held that human eyes sense light around the wavelength of 555 nm most strongly in a bright place and sense light around the wavelength of 507 nm most strongly in a dark place. Since the projectors are utilized in various scenes such as bright places and dark places, light of a projector that human eyes sense brightly in both the scenes at bright places and dark places is light around the wavelength of 528 nm. Thus, a result of calculation of output power Pw [W] of the light source of the projector when light around the wavelength of 528 nm is radiated from the projector at a brightness (luminous flux) of 5000 [lm] is shown in Table 3.

[Table 3]

[Table 3]

| Wavelength [nm] | Spectral luminous efficacy [-] | Luminous efficiency function [lm/W] |
|---|---|---|
| 555 | 1 | 683 |
| 528 | 0.84 | 573.7 |
| | | |
| Wavelength [nm] | Light flux [lm] | Output power Pw [W] |
| 528 | 5000 | 8.7 |

As described above, human eyes sense light around the wavelength of 555 nm most strongly in a bright place. In other words, in the curve of the photopic luminous efficiency function shown in the graph of FIG. 32, a wavelength at which the maximum spectral luminous efficacy $K_m$ is obtained is around 555 nm. The spectral luminous efficacy K at the wavelength of 555 nm is the maximum spectral luminous efficacy $K_m$ = 683 [lm/W]. The graph of FIG. 32 shows that the luminous efficiency function V is 0.84 at the wavelength of 528 nm. In the case where the maximum spectral luminous efficacy $K_m$ at the wavelength of 555 nm is 683 [lm/W], the spectral luminous efficacy K at the wavelength of 528 nm is 573.7 [lm/W] (683 [lm/W] $\times$ 0.84 $\approx$ 573.7 [lm/W]). Consequently, in the case where light of 5000 [lm] is radiated from the projector, the output power Pw of the light source of the projector (electromagnetic flux radiated from the light source) will be 8.7 [W] (5000 [lm] / 573.7 [lm/W] $\approx$ 8.7 [W]).

Consider the case in which the output power Pw of the light source of the projector is 8.7 [W] as described, and the polarizing element 1 having a rectangular plate shape which is 10 [mm] in length (Y direction) $\times$ 20 [mm] in width (X direction) is irradiated with light of the wavelength of 528 nm. In this case, output power Pw' per unit area at the front surface of the polarizing element 1 is Pw' [W/m$^2$] = Pw [W] / A [m$^2$] where A [m$^2$] is the area of the front surface of the polarizing element 1. In this case, it was evaluated how the temperature difference $\Delta T$ between the temperature T1 of the frontmost surface of the base part 21 and the temperature T2 at the interface between the base part 21 and the substrate 10 changed depending on the thickness TB of the base part 21. On this occasion, the thickness TB of the base part 21 was changed in a range of 0.010 to 0.255 [mm]. The relationship between the thickness TB of the base part 21 and the temperature difference $\Delta T$ is shown in Table 4. Note that PMMA was used as the material of the grid structural body 20 of the polarizing element 1. A thermal conductivity $\lambda$ of PMMA was 0.21 [W/m•K]. In addition, a calculation formula of the temperature difference $\Delta T$ is as follows:

Temperature Difference $\Delta T$ [K] = Thermal Resistance R [m$^2$•K/W] $\times$ Output Power Pw' [W/m$^2$] Per Unit Area

Herein, since the temperature difference $\Delta T$ is a relative temperature, the temperature difference $\Delta T$ [K] = the temperature difference $\Delta T$ [°C] holds. Thus, the unit of $\Delta T$ is 1 [K] = 1 [°C].

[Table 4]

[Table 4]

| | Type of polarizing element | Thickness TB of base part (≈ $D_{ALL}$) [mm] | Vertical length of polarizing element [mm] | Horizontal length of polarizing element [mm] | Thermal conductivity λ [W/m•K] | Thermal resistance R [$m^2$•K/W] | Output power Pw [W] | Temperature difference ΔT [°C] |
|---|---|---|---|---|---|---|---|---|
| Conventional Example | Film type | 0.255 | 10 | 20 | 0.21 | 6.0762 | 8.7 | 52.9 |
| Example 1 | Hybrid type | 0.150 | | | | 3.5714 | | 31.1 |
| Example 2 | Hybrid type | 0.100 | | | | 2.3810 | | 20.7 |
| Example 3 | Hybrid type | 0.090 | | | | 2.1429 | | 18.6 |
| Example 4 | Hybrid type | 0.080 | | | | 1.9048 | | 16.6 |
| Example 5 | Hybrid type | 0.050 | | | | 1.1905 | | 10.4 |
| Example 6 | Hybrid type | 0.045 | | | | 1.0714 | | 9.3 |
| Example 7 | Hybrid type | 0.040 | | | | 0.9524 | | 8.3 |
| Example 8 | Hybrid type | 0.030 | | | | 0.7143 | | 6.2 |
| Example 9 | Hybrid type | 0.020 | | | | 0.4762 | | 4.1 |
| Example 10 | Hybrid type | 0.010 | | | | 0.2381 | | 2.1 |

As shown in Table 4, in Examples 1 to 10 of the present invention, the wire grid polarizing element 1 of the hybrid type made of an inorganic material (the substrate 10) and an organic material (the grid structural body 20) was used. On the other hand, in the conventional example, a wire grid polarizing element of a film type made of an organic material was used.

Note that the thickness TB (= 0.255 mm) of the base part of the conventional example shown in Table 4 indicates "a total thickness $D_{ALL}$ of the PMMA material (see Table 2)" in the wire grid polarizing element of the film type. The conventional example shows a configuration example of the thinnest wire grid polarizing element of the film type in consideration of the thickness of films and double-faced tapes (OCA) commonly distributed. Consequently, it is considered difficult to make the total thickness $D_{ALL}$ thinner in the wire grid polarizing element of the film type configured by bonding a plurality of films or double-faced tapes together than in the conventional example shown in Table 4. In contrast, the wire grid polarizing elements 1 of the hybrid type of Examples 1 to 10 have a structure in which the grid structural body 20 made of an organic material (PMMA) is formed directly on the substrate 10 made of an inorganic material. Consequently, in Examples 1 to 10, the thickness TB of the base part 21 (≈ the total thickness $D_{ALL}$ of the PMMA material) can be made considerably thinner than in the conventional example as shown in Table 4.

As is understood from Table 4, since the thickness TB of the base part (= the total thickness $D_{ALL}$ of the PMMA material) was as thick as 0.255 [mm] in the wire grid polarizing element of the film type of the conventional example, the temperature difference $\Delta T$ between the front and rear of the base part was 52.9°C, which resultantly exceeded 50°C. In addition, since an inner space of the projector was sealed, a surrounding temperature of the wire grid polarizing element and the like installed inside the projector was more than or equal to 50°C. Further, in a case where the projector was a high-brightness model, the surrounding temperature of the wire grid polarizing element and the like was around 100°C in some cases. Consequently, in the case of the wire grid polarizing element of the film type of the conventional example, the surface temperature of the grid structural body was likely to locally exceed 150°C, which raised a problem of durability of the wire grid polarizing element.

In contrast, the wire grid polarizing elements 1 of the hybrid side according to Examples 1 to 10 of the present invention had the structure in which the base part 21 and the plurality of ridge portions 22 of the grid structural body 20 were formed directly on the substrate 10 made of an inorganic material. It is understood that since the thickness TB of the base part 21 (≈ the total thickness $D_{ALL}$ of the PMMA material) was thereby able to be made considerably thinner in Examples 1 to 10 than in the conventional example, the temperature difference $\Delta T$ was able to be reduced considerably. As a result, heat of the base part 21 of the grid structural body 20 was able to be dissipated to the outside via the substrate 10 made of an inorganic material in Examples 1 to 10, which verified that the polarizing elements 1 were excellent in heat dissipation and durability.

Herein, it is understood that by making the thickness TB of the base part 21 less than or equal to 0.15 [mm] in Examples 1 to 10, the temperature difference $\Delta T$ was able to be controlled to be less than or equal to 32°C and was able to be reduced by as much as more than or equal to about 40% as compared with the temperature difference $\Delta T$ = 52.9°C in the conventional example. Thus, it was verified that making the thickness TB of the base part 21 less than or equal to 0.15 [mm] allowed heat of the grid structural body 20 to be conveyed quickly to the substrate 10 and to be released efficiently from the substrate 10 to the outside to achieve heat dissipation.

It is further understood that in Examples 3 to 10, by making the thickness TB of the base part 21 less than or equal to 0.09 [mm], the temperature difference $\Delta T$ was able to be controlled to be less than or equal to 20°C and was able to be reduced by as much as more than or equal to about 65% as compared with the temperature difference $\Delta T$ = 52.9°C in the conventional example. Thus, making the thickness TB of the base part 21 less than or equal to 0.09 [mm] allowed heat of the grid structural body 20 to be conveyed quickly to the substrate 10 and to be released efficiently from the substrate 10 to the outside to achieve heat dissipation. Thus, it was verified that the reliability of heat dissipation of the wire grid polarizing element 1 was able to be improved further.

Particularly by making the thickness TB of the base part 21 less than or equal to 0.045 [mm], the temperature difference $\Delta T$ was able to be controlled to be less than or equal to 10°C and was able to be reduced by as much as more than or equal to about 80% as compared with the temperature difference $\Delta T$ = 52.9°C in the conventional example. Thus, it is understood that from the viewpoint of improving the reliability of heat dissipation, it is more preferable that the thickness TB of the base part 21 should be less than or equal to 0.045 [mm]. In addition, by making the thickness TB of the base part 21 less than or equal to 0.02 [mm], the temperature difference $\Delta T$ was able to be controlled to be less than or equal to 5°C and was able to be reduced by as much as more than or equal to about 90% as compared with the temperature difference $\Delta T$ = 52.9°C in the conventional example. Thus, it is understood that from the viewpoint of improving the reliability of heat dissipation, it is still more preferable that the thickness TB of the base part 21 should be less than or equal to 0.002 [mm].

In this manner, it was verified that in order to improve the heat dissipation and durability of the polarizing element 1, the thickness TB of the base part 21 preferably was less than or equal to 0.09 [mm], more preferably was less than or equal to 0.045 [mm], and particularly preferably was less than or equal to 0.02 [mm].

Note that although PMMA was used as the material of the grid structural body 20 in the example described above, the material of the grid structural body of the present invention is not limited to such an example, and various organic materials other than PMMA may be used.

<3. Result of Inspection of Composition of Organic Material (Light Curing Acrylic Resin for Imprinting)>

As the light curing acrylic resin for imprinting, Examples 31 to 38 and Comparative Examples 1 to 9 were created.

The viscosities of the light curing acrylic resins for imprinting according to Examples 31 to 38 and Comparative Examples 1 to 9 were measured. The viscosities were measured using a cone plate in the Brookfield Viscometer made by EKO INSTRUMENTS CO.,LTD.

The YI values after cured products of the light curing acrylic resins for imprinting according to Examples 31 to 38 and Comparative Examples 1 to 9 were held at 120°C for 500 hours (heating treatment) were measured. The YI values were calculated based on a measurement result obtained using the spectrophotometer V-770 made by JASCO Corporation. Measurement conditions when calculating the YI values and the method for calculating the YI values were similar to those in the above-described embodiment.

The average transmittances of the cured products of the light curing acrylic resins for imprinting according to Examples 31 to 38 and Comparative Examples 1 to 9 for light in the wavelength range of more than or equal to 430 nm and less than or equal to 680 nm and the average transmittances of the cured products for light in the wavelength range of more than or equal to 430 nm and less than or equal to 510 nm before heating treatment (holding at 120°C for 500 hours) was performed on the cured products were measured. In addition, after the cured products of the light curing acrylic resins for imprinting according to Examples 3 to 38 and Comparative Examples 1 to 9 were held at 120°C for 500 hours, the average transmittances of the cured products for light in the wavelength range of more than or equal to 430 nm and less than or equal to 680 nm and the average transmittances of the cured products for light in the wavelength range of more than or equal to 430 nm and less than or equal to 510 nm were measured. The average transmittances were calculated by measuring the transmittance every 1 nm in the wavelength range of more than or equal to 430 nm and less than or equal to 680 nm and simply averaging 251 pieces of measurement data as obtained. The average transmittances were measured using the spectrophotometer V-770 made by JASCO Corporation.

The storage elastic moduli at 30°C, the storage elastic moduli at 120°C, the storage elastic moduli at 130°C, and the storage elastic moduli at 140°C of the cured products of the light curing acrylic resins for imprinting according to Examples 31 to 38 and Comparative Examples 1 to 9 were measured. The storage elastic moduli were measured using DMA7100 made by Hitachi High-Tech Corporation. The storage elastic moduli at 25°C to 300°C were measured by cutting sheets of the cured products of the light curing acrylic resins for imprinting according to Examples 31 to 38 and Comparative Examples 1 to 9 into 20 mm in length and 3 mm in width and raising the temperature at 5°C/min in the tensile mode at a certain frequency (1 Hz).

The glass transition temperatures Tg of the cured products of the light curing acrylic resins for imprinting according to Examples 31 to 38 and Comparative Examples 1 to 9 were measured. The glass transition temperatures Tg were measured using DMA7100 made by Hitachi High-Tech Corporation. The glass transition temperatures Tg were measured by cutting sheets of the cured products of the light curing acrylic resins for imprinting according to Examples 31 to 38 and Comparative Examples 1 to 9 into 20 mm in length and 3 mm in width, raising the temperature at 5°C/min in the tensile mode at a certain frequency (1 Hz), and confirming the maximum values of the loss tangents tan$\delta$ at 25°C to 300°C.

Compositions and viscosities of the light curing acrylic resins for imprinting of Examples 31 to 34 are shown in Table 5 below. The YI values, average transmittances, storage elastic moduli, and the glass transition temperatures Tg of the cured products of the light curing acrylic resins for imprinting according to Examples 31 to 34 are shown in Table 6 below.

Compositions and viscosities of the light curing acrylic resins for imprinting of Examples 35 to 38 are shown in Table 7 below. The YI values, average transmittances, storage elastic moduli, and the glass transition temperatures Tg of the cured products of the light curing acrylic resins for imprinting according to Examples 35 to 38 are shown in Table 8 below.

Compositions and viscosities of the light curing acrylic resins for imprinting of Comparative Examples 1 to 3 are shown in Table 9 below. The YI values, average transmittances, storage elastic moduli, and the glass transition temperatures Tg of the cured products of the light curing acrylic resins for imprinting according to Comparative Examples 1 to 3 are shown in Table 10 below.

Compositions and viscosities of the light curing acrylic resins for imprinting of Comparative Examples 4 to 6 are shown in Table 11 below. The YI values, average transmittances, storage elastic moduli, and the glass transition temperatures Tg of the cured products of the light curing acrylic resins for imprinting according to Comparative Examples 4 to 6 are shown in Table 12 below.

Compositions and viscosities of the light curing acrylic resins for imprinting of Comparative Examples 7 to 9 are shown in Table 13 below. The YI values, average transmittances, storage elastic moduli, and the glass transition temperatures Tg of the cured products of the light curing acrylic resins for imprinting according to Comparative Examples 7 to 9 are shown in Table 14 below.

Note that the unit of content in Table 5, Table 7, Table 9, Table 11, and Table 13 is mass %. In addition, the viscosities in Table 5, Table 7, Table 9, Table 11, and Table 13 are the viscosities [mPa•s] at 25°C.

[Table 5]

[Table 5]

| | Material | The number of functional groups | | Example 31 | Example 32 | Example 33 | Example 34 |
|---|---|---|---|---|---|---|---|
| Photopolymerization component [mass %] | R-684 | 2 | Resin (A) | 30 | 40 | 20 | 40 |
| | HDDA | 2 | Resin (B) | 20 | 30 | 40 | 30 |
| | NDDA | 2 | Resin (B) | - | - | - | - |
| | IBOA | 1 | Resin (C) | 30 | 29 | 30 | 30 |
| | DPHA | 3 or more | Resin (D) | 20 | 1 | 10 | - |
| | M9050 | 3 or more | Resin (D) | - | - | - | - |
| | TMPTA | 3 | Resin (D) | - | - | - | - |
| Resin (A) + Resin (B) [mass %] | | | | 50 | 70 | 60 | 70 |
| Resin (B) + Resin (C) [mass %] | | | | 50 | 59 | 70 | 60 |
| Total of Resins (D) [mass %] | | | | 20 | 1 | 10 | 0 |
| Viscosity of light curing acrylic resin for imprinting [mPa•s] @25°C | | | | 34.4 | 17.4 | 19.13 | 15.07 |

[Table 6]

[Table 6]

| | | Example 31 | Example 32 | Example 33 | Example 34 |
|---|---|---|---|---|---|
| YI | | 2.4 | 1.9 | 1.5 | 1.3 |
| Average transmittance (430 nm - 680 nm) [%] | Before heating | 92.2 | 91.5 | 92.5 | 91.4 |
| Average transmittance (430 nm - 510 nm) [%] | Before heating | 91.9 | 91.1 | 91.7 | 90.5 |
| Average transmittance (430 nm - 680 nm) [%] | After heating | 91.7 | 91.4 | 92.4 | 91.8 |
| Average transmittance (430 nm - 510 nm) [%] | After heating | 90.7 | 90.5 | 91.8 | 91.2 |
| Average transmittance (430 nm - 680 nm) [%] | ΔA | -0.5 | -0.1 | -0.1 | 0.3 |
| Average transmittance (430 nm - 510 nm) [%] | ΔA | -1.2 | -0.6 | 0.1 | 0.7 |

(continued)

| | | Example 31 | Example 32 | Example 33 | Example 34 |
|---|---|---|---|---|---|
| Storage elastic modulus [Pa] | 30°C | 1.6.E+09 | 2.0.E+09 | 2.1.E+09 | 2.2.E+09 |
| | 120°C | 6.5.E+08 | 6.2.E+08 | 7.1.E+08 | 3.9.E+08 |
| | 130°C | 5.7.E+08 | 5.6.E+08 | 5.9.E+08 | 3.1.E+08 |
| | 140°C | 5.0.E+08 | 5.0.E+08 | 5.0.E+08 | 2.6.E+08 |
| Change of storage elastic modulus | 120°C | 41.6% | 30.9% | 33.4% | 17.8% |
| | 130°C | 36.4% | 27.6% | 27.8% | 14.0% |
| | 140°C | 31.8% | 25.0% | 23.5% | 11.9% |
| Tg [°C] | | 142.6 | 174.2 | 126.1 | 115.5 |

[Example 31]

As shown in Table 5, Example 31 contained only the resin (A), the resin (B), the resin (C), and the resin (D) as the photopolymerization component and further contained a photopolymerization initiator. As the resin (A), "KAYARAD R-684" made by Nippon Kayaku Co.,Ltd. was used. As the resin (B), 1,6-hexanediol diacrylate (HDDA) was used. As the resin (C), isobornyl acrylate (IBOA) was used. As isobornyl acrylate, "IBOA-B" made by DAICEL-ALLNEX LTD. was used. As the resin (D), dipentaerythritol hexaacrylate (DPHA) was used. As the photopolymerization initiator, "Irgacure 819" made by IGM Resins B.V. was used. In addition, in Example 31, the content of the resin (A) in the whole of the photopolymerization component was 30 mass %, the content of the resin (B) was 20 mass %, the content of the resin (C) was 30 mass %, and the content of the resin (D) was 20 mass %. In other words, in Example 31, the total content of the resin (A) and the resin (B) in the whole of the photopolymerization component was 50 mass %, and the total content of the resin (B) and the resin (C) was 50%. In addition, in Example 31, the content of the photopolymerization initiator was 1 mass % when the entire content of the photopolymerization component was 100 mass %.

As shown in Table 5, the viscosity of the light curing acrylic resin for imprinting of Example 31 was 34.4 mPa•s.

As shown in Table 6, the YI value of the cured product of the light curing acrylic resin for imprinting of Example 31 was 2.4. It was confirmed from the above result that a low YI value was able to be maintained even if heating treatment was performed on the cured product of Example 31.

As shown in Table 6, the average transmittance of the cured product of the light curing acrylic resin for imprinting of Example 31 for light in the wavelength range of more than or equal to 430 nm and less than or equal to 680 nm was 92.2% before heating treatment was performed, and the average transmittance for light in the wavelength range of more than or equal to 430 nm and less than or equal to 510 nm before heating treatment was performed was 91.9%. In addition, the average transmittance of the cured product of the light curing acrylic resin for imprinting of Example 31 for light in the wavelength range of more than or equal to 430 nm and less than or equal to 680 nm after heating treatment was performed was 91.7%, and the average transmittance for light in the wavelength range of more than or equal to 430 nm and less than or equal to 510 nm after heating treatment was performed was 90.7%.

A difference ΔA in average transmittance of the cured product of Example 31 for light in the wavelength range of more than or equal to 430 nm and less than or equal to 680 nm before and after heating treatment was performed (average transmittance before heating treatment - average transmittance after heating treatment) was -0.5%. The difference ΔA in average transmittance of the cured product of Example 31 for light in the wavelength range of more than or equal to 430 nm and less than or equal to 510 nm before and after heating treatment was performed was -1.2%. It was confirmed from the above result that even if heating treatment was performed on the cured product of Example 31, the average transmittance for light in the wavelength range of more than or equal to 430 nm and less than or equal to 680 nm and the average transmittance for light in the wavelength range of more than or equal to 430 nm and less than or equal to 510 nm hardly decreased.

As shown in Table 6, the storage elastic modulus at 30°C of the cured product of the light curing acrylic resin for imprinting of Example 31 was $1.6 \times 10^9$ Pa. The storage elastic modulus at 120°C of the cured product of the light curing acrylic resin for imprinting of Example 31 was $6.5 \times 10^8$ Pa. The storage elastic modulus at 130°C of the cured product of the light curing acrylic resin for imprinting of Example 31 was $5.7 \times 10^8$ Pa. The storage elastic modulus at 140°C of the cured product of the light curing acrylic resin for imprinting of Example 31 was $5.0 \times 10^8$ Pa.

The rate of change of the storage elastic modulus at 120°C of the cured product of Example 31 with respect to the storage elastic modulus at 30°C (the storage elastic modulus at 120°C / the storage elastic modulus at 30°C × 100%) was 41.6%. The rate of change of the storage elastic modulus at 130°C of the cured product of Example 31 with respect to the storage elastic modulus at 30°C (the storage elastic modulus at 130°C / the storage elastic modulus at 30°C × 100%) was

36.4%. The rate of change of the storage elastic modulus at 140°C of the cured product of Example 31 with respect to the storage elastic modulus at 30°C (the storage elastic modulus at 140°C / the storage elastic modulus at 30°C $\times$ 100%) was 31.8%. It was confirmed from the above result that the cured product of Example 31 had a storage elastic modulus as high as 1.6 $\times$ $10^9$ Pa before heating treatment was performed. It was also confirmed that the storage elastic modulus was restrained from decreasing even if heating treatment was performed on the cured product of Example 31.

As shown in Table 6, the glass transition temperature Tg of the cured product of the light curing acrylic resin for imprinting of Example 31 was 142.6°C. It was confirmed from the above result that the cured product of Example 31 had a high glass transition temperature Tg.

[Example 32]

As shown in Table 5, Example 32 contained only the resin (A), the resin (B), the resin (C), and the resin (D) as the photopolymerization component and further contained a photopolymerization initiator. The resin (A), the resin (B), the resin (C), the resin (D), and the photopolymerization initiator were identical to those of Example 31. In Example 32, the content of the resin (A) in the whole of the photopolymerization component was 40 mass %, the content of the resin (B) was 30 mass %, the content of the resin (C) was 29 mass %, and the content of the resin (D) was 1 mass %. In other words, in Example 32, the total content of the resin (A) and the resin (B) in the whole of the photopolymerization component was 70 mass %, and the total content of the resin (B) and the resin (C) was 59%. In addition, in Example 32, the content of the photopolymerization initiator was 1 mass % when the entire content of the photopolymerization component was 100 mass %. In other words, Example 32 was different from Example 31 only in terms of the contents of the resin (A) to the resin (D).

As shown in Table 5, the viscosity of the light curing acrylic resin for imprinting of Example 32 was 17.4 mPa•s. The light curing acrylic resin for imprinting of Example 32 had a higher total content of the resin (B) and the resin (C) and a lower content of the resin (D) as compared with the light curing acrylic resin for imprinting of Example 31. It is assumed that this made the viscosity of the light curing acrylic resin for imprinting of Example 32 lower than the viscosity of the light curing acrylic resin for imprinting of Example 31.

As shown in Table 6, the YI value of the cured product of the light curing acrylic resin for imprinting of Example 32 was 1.9. It was confirmed from the above result that a low YI value was able to be maintained even if heating treatment was performed on the cured product of Example 32. The light curing acrylic resin for imprinting of Example 32 had a higher total content of the resin (A) and the resin (B) as compared with the light curing acrylic resin for imprinting of Example 31. It is assumed that this made the YI value of the cured product of the light curing acrylic resin for imprinting of Example 32 lower than the YI value of the cured product of the light curing acrylic resin for imprinting of Example 31.

As shown in Table 6, the average transmittance of the cured product of the light curing acrylic resin for imprinting of Example 32 for light in the wavelength range of more than or equal to 430 nm and less than or equal to 680 nm before heating treatment was performed was 91.5%, and the average transmittance for light in the wavelength range of more than or equal to 430 nm and less than or equal to 510 nm before heating treatment was performed was 91.1%. In addition, the average transmittance of the cured product of the light curing acrylic resin for imprinting of Example 32 for light in the wavelength range of more than or equal to 430 nm and less than or equal to 680 nm after heating treatment was performed was 91.4%, and the average transmittance for light in the wavelength range of more than or equal to 430 nm and less than or equal to 510 nm after heating treatment was performed was 90.5%.

The difference $\Delta$A in average transmittance of the cured product of Example 32 for light in the wavelength range of more than or equal to 430 nm and less than or equal to 680 nm before and after heating treatment was performed (average transmittance before heating treatment - average transmittance after heating treatment) was -0.1%. The difference $\Delta$A in average transmittance of the cured product of Example 32 for light in the wavelength range of more than or equal to 430 nm and less than or equal to 510 nm before and after heating treatment was performed -0.6%. It was confirmed from the above result that the average transmittance for light in the wavelength range of more than or equal to 430 nm and less than or equal to 680 nm and the average transmittance for light in the wavelength range of more than or equal to 430 nm and less than or equal to 510 nm hardly decreased even if heating treatment was performed on the cured product of Example 32. The light curing acrylic resin for imprinting of Example 32 had a higher total content of the resin (A) and the resin (B) as compared with the light curing acrylic resin for imprinting of Example 31. It is assumed that this made the difference $\Delta$A in average transmittance of the cured product of the light curing acrylic resin for imprinting of Example 32 smaller than the difference $\Delta$A in average transmittance of the cured product of the light curing acrylic resin for imprinting of Example 31.

As shown in Table 6, the storage elastic modulus at 30°C of the cured product of the light curing acrylic resin for imprinting of Example 32 was 2.0 $\times$ $10^9$ Pa. The storage elastic modulus at 120°C of the cured product of the light curing acrylic resin for imprinting of Example 32 was 6.2 $\times$ $10^8$ Pa. The storage elastic modulus at 130°C of the cured product of the light curing acrylic resin for imprinting of Example 32 was 5.6 $\times$ $10^8$ Pa. The storage elastic modulus at 140°C of the cured product of the light curing acrylic resin for imprinting of Example 32 was 5.0 $\times$ $10^8$ Pa.

The rate of change of the storage elastic modulus at 120°C of the cured product of Example 32 with respect to the

storage elastic modulus at 30°C (the storage elastic modulus at 120°C / the storage elastic modulus at 30°C × 100%) was 30.9%. The rate of change of the storage elastic modulus at 130°C of the cured product of Example 32 with respect to the storage elastic modulus at 30°C (the storage elastic modulus at 130°C / the storage elastic modulus at 30°C × 100%) was 27.6%. The rate of change of the storage elastic modulus at 140°C of the cured product of Example 32 with respect to the storage elastic modulus at 30°C (the storage elastic modulus at 140°C / the storage elastic modulus at 30°C × 100%) was 25.0%. It was confirmed from the above result that the cured product of Example 32 had a storage elastic modulus as high as $2.0 \times 10^9$ Pa before heating treatment was performed. It was also confirmed that the storage elastic modulus was restrained from decreasing even if heating treatment was performed on the cured product of Example 32.

As shown in Table 6, the glass transition temperature Tg of the cured product of the light curing acrylic resin for imprinting of Example 32 was 174.2°C. It was confirmed from the above result that the cured product of Example 32 had a high glass transition temperature Tg.

[Example 33]

As shown in Table 5, Example 33 contained only the resin (A), the resin (B), the resin (C), and the resin (D) as the photopolymerization component and further contained a photopolymerization initiator. The resin (A), the resin (B), the resin (C), the resin (D), and the photopolymerization initiator were identical to those of Example 31. In Example 33, the content of the resin (A) in the whole of the photopolymerization component was 20 mass %, the content of the resin (B) was 40 mass %, the content of the resin (C) was 30 mass %, and the content of the resin (D) was 10 mass %. In other words, in Example 33, the total content of the resin (A) and the resin (B) in the whole of the photopolymerization component was 60 mass %, and the total content of the resin (B) and the resin (C) was 70%. In addition, in Example 33, the content of the photopolymerization initiator was 1 mass % when the entire content of the photopolymerization component was 100 mass %. In other words, Example 33 was different from Example 31 only in terms of the contents of the resin (A) to the resin (D) .

As shown in Table 5, the viscosity of the light curing acrylic resin for imprinting of Example 33 was 19.13 mPa•s. The light curing acrylic resin for imprinting of Example 33 had a higher total content of the resin (B) and the resin (C) and a lower content of the resin (D) as compared with the light curing acrylic resin for imprinting of Example 31. It is assumed that this made the viscosity of the light curing acrylic resin for imprinting of Example 33 lower than the viscosity of the light curing acrylic resin for imprinting of Example 31.

As shown in Table 6, the YI value of the cured product of the light curing acrylic resin for imprinting of Example 33 was 1.5. It was confirmed from the above result that a low YI value was able to be maintained even if heating treatment was performed on the cured product of Example 33. The light curing acrylic resin for imprinting of Example 33 had a higher total content of the resin (A) and the resin (B) as compared with the light curing acrylic resin for imprinting of Example 31. It is assumed that this made the YI value of the cured product of the light curing acrylic resin for imprinting of Example 33 lower than the YI value of the cured product of the light curing acrylic resin for imprinting of Example 31.

As shown in Table 6, the average transmittance of the cured product of the light curing acrylic resin for imprinting of Example 33 for light in the wavelength range of more than or equal to 430 nm and less than or equal to 680 nm before heating treatment was performed was 92.5%, and the average transmittance for light in the wavelength range of more than or equal to 430 nm and less than or equal to 510 nm before heating treatment was performed was 91.7%. In addition, the average transmittance of the cured product of the light curing acrylic resin for imprinting of Example 33 for light in the wavelength range of more than or equal to 430 nm and less than or equal to 680 nm after heating treatment was performed was 92.4%, and the average transmittance for light in the wavelength range of more than or equal to 430 nm and less than or equal to 510 nm after heating treatment was performed was 91.8%.

The difference ΔA in average transmittance of the cured product of Example 33 for light in the wavelength range of more than or equal to 430 nm and less than or equal to 680 nm before and after heating treatment was performed (average transmittance before heating treatment - average transmittance after heating treatment) was -0.1%. The difference ΔA in average transmittance of the cured product of Example 33 for light in the wavelength range of more than or equal to 430 nm and less than or equal to 510 nm before and after heating treatment was performed was +0.1%. It was confirmed from the above result that the average transmittance for light in the wavelength range of more than or equal to 430 nm and less than or equal to 680 nm and the average transmittance for light in the wavelength range of more than or equal to 430 nm and less than or equal to 510 nm hardly decreased even if heating treatment was performed on the cured product of Example 33. The light curing acrylic resin for imprinting of Example 33 had a higher total content of the resin (A) and the resin (B) as compared with the light curing acrylic resin for imprinting of Example 31. It is assumed that this made the difference ΔA in average transmittance of the cured product of the light curing acrylic resin for imprinting of Example 33 smaller than the difference ΔA in average transmittance of the cured product of the light curing acrylic resin for imprinting of Example 31.

As shown in Table 6, the storage elastic modulus at 30°C of the cured product of the light curing acrylic resin for imprinting of Example 33 was $2.1 \times 10^9$ Pa. The storage elastic modulus at 120°C of the cured product of the light curing acrylic resin for imprinting of Example 33 was $7.1 \times 10^8$ Pa. The storage elastic modulus at 130°C of the cured product of the light curing acrylic resin for imprinting of Example 33 was $5.9 \times 10^8$ Pa. The storage elastic modulus at 140°C of the

cured product of the light curing acrylic resin for imprinting of Example 33 was 5.0 $\times$ $10^8$ Pa.

The rate of change of the storage elastic modulus at 120°C of the cured product of Example 33 with respect to the storage elastic modulus at 30°C (the storage elastic modulus at 120°C / the storage elastic modulus at 30°C $\times$ 100%) was 33.4%. The rate of change of the storage elastic modulus at 130°C of the cured product of Example 33 with respect to the storage elastic modulus at 30°C (the storage elastic modulus at 130°C / the storage elastic modulus at 30°C $\times$ 100%) was 27.8%. The rate of change of the storage elastic modulus at 140°C of the cured product of Example 33 with respect to the storage elastic modulus at 30°C (the storage elastic modulus at 140°C / the storage elastic modulus at 30°C $\times$ 100%) was 23.5%. It was confirmed from the above result that the cured product of Example 33 had a storage elastic modulus as high as 2.1 $\times$ $10^9$ Pa before heating treatment was performed. It was also confirmed that the storage elastic modulus was restrained from decreasing even if heating treatment was performed on the cured product of Example 33.

As shown in Table 6, the glass transition temperature Tg of the cured product of the light curing acrylic resin for imprinting of Example 33 was 126.1°C. It was confirmed from the above result that the cured product of Example 33 had a high glass transition temperature Tg.

[Example 34]

As shown in Table 5, Example 34 contained only the resin (A), the resin (B), and the resin (C) as the photopolymerization component and further contained a photopolymerization initiator. The resin (A), the resin (B), the resin (C), and the photopolymerization initiator were identical to those of Example 31. In Example 34, the content of the resin (A) in the whole of the photopolymerization component was 40 mass %, the content of the resin (B) was 30 mass %, and the content of the resin (C) was 30 mass %. In other words, in Example 34, the total content of the resin (A) and the resin (B) in the whole of the photopolymerization component was 70 mass %, and the total content of the resin (B) and the resin (C) was 60%. In addition, in Example 34, the content of the photopolymerization initiator was 1 mass % when the entire content of the photopolymerization component was 100 mass %. In other words, unlike Examples 31 to 33, Example 34 did not contain the resin (D).

As shown in Table 5, the viscosity of the light curing acrylic resin for imprinting of Example 34 was 15.07 mPa•s. The light curing acrylic resin for imprinting of Example 34 did not contain the resin (D) as compared with the light curing acrylic resins for imprinting of Examples 31 to 33. It is assumed that this made the viscosity of the light curing acrylic resin for imprinting of Example 34 lower than the viscosities of the light curing acrylic resins for imprinting of Examples 31 to 33.

As shown in Table 6, the YI value of the cured product of the light curing acrylic resin for imprinting of Example 34 was 1.3. It was confirmed from the above result that a low YI value was able to be maintained even if heating treatment was performed on the cured product of Example 34. The light curing acrylic resin for imprinting of Example 34 had a higher total content of the resin (A) and the resin (B) as compared with the light curing acrylic resin for imprinting of Example 31. It is assumed that this made the YI value of the cured product of the light curing acrylic resin for imprinting of Example 34 lower than the YI value of the cured product of the light curing acrylic resin for imprinting of Example 31.

As shown in Table 6, the average transmittance of the cured product of the light curing acrylic resin for imprinting of Example 34 for light in the wavelength range of more than or equal to 430 nm and less than or equal to 680 nm before heating treatment was performed was 91.4%, and the average transmittance for light in the wavelength range of more than or equal to 430 nm and less than or equal to 510 nm before heating treatment was performed was 90.5%. In addition, the average transmittance of the cured product of the light curing acrylic resin for imprinting of Example 34 for light in the wavelength range of more than or equal to 430 nm and less than or equal to 680 nm after heating treatment was performed was 91.8%, and the average transmittance for light in the wavelength range of more than or equal to 430 nm and less than or equal to 510 nm after heating treatment was performed was 91.2%.

The difference $\Delta$A in average transmittance of the cured product of Example 34 for light in the wavelength range of more than or equal to 430 nm and less than or equal to 680 nm before and after heating treatment was performed (average transmittance before heating treatment - average transmittance after heating treatment) was +0.3%. The difference $\Delta$A in average transmittance of the cured product of Example 34 for light in the wavelength range of more than or equal to 430 nm and less than or equal to 510 nm before and after heating treatment was performed was +0.7%. It was confirmed from the above result that the average transmittance for light in the wavelength range of more than or equal to 430 nm and less than or equal to 680 nm and the average transmittance for light in the wavelength range of more than or equal to 430 nm and less than or equal to 510 nm hardly decreased even if heating treatment was performed on the cured product of Example 34. The light curing acrylic resin for imprinting of Example 34 had a higher total content of the resin (A) and the resin (B) as compared with the light curing acrylic resin for imprinting of Example 31. It is assumed that this made the difference $\Delta$A in average transmittance of the cured product of the light curing acrylic resin for imprinting of Example 34 smaller than the difference $\Delta$A in average transmittance of the cured product of the light curing acrylic resin for imprinting of Example 31.

As shown in Table 6, the storage elastic modulus at 30°C of the cured product of the light curing acrylic resin for imprinting of Example 34 was 2.2 $\times$ $10^9$ Pa. The storage elastic modulus at 120°C of the cured product of the light curing acrylic resin for imprinting of Example 34 was 3.9 $\times$ $10^8$ Pa. The storage elastic modulus at 130°C of the cured product of

the light curing acrylic resin for imprinting of Example 34 was 3.1 × $10^8$ Pa. The storage elastic modulus at 140°C of the cured product of the light curing acrylic resin for imprinting of Example 34 was 2.6 × $10^8$ Pa.

The rate of change of the storage elastic modulus at 120°C of the cured product of Example 34 with respect to the storage elastic modulus at 30°C (the storage elastic modulus at 120°C / the storage elastic modulus at 30°C × 100%) was 17.8%. The rate of change of the storage elastic modulus at 130°C of the cured product of Example 34 with respect to the storage elastic modulus at 30°C (the storage elastic modulus at 130°C / the storage elastic modulus at 30°C × 100%) was 14.0%. The rate of change of the storage elastic modulus at 140°C of the cured product of Example 34 with respect to the storage elastic modulus at 30°C (the storage elastic modulus at 140°C / the storage elastic modulus at 30°C × 100%) was 11.9%. It was confirmed from the above result that the cured product of Example 34 had a storage elastic modulus as high as 2.2 × $10^9$ Pa before heating treatment was performed. It was also confirmed that the storage elastic modulus was restrained from decreasing even if heating treatment was performed on the cured product of Example 34. Note that the light curing acrylic resin for imprinting of Example 34 did not contain the resin (D) as compared with the light curing acrylic resin for imprinting of Example 32. It is assumed that this made the rate of change of the storage elastic modulus of the cured product of the light curing acrylic resin for imprinting of Example 34 smaller than the rate of change of storage elastic modulus of the cured product of the light curing acrylic resin for imprinting of Example 32.

As shown in Table 6, the glass transition temperature Tg of the cured product of the light curing acrylic resin for imprinting of Example 34 was 115.5°C. It was confirmed from the above result that the cured product of Example 34 had a high glass transition temperature Tg. In addition, the light curing acrylic resin for imprinting of Example 34 did not contain the resin (D) as compared with the light curing acrylic resin for imprinting of Example 32. It is assumed that this made the glass transition temperature Tg of the cured product of the light curing acrylic resin for imprinting of Example 34 lower than the glass transition temperature Tg of the cured product of the light curing acrylic resin for imprinting of Example 32.

[Table 7]

[Table 7]

| | Material | The number of functional groups | | Example 35 | Example 36 | Example 37 | Example 38 |
|---|---|---|---|---|---|---|---|
| Photopolymerization component [mass %] | R-684 | 2 | Resin (A) | 30 | 30 | 30 | 30 |
| | HDDA | 2 | Resin (B) | 30 | 30 | 30 | - |
| | NDDA | 2 | Resin (B) | - | - | - | 30 |
| | IBOA | 1 | Resin (C) | 30 | 30 | 30 | 30 |
| | DPHA | 3 or more | Resin (D) | 10 | - | | 10 |
| | M9050 | 3 or more | Resin (D) | - | 10 | - | - |
| | TMPTA | 3 | Resin (D) | - | - | 10 | - |
| Resin (A) + Resin (B) [mass %] | | | | 60 | 60 | 60 | 60 |
| Resin (B) + Resin (C) [mass %] | | | | 60 | 60 | 60 | 60 |
| Total of Resins (D) [mass %] | | | | 10 | 10 | 10 | 10 |
| Viscosity of light curing acrylic resin for imprinting [mPa•s] @25°C | | | | 18.97 | 23.02 | 15.43 | 20.01 |

[Table 8]

[Table 8]

| | | Example 35 | Example 36 | Example 37 | Example 38 |
|---|---|---|---|---|---|
| YI | | 1.2 | 0.8 | 0.9 | 1.0 |
| Average transmittance (430 nm - 680 nm) [%] | Before heating | 91.5 | 92.2 | 92.2 | 92.3 |
| Average transmittance (430 nm - 510 nm) [%] | Before heating | 90.6 | 92.0 | 92.0 | 92.0 |
| Average transmittance (430 nm - 680 nm) [%] | After heating | 91.7 | 92.6 | 92.6 | 92.4 |
| Average transmittance (430 nm - 510 nm) [%] | After heating | 91.2 | 92.2 | 92.2 | 91.9 |
| Average transmittance (430 nm - 680 nm) [%] | ΔA | 0.2 | 0.4 | 0.3 | 0.2 |
| Average transmittance (430 nm - 510 nm) [%] | ΔA | 0.6 | 0.2 | 0.1 | -0.1 |
| Storage elastic modulus [Pa] | 30°C | 2.0.E+09 | 2.2.E+09 | 2.1.E+09 | 1.9.E+09 |
| | 120°C | 8.6.E+08 | 8.1.E+08 | 7.8.E+08 | 7.1.E+08 |
| | 130°C | 7.8.E+08 | 7.3.E+08 | 7.1.E+08 | 6.4.E+08 |
| | 140°C | 7.2.E+08 | 6.7.E+08 | 6.3.E+08 | 5.8.E+08 |
| Change of storage elastic modulus | 120°C | 43.3% | 37.1% | 37.9% | 37.4% |
| | 130°C | 39.5% | 33.6% | 34.2% | 33.5% |
| | 140°C | 36.3% | 30.8% | 30.4% | 30.3% |
| Tg [°C] | | 181.3 | 179 | 170 | 180.6 |

[Example 35]

As shown in Table 7, Example 35 contained only the resin (A), the resin (B), the resin (C), and the resin (D) as the photopolymerization component and further contained a photopolymerization initiator. The resin (A), the resin (B), the resin (C), the resin (D), and the photopolymerization initiator were identical to those of Example 31. In Example 35, the content of the resin (A) in the whole of the photopolymerization component was 30 mass %, the content of the resin (B) was 30 mass %, the content of the resin (C) was 30 mass %, and the content of the resin (D) was 10 mass %. In other words, in Example 35, the total content of the resin (A) and the resin (B) in the whole of the photopolymerization component was 60 mass %, and the total content of the resin (B) and the resin (C) was 60%. In addition, in Example 35, the content of the photopolymerization initiator was 1 mass % when the entire content of the photopolymerization component was 100 mass %. In other words, Example 35 was different from Example 31 only in terms of the contents of the resin (B) and the resin (D).

As shown in Table 7, the viscosity of the light curing acrylic resin for imprinting of Example 35 was 18.97 mPa•s. The light curing acrylic resin for imprinting of Example 35 had a higher total content of the resin (B) and the resin (C) and a lower content of the resin (D) as compared with the light curing acrylic resin for imprinting of Example 31. It is assumed that this made the viscosity of the light curing acrylic resin for imprinting of Example 35 lower than the viscosity of the light curing acrylic resin for imprinting of Example 31.

As shown in Table 8, the YI value of the cured product of the light curing acrylic resin for imprinting of Example 35 was 1.2. It was confirmed from the above result that a low YI value was able to be maintained even if heating treatment was performed on the cured product of Example 35.

As shown in Table 8, the average transmittance of the cured product of the light curing acrylic resin for imprinting of Example 35 for light in the wavelength range of more than or equal to 430 nm and less than or equal to 680 nm before heating treatment was performed was 91.5%, and the average transmittance for light in the wavelength range of more than or equal to 430 nm and less than or equal to 510 nm before heating treatment was performed was 90.6%. In addition, the

average transmittance of the cured product of the light curing acrylic resin for imprinting of Example 35 for light in the wavelength range of more than or equal to 430 nm and less than or equal to 680 nm after heating treatment was performed was 91.7%, and the average transmittance for light in the wavelength range of more than or equal to 430 nm and less than or equal to 510 nm after heating treatment was performed was 91.2%.

The difference ΔA in average transmittance of the cured product of Example 35 for light in the wavelength range of more than or equal to 430 nm and less than or equal to 680 nm before and after heating treatment was performed (average transmittance before heating treatment - average transmittance after heating treatment) was +0.2%. The difference ΔA in average transmittance of the cured product of Example 35 for light in the wavelength range of more than or equal to 430 nm and less than or equal to 510 nm before and after heating treatment was performed was +0.6%. It was confirmed from the above result that the average transmittance for light in the wavelength range of more than or equal to 430 nm and less than or equal to 680 nm and the average transmittance for light in the wavelength range of more than or equal to 430 nm and less than or equal to 510 nm hardly decreased even if heating treatment was performed on the cured product of Example 35.

As shown in Table 8, the storage elastic modulus at 30°C of the cured product of the light curing acrylic resin for imprinting of Example 35 was $2.0 \times 10^9$ Pa. The storage elastic modulus at 120°C of the cured product of the light curing acrylic resin for imprinting of Example 35 was $8.6 \times 10^8$ Pa. The storage elastic modulus at 130°C of the cured product of the light curing acrylic resin for imprinting of Example 35 was $7.8 \times 10^8$ Pa. The storage elastic modulus at 140°C of the cured product of the light curing acrylic resin for imprinting of Example 35 was $7.2 \times 10^8$ Pa.

The rate of change of the storage elastic modulus at 120°C of the cured product of Example 35 with respect to the storage elastic modulus at 30°C (the storage elastic modulus at 120°C / the storage elastic modulus at 30°C × 100%) was 43.3%. The rate of change of the storage elastic modulus at 130°C of the cured product of Example 35 with respect to the storage elastic modulus at 30°C (the storage elastic modulus at 130°C / the storage elastic modulus at 30°C × 100%) was 39.5%. The rate of change of the storage elastic modulus at 140°C of the cured product of Example 35 with respect to the storage elastic modulus at 30°C (the storage elastic modulus at 140°C / the storage elastic modulus at 30°C × 100%) was 36.3%. It was confirmed from the above result that the cured product of Example 35 had a storage elastic modulus as high as $2.0 \times 10^9$ Pa before heating treatment was performed. It was also confirmed that the storage elastic modulus was restrained from decreasing even if heating treatment was performed on the cured product of Example 35.

As shown in Table 8, the glass transition temperature Tg of the cured product of the light curing acrylic resin for imprinting of Example 35 was 181.3°C. It was confirmed from the above result that the cured product of Example 35 had a high glass transition temperature Tg.

[Example 36]

As shown in Table 7, Example 36 contained only the resin (A), the resin (B), the resin (C), and the resin (D) as the photopolymerization component and further contained a photopolymerization initiator. The resin (A), the resin (B), the resin (C), and the photopolymerization initiator were identical to those of Example 35. In Example 36, M-9050 made by TOAGOSEI CO., LTD. was used as the resin (D). In Example 36, the contents of the resin (A), the resin (B), the resin (C), and the resin (D) in the whole of the photopolymerization component were identical to those of Example 35. In addition, in Example 36, the content of the photopolymerization initiator was 1 mass % when the entire content of the photopolymerization component was 100 mass %. In other words, Example 36 was different from Example 35 only in terms of the resin (D).

As shown in Table 7, the viscosity of the light curing acrylic resin for imprinting of Example 36 was 23.02 mPa•s. The viscosity of the resin (D) of Example 36 was higher than the viscosity of the resin (D) of Example 35. It is assumed that this made the viscosity of the light curing acrylic resin for imprinting of Example 36 higher than the viscosity of the light curing acrylic resin for imprinting of Example 35.

As shown in Table 8, the YI value of the cured product of the light curing acrylic resin for imprinting of Example 36 was 0.8. It was confirmed from the above result that a low YI value was able to be maintained even if heating treatment was performed on the cured product of Example 36. It was also found that since there was little difference between the YI values of the cured product of Example 35 and the cured product of Example 36, the cured product of the light curing acrylic resin for imprinting was able to maintain a low YI value even if the resin (D) was a different material.

As shown in Table 8, the average transmittance of the cured product of the light curing acrylic resin for imprinting of Example 36 for light in the wavelength range of more than or equal to 430 nm and less than or equal to 680 nm before heating treatment was performed was 92.2%, and the average transmittance for light in the wavelength range of more than or equal to 430 nm and less than or equal to 510 nm before heating treatment was performed was 92.0%. In addition, the average transmittance of the cured product of the light curing acrylic resin for imprinting of Example 36 for light in the wavelength range of more than or equal to 430 nm and less than or equal to 680 nm after heating treatment was performed was 92.6%, and the average transmittance for light in the wavelength range of more than or equal to 430 nm and less than or equal to 510 nm after heating treatment was performed was 92.2%. It was found that since there was little difference between the average transmittances of the cured product of Example 35 and the cured product of Example 36, the cured

product of the light curing acrylic resin for imprinting was able to maintain a high average transmittance even if the resin (D) was a different material.

The difference ΔA in average transmittance of the cured product of Example 36 for light in the wavelength range of more than or equal to 430 nm and less than or equal to 680 nm before and after heating treatment was performed (average transmittance before heating treatment - average transmittance after heating treatment) was +0.4%. The difference ΔA in average transmittance of the cured product of Example 36 for light in the wavelength range of more than or equal to 430 nm and less than or equal to 510 nm before and after heating treatment was performed was +0.2%. It was confirmed from the above result that the average transmittance for light in the wavelength range of more than or equal to 430 nm and less than or equal to 680 nm and the average transmittance for light in the wavelength range of more than or equal to 430 nm and less than or equal to 510 nm hardly decreased even if heating treatment was performed on the cured product of Example 36. It was also found that since there was little difference between the differences ΔA in average transmittance of the cured product of Example 35 and the cured product of Example 36, the average transmittance hardly decreased in the cured product of the light curing acrylic resin for imprinting even if the resin (D) was a different material and even if heating treatment was performed.

As shown in Table 8, the storage elastic modulus at 30°C of the cured product of the light curing acrylic resin for imprinting of Example 36 was $2.2 \times 10^9$ Pa. The storage elastic modulus at 120°C of the cured product of the light curing acrylic resin for imprinting of Example 36 was $8.1 \times 10^8$ Pa. The storage elastic modulus at 130°C of the cured product of the light curing acrylic resin for imprinting of Example 36 was $7.3 \times 10^8$ Pa. The storage elastic modulus at 140°C of the cured product of the light curing acrylic resin for imprinting of Example 36 was $6.7 \times 10^8$ Pa. It was found that since there was little difference between the storage elastic moduli of the cured product of Example 35 and the cured product of Example 36, the cured product of the light curing acrylic resin for imprinting had a high storage elastic modulus even if the resin (D) was a different material.

The rate of change of the storage elastic modulus at 120°C of the cured product of Example 36 with respect to the storage elastic modulus at 30°C (the storage elastic modulus at 120°C / the storage elastic modulus at 30°C × 100%) was 37.1%. The rate of change of the storage elastic modulus at 130°C of the cured product of Example 36 with respect to the storage elastic modulus at 30°C (the storage elastic modulus at 130°C / the storage elastic modulus at 30°C × 100%) was 33.6%. The rate of change of the storage elastic modulus at 140°C of the cured product of Example 36 with respect to the storage elastic modulus at 30°C (the storage elastic modulus at 140°C / the storage elastic modulus at 30°C × 100%) was 30.8%. It was confirmed from the above result that the cured product of Example 36 had a storage elastic modulus as high as $2.2 \times 10^9$ Pa before heating treatment was performed. It was also confirmed that the storage elastic modulus was restrained from decreasing even if heating treatment was performed on the cured product of Example 36. It was also found that since there was little difference between the rates of change of the storage elastic modulus of the cured product of Example 35 and the cured product of Example 36, the storage elastic modulus was restrained from decreasing in the cured product of the light curing acrylic resin for imprinting even if the resin (D) was a different material and even if heating treatment was performed.

As shown in Table 8, the glass transition temperature Tg of the cured product of the light curing acrylic resin for imprinting of Example 36 was 179°C. It was confirmed from the above result that the cured product of Example 36 had a high glass transition temperature Tg. It was also found that since there was little difference between the glass transition temperatures Tg of the cured product of Example 35 and the cured product of Example 36, the cured product of the light curing acrylic resin for imprinting had a high glass transition temperature Tg even if the resin (D) was a different material.

[Example 37]

As shown in Table 7, Example 37 contained only the resin (A), the resin (B), the resin (C), and the resin (D) as the photopolymerization component and further contained a photopolymerization initiator. The resin (A), the resin (B), the resin (C), and the photopolymerization initiator were identical to those of Example 35. In Example 37, trimethylolpropane triacrylate (TMPTA) was used as the resin (D). In Example 37, the contents of the resin (A), the resin (B), the resin (C), and the resin (D) in the whole of the photopolymerization component were identical to those of Example 35. In addition, in Example 37, the content of the photopolymerization initiator was 1 mass % when the entire content of the photopolymerization component was 100 mass %. In other words, Example 37 was different from Example 35 only in terms of the resin (D).

As shown in Table 7, the viscosity of the light curing acrylic resin for imprinting of Example 37 was 15.43 mPa•s. The viscosity of the resin (D) of Example 37 was lower than the viscosity of the resin (D) of Example 35. It is assumed that this made the viscosity of the light curing acrylic resin for imprinting of Example 37 lower than the viscosity of the light curing acrylic resin for imprinting of Example 35.

As shown in Table 8, the YI value of the cured product of the light curing acrylic resin for imprinting of Example 37 was 0.9. It was confirmed from the above result that a low YI value was able to be maintained even if heating treatment was performed on the cured product of Example 37. It was also found that since there was little difference between the YI values

of the cured product of Example 35 and the cured product of Example 37, the cured product of the light curing acrylic resin for imprinting was able to maintain a low YI value even if the resin (D) was a different material.

As shown in Table 8, the average transmittance of the cured product of the light curing acrylic resin for imprinting of Example 37 for light in the wavelength range of more than or equal to 430 nm and less than or equal to 680 nm before heating treatment was performed was 92.2%, and the average transmittance for light in the wavelength range of more than or equal to 430 nm and less than or equal to 510 nm before heating treatment was performed was 92.0%. In addition, the average transmittance of the cured product of the light curing acrylic resin for imprinting of Example 37 for light in the wavelength range of more than or equal to 430 nm and less than or equal to 680 nm after heating treatment was performed was 92.6%, and the average transmittance for light in the wavelength range of more than or equal to 430 nm and less than or equal to 510 nm after heating treatment was performed was 92.2%. It was found that since there was little difference between the average transmittances of the cured product of Example 35 and the cured product of Example 37, the cured product of the light curing acrylic resin for imprinting was able to maintain a high average transmittance even if the resin (D) was a different material.

The difference ΔA in average transmittance of the cured product of Example 37 for light in the wavelength range of more than or equal to 430 nm and less than or equal to 680 nm before and after heating treatment was performed (average transmittance before heating treatment - average transmittance after heating treatment) was +0.3%. The difference ΔA in average transmittance of the cured product of Example 37 for light in the wavelength range of more than or equal to 430 nm and less than or equal to 510 nm before and after heating treatment was performed was +0.1%. It was confirmed from the above result that the average transmittance for light in the wavelength range of more than or equal to 430 nm and less than or equal to 680 nm and the average transmittance for light in the wavelength range of more than or equal to 430 nm and less than or equal to 510 nm hardly decreased even if heating treatment was performed on the cured product of Example 37. It was also found that since there was little difference between the differences ΔA in average transmittance of the cured product of Example 35 and the cured product of Example 37, the average transmittance hardly decreased in the cured product of the light curing acrylic resin for imprinting even if the resin (D) was a different material and even if heating treatment was performed.

As shown in Table 8, the storage elastic modulus at 30°C of the cured product of the light curing acrylic resin for imprinting of Example 37 was $2.1 \times 10^9$ Pa. The storage elastic modulus at 120°C of the cured product of the light curing acrylic resin for imprinting of Example 37 was $7.8 \times 10^8$ Pa. The storage elastic modulus at 130°C of the cured product of the light curing acrylic resin for imprinting of Example 37 was $7.1 \times 10^8$ Pa. The storage elastic modulus at 140°C of the cured product of the light curing acrylic resin for imprinting of Example 37 was $6.3 \times 10^8$ Pa. It was found that since there was little difference between the storage elastic moduli of the cured product of Example 35 and the cured product of Example 37, the cured product of the light curing acrylic resin for imprinting had a high storage elastic modulus even if the resin (D) was a different material.

The rate of change of the storage elastic modulus at 120°C of the cured product of Example 37 with respect to the storage elastic modulus at 30°C (the storage elastic modulus at 120°C / the storage elastic modulus at 30°C $\times$ 100%) was 37.9%. The rate of change of the storage elastic modulus at 130°C of the cured product of Example 37 with respect to the storage elastic modulus at 30°C (the storage elastic modulus at 130°C / the storage elastic modulus at 30°C $\times$ 100%) was 34.2%. The rate of change of the storage elastic modulus at 140°C of the cured product of Example 37 with respect to the storage elastic modulus at 30°C (the storage elastic modulus at 140°C / the storage elastic modulus at 30°C $\times$ 100%) was 30.4%. It was confirmed from the above result that the cured product of Example 37 had a storage elastic modulus as high as $2.1 \times 10^9$ Pa before heating treatment was performed. It was also confirmed that the storage elastic modulus was restrained from decreasing even if heating treatment was performed on the cured product of Example 37. It was also found that since there was little difference between the rates of change of the storage elastic modulus of the cured product of Example 35 and the cured product of Example 37, the storage elastic modulus was restrained from decreasing in the cured product of the light curing acrylic resin for imprinting even if the resin (D) was a different material and even if heating treatment was performed.

As shown in Table 8, the glass transition temperature Tg of the cured product of the light curing acrylic resin for imprinting of Example 37 was 170°C. It was confirmed from the above result that the cured product of Example 37 had a high glass transition temperature Tg. It was also found that since there was little difference between the glass transition temperatures Tg of the cured product of Example 35 and the cured product of Example 37, the cured product of the light curing acrylic resin for imprinting had a high glass transition temperature Tg even if the resin (D) was a different material.

[Example 38]

As shown in Table 7, Example 38 contained only the resin (A), the resin (B), the resin (C), and the resin (D) as the photopolymerization component and further contained a photopolymerization initiator. The resin (A), the resin (C), the resin (D), and the photopolymerization initiator were identical to those of Example 35. In Example 38, 1,9-nonanediol diacrylate (NDDA) was used as the resin (B). In Example 38, the contents of the resin (A), the resin (B), the resin (C), and

the resin (D) in the whole of the photopolymerization component were identical to those of Example 35. In addition, in Example 38, the content of the photopolymerization initiator was 1 mass % when the entire content of the photopolymerization component was 100 mass %. In other words, Example 38 was different from Example 35 only in terms of the resin (B).

As shown in Table 7, the viscosity of the light curing acrylic resin for imprinting of Example 38 was 20.01 mPa•s. The viscosity of the resin (B) of Example 38 was higher than the viscosity of the resin (B) of Example 35. It is assumed that this made the viscosity of the light curing acrylic resin for imprinting of Example 38 higher than the viscosity of the light curing acrylic resin for imprinting of Example 35.

As shown in Table 8, the YI value of the cured product of the light curing acrylic resin for imprinting of Example 38 was 1.0. It was confirmed from the above result that a low YI value was able to be maintained even if heating treatment was performed on the cured product of Example 38. It was also found that since there was little difference between the YI values of the cured product of Example 35 and the cured product of Example 38, the cured product of the light curing acrylic resin for imprinting was able to maintain a low YI value even if the resin (B) was a different material.

As shown in Table 8, the average transmittance of the cured product of the light curing acrylic resin for imprinting of Example 38 for light in the wavelength range of more than or equal to 430 nm and less than or equal to 680 nm before heating treatment was performed was 92.3%, and the average transmittance for light in the wavelength range of more than or equal to 430 nm and less than or equal to 510 nm before heating treatment was performed was 92.0%. In addition, the average transmittance of the cured product of the light curing acrylic resin for imprinting of Example 38 for light in the wavelength range of more than or equal to 430 nm and less than or equal to 680 nm after heating treatment was performed was 92.4%, and the average transmittance for light in the wavelength range of more than or equal to 430 nm and less than or equal to 510 nm after heating treatment was performed was 91.9%. It was found that since there was little difference between the average transmittances of the cured product of Example 35 and the cured product of Example 38, the cured product of the light curing acrylic resin for imprinting was able to maintain a high average transmittance even if the resin (B) was a different material.

The difference $\Delta A$ in average transmittance of the cured product of Example 38 for light in the wavelength range of more than or equal to 430 nm and less than or equal to 680 nm before and after heating treatment was performed (average transmittance before heating treatment - average transmittance after heating treatment) was +0.2%. The difference $\Delta A$ in average transmittance of the cured product of Example 38 for light in the wavelength range of more than or equal to 430 nm and less than or equal to 510 nm before and after heating treatment was performed was -0.1%. It was confirmed from the above result that the average transmittance for light in the wavelength range of more than or equal to 430 nm and less than or equal to 680 nm and the average transmittance for light in the wavelength range of more than or equal to 430 nm and less than or equal to 510 nm hardly decreased even if heating treatment was performed on the cured product of Example 38. It was also found that since there was little difference between the differences $\Delta A$ in average transmittance of the cured product of Example 35 and the cured product of Example 38, the average transmittance hardly decreased in the cured product of the light curing acrylic resin for imprinting even if the resin (B) was a different material and even if heating treatment was performed.

As shown in Table 8, the storage elastic modulus at 30°C of the cured product of the light curing acrylic resin for imprinting of Example 38 was $1.9 \times 10^9$ Pa. The storage elastic modulus at 120°C of the cured product of the light curing acrylic resin for imprinting of Example 38 was $7.1 \times 10^8$ Pa. The storage elastic modulus at 130°C of the cured product of the light curing acrylic resin for imprinting of Example 38 was $6.4 \times 10^8$ Pa. The storage elastic modulus at 140°C of the cured product of the light curing acrylic resin for imprinting of Example 38 was $5.8 \times 10^8$ Pa. It was found that since there was little difference between the storage elastic moduli of the cured product of Example 35 and the cured product of Example 38, the cured product of the light curing acrylic resin for imprinting had a high storage elastic modulus even if the resin (B) was a different material.

The rate of change of the storage elastic modulus at 120°C of the cured product of Example 38 with respect to the storage elastic modulus at 30°C (the storage elastic modulus at 120°C / the storage elastic modulus at 30°C $\times$ 100%) was 37.4%. The rate of change of the storage elastic modulus at 130°C of the cured product of Example 38 with respect to the storage elastic modulus at 30°C (the storage elastic modulus at 130°C / the storage elastic modulus at 30°C $\times$ 100%) was 33.5%. The rate of change of the storage elastic modulus at 140°C of the cured product of Example 38 with respect to the storage elastic modulus at 30°C (the storage elastic modulus at 140°C / the storage elastic modulus at 30°C $\times$ 100%) was 30.3%. It was confirmed from the above result that the cured product of Example 38 had a storage elastic modulus as high as $1.9 \times 10^9$ Pa before heating treatment was performed. It was also confirmed that the storage elastic modulus was restrained from decreasing in the cured product of Example 38 even if heating treatment was performed. It was also found that since there was little difference between the rates of change of the storage elastic modulus of the cured product of Example 35 and the cured product of Example 38, the storage elastic modulus was restrained from decreasing in the cured product of the light curing acrylic resin for imprinting even if the resin (B) was a different material and even if heating treatment was performed.

As shown in Table 8, the glass transition temperature Tg of the cured product of the light curing acrylic resin for

imprinting of Example 38 was 180.6°C. It was confirmed from the above result that the cured product of Example 38 had a high glass transition temperature Tg. It was also found that since there was little difference between the glass transition temperatures Tg of the cured product of Example 35 and the cured product of Example 38, the cured product of the light curing acrylic resin for imprinting had a high glass transition temperature Tg even if the resin (D) was a different material.

It was confirmed from the above result that in Examples 31 to 38, the viscosities of the light curing acrylic resins for imprinting at 25°C were less than or equal to 35 mPa•s. It was also confirmed that in Examples 31 to 38, the YI values of the cured products of the light curing acrylic resins for imprinting after the cured products were held at 120°C for 500 hours were less than or equal to 3. It was also confirmed that in Examples 31 to 38, the average transmittances of the cured products for light in the wavelength range of more than or equal to 430 nm and less than or equal to 680 nm after the cured products were held at 120°C for 500 hours were more than or equal to 91%, and the average transmittances of the cured products for light in the wavelength range of more than or equal to 430 nm and less than or equal to 510 nm were more than or equal to 90%. It was also confirmed that in Examples 31 to 38, the storage elastic moduli at 30°C of the cured products of the light curing acrylic resins for imprinting were more than or equal to $1.6 \times 10^9$ Pa, and the storage elastic moduli at 120°C of the cured products were more than or equal to $3.9 \times 10^8$ Pa.

[Table 9]

[Table 9]

| | Material | The number of functional groups | | Comparative example 1 | Comparative example 2 | Comparative example 3 |
|---|---|---|---|---|---|---|
| Photopolymerization component [mass %] | R-684 | 2 | Resin (A) | - | - | - |
| | R-604 | 2 | - | 20 | 40 | 40 |
| | HDDA | 2 | Resin (B) | - | 10 | 10 |
| | NDDA | 2 | Resin (B) | - | - | - |
| | Silicon diacrylate | 2 | - | - | - | - |
| | IBOA | 1 | Resin (C) | 20 | 30 | 40 |
| | Benzyl acrylate | 1 | Resin (C) | - | - | - |
| | N-vinyl-2-pyrrolidone | 1 | - | - | - | - |
| | DPHA | 3 or more | Resin (D) | 20 | 20 | 10 |
| | M9050 | 3 or more | Resin (D) | 40 | - | - |
| | TMPTA | 3 | Resin (D) | - | - | - |
| Total of bifunctional acrylate monomers [mass %] | | | | 20 | 50 | 50 |
| Total of acrylate monomers less than or equal to 10 mPa•s [mass %] | | | | 20 | 40 | 50 |
| Total of Resins (D) [mass %] | | | | 60 | 20 | 10 |
| Viscosity of light curing acrylic resin for imprinting [mPa•s] @25°C | | | | 717.5 | 26.25 | 39.6 |

[Table 10]

[Table 10]

| | | Comparative example 1 | Comparative example 2 | Comparative example 3 |
|---|---|---|---|---|
| YI | | 6.6 | 4.6 | 3.9 |
| Average transmittance (430 nm - 680 nm) [%] | Before heating | 91.5 | 92.4 | 92.7 |
| Average transmittance (430 nm - 510 nm) [%] | Before heating | 90.6 | 92.2 | 92.5 |
| Average transmittance (430 nm - 680 nm) [%] | After heating | 90.4 | 91.5 | 91.9 |
| Average transmittance (430 nm - 510 nm) [%] | After heating | 87.7 | 89.6 | 90.3 |
| Average transmittance (430 nm - 680 nm) [%] | ΔA | -1.1 | -0.9 | -0.8 |
| Average transmittance (430 nm - 510 nm) [%] | ΔA | -2.9 | -2.7 | -2.3 |
| Storage elastic modulus [Pa] | 30°C | 2.2.E+09 | 2.5.E+09 | 2.0.E+09 |
| | 120°C | 1.3.E+09 | 9.1.E+08 | 3.3.E+08 |
| | 130°C | 1.3.E+09 | 8.1.E+08 | 2.6.E+08 |
| | 140°C | 1.2.E+09 | 7.1.E+08 | 2.1.E+08 |
| Change of storage elastic modulus | 120°C | 58.7% | 36.5% | 16.7% |
| | 130°C | 56.6% | 32.2% | 13.3% |
| | 140°C | 54.6% | 28.5% | 11.0% |
| Tg [°C] | | 115 | 168.3 | 113.6 |

[Comparative Example 1]

As shown in Table 9, Comparative Example 1 contained only the resin (C), the resin (D), and a bifunctional acrylate monomer as the photopolymerization component and further contained a photopolymerization initiator. In Comparative Example 1, the resin (C) and the photopolymerization initiator were identical to those of Example 31. In Comparative Example 1, dipentaerythritol hexaacrylate (DPHA) and "M-9050" made by TOAGOSEI CO., LTD. were used as the resins (D). As the bifunctional acrylate monomer, "KAYARAD R-604" made by Nippon Kayaku Co.,Ltd. was used. "KAYARAD R-604" has a viscosity of more than or equal to 200 mPa•s and less than or equal to 400 mPa•s at 25°C. In addition, in Comparative Example 1, the content of "KAYARAD R-604" in the whole of the photopolymerization component was 20 mass %, the content of the resin (C) was 20 mass %, and the content of the resin (D) was 60 mass %. In addition, in Comparative Example 1, the content of dipentaerythritol hexaacrylate as the resin (D) was 20 mass %, and the content of M-9050 as the resin (D) was 40 mass %. In other words, in Comparative Example 1, the total content of the acrylate monomers less than or equal to 10 mPa•s at 25°C in the whole of the photopolymerization component was 20 mass %. In Comparative Example 1, the total content of the resins (D) in the whole of the photopolymerization component was 60 mass %. In addition, in Comparative Example 1, the content of the photopolymerization initiator was 1 mass % when the entire content of the photopolymerization component was 100 mass %.

As shown in Table 9, the viscosity of the light curing acrylic resin for imprinting of Comparative Example 1 was 717.5 mPa•s. It was confirmed from the above result that the light curing acrylic resin for imprinting of Comparative Example 1 had a high viscosity because the total content of the acrylate monomers less than or equal to 10 mPa•s at 25°C was less than 50 mass %, and the content of the resins (D) was more than 20 mass %.

As shown in Table 10, the YI value of the cured product of the light curing acrylic resin for imprinting of Comparative Example 1 was 6.6. It was confirmed from the above result that the YI value increased in the case where heating treatment was performed on the cured product of Comparative Example 1. Consequently, it was found that the YI value after heating treatment was performed on the cured product increased merely by increasing the content of the resins (D).

As shown in Table 10, the average transmittance of the cured product of the light curing acrylic resin for imprinting of Comparative Example 1 for light in the wavelength range of more than or equal to 430 nm and less than or equal to 680 nm before heating treatment was performed was 91.5%, and the average transmittance for light in the wavelength range of

more than or equal to 430 nm and less than or equal to 510 nm before heating treatment was performed was 90.6%. In addition, the average transmittance of the cured product of the light curing acrylic resin for imprinting of Comparative Example 1 for light in the wavelength range of more than or equal to 430 nm and less than or equal to 680 nm after heating treatment was performed was 90.4%, and the average transmittance for light in the wavelength range of more than or equal to 430 nm and less than or equal to 510 nm after heating treatment was performed was 87.7%.

The difference ΔA in average transmittance of the cured product of Comparative Example 1 for light in the wavelength range of more than or equal to 430 nm and less than or equal to 680 nm before and after heating treatment was performed (average transmittance before heating treatment - average transmittance after heating treatment) was -1.1%. The difference ΔA in average transmittance of the cured product of Comparative Example 1 for light in the wavelength range of more than or equal to 430 nm and less than or equal to 510 nm before and after heating treatment was performed was -2.9%. It was confirmed from the above result that in the case where heating treatment was performed on the cured product of Comparative Example 1, the average transmittance for light in the wavelength range of more than or equal to 430 nm and less than or equal to 680 nm and the average transmittance for light in the wavelength range of more than or equal to 430 nm and less than or equal to 510 nm noticeably decreased.

As shown in Table 10, the storage elastic modulus at 30°C of the cured product of the light curing acrylic resin for imprinting of Comparative Example 1 was $2.2 \times 10^9$ Pa. The storage elastic modulus at 120°C of the cured product of the light curing acrylic resin for imprinting of Comparative Example 1 was $1.3 \times 10^9$ Pa. The storage elastic modulus at 130°C of the cured product of the light curing acrylic resin for imprinting of Comparative Example 1 was $1.3 \times 10^9$ Pa. The storage elastic modulus at 140°C of the cured product of the light curing acrylic resin for imprinting of Comparative Example 1 was $1.2 \times 10^9$ Pa.

The rate of change of the storage elastic modulus at 120°C of the cured product of Comparative Example 1 with respect to the storage elastic modulus at 30°C (the storage elastic modulus at 120°C / the storage elastic modulus at 30°C × 100%) was 58.7%. The rate of change of the storage elastic modulus at 130°C of the cured product of Comparative Example 1 with respect to the storage elastic modulus at 30°C (the storage elastic modulus at 130°C / the storage elastic modulus at 30°C × 100%) was 56.6%. The rate of change of the storage elastic modulus at 140°C of the cured product of Comparative Example 1 with respect to the storage elastic modulus at 30°C (the storage elastic modulus at 140°C / the storage elastic modulus at 30°C × 100%) was 54.6%.

As shown in Table 10, the glass transition temperature Tg of the cured product of the light curing acrylic resin for imprinting of Comparative Example 1 was 115°C.

[Comparative Example 2]

As shown in Table 9, Comparative Example 2 contained only "KAYARAD R-604", the resin (B), the resin (C), and the resin (D) as the photopolymerization component and further contained a photopolymerization initiator. In Comparative Example 2, the resin (B), the resin (C), the resin (D), and the photopolymerization initiator were identical to those of Example 3. In addition, in Comparative Example 2, the content of "KAYARAD R-604" in the whole of the photopolymerization component was 40 mass %, the content of the resin (B) was 10 mass %, the content of the resin (C) was 30 mass %, and the content of the resin (D) was 20 mass %. In other words, in Comparative Example 2, the total content of the acrylate monomers (the resin (B) + the resin (C)) less than or equal to 10 mPa•s at 25°C in the whole of the photopolymerization component was 40 mass %. In Comparative Example 2, the total content of the bifunctional acrylate monomers ("KAYARAD R-604" + the resin (B)) was 50 mass %. In addition, in Comparative Example 2, the content of the photopolymerization initiator was 1 mass % when the entire content of the photopolymerization component was 100 mass %.

As shown in Table 9, the viscosity of the light curing acrylic resin for imprinting of Comparative Example 2 was 26.25 mPa•s.

As shown in Table 10, the YI value of the cured product of the light curing acrylic resin for imprinting of Comparative Example 2 was 4.6. It was confirmed from the above result that the YI value increased in the case where heating treatment was performed on the cured product of Comparative Example 2. Consequently, it was found that without containing the resin (A), the YI value after heating treatment was performed on the cured product increased.

As shown in Table 10, the average transmittance of the cured product of the light curing acrylic resin for imprinting of Comparative Example 2 for light in the wavelength range of more than or equal to 430 nm and less than or equal to 680 nm before heating treatment was performed was 92.4%, and the average transmittance for light in the wavelength range of more than or equal to 430 nm and less than or equal to 510 nm before heating treatment was performed was 92.2%. In addition, the average transmittance of the cured product of the light curing acrylic resin for imprinting of Comparative Example 2 for light in the wavelength range of more than or equal to 430 nm and less than or equal to 680 nm after heating treatment was performed was 91.5%, and the average transmittance for light in the wavelength range of more than or equal to 430 nm and less than or equal to 510 nm after heating treatment was performed was 89.6%.

The difference ΔA in average transmittance of the cured product of Comparative Example 2 for light in the

wavelength range of more than or equal to 430 nm and less than or equal to 680 nm before and after heating treatment was performed (average transmittance before heating treatment - average transmittance after heating treatment) was -0.9%. The difference ΔA in average transmittance of the cured product of Comparative Example 2 for light in the wavelength range of more than or equal to 430 nm and less than or equal to 510 nm before and after heating treatment was performed was -2.7%. It was confirmed from the above result that in the case where heating treatment was performed on the cured product of Comparative Example 2, the average transmittance for light in the wavelength range of more than or equal to 430 nm and less than or equal to 680 nm and the average transmittance for light in the wavelength range of more than or equal to 430 nm and less than or equal to 510 nm noticeably decreased.

As shown in Table 10, the storage elastic modulus at 30°C of the cured product of the light curing acrylic resin for imprinting of Comparative Example 2 was $2.5 \times 10^9$ Pa. The storage elastic modulus at 120°C of the cured product of the light curing acrylic resin for imprinting of Comparative Example 2 was $9.1 \times 10^8$ Pa. The storage elastic modulus at 130°C of the cured product of the light curing acrylic resin for imprinting of Comparative Example 2 was $8.1 \times 10^8$ Pa. The storage elastic modulus at 140°C of the cured product of the light curing acrylic resin for imprinting of Comparative Example 2 was $7.1 \times 10^8$ Pa.

The rate of change of the storage elastic modulus at 120°C of the cured product of Comparative Example 2 with respect to the storage elastic modulus at 30°C (the storage elastic modulus at 120°C / the storage elastic modulus at 30°C × 100%) was 36.5%. The rate of change of the storage elastic modulus at 130°C of the cured product of Comparative Example 2 with respect to the storage elastic modulus at 30°C (the storage elastic modulus at 130°C / the storage elastic modulus at 30°C × 100%) was 32.2%. The rate of change of the storage elastic modulus at 140°C of the cured product of Comparative Example 2 with respect to the storage elastic modulus at 30°C (the storage elastic modulus at 140°C / the storage elastic modulus at 30°C × 100%) was 28.5%.

As shown in Table 10, the glass transition temperature Tg of the cured product of the light curing acrylic resin for imprinting of Comparative Example 2 was 168.3°C.

[Comparative Example 3]

As shown in Table 9, Comparative Example 3 contained only "KAYARAD R-604", the resin (B), the resin (C), and the resin (D) as the photopolymerization component and further contained a photopolymerization initiator. In Comparative Example 3, the photopolymerization component and the photopolymerization initiator were identical to those of Comparative Example 2. In Comparative Example 3, the content of "KAYARAD R-604" in the whole of the photopolymerization component was 40 mass %, the content of the resin (B) was 10 mass %, the content of the resin (C) was 40 mass %, and the content of the resin (D) was 10 mass %. In other words, Comparative Example 3 was different from Comparative Example 2 only in terms of the contents of the resin (C) and the resin (D). In Comparative Example 3, the total content of the acrylate monomers (the resin (B) + the resin (C)) less than or equal to 10 mPa•s at 25°C in the whole of the photopolymerization component was 50 mass %. In Comparative Example 3, the total content of the bifunctional acrylate monomers (KAYARAD R-604 + the resin (B)) was 50 mass %. In addition, in Comparative Example 3, the content of the photopolymerization initiator was 1 mass % when the entire content of the photopolymerization component was 100 mass %.

As shown in Table 9, the viscosity of the light curing acrylic resin for imprinting of Comparative Example 3 was 39.6 mPa•s.

As shown in Table 10, the YI value of the cured product of the light curing acrylic resin for imprinting of Comparative Example 3 was 3.9. It was confirmed from the above result that the YI value increased in the case where heating treatment was performed on the cured product of Comparative Example 3. Consequently, it was found that without containing the resin (A), the YI value after heating treatment was performed on the cured product increased.

As shown in Table 10, the average transmittance of the cured product of the light curing acrylic resin for imprinting of Comparative Example 3 for light in the wavelength range of more than or equal to 430 nm and less than or equal to 680 nm before heating treatment was performed was 92.7%, and the average transmittance for light in the wavelength range of more than or equal to 430 nm and less than or equal to 510 nm before heating treatment was performed was 92.5%. In addition, the average transmittance of the cured product of the light curing acrylic resin for imprinting of Comparative Example 3 for light in the wavelength range of more than or equal to 430 nm and less than or equal to 680 nm after heating treatment was performed was 91.9%, and the average transmittance for light in the wavelength range of more than or equal to 430 nm and less than or equal to 510 nm after heating treatment was performed was 90.3%.

The difference ΔA in average transmittance of the cured product of Comparative Example 3 for light in the wavelength range of more than or equal to 430 nm and less than or equal to 680 nm before and after heating treatment was performed (average transmittance before heating treatment - average transmittance after heating treatment) was -0.8%. The difference ΔA in average transmittance of the cured product of Comparative Example 3 for light in the wavelength range of more than or equal to 430 nm and less than or equal to 510 nm before and after heating treatment was performed was -2.3%. It was confirmed from the above result that in the case where heating treatment was performed on the cured product of Comparative Example 3, the average transmittance for light in the wavelength range of more than or equal to

430 nm and less than or equal to 680 nm and the average transmittance for light in the wavelength range of more than or equal to 430 nm and less than or equal to 510 nm noticeably decreased.

As shown in Table 10, the storage elastic modulus at 30°C of the cured product of the light curing acrylic resin for imprinting of Comparative Example 3 was $2.0 \times 10^9$ Pa. The storage elastic modulus at 120°C of the cured product of the light curing acrylic resin for imprinting of Comparative Example 3 was $3.3 \times 10^8$ Pa. The storage elastic modulus at 130°C of the cured product of the light curing acrylic resin for imprinting of Comparative Example 3 was $2.6 \times 10^8$ Pa. The storage elastic modulus at 140°C of the cured product of the light curing acrylic resin for imprinting of Comparative Example 3 was $2.1 \times 10^8$ Pa.

The rate of change of the storage elastic modulus at 120°C of the cured product of Comparative Example 3 with respect to the storage elastic modulus at 30°C (the storage elastic modulus at 120°C / the storage elastic modulus at 30°C $\times$ 100%) was 16.7%. The rate of change of the storage elastic modulus at 130°C of the cured product of Comparative Example 3 with respect to the storage elastic modulus at 30°C (the storage elastic modulus at 130°C / the storage elastic modulus at 30°C $\times$ 100%) was 13.3%. The rate of change of the storage elastic modulus at 140°C of the cured product of Comparative Example 3 with respect to the storage elastic modulus at 30°C (the storage elastic modulus at 140°C / the storage elastic modulus at 30°C $\times$ 100%) was 11.0%.

As shown in Table 10, the glass transition temperature Tg of the cured product of the light curing acrylic resin for imprinting of Comparative Example 3 was 113.6°C.

[Table 11]

[Table 11]

| | Material | The number of functional groups | | Comparative example 4 | Comparative example 5 | Comparative example 6 |
|---|---|---|---|---|---|---|
| Photopolymerization component [mass %] | R-684 | 2 | Resin (A) | 40 | - | - |
| | R-604 | 2 | - | - | 50 | 70 |
| | HDDA | 2 | Resin (B) | 40 | - | - |
| | NDDA | 2 | Resin (B) | - | - | - |
| | Silicon diacrylate | 2 | - | - | - | - |
| | IBOA | 1 | Resin (C) | 10 | 30 | 20 |
| | Benzyl acrylate | 1 | Resin (C) | - | - | - |
| | N-vinyl-2-pyrrolidone | 1 | - | - | - | - |
| | DPHA | 3 or more | Resin (D) | 10 | - | 10 |
| | M9050 | 3 or more | Resin (D) | - | 20 | - |
| | TMPTA | 3 | Resin (D) | - | - | - |
| Total of bifunctional acrylate monomers [mass %] | | | | 80 | 50 | 70 |
| Total of acrylate monomers less than or equal to 10 mPa•s [mass %] | | | | 50 | 30 | 20 |
| Total of Resins (D) [mass %] | | | | 10 | 20 | 10 |

(continued)

| | Material | The number of functional groups | | Comparative example 4 | Comparative example 5 | Comparative example 6 |
|---|---|---|---|---|---|---|
| Viscosity of light curing acrylic resin for imprinting [mPa•s] @25°C | | | | 35 | 192.5 | 245 |

[Table 12]

[Table 12]

| | | Comparative example 4 | Comparative example 5 | Comparative example 6 |
|---|---|---|---|---|
| YI | | 3.6 | 3.5 | 3.1 |
| Average transmittance (430 nm - 680 nm) [%] | Before heating | 91.5 | 92.1 | 91.8 |
| Average transmittance (430 nm - 510 nm) [%] | Before heating | 90.4 | 91.8 | 90.6 |
| Average transmittance (430 nm - 680 nm) [%] | After heating | 91.2 | 91.4 | 91.6 |
| Average transmittance (430 nm - 510 nm) [%] | After heating | 89.7 | 90.0 | 90.4 |
| Average transmittance (430 nm - 680 nm) [%] | ΔA | -0.3 | -0.7 | -0.1 |
| Average transmittance (430 nm - 510 nm) [%] | ΔA | -0.6 | -1.8 | -0.2 |
| Storage elastic modulus [Pa] | 30°C | 2.3.E+09 | 1.8.E+09 | 2.4.E+09 |
| | 120°C | 1.0.E+09 | 5.2.E+08 | 7.5.E+08 |
| | 130°C | 9.1.E+08 | 4.5.E+08 | 6.4.E+08 |
| | 140°C | 8.3.E+08 | 3.9.E+08 | 5.6.E+08 |
| Change of storage elastic modulus | 120°C | 44.2% | 28.5% | 31.6% |
| | 130°C | 39.5% | 24.7% | 27.1% |
| | 140°C | 36.3% | 21.2% | 23.5% |
| Tg [°C] | | 128 | 169.6 | 164.1 |

[Comparative Example 4]

As shown in Table 11, Comparative Example 4 contained only the resin (A), the resin (B), the resin (C), and the resin (D) as the photopolymerization component and further contained a photopolymerization initiator. In Comparative Example 4, the photopolymerization component and the photopolymerization initiator were identical to those of Example 31. In Comparative Example 4, the content of the resin (A) in the whole of the photopolymerization component was 40 mass %, the content of the resin (B) was 40 mass %, the content of the resin (C) was 10 mass %, and the content of the resin (D) was 10 mass %. In Comparative Example 4, the total content of the acrylate monomers (the resin (B) + the resin (C)) less than or equal to 10 mPa•s at 25°C was 50 mass %. In Comparative Example 4, the total content of the bifunctional acrylate monomers (the resin (A) + the resin (B)) was 80 mass %. In addition, in Comparative Example 4, the content of the photopolymerization initiator was 1 mass % when the entire content of the photopolymerization component was 100 mass %.

As shown in Table 11, the viscosity of the light curing acrylic resin for imprinting of Comparative Example 4 was 35 mPa•s.

As shown in Table 12, the YI value of the cured product of the light curing acrylic resin for imprinting of Comparative Example 4 was 3.6. It was confirmed from the above result that the YI value increased in the case where heating treatment was performed on the cured product of Comparative Example 4. Consequently, it was found that when the total content of the resin (A) and the resin (B) in the whole of the photopolymerization component was more than 70 mass % even if the content of the resin (A) in the whole of the photopolymerization component was more than or equal to 20

mass % and less than or equal to 40 mass %, the YI value after heating treatment was performed on the cured product increased.

As shown in Table 12, the average transmittance of the cured product of the light curing acrylic resin for imprinting of Comparative Example 4 for light in the wavelength range of more than or equal to 430 nm and less than or equal to 680 nm before heating treatment was performed was 91.5%, and the average transmittance for light in the wavelength range of more than or equal to 430 nm and less than or equal to 510 nm before heating treatment was performed was 90.4%. In addition, the average transmittance of the cured product of the light curing acrylic resin for imprinting of Comparative Example 4 for light in the wavelength range of more than or equal to 430 nm and less than or equal to 680 nm after heating treatment was performed was 91.2%, and the average transmittance for light in the wavelength range of more than or equal to 430 nm and less than or equal to 510 nm after heating treatment was performed was 89.7%. It was confirmed from the above result that when the total content of the resin (A) and the resin (B) in the whole of the photopolymerization component was more than 70 mass % even if the content of the resin (A) in the whole of the photopolymerization component was more than or equal to 20 mass % and less than or equal to 40 mass %, the average transmittance for light in the wavelength range of more than or equal to 430 nm and less than or equal to 510 nm after heating treatment was performed on the cured product decreased.

The difference ΔA in average transmittance of the cured product of Comparative Example 4 for light in the wavelength range of more than or equal to 430 nm and less than or equal to 680 nm before and after heating treatment was performed (average transmittance before heating treatment - average transmittance after heating treatment) was -0.3%. The difference ΔA in average transmittance of the cured product of Comparative Example 4 for light in the wavelength range of more than or equal to 430 nm and less than or equal to 510 nm before and after heating treatment was performed was -0.6%.

As shown in Table 12, the storage elastic modulus at 30°C of the cured product of the light curing acrylic resin for imprinting of Comparative Example 4 was $2.3 \times 10^9$ Pa. The storage elastic modulus at 120°C of the cured product of the light curing acrylic resin for imprinting of Comparative Example 4 was $1.0 \times 10^9$ Pa. The storage elastic modulus at 130°C of the cured product of the light curing acrylic resin for imprinting of Comparative Example 4 was $9.1 \times 10^8$ Pa. The storage elastic modulus at 140°C of the cured product of the light curing acrylic resin for imprinting of Comparative Example 4 was $8.3 \times 10^8$ Pa.

The rate of change of the storage elastic modulus at 120°C of the cured product of Comparative Example 4 with respect to the storage elastic modulus at 30°C (the storage elastic modulus at 120°C / the storage elastic modulus at 30°C × 100%) was 44.2%. The rate of change of the storage elastic modulus at 130°C of the cured product of Comparative Example 4 with respect to the storage elastic modulus at 30°C (the storage elastic modulus at 130°C / the storage elastic modulus at 30°C × 100%) was 39.5%. The rate of change of the storage elastic modulus at 140°C of the cured product of Comparative Example 4 with respect to the storage elastic modulus at 30°C (the storage elastic modulus at 140°C / the storage elastic modulus at 30°C × 100%) was 36.3%.

As shown in Table 12, the glass transition temperature Tg of the cured product of the light curing acrylic resin for imprinting of Comparative Example 4 was 128°C.

[Comparative Example 5]

As shown in Table 11, Comparative Example 5 contained only "KAYARAD R-604", the resin (C), and the resin (D) as the photopolymerization component and further contained a photopolymerization initiator. The resin (C), the resin (D), and the photopolymerization initiator were identical to those of Example 36. In Comparative Example 5, the content of "KAYARAD R-604" in the whole of the photopolymerization component was 50 mass %, the content of the resin (C) was 30 mass %, and the content of the resin (D) was 20 mass %. In other words, in Comparative Example 5, the total content of the acrylate monomer (the resin (C)) less than or equal to 10 mPa•s at 25°C was 30 mass %. In Comparative Example 5, the total content of the bifunctional acrylate monomer ("KAYARAD R-604") was 50 mass %. In addition, in Comparative Example 5, the content of the photopolymerization initiator was 1 mass % when the entire content of the photopolymerization component was 100 mass %.

As shown in Table 11, the viscosity of the light curing acrylic resin for imprinting of Comparative Example 5 was 192.5 mPa•s.

As shown in Table 12, the YI value of the cured product of the light curing acrylic resin for imprinting of Comparative Example 5 was 3.5. It was confirmed from the above result that the YI value increased in the case where heating treatment was performed on the cured product of Comparative Example 5. Consequently, it was found that without containing the resin (A), the YI value after heating treatment was performed on the cured product increased.

As shown in Table 12, the average transmittance of the cured product of the light curing acrylic resin for imprinting of Comparative Example 5 for light in the wavelength range of more than or equal to 430 nm and less than or equal to 680 nm before heating treatment was performed was 92.1%, and the average transmittance for light in the wavelength range of more than or equal to 430 nm and less than or equal to 510 nm before heating treatment was performed was 91.8%. In

addition, the average transmittance of the cured product of the light curing acrylic resin for imprinting of Comparative Example 5 for light in the wavelength range of more than or equal to 430 nm and less than or equal to 680 nm after heating treatment was performed was 91.4%, and the average transmittance for light in the wavelength range of more than or equal to 430 nm and less than or equal to 510 nm after heating treatment was performed was 90.0%.

The difference ΔA in average transmittance of the cured product of Comparative Example 5 for light in the wavelength range of more than or equal to 430 nm and less than or equal to 680 nm before and after heating treatment was performed (average transmittance before heating treatment - average transmittance after heating treatment) was -0.7%. The difference ΔA in average transmittance of the cured product of Comparative Example 5 for light in the wavelength range of more than or equal to 430 nm and less than or equal to 510 nm before and after heating treatment was performed was -1.8%. It was confirmed from the above result that without containing the resin (A), the average transmittance for light in the wavelength range of more than or equal to 430 nm and less than or equal to 680 nm and the average transmittance for light in the wavelength range of more than or equal to 430 nm and less than or equal to 510 nm noticeably decreased in the case where heating treatment was performed on the cured product of Comparative Example 5.

As shown in Table 12, the storage elastic modulus at 30°C of the cured product of the light curing acrylic resin for imprinting of Comparative Example 5 was $1.8 \times 10^9$ Pa. The storage elastic modulus at 120°C of the cured product of the light curing acrylic resin for imprinting of Comparative Example 5 was $5.2 \times 10^8$ Pa. The storage elastic modulus at 130°C of the cured product of the light curing acrylic resin for imprinting of Comparative Example 5 was $4.5 \times 10^8$ Pa. The storage elastic modulus at 140°C of the cured product of the light curing acrylic resin for imprinting of Comparative Example 5 was $3.9 \times 10^8$ Pa.

The rate of change of the storage elastic modulus at 120°C of the cured product of Comparative Example 5 with respect to the storage elastic modulus at 30°C (the storage elastic modulus at 120°C / the storage elastic modulus at 30°C × 100%) was 28.5%. The rate of change of the storage elastic modulus at 130°C of the cured product of Comparative Example 5 with respect to the storage elastic modulus at 30°C (the storage elastic modulus at 130°C / the storage elastic modulus at 30°C × 100%) was 24.7%. The rate of change of the storage elastic modulus at 140°C of the cured product of Comparative Example 5 with respect to the storage elastic modulus at 30°C (the storage elastic modulus at 140°C / the storage elastic modulus at 30°C × 100%) was 21.2%.

As shown in Table 12, the glass transition temperature Tg of the cured product of the light curing acrylic resin for imprinting of Comparative Example 5 was 169.6°C.

[Comparative Example 6]

As shown in Table 11, Comparative Example 6 contained only "KAYARAD R-604", the resin (C), and the resin (D) as the photopolymerization component and further contained a photopolymerization initiator. In Comparative Example 6, the resin (C), the resin (D), and the light initiator were identical to those of Example 31. In Comparative Example 6, the content of "KAYARAD R-604" in the whole of the photopolymerization component was 70 mass %, the content of the resin (C) was 20 mass %, and the content of the resin (D) was 10 mass %. In other words, in Comparative Example 6, the total content of the acrylate monomer (the resin (C)) less than or equal to 10 mPa•s at 25°C was 20 mass %. In Comparative Example 6, the total content of the bifunctional acrylate monomer ("KAYARAD R-604") was 70 mass %. In addition, in Comparative Example 6, the content of the photopolymerization initiator was 1 mass % when the entire content of the photopolymerization component was 100 mass %.

As shown in Table 11, the viscosity of the light curing acrylic resin for imprinting of Comparative Example 6 was 245 mPa•s.

As shown in Table 12, the YI value of the cured product of the light curing acrylic resin for imprinting of Comparative Example 6 was 3.1. It was confirmed from the above result that the YI value increased in the case where heating treatment was performed on the cured product of Comparative Example 6. Consequently, it was found that without containing the resin (A), the YI value after heating treatment was performed on the cured product increased.

As shown in Table 12, the average transmittance of the cured product of the light curing acrylic resin for imprinting of Comparative Example 6 for light in the wavelength range of more than or equal to 430 nm and less than or equal to 680 nm before heating treatment was performed was 91.8%, and the average transmittance for light in the wavelength range of more than or equal to 430 nm and less than or equal to 510 nm before heating treatment was performed was 90.6%. In addition, the average transmittance of the cured product of the light curing acrylic resin for imprinting of Comparative Example 6 for light in the wavelength range of more than or equal to 430 nm and less than or equal to 680 nm after heating treatment was performed was 91.6%, and the average transmittance for light in the wavelength range of more than or equal to 430 nm and less than or equal to 510 nm after heating treatment was performed was 90.4%.

The difference ΔA in average transmittance of the cured product of Comparative Example 6 for light in the wavelength range of more than or equal to 430 nm and less than or equal to 680 nm before and after heating treatment was performed (average transmittance before heating treatment - average transmittance after heating treatment) was -0.1%. The difference ΔA in average transmittance of the cured product of Comparative Example 6 for light in the wavelength

range of more than or equal to 430 nm and less than or equal to 510 nm before and after heating treatment was performed was -0.2%.

As shown in Table 12, the storage elastic modulus at 30°C of the cured product of the light curing acrylic resin for imprinting of Comparative Example 6 was $2.4 \times 10^9$ Pa. The storage elastic modulus at 120°C of the cured product of the light curing acrylic resin for imprinting of Comparative Example 6 was $7.5 \times 10^8$ Pa. The storage elastic modulus at 130°C of the cured product of the light curing acrylic resin for imprinting of Comparative Example 6 was $6.4 \times 10^8$ Pa. The storage elastic modulus at 140°C of the cured product of the light curing acrylic resin for imprinting of Comparative Example 6 was $5.6 \times 10^8$ Pa.

The rate of change of the storage elastic modulus at 120°C of the cured product of Comparative Example 6 with respect to the storage elastic modulus at 30°C (the storage elastic modulus at 120°C / the storage elastic modulus at 30°C × 100%) was 31.6%. The rate of change of the storage elastic modulus at 130°C of the cured product of Comparative Example 6 with respect to the storage elastic modulus at 30°C (the storage elastic modulus at 130°C / the storage elastic modulus at 30°C × 100%) was 27.1%. The rate of change of the storage elastic modulus at 140°C of the cured product of Comparative Example 6 with respect to the storage elastic modulus at 30°C (the storage elastic modulus at 140°C / the storage elastic modulus at 30°C × 100%) was 23.5%.

As shown in Table 12, the glass transition temperature Tg of the cured product of the light curing acrylic resin for imprinting of Comparative Example 6 was 164.1°C.

[Table 13]

[Table 13]

| | Material | The number of functional groups | | Comparative example 7 | Comparative example 8 | Comparative example 9 |
|---|---|---|---|---|---|---|
| Photopolymerization component [mass %] | R-684 | 2 | Resin (A) | 25 | 40 | - |
| | R-604 | 2 | - | - | - | - |
| | HDDA | 2 | Resin (B) | - | - | - |
| | NDDA | 2 | Resin (B) | - | - | 33 |
| | Silicon diacrylate | 2 | - | - | - | - |
| | IBOA | 1 | Resin (C) | - | - | - |
| | Benzyl acrylate | 1 | Resin (C) | 75 | 60 | - |
| | N-vinyl-2-pyrrolidone | 1 | - | - | - | 32 |
| | DPHA | 3 or more | Resin (D) | - | - | - |
| | M9050 | 3 or more | Resin (D) | - | - | - |
| | TMPTA | 3 | Resin (D) | - | - | 33 |
| Total of bifunctional acrylate monomers [mass %] | | | | 25 | 40 | 0 |
| Total of acrylate monomers less than or equal to 10 mPa•s [mass %] | | | | 75 | 60 | 65 |
| Total of Resins (D) [mass %] | | | | 0 | 0 | 33 |

(continued)

| | Material | The number of functional groups | | Comparative example 7 | Comparative example 8 | Comparative example 9 |
|---|---|---|---|---|---|---|
| Viscosity of light curing acrylic resin for imprinting [mPa•s] @25°C | | | | 4.2 | 6.6 | 7.9 |

[Table 14]

[Table 14]

| | | Comparative example 7 | Comparative example 8 | Comparative example 9 |
|---|---|---|---|---|
| YI | | 1.44 | 1.42 | 5.8 |
| Average transmittance (430 nm - 680 nm) [%] | Before heating | 91.4 | 91.6 | 92 |
| Average transmittance (430 nm - 510 nm) [%] | Before heating | 91.2 | 91.3 | 91.7 |
| Average transmittance (430 nm - 680 nm) [%] | After heating | 91.1 | 91.2 | 90.5 |
| Average transmittance (430 nm - 510 nm) [%] | After heating | 90.5 | 90.6 | 87.8 |
| Average transmittance (430 nm - 680 nm) [%] | ΔA | -0.3 | -0.4 | -1.5 |
| Average transmittance (430 nm - 510 nm) [%] | ΔA | -0.7 | -0.7 | -3.9 |
| Storage elastic modulus [Pa] | 30°C | 7.3.E+08 | 2.1.E+09 | 2.4.E+09 |
| | 120°C | 1.2.E+07 | 3.0.E+07 | 1.5.E+09 |
| | 130°C | 1.3.E+07 | 3.1.E+07 | 1.4.E+09 |
| | 140°C | 1.4.E+07 | 3.2.E+07 | 1.3.E+09 |
| Change of storage elastic modulus | 120°C | 1.7% | 1.4% | 61.0% |
| | 130°C | 1.8% | 1.5% | 57.3% |
| | 140°C | 1.9% | 1.5% | 52.8% |
| Tg [°C] | | 35.4 | 46 | 180.1 |

[Comparative Example 7]

As shown in Table 13, Comparative Example 7 contained only the resin (A) and the resin (C) as the photopolymerization component and contained "Irgacure TPO" made by IGM Resins B.V. as the photopolymerization initiator. In Comparative Example 7, benzyl acrylate was used as the resin (C). As benzyl acrylate, benzyl acrylate "V#160" made by OSAKA ORGANIC CHEMICAL INDUSTRY LTD. was used. Benzyl acrylate had a viscosity of 2.2 mPa•s at 25°C. In Comparative Example 7, the content of the resin (A) in the whole of the photopolymerization component was 25 mass %, and the content of the resin (C) was 75 mass %. In other words, in Comparative Example 7, the total content of the acrylate monomer (the resin (C)) less than or equal to 10 mPa•s at 25°C was 75 mass %. In Comparative Example 7, the total content of the bifunctional acrylate monomer (the resin (A)) was 25 mass %. In addition, in Comparative Example 7, the content of the photopolymerization initiator was 3 mass % when the entire content of the photopolymerization component was 100 mass %.

As shown in Table 13, the viscosity of the light curing acrylic resin for imprinting of Comparative Example 7 was 4.2 mPa•s.

As shown in Table 14, the YI value of the cured product of the light curing acrylic resin for imprinting of Comparative Example 7 was 1.44.

As shown in Table 14, the average transmittance of the cured product of the light curing acrylic resin for imprinting of Comparative Example 7 for light in the wavelength range of more than or equal to 430 nm and less than or equal to 680 nm before heating treatment was performed was 91.4%, and the average transmittance for light in the wavelength range of

more than or equal to 430 nm and less than or equal to 510 nm before heating treatment was performed was 91.2%. In addition, the average transmittance of the cured product of the light curing acrylic resin for imprinting of Comparative Example 7 for light in the wavelength range of more than or equal to 430 nm and less than or equal to 680 nm after heating treatment was performed was 91.1%, and the average transmittance for light in the wavelength range of more than or equal to 430 nm and less than or equal to 510 nm after heating treatment was performed was 90.5%.

The difference ΔA in average transmittance of the cured product of Comparative Example 7 for light in the wavelength range of more than or equal to 430 nm and less than or equal to 680 nm before and after heating treatment was performed (average transmittance before heating treatment - average transmittance after heating treatment) was -0.3%. The difference ΔA in average transmittance of the cured product of Comparative Example 7 for light in the wavelength range of more than or equal to 430 nm and less than or equal to 510 nm before and after heating treatment was performed was -0.7%.

As shown in Table 14, the storage elastic modulus at 30°C of the cured product of the light curing acrylic resin for imprinting of Comparative Example 7 was $7.3 \times 10^8$ Pa. The storage elastic modulus at 120°C of the cured product of the light curing acrylic resin for imprinting of Comparative Example 7 was $1.2 \times 10^7$ Pa. The storage elastic modulus at 130°C of the cured product of the light curing acrylic resin for imprinting of Comparative Example 7 was $1.3 \times 10^7$ Pa. The storage elastic modulus at 140°C of the cured product of the light curing acrylic resin for imprinting of Comparative Example 7 was $1.4 \times 10^7$ Pa.

The rate of change of the storage elastic modulus at 120°C of the cured product of Comparative Example 7 with respect to the storage elastic modulus at 30°C (the storage elastic modulus at 120°C / the storage elastic modulus at 30°C × 100%) was 1.7%. The rate of change of the storage elastic modulus at 130°C of the cured product of Comparative Example 7 with respect to the storage elastic modulus at 30°C (the storage elastic modulus at 130°C / the storage elastic modulus at 30°C × 100%) was 1.8%. The rate of change of the storage elastic modulus at 140°C of the cured product of Comparative Example 7 with respect to the storage elastic modulus at 30°C (the storage elastic modulus at 140°C / the storage elastic modulus at 30°C × 100%) was 1.9%. It was confirmed from the above result that the cured product of Comparative Example 7 had a storage elastic modulus as low as $7.3 \times 10^8$ Pa before heating treatment was performed. It was also confirmed that when heating treatment was performed on the cured product of Comparative Example 7, the storage elastic modulus noticeably decreased. Consequently, it was confirmed that without containing the resin (B), the storage elastic modulus considerably decreased.

As shown in Table 14, the glass transition temperature Tg of the cured product of the light curing acrylic resin for imprinting of Comparative Example 7 was 35.4°C. It was confirmed from the above result that since the resin (B) was not contained, the glass transition temperature Tg of the cured product of Comparative Example 7 was noticeably low.

[Comparative Example 8]

As shown in Table 13, Comparative Example 8 contained only the resin (A) and the resin (C) as the photopolymerization component and further contained a photopolymerization initiator. In Comparative Example 8, the resin (A), the resin (C), and the photopolymerization initiator were identical to those of Comparative Example 7. In other words, Comparative Example 8 was different from Comparative Example 7 only in terms of the contents of the resin (A) and the resin (C). In Comparative Example 8, the content of the resin (A) in the whole of the photopolymerization component was 40 mass %, and the content of the resin (C) was 60 mass %. In other words, in Comparative Example 8, the total content of the acrylate monomer (the resin (C)) less than or equal to 10 mPa•s at 25°C was 60 mass %. In Comparative Example 8, the total content of the bifunctional acrylate monomer (the resin (A)) was 40 mass %. In addition, in Comparative Example 8, the content of the photopolymerization initiator was 3 mass % when the entire content of the photopolymerization component was 100 mass %.

As shown in Table 13, the viscosity of the light curing acrylic resin for imprinting of Comparative Example 8 was 6.6 mPa•s.

As shown in Table 14, the YI value of the cured product of the light curing acrylic resin for imprinting of Comparative Example 8 was 1.42.

As shown in Table 14, the average transmittance of the cured product of the light curing acrylic resin for imprinting of Comparative Example 8 for light in the wavelength range of more than or equal to 430 nm and less than or equal to 680 nm before heating treatment was performed was 91.6%, and the average transmittance for light in the wavelength range of more than or equal to 430 nm and less than or equal to 510 nm before heating treatment was performed was 91.3%. In addition, the average transmittance of the cured product of the light curing acrylic resin for imprinting of Comparative Example 8 for light in the wavelength range of more than or equal to 430 nm and less than or equal to 680 nm after heating treatment was performed was 91.2%, and the average transmittance for light in the wavelength range of more than or equal to 430 nm and less than or equal to 510 nm after heating treatment was performed was 90.6%.

The difference ΔA in average transmittance of the cured product of Comparative Example 8 for light in the wavelength range of more than or equal to 430 nm and less than or equal to 680 nm before and after heating treatment was

performed (average transmittance before heating treatment - average transmittance after heating treatment) was -0.4%. The difference ΔA in average transmittance of the cured product of Comparative Example 8 for light in the wavelength range of more than or equal to 430 nm and less than or equal to 510 nm before and after heating treatment was performed was -0.7%.

As shown in Table 14, the storage elastic modulus at 30°C of the cured product of the light curing acrylic resin for imprinting of Comparative Example 8 was $2.1 \times 10^9$ Pa. The storage elastic modulus at 120°C of the cured product of the light curing acrylic resin for imprinting of Comparative Example 8 was $3.0 \times 10^7$ Pa. The storage elastic modulus at 130°C of the cured product of the light curing acrylic resin for imprinting of Comparative Example 8 was $3.1 \times 10^7$ Pa. The storage elastic modulus at 140°C of the cured product of the light curing acrylic resin for imprinting of Comparative Example 8 was $3.2 \times 10^7$ Pa.

The rate of change of the storage elastic modulus at 120°C of the cured product of Comparative Example 8 with respect to the storage elastic modulus at 30°C (the storage elastic modulus at 120°C / the storage elastic modulus at 30°C × 100%) was 1.4%. The rate of change of the storage elastic modulus at 130°C of the cured product of Comparative Example 8 with respect to the storage elastic modulus at 30°C (the storage elastic modulus at 130°C / the storage elastic modulus at 30°C × 100%) was 1.5%. The rate of change of the storage elastic modulus at 140°C of the cured product of Comparative Example 8 with respect to the storage elastic modulus at 30°C (the storage elastic modulus at 140°C / the storage elastic modulus at 30°C × 100%) was 1.5%. It was confirmed from the above result that the cured product of Comparative Example 8 had a storage elastic modulus as high as $2.1 \times 10^9$ Pa before heating treatment was performed. However, it was confirmed that when heating treatment was performed on the cured product of Comparative Example 8, the storage elastic modulus noticeably decreased. Consequently, it was confirmed that without containing the resin (B), the storage elastic modulus considerably decreased.

As shown in Table 14, the glass transition temperature Tg of the cured product of the light curing acrylic resin for imprinting of Comparative Example 8 was 46°C. It was confirmed from the above result that since the resin (B) was not contained, the glass transition temperature Tg of the cured product of Comparative Example 8 was noticeably low.

[Comparative Example 9]

As shown in Table 13, Comparative Example 9 contained only the resin (B), the resin (D), and a monofunctional monomer as the photopolymerization component and contained "Irgacure TPO" made by IGM Resins B.V. as the photopolymerization initiator. In Comparative Example 9, 1,9-nonanediol diacrylate (NDDA) was used as the resin (B). In addition, trimethylolpropane triacrylate (TMPTA) was used as the resin (D). N-vinyl-2-pyrrolidone was used as the monofunctional monomer. N-vinyl-2-pyrrolidone had a viscosity of 1.7 mPa•s at 25°C. In Comparative Example 9, the content of the resin (B) in the whole of the photopolymerization component was 33 mass %, the content of the resin (D) was 33 mass %, and the content of N-vinyl-2-pyrrolidone was 32 mass %. In other words, in Comparative Example 9, the total content of the acrylate monomers (the resin (B) + the monofunctional monomer) less than or equal to 10 mPa•s at 25°C was 65 mass %. In Comparative Example 9, the total content of the bifunctional acrylate monomer (the resin (B)) was 33 mass %. In addition, in Comparative Example 9, the content of the photopolymerization initiator was 2 mass % when the entire content of the photopolymerization component was 100 mass %.

As shown in Table 13, the viscosity of the light curing acrylic resin for imprinting of Comparative Example 9 was 7.9 mPa•s.

As shown in Table 14, the YI value of the cured product of the light curing acrylic resin for imprinting of Comparative Example 9 was 5.8. It was confirmed from the above result that the YI value increased in the case where heating treatment was performed on the cured product of Comparative Example 9. Consequently, it was found that without containing the resin (A), the YI value after heating treatment was performed on the cured product increased.

As shown in Table 14, the average transmittance of the cured product of the light curing acrylic resin for imprinting of Comparative Example 9 for light in the wavelength range of more than or equal to 430 nm and less than or equal to 680 nm before heating treatment was performed was 92.0%, and the average transmittance for light in the wavelength range of more than or equal to 430 nm and less than or equal to 510 nm before heating treatment was performed was 91.7%. In addition, the average transmittance of the cured product of the light curing acrylic resin for imprinting of Comparative Example 9 for light in the wavelength range of more than or equal to 430 nm and less than or equal to 680 nm after heating treatment was performed was 90.5%, and the average transmittance for light in the wavelength range of more than or equal to 430 nm and less than or equal to 510 nm after heating treatment was performed was 87.8%.

The difference ΔA in average transmittance of the cured product of Comparative Example 9 for light in the wavelength range of more than or equal to 430 nm and less than or equal to 680 nm before and after heating treatment was performed (average transmittance before heating treatment - average transmittance after heating treatment) was -1.5%. The difference ΔA in average transmittance of the cured product of Comparative Example 9 for light in the wavelength range of more than or equal to 430 nm and less than or equal to 510 nm before and after heating treatment was performed was -3.9%. It was confirmed from the above result that in the case where heating treatment was performed on the cured

product of Comparative Example 9, the average transmittance for light in the wavelength range of more than or equal to 430 nm and less than or equal to 680 nm and the average transmittance for light in the wavelength range of more than or equal to 430 nm and less than or equal to 510 nm noticeably decreased.

As shown in Table 14, the storage elastic modulus at 30°C of the cured product of the light curing acrylic resin for imprinting of Comparative Example 9 was $2.4 \times 10^9$ Pa. The storage elastic modulus at 120°C of the cured product of the light curing acrylic resin for imprinting of Comparative Example 9 was $1.5 \times 10^9$ Pa. The storage elastic modulus at 130°C of the cured product of the light curing acrylic resin for imprinting of Comparative Example 9 was $1.4 \times 10^9$ Pa. The storage elastic modulus at 140°C of the cured product of the light curing acrylic resin for imprinting of Comparative Example 9 was $1.3 \times 10^9$ Pa.

The rate of change of the storage elastic modulus at 120°C of the cured product of Comparative Example 9 with respect to the storage elastic modulus at 30°C (the storage elastic modulus at 120°C / the storage elastic modulus at 30°C × 100%) was 61.0%. The rate of change of the storage elastic modulus at 130°C of the cured product of Comparative Example 9 with respect to the storage elastic modulus at 30°C (the storage elastic modulus at 130°C / the storage elastic modulus at 30°C × 100%) was 57.3%. The rate of change of the storage elastic modulus at 140°C of the cured product of Comparative Example 9 with respect to the storage elastic modulus at 30°C (the storage elastic modulus at 140°C / the storage elastic modulus at 30°C × 100%) was 52.8%.

As shown in Table 14, the glass transition temperature Tg of the cured product of the light curing acrylic resin for imprinting of Comparative Example 9 was 180.1°C.

[Evaluation of Examples and Comparative Examples]

Table 15 and Table 16 below show two-level evaluation Examples 31 to 38 and Comparative Examples 1 to 9 described above in heat tolerance and viscosity. As to the evaluation of heat tolerance, the heat tolerance was evaluated by optical properties after heating treatment and shape after heating treatment. As to the optical properties after heating treatment, cured products of light curing acrylic resins for imprinting in a case where the YI value after heating treatment of holding the cured products of the light curing acrylic resins for imprinting at 120°C for 500 hours was less than or equal to 3 were evaluated as "A", and cured products of light curing acrylic resins for imprinting in a case where the YI value was more than 3 were evaluated as "B". As to the shape after heating treatment, nano-imprinting molding was performed on the substrate using the master and the light curing acrylic resin for imprinting to form the micro concave-convex structure on the substrate, and after heating treatment of holding the cured product at 120°C for 500 hours was performed, a cross-section of the cured product was observed with a transmission-type electron microscope (TEM). As a result, cured products of light curing acrylic resins for imprinting in a case where there was no change in shape from the shape before the heating treatment were evaluated as "A", and cured products of light curing acrylic resins for imprinting in a case where there was a change in shape from the shape before the heating treatment were evaluated as "B".

The viscosity was evaluated by the followability of the uncured light curing acrylic resin for imprinting to the master and by the outer appearance. As to the followability of the light curing acrylic resin for imprinting to the master, a master having a known micro concave-convex structure (sectional structure) was prepared, nano-imprinting molding was performed on the substrate using the master and the light curing acrylic resin for imprinting, and then a cross-section of the micro concave-convex structure on the substrate was observed with a transmission-type electron microscope. As a result, cured products of light curing acrylic resins for imprinting in a case where the micro concave-convex structure molded on the substrate was similar to the micro concave-convex structure of the master had a high followability and were evaluated as "A", and cured products of light curing acrylic resins for imprinting in a case where the micro concave-convex structure on the substrate was obviously different from the micro concave-convex structure of the master (such as a case where the micro concave-convex structure on the substrate had a pattern dimension extremely smaller than that of the micro concave-convex structure of the master) had a poor followability and were evaluated as "B". As to the outer appearance, nano-imprinting molding was performed on the substrate using the master and the light curing acrylic resin for imprinting, and then the substrate with the micro concave-convex structure formed thereon was observed in a dark room through fluorescent light transmission and fluorescent light reflection. As a result, cured products of light curing acrylic resins for imprinting without collapsing of the pattern of the micro concave-convex structure on the substrate nor peeling of resin on the substrate and having a uniform substrate as a whole were evaluated as "A", and cured products of light curing acrylic resins for imprinting with an uneven substrate as a whole with partial collapsing of the pattern of the micro concave-convex structure on the substrate and peeling of resin on the substrate were evaluated as "B".

[Table 15]

[Table 15]

| | | Examples | | | | | | | |
|---|---|---|---|---|---|---|---|---|---|
| | | 31 | 32 | 33 | 34 | 35 | 36 | 37 | 38 |
| Heat tolerance | Optical properties after heating treatment | A | A | A | A | A | A | A | A |
| | Shape after heating treatment | A | A | A | A | A | A | A | A |
| Low viscosity | Followability to master shape | A | A | A | A | A | A | A | A |
| | Outer appearance | A | A | A | A | A | A | A | A |

[Table 16]

| | | Comparative examples | | | | | | | | |
|---|---|---|---|---|---|---|---|---|---|---|
| | | 1 | 2 | 3 | 4 | 5 | 6 | 7 | 8 | 9 |
| Heat tolerance | Optical properties after heating treatment | B | B | B | B | B | B | A | A | B |
| | Shape after heating treatment | A | A | A | A | A | A | B | B | A |
| Low viscosity | Followability to master shape | B | A | A | A | B | B | A | A | A |
| | Outer appearance | B | A | A | A | B | B | A | A | A |

As shown in Table 15, the cured products of the light curing acrylic resins for imprinting of Examples 31 to 38 were evaluated as "A" in the optical properties after heating treatment and in the shape after heating treatment. In addition, the light curing acrylic resins for imprinting of Examples 31 to 38 were also evaluated as "A" in the followability to the master and in the outer appearance. It was confirmed from the above evaluation that the light curing acrylic resins for imprinting of Examples 31 to 38 had both heat tolerance and low viscosity.

On the other hand, as shown in Table 16, the cured product of the light curing acrylic resin for imprinting of Comparative Example 1 was evaluated as "B" in the optical properties after heating treatment. The light curing acrylic resin for imprinting of Comparative Example 1 was also evaluated as "B" in the followability to the master and in the outer appearance. It was confirmed from the above evaluation that Comparative Example 1 was low in heat tolerance and high in viscosity.

As shown in Table 16, the cured products of the light curing acrylic resins for imprinting of Comparative Examples 2 to 4 were evaluated as "B" in the optical properties after heating treatment. It was confirmed from the above evaluation that Comparative Examples 2 to 4 were low in heat tolerance although being low in viscosity.

As shown in Table 16, the cured products of the light curing acrylic resins for imprinting of Comparative Examples 5 and 6 were evaluated as "B" in the optical properties after heating treatment. In addition, the light curing acrylic resins for imprinting of Comparative Examples 5 and 6 were also evaluated as "B" in the followability to the master and in the outer appearance. It was confirmed from the above evaluation that Comparative Example 1 was low in heat tolerance and high in viscosity.

As shown in Table 16, the cured products of the light curing acrylic resins for imprinting of Comparative Examples 7 and 8 were evaluated as "B" in the shape after heating treatment. It was confirmed from the above evaluation that Comparative Examples 7 and 8 were low in heat tolerance although being low in viscosity.

As shown in Table 16, the cured product of the light curing acrylic resin for imprinting of Comparative Example 9 was evaluated as "B" in the optical properties after heating treatment. It was confirmed from the above evaluation that Comparative Example 9 was low in heat tolerance although being low in viscosity.

The preferred embodiment(s) of the present invention has/have been described above in detail with reference to the accompanying drawings, whilst the present invention is not limited to the above examples. A person skilled in the art may find various alterations and modifications within the scope of the appended claims, and it should be understood that they will naturally come under the technical scope of the present invention.

## Industrial Applicability

According to the present embodiment, a polarizing element which has favorable polarization properties, avoids deterioration in heat dissipation and cost in manufacturing, and is excellent in transmissivity for light at wide-range incident angles as well as a method for manufacturing the polarizing element can be provided. In addition, according to the present embodiment, a projection display device excellent in polarization properties and heat tolerance as well as a vehicle including the projection display device can be provided. In addition, according to the present embodiment, a light curing

acrylic resin for imprinting in which an uncured resin composition has a low viscosity and a resin composition after curing is excellent in heat tolerance can be provided.

Reference Signs List

| | |
|---|---|
| 1 | wire grid polarizing element |
| 2 | light source |
| 3 | display element |
| 4 | reflector |
| 5 | display surface |
| 6 | cover portion |
| 10 | substrate |
| 20 | grid structural body |
| 21 | base part |
| 22 | ridge portion |
| 23 | grid structural body material |
| 24 | concavity |
| 30 | reflection film |
| 40 | protection film |
| 50 | heat dissipation member |
| 60 | master |
| 61 | master base material |
| 62 | master metal film |
| 63 | convexity |
| 64 | release film coating |
| 65 | concave groove |
| 70 | resist mask |
| 80 | metal film |
| 100 | head-up display device |
| 200 | projection display device |
| 210 | light source |
| 220 | PS converter |
| 230 | polarizing beam splitter |
| 240 | reflection-type liquid crystal display element |
| 250 | lens |
| 260 | light absorber |
| TS | thickness of substrate |
| TB | thickness of base part |
| P | pitch of ridge portions |
| H | height of ridge portions |
| Hx | range of height in which reflection film covers side surfaces of ridge portion |
| Ds | side surface thickness of reflection film |
| Dt | leading end thickness of reflection film |
| $W_{MAX}$ | maximum width of reflection film covering and wrapping ridge portion (grid maximum width) |
| $W_B$ | bottom width of ridge portion (grid bottom width) |
| $W_T$ | top width of ridge portion (ridge portion top width) |
| $W_A$ | effective grid width |
| $W_G$ | gap width |

**Claims**

**1.** A light curing acrylic resin for imprinting, containing a photopolymerization component, wherein

the photopolymerization component contains

a resin (A), and

a resin (B),

the resin (A) is (octahydro-4,7-methano-1H-indenediyl)bis(methylene) diacrylate,
the resin (B) is a bifunctional acrylate monomer having a viscosity of less than or equal to 10 mPa•s at 25°C,
a content of the resin (A) in a whole of the photopolymerization component is more than or equal to 20 mass % and less than or equal to 40 mass %, and
a total content of the resin (A) and the resin (B) in the whole of the photopolymerization component is less than or equal to 70 mass %.

**2.** The light curing acrylic resin for imprinting according to claim 1, wherein a viscosity of the light curing acrylic resin for imprinting at 25°C is less than or equal to 35 mPa•s.

**3.** The light curing acrylic resin for imprinting according to claim 1, wherein

the photopolymerization component further contains a resin (C),
the resin (C) is an acrylate monomer having a viscosity of less than or equal to 10 mPa•s at 25°C, and
a total content of the resin (B) and the resin (C) in the whole of the photopolymerization component is more than or equal to 50 mass % and less than or equal to 70 mass %.

**4.** The light curing acrylic resin for imprinting according to claim 3, wherein the resin (C) is a monofunctional acrylate monomer.

**5.** The light curing acrylic resin for imprinting according to claim 4, wherein the resin (C) is isobornyl acrylate.

**6.** The light curing acrylic resin for imprinting according to claim 1, wherein

the photopolymerization component further contains a resin (D),
the resin (D) is an acrylate monomer having three or more functional groups, and
a content of the resin (D) in the whole of the photopolymerization component is more than 0 mass % and less than or equal to 20 mass %.

**7.** The light curing acrylic resin for imprinting according to claim 6, wherein the resin (D) is one or more selected from the group consisting of trimethylolpropane triacrylate, dipentaerythritol hexaacrylate, and polyfunctional polyester acrylate.

**8.** The light curing acrylic resin for imprinting according to claim 1, wherein the resin (B) is a bifunctional acrylate monomer with an acryloyl group combined with each of opposite ends of a straight-chain structure composed of a hydrocarbon group or a bifunctional acrylate monomer with an acryloyl group combined with each of opposite ends of a straight-chain structure having an ether bond.

**9.** The light curing acrylic resin for imprinting according to claim 8, wherein the resin (B) is a bifunctional acrylate monomer expressed by a chemical Formula (I) below, and in the chemical Formula (I), n is an integer of more than or equal to 1 and less than or equal to 9:

$$CH_2 = CHCOO(CH_2)_nOOCCH = CH_2 \ldots \qquad (I).$$

**10.** The light curing acrylic resin for imprinting according to claim 9, wherein in the chemical Formula (I), n is an integer of more than or equal to 6 and less than or equal to 9.

**11.** The light curing acrylic resin for imprinting according to claim 10, wherein in the chemical Formula (I), n is 6 or 9.

**12.** The light curing acrylic resin for imprinting according to claim 1, wherein after a cured product of the light curing acrylic resin for imprinting is held at 120°C for 500 hours, a YI value of the cured product is less than or equal to 3.

**13.** The light curing acrylic resin for imprinting according to claim 1, wherein

a storage elastic modulus at 30°C of the cured product of the light curing acrylic resin for imprinting is more than or

equal to $1.6 \times 10^9$ Pa, and
a storage elastic modulus at 120°C of the cured product is more than or equal to $3.9 \times 10^8$ Pa.

**14.** The light curing acrylic resin for imprinting according to claim 1, wherein after the cured product of the light curing acrylic resin for imprinting is held at 120°C for 500 hours,

an average transmittance of the cured product for light in a wavelength range of more than or equal to 430 nm and less than or equal to 680 nm is more than or equal to 91%, and
an average transmittance of the cured product for light in a wavelength range of more than or equal to 430 nm and less than or equal to 510 nm is more than or equal to 90%.

**15.** The light curing acrylic resin for imprinting according to claim 1, further containing a photopolymerization initiator for polymerizing the photopolymerization component.

FIG. 1

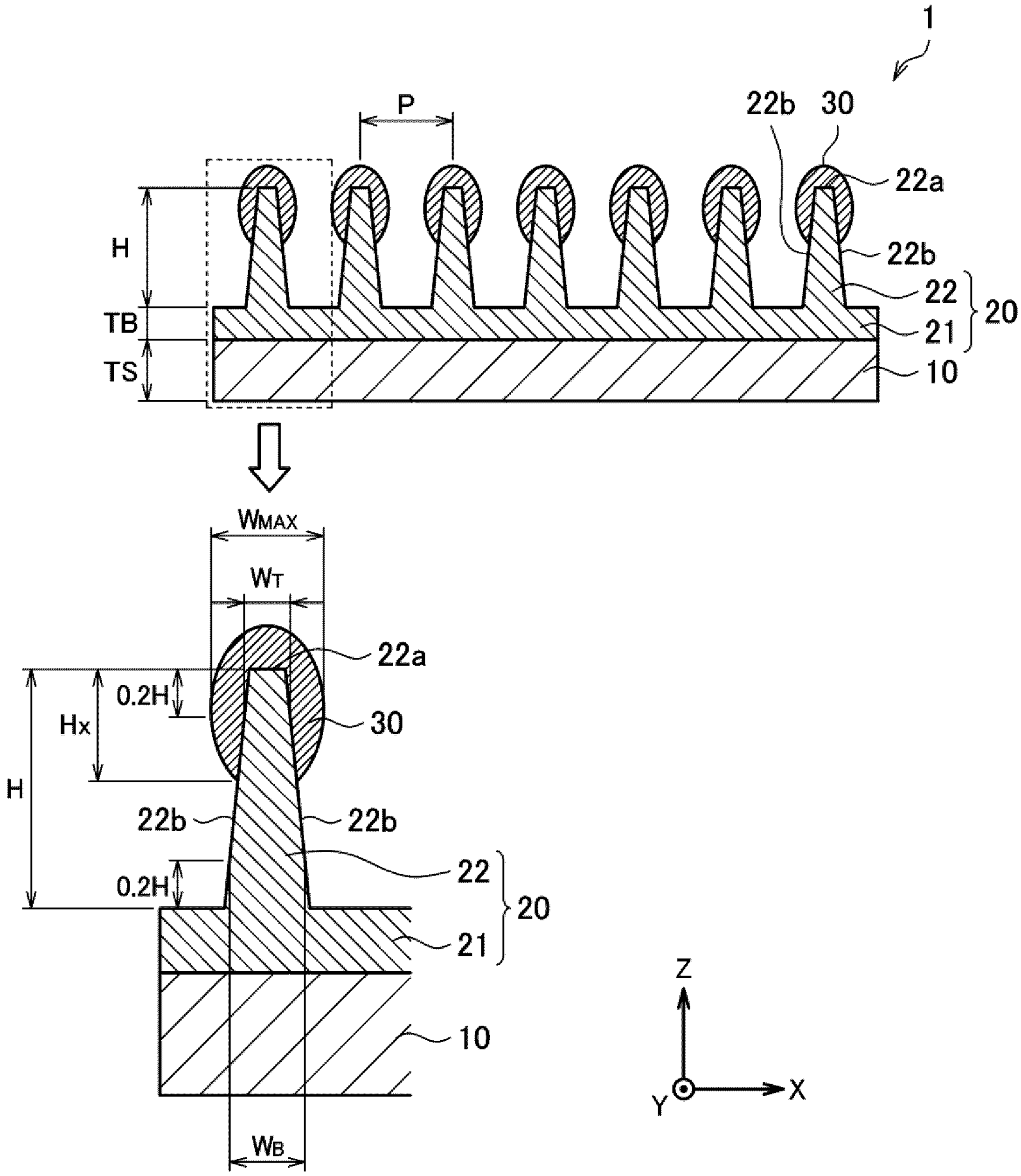
1
P
22b
30
22a
22b
22
20
21
10
H
TB
TS
WMAX
WT
22a
0.2H
Hx
30
H
22b
22b
22
20
0.2H
21
10
WB
Z
X
Y

FIG. 2

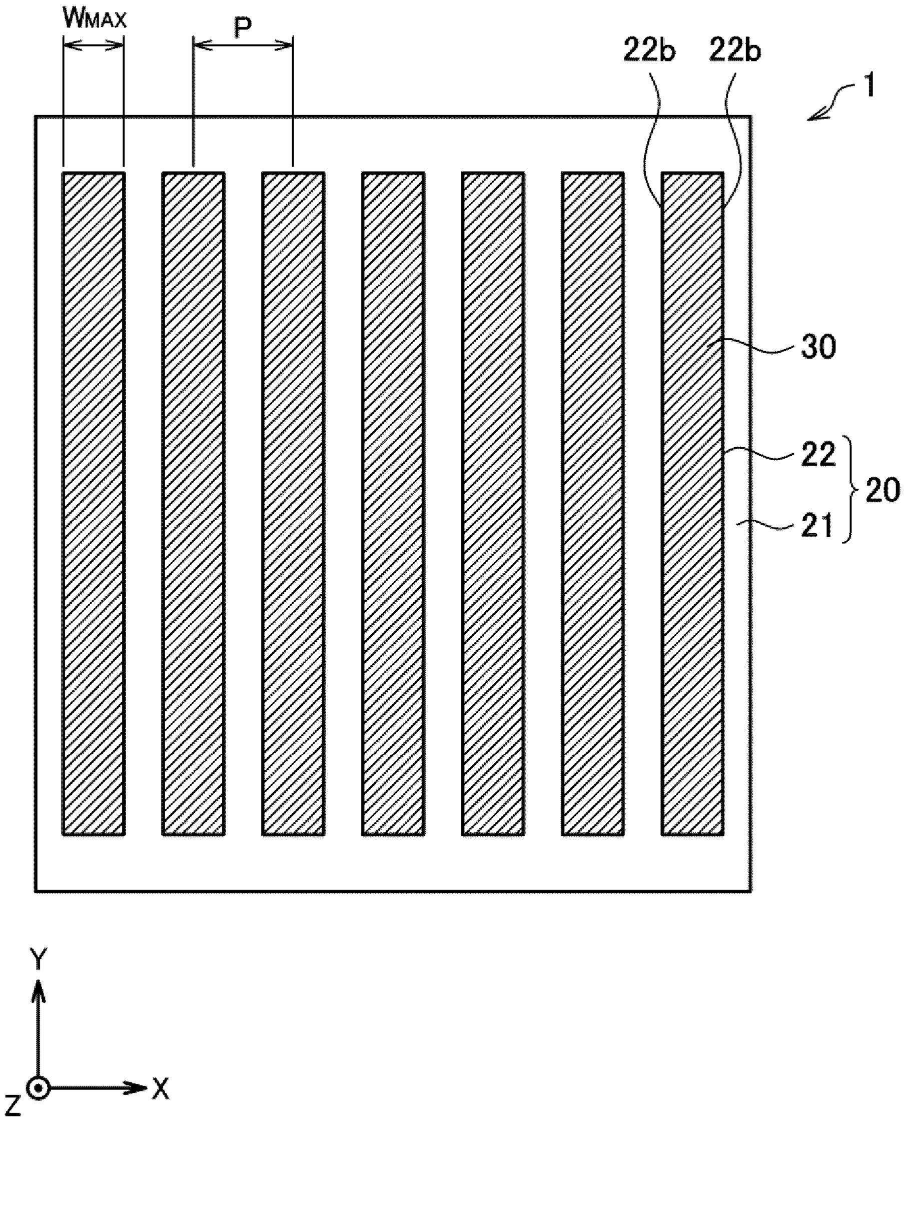

FIG. 3

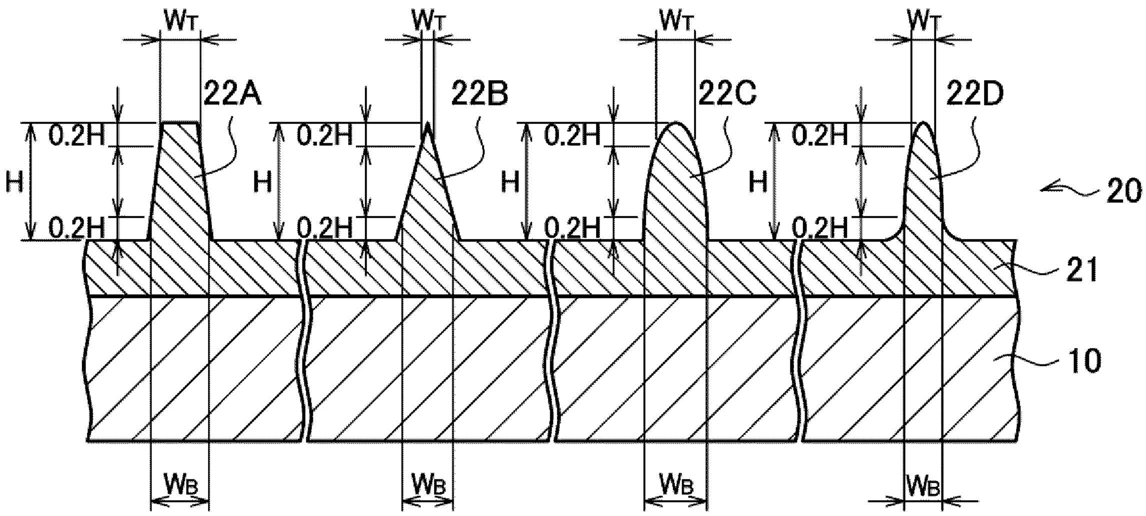
WT
WT
WT
WT
22A
22B
22C
22D
0.2H
0.2H
0.2H
0.2H
H
H
H
H
0.2H
0.2H
0.2H
0.2H
20
21
10
WB
WB
WB
WB

FIG. 4

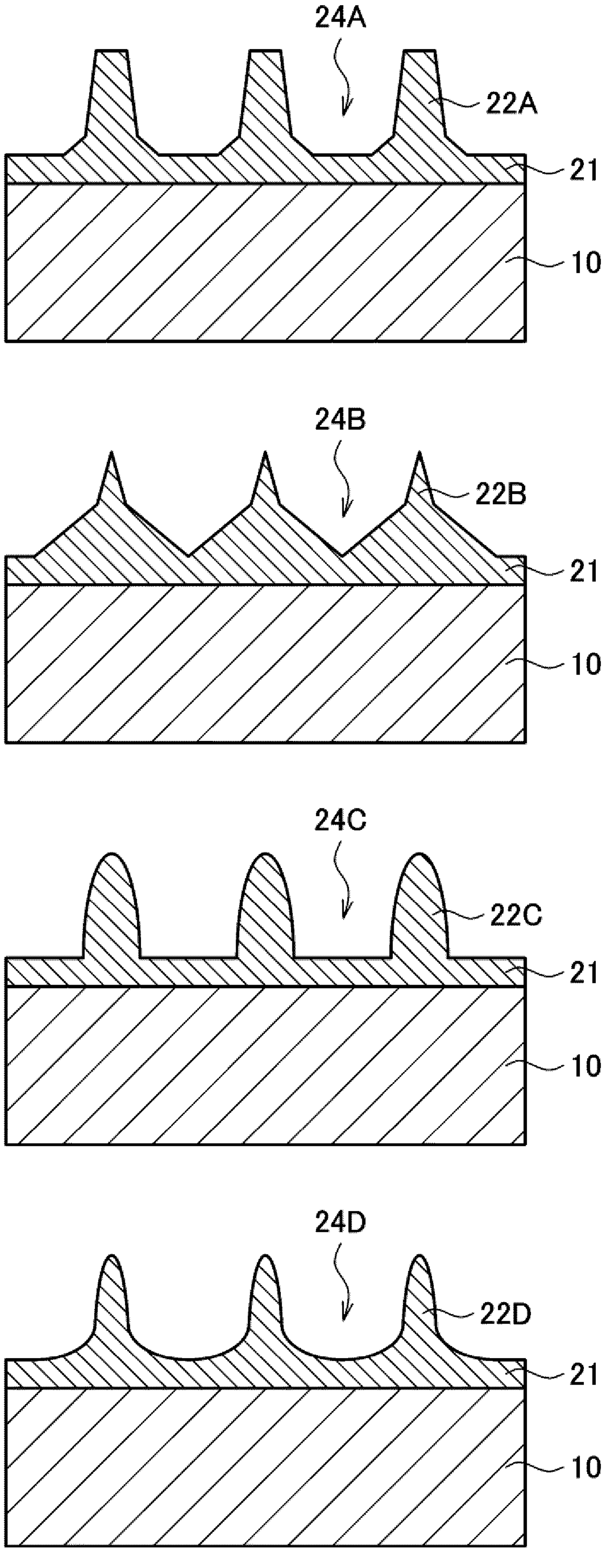

FIG. 5

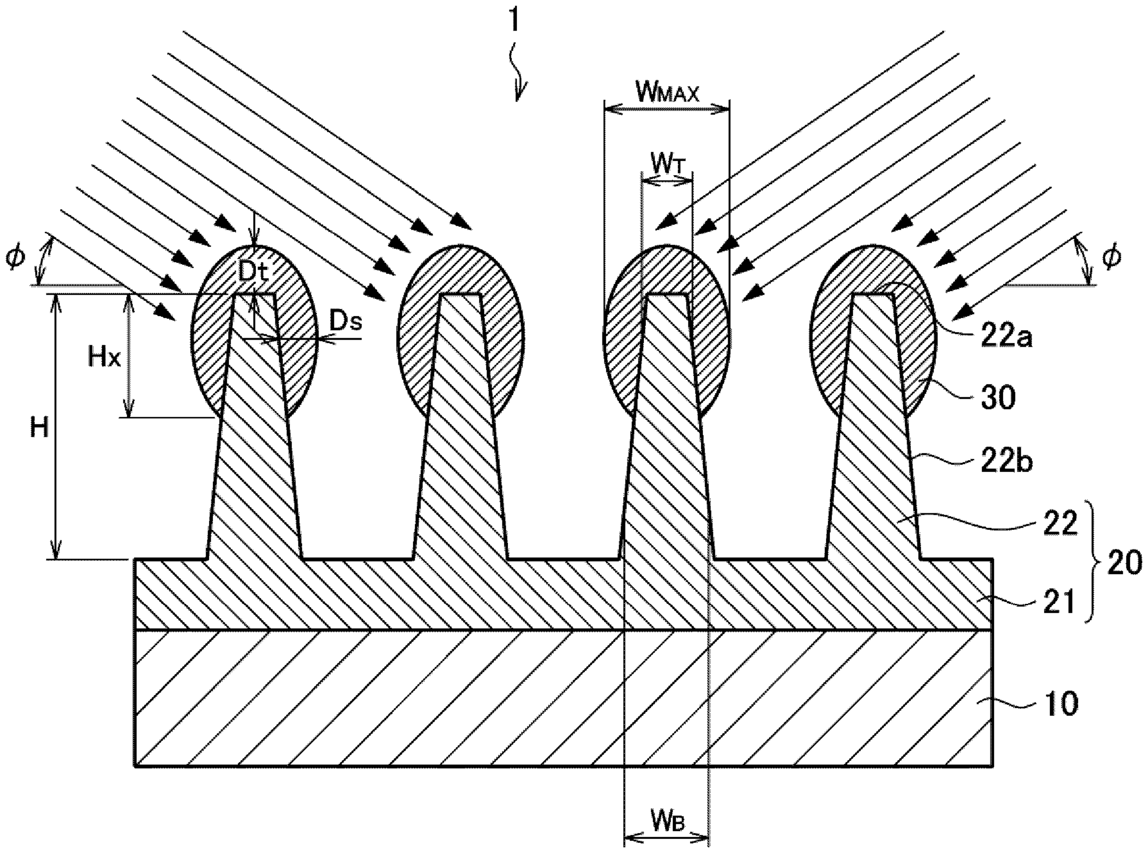

FIG. 6

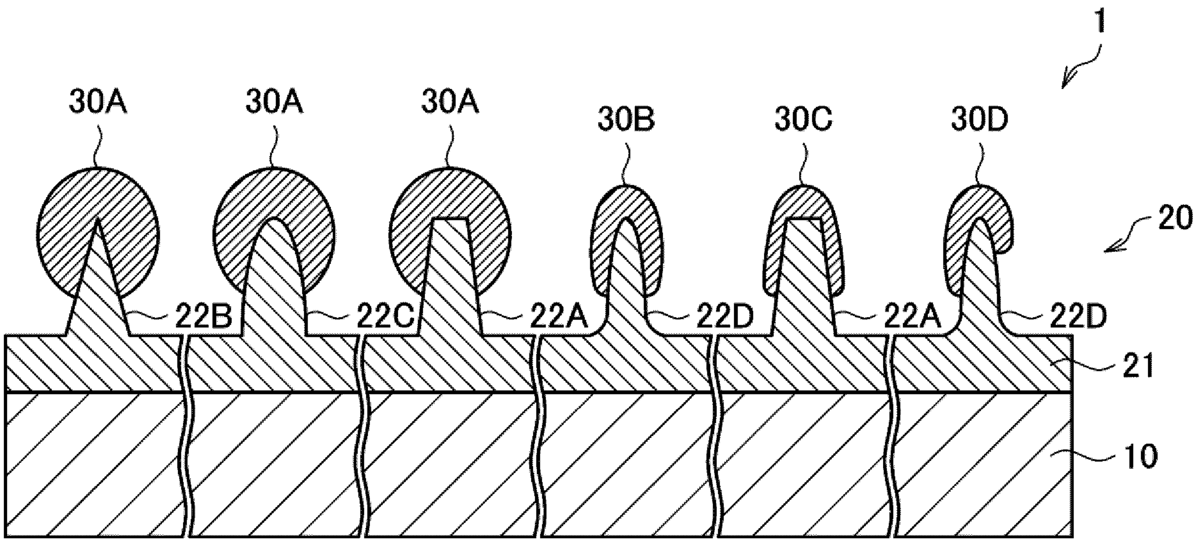

FIG. 7

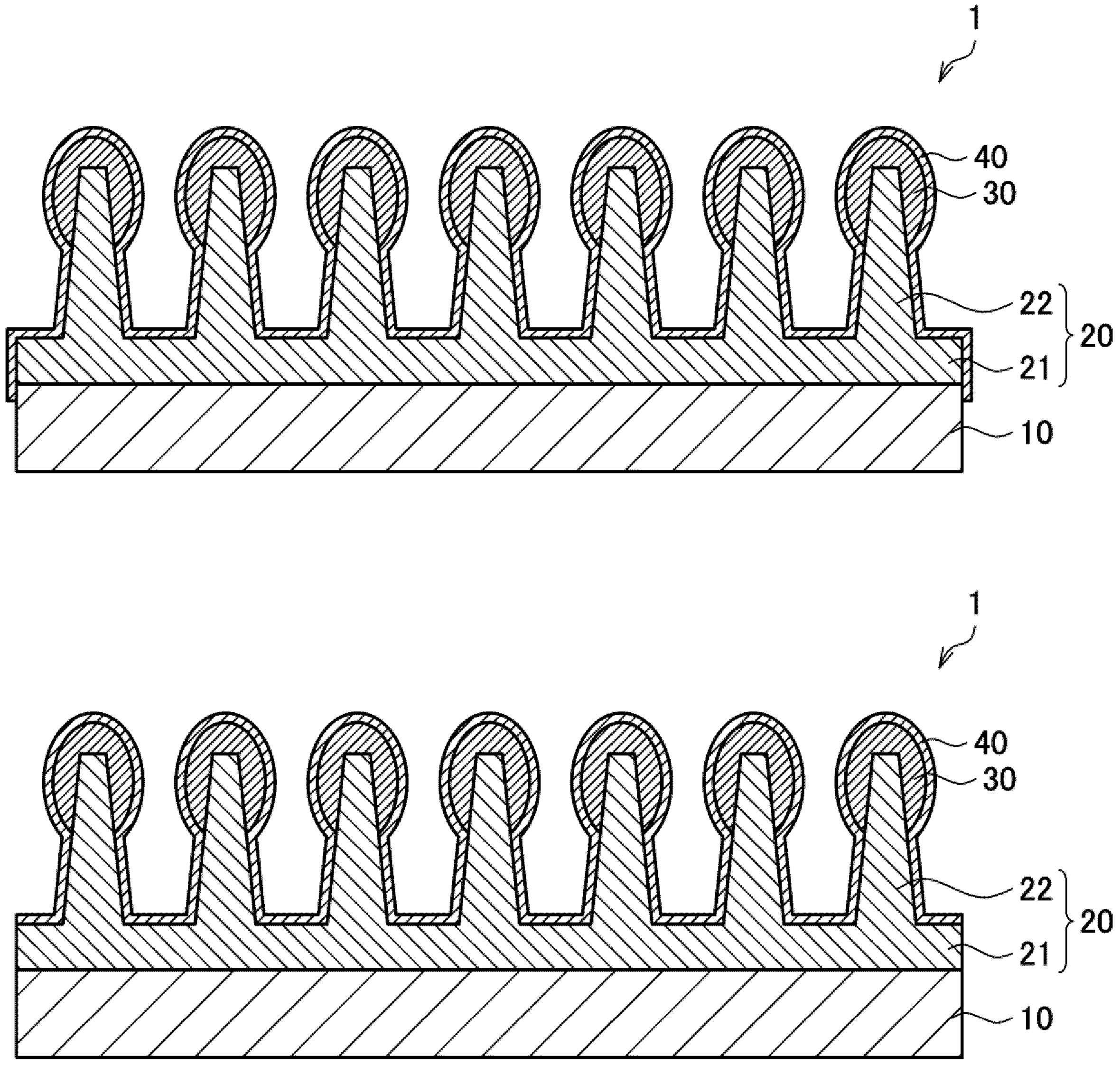

FIG. 8

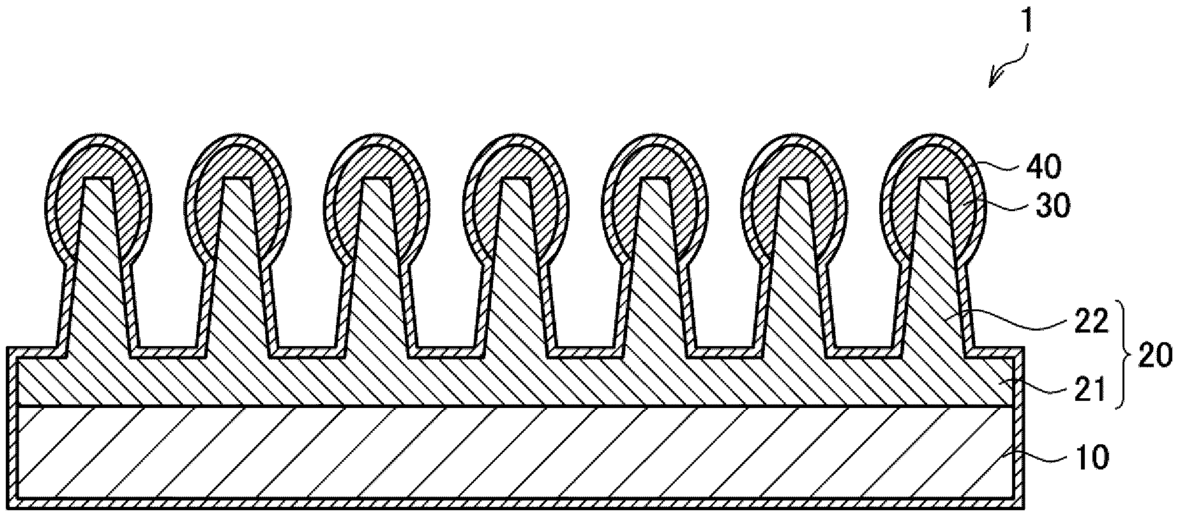

FIG. 9

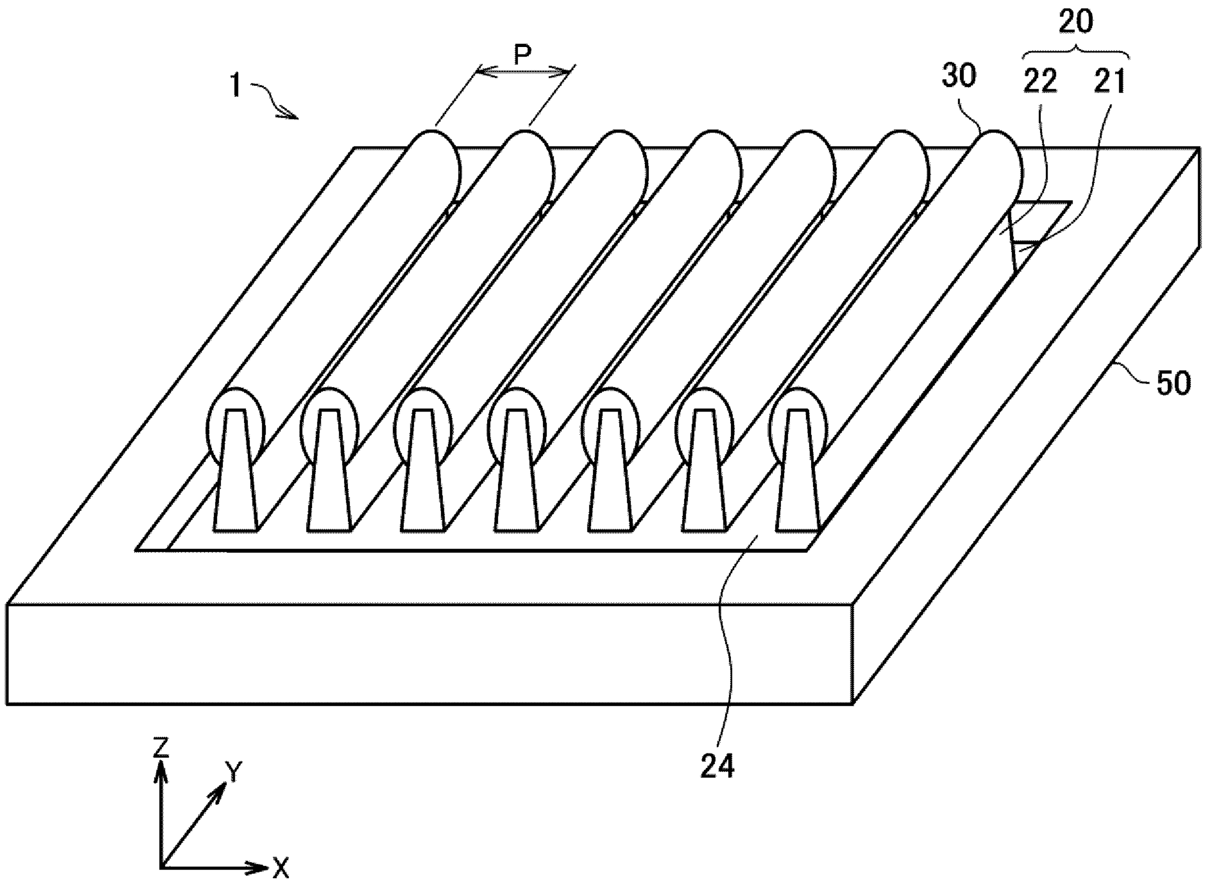

FIG. 10

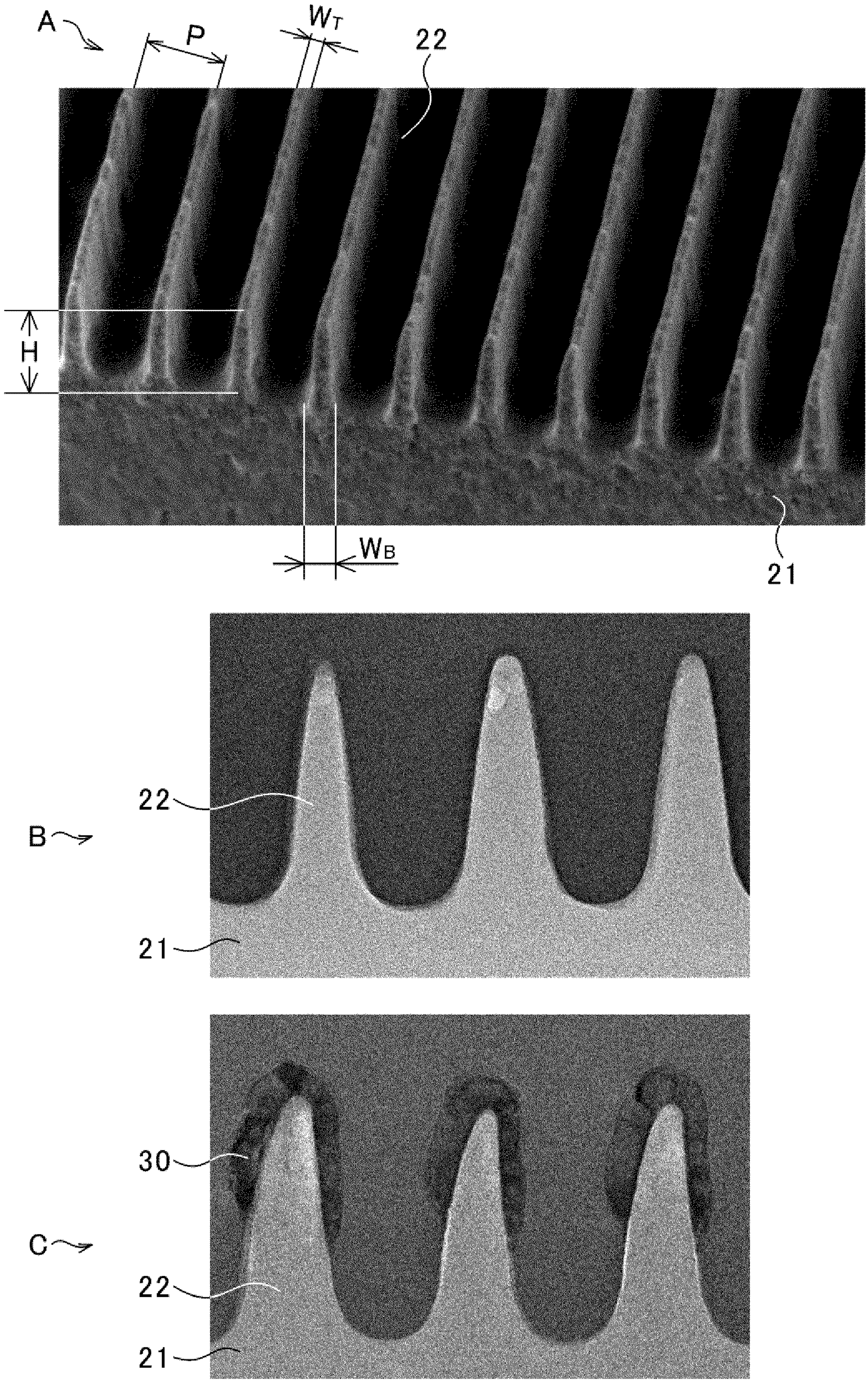

FIG. 11

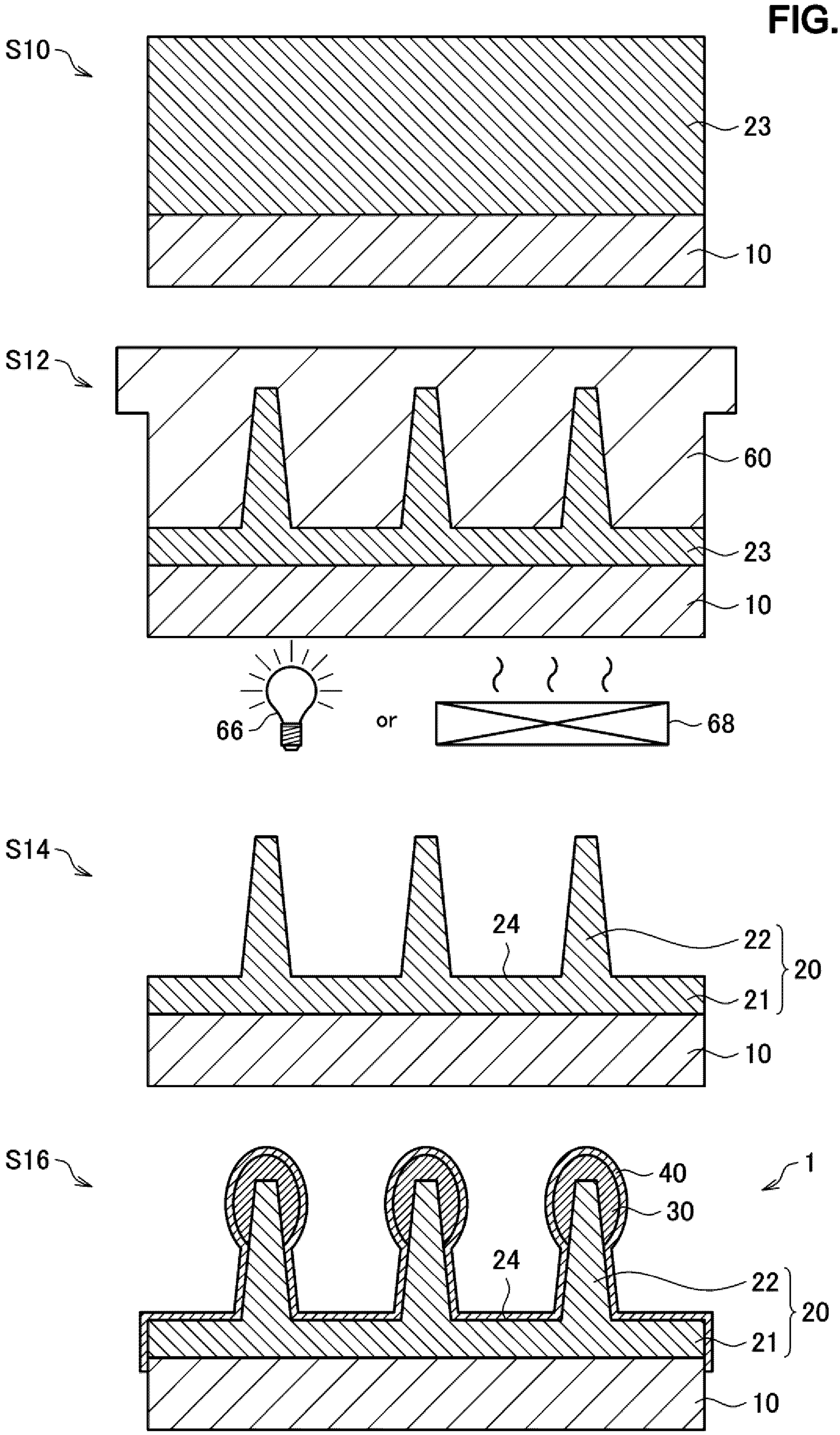
S10
23
10
S12
60
23
10
66
or
68
S14
24
22
20
21
10
S16
40
1
30
24
22
20
21
10

FIG. 12

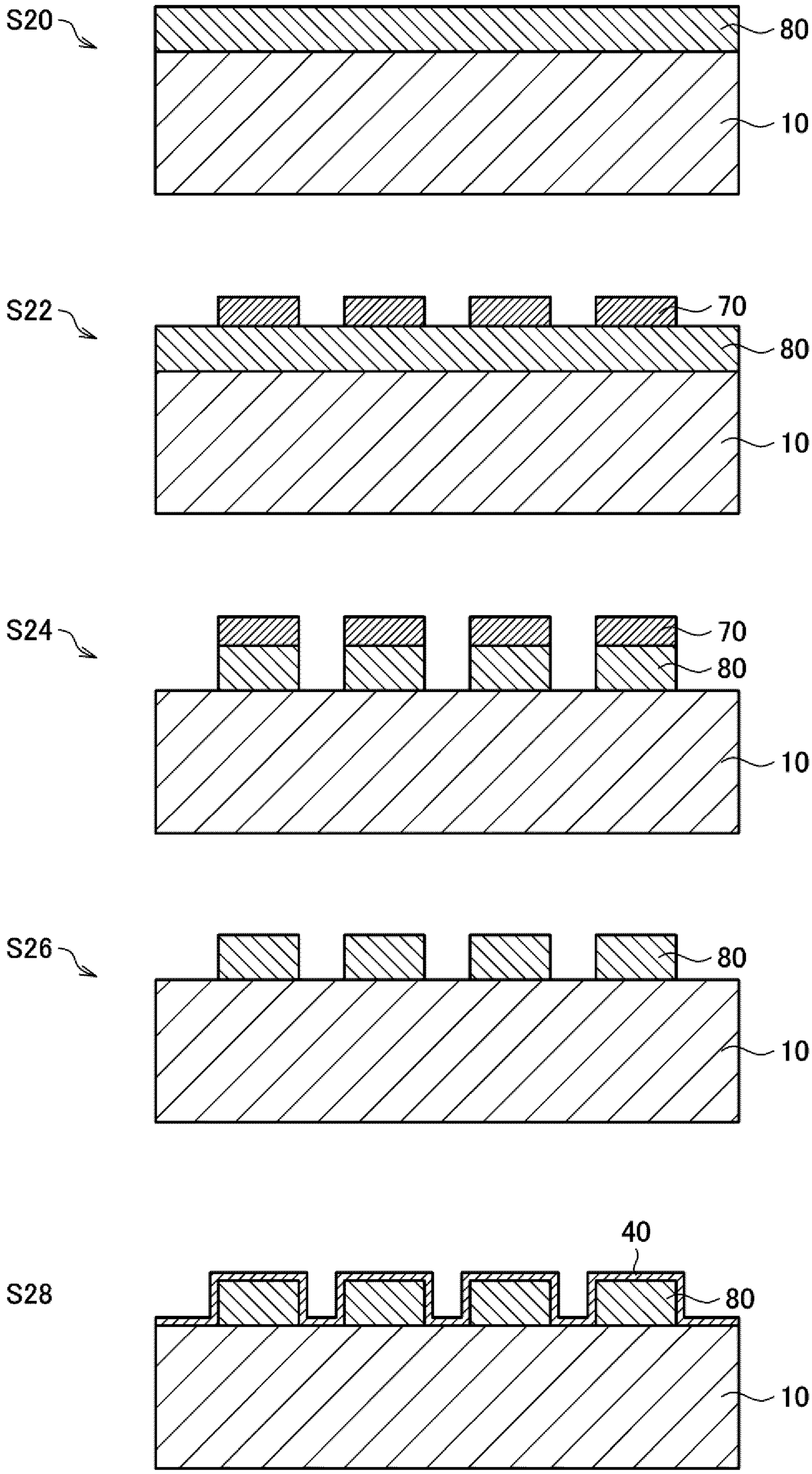

FIG. 13

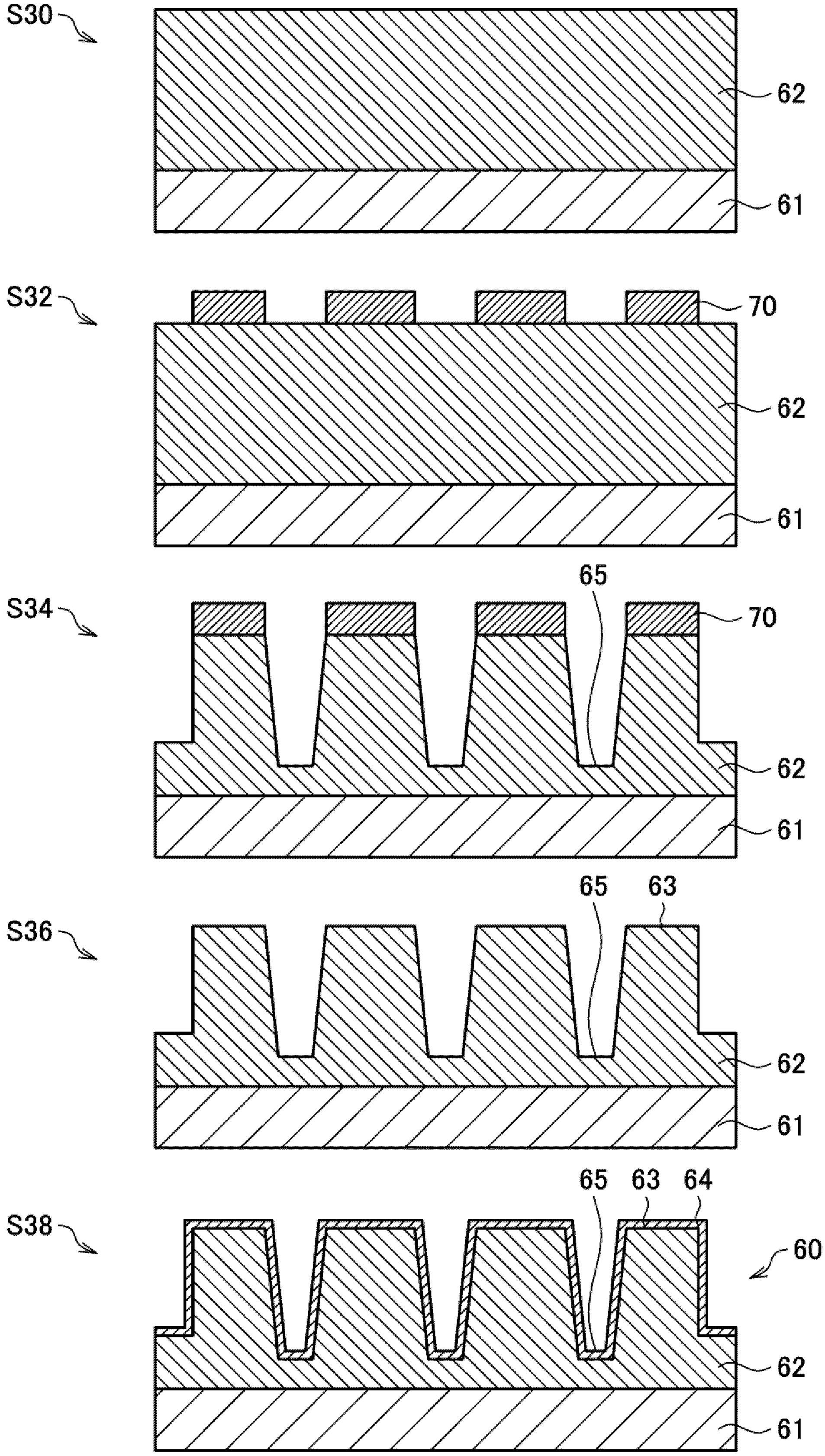
S30
62
61
S32
70
62
61
S34
65
70
62
61
S36
65
63
62
61
S38
65
63
64
60
62
61

FIG. 14

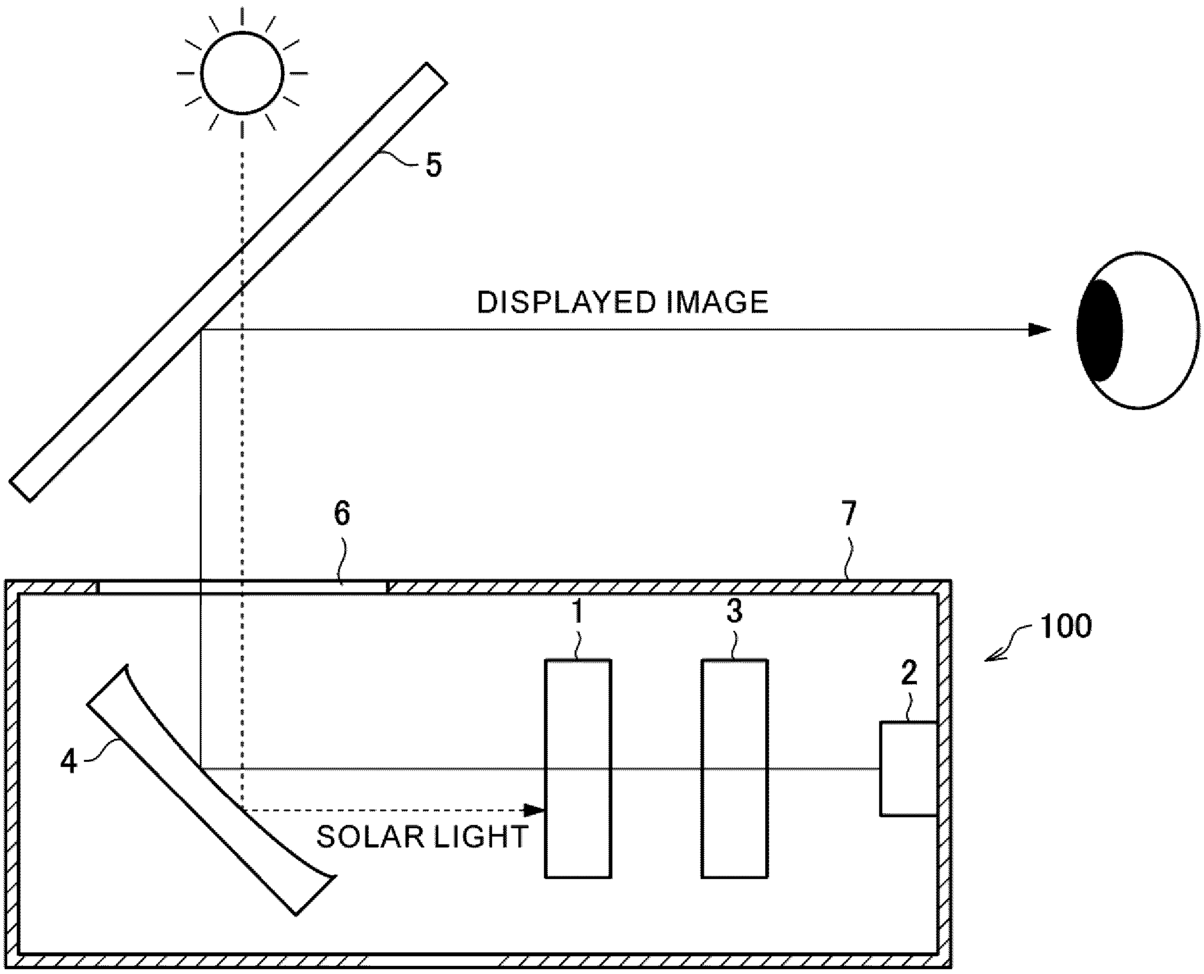

FIG. 15

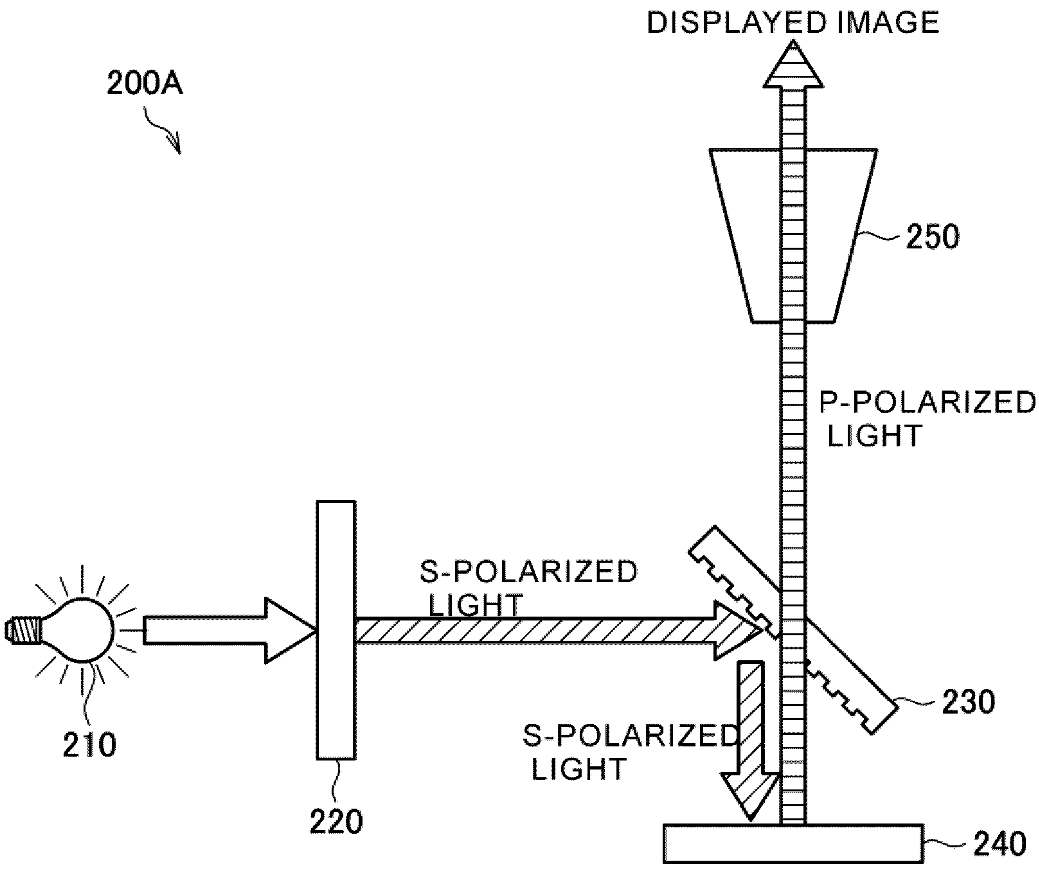

DISPLAYED IMAGE
200A
250
P-POLARIZED
LIGHT
S-POLARIZED
LIGHT
230
S-POLARIZED
LIGHT
210
220
240

FIG. 16

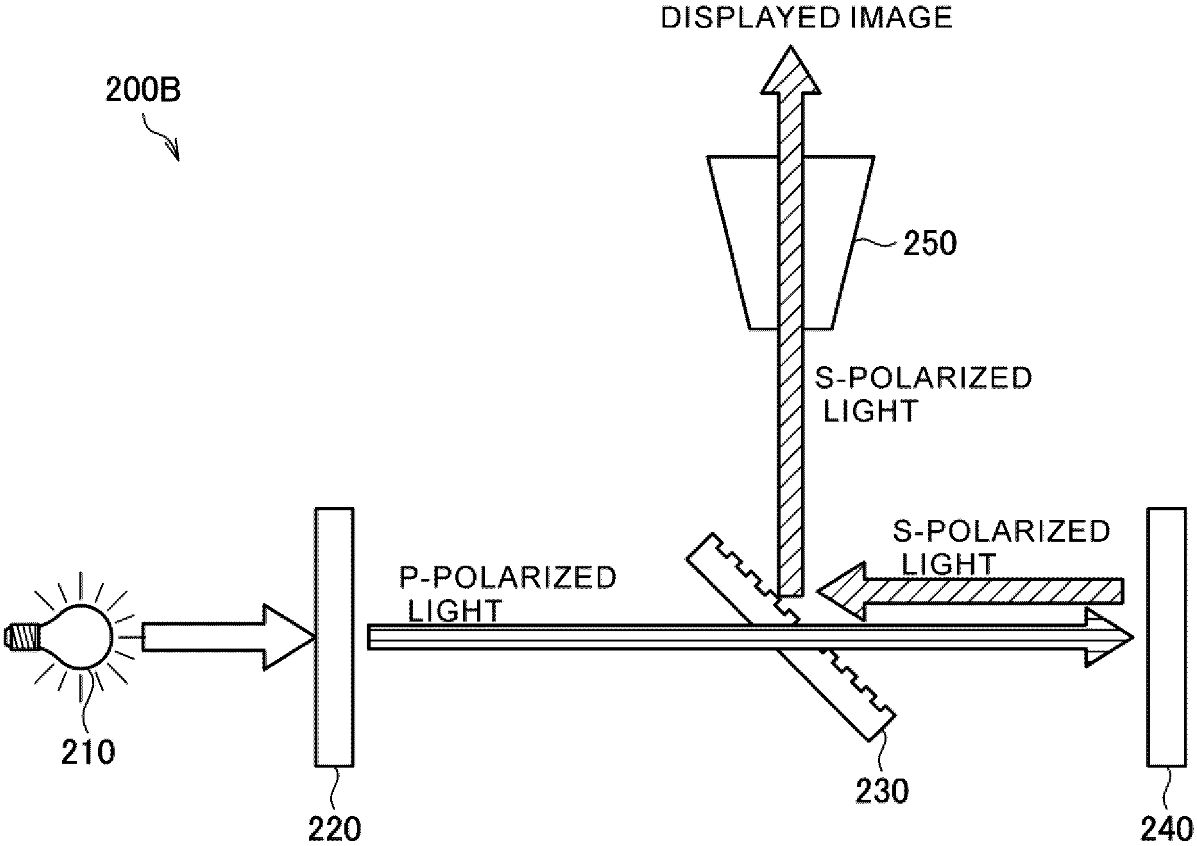
DISPLAYED IMAGE
200B
250
S-POLARIZED LIGHT
S-POLARIZED LIGHT
P-POLARIZED LIGHT
210
220
230
240

FIG. 17

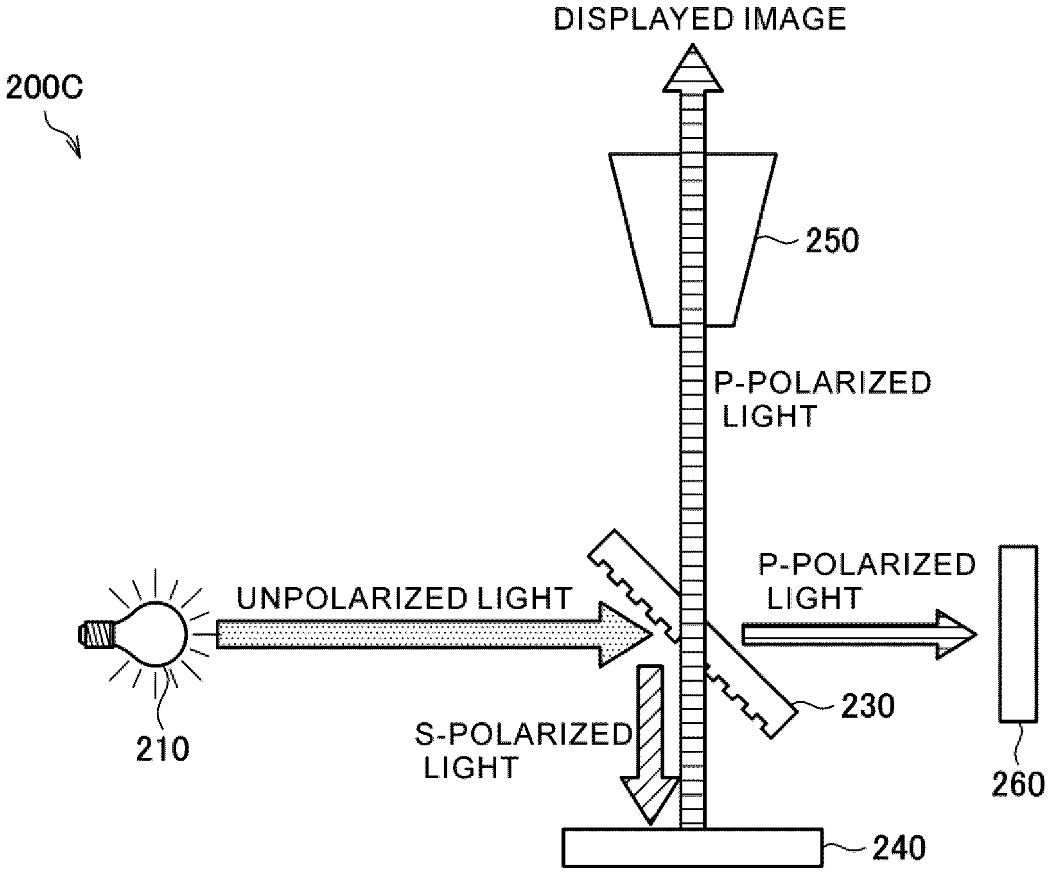
DISPLAYED IMAGE
200C
250
P-POLARIZED LIGHT
P-POLARIZED LIGHT
UNPOLARIZED LIGHT
230
S-POLARIZED LIGHT
210
260
240

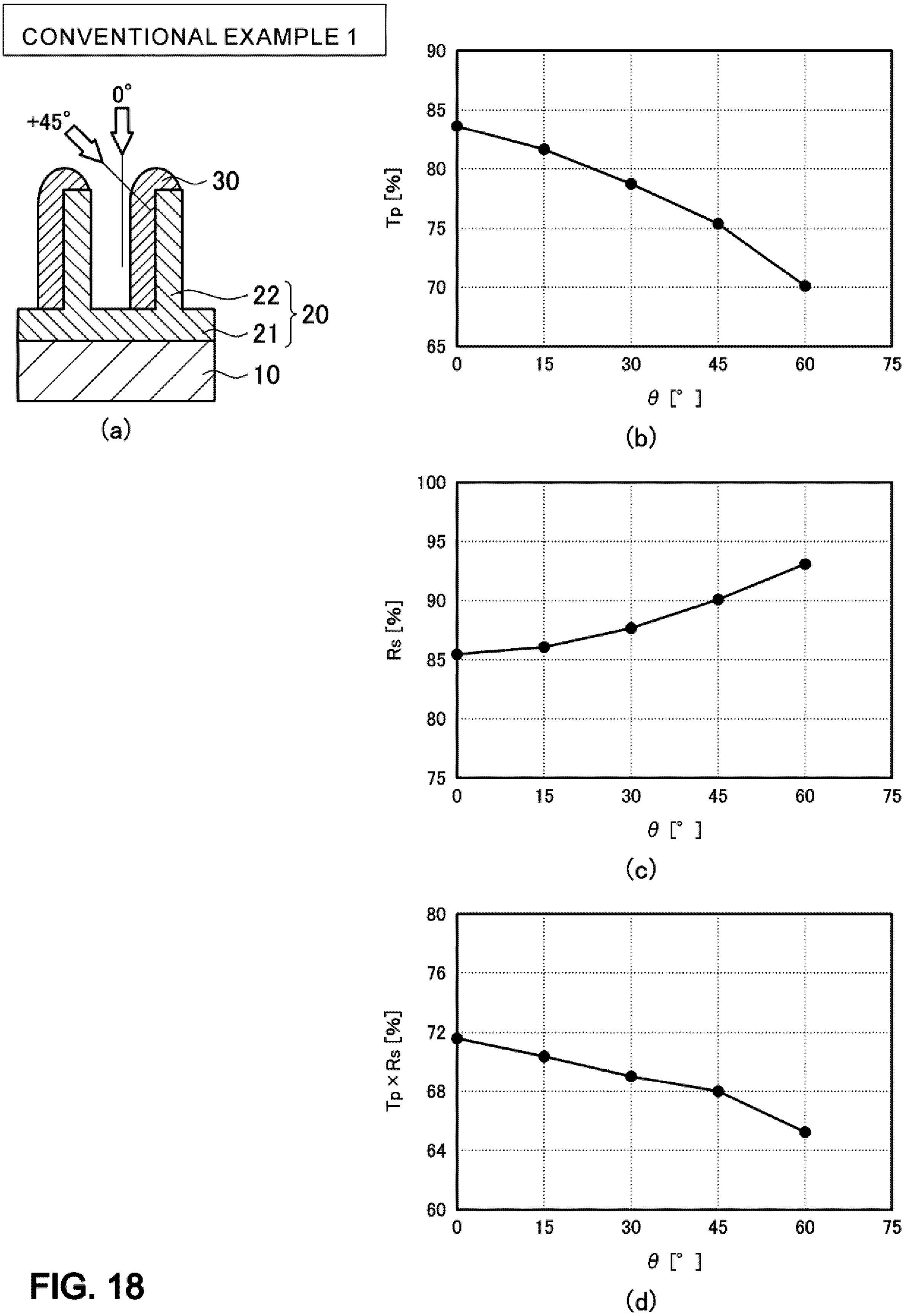
CONVENTIONAL EXAMPLE 1
0°
+45°
30
22
20
21
10
(a)
90
85
80
75
70
65
Tp [%]
0
15
30
45
60
75
θ [° ]
(b)
100
95
90
85
80
75
Rs [%]
0
15
30
45
60
75
θ [° ]
(c)
80
76
72
68
64
60
Tp × Rs [%]
0
15
30
45
60
75
θ [° ]
(d)

FIG. 18

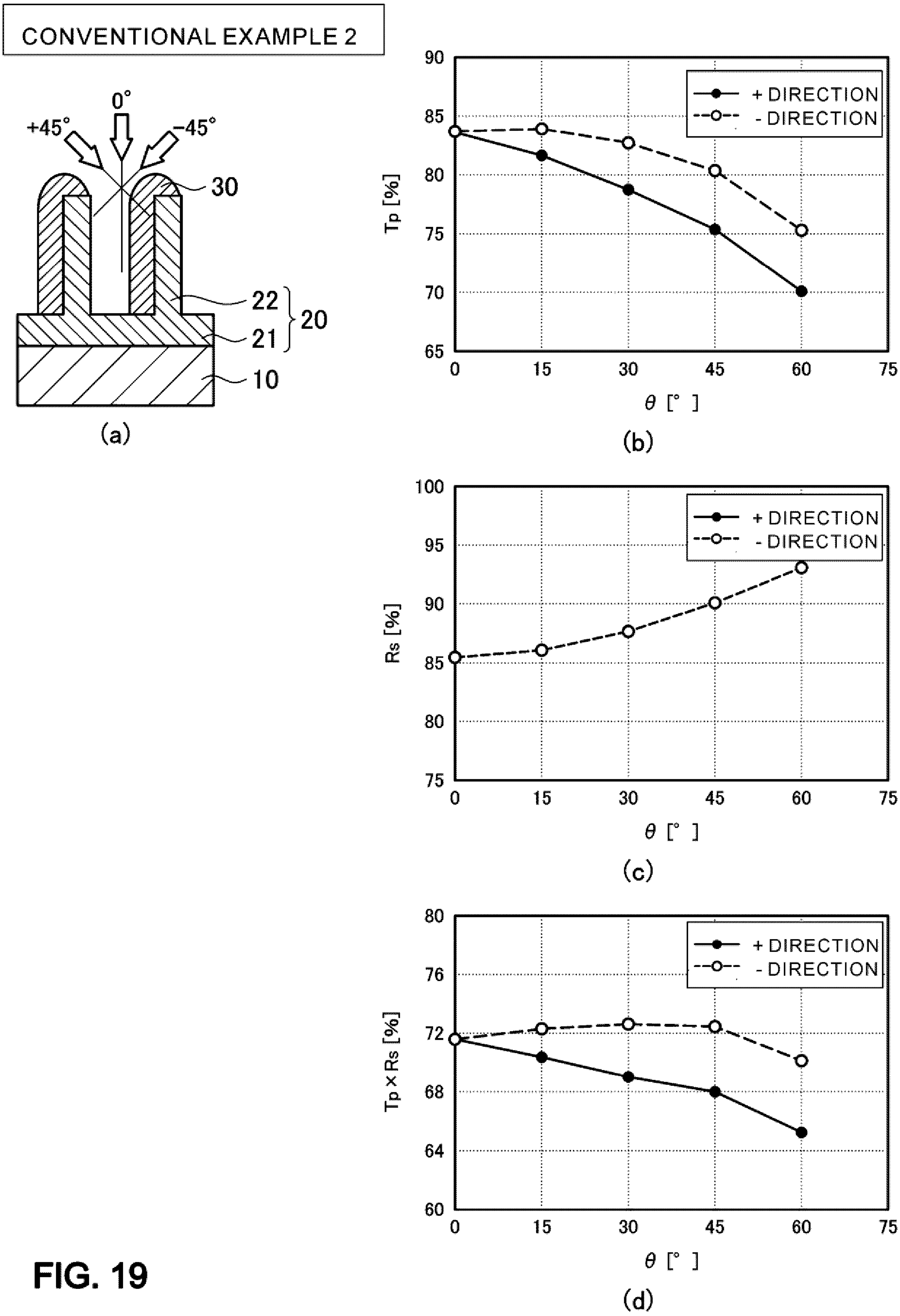
CONVENTIONAL EXAMPLE 2
0°
+45°
-45°
30
22
21
20
10
(a)
+ DIRECTION
- DIRECTION
Tp [%]
θ [° ]
(b)
Rs [%]
(c)
Tp × Rs [%]
(d)

FIG. 19

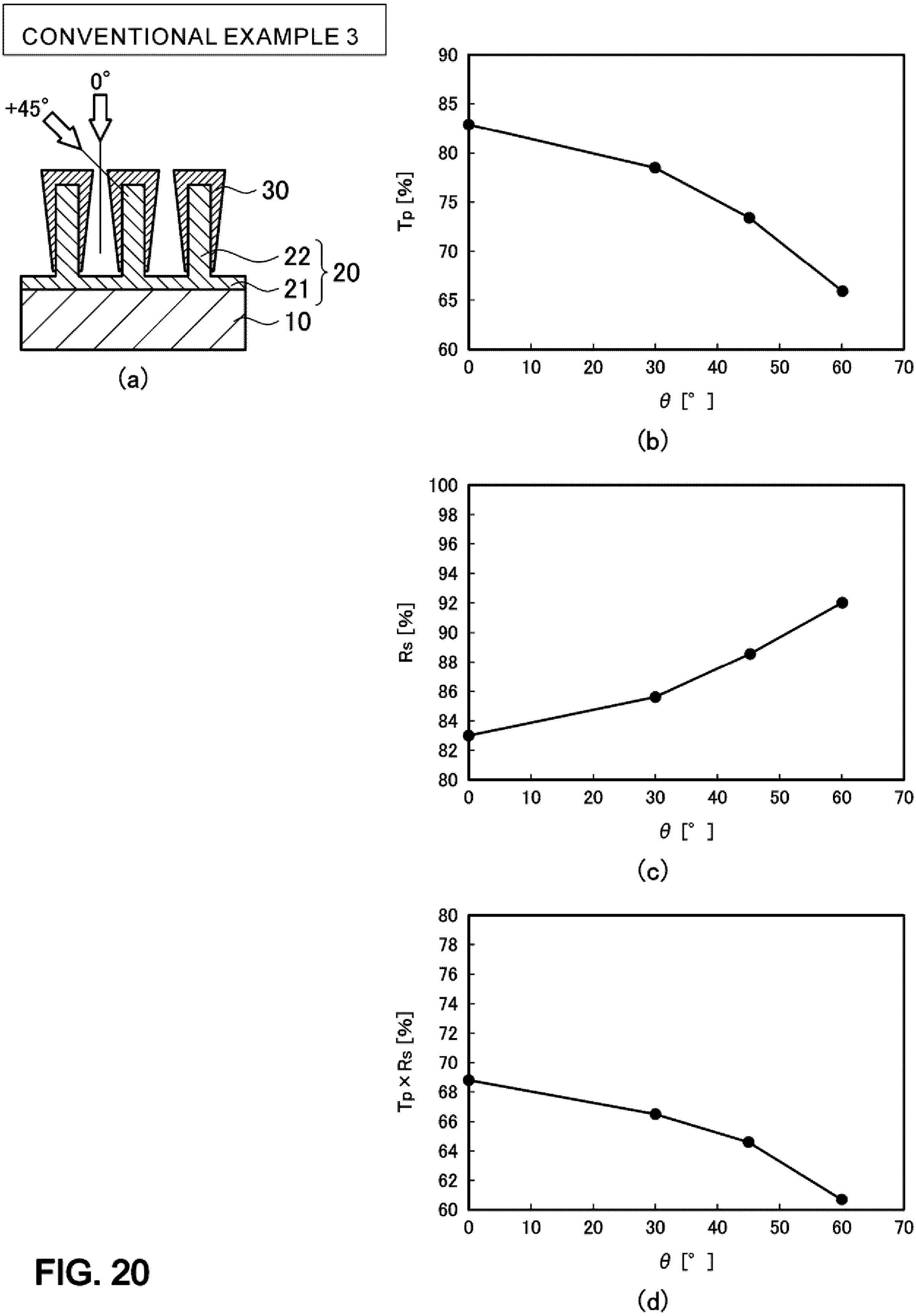


FIG. 20

EXAMPLE 1

FIG. 21

(a)

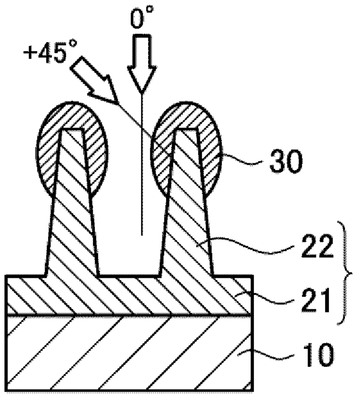


(b)

| | Tp[%] | Ts[%] | Rp[%] | Rs[%] | CR | Tp × Rs[%] |
|---|---|---|---|---|---|---|
| 430～510nm | 88.9 | 0.4 | 0.3 | 90.8 | 201 | 80.7 |
| 520～590nm | 88.2 | 0.3 | 0.4 | 90.8 | 350 | 80.0 |
| 600～680nm | 84.9 | 0.2 | 0.3 | 90.1 | 485 | 76.5 |
| 430～680nm | 87.3 | 0.3 | 0.3 | 90.5 | 345 | 79.1 |

(c)

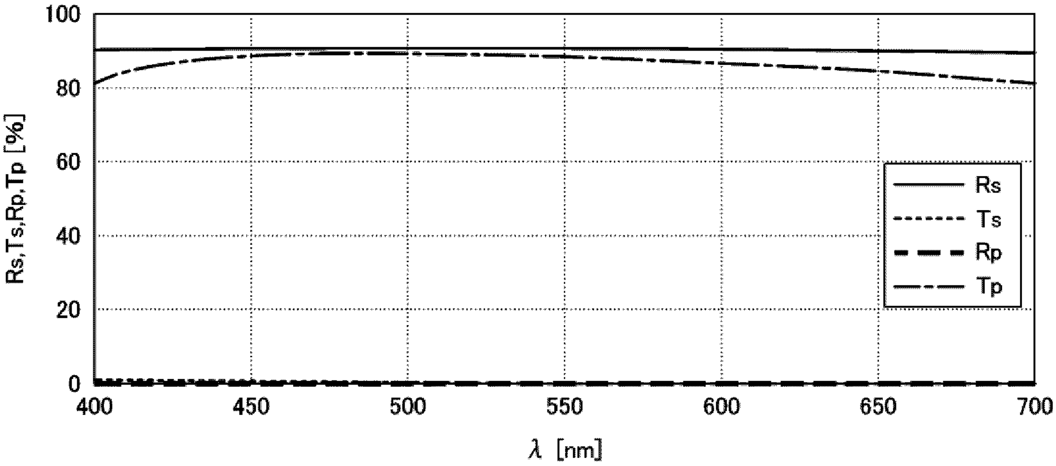


(d)

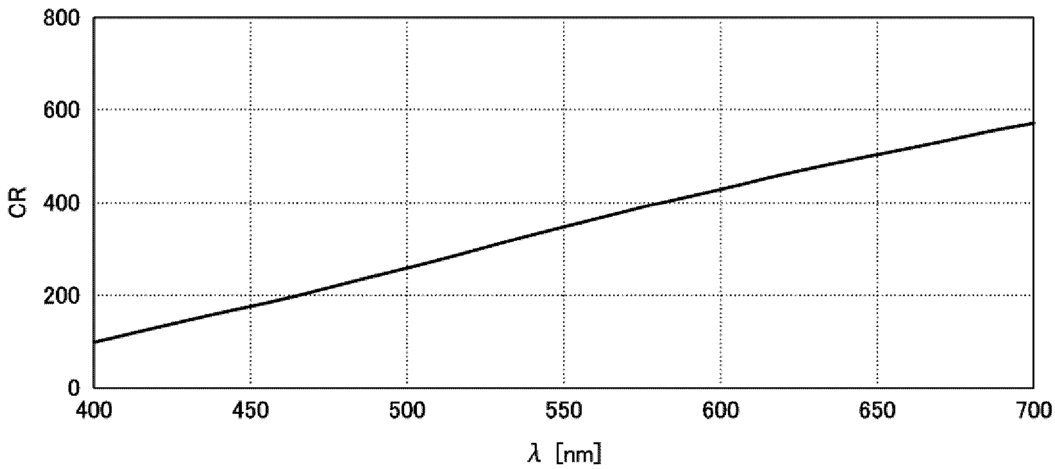

FIG. 22

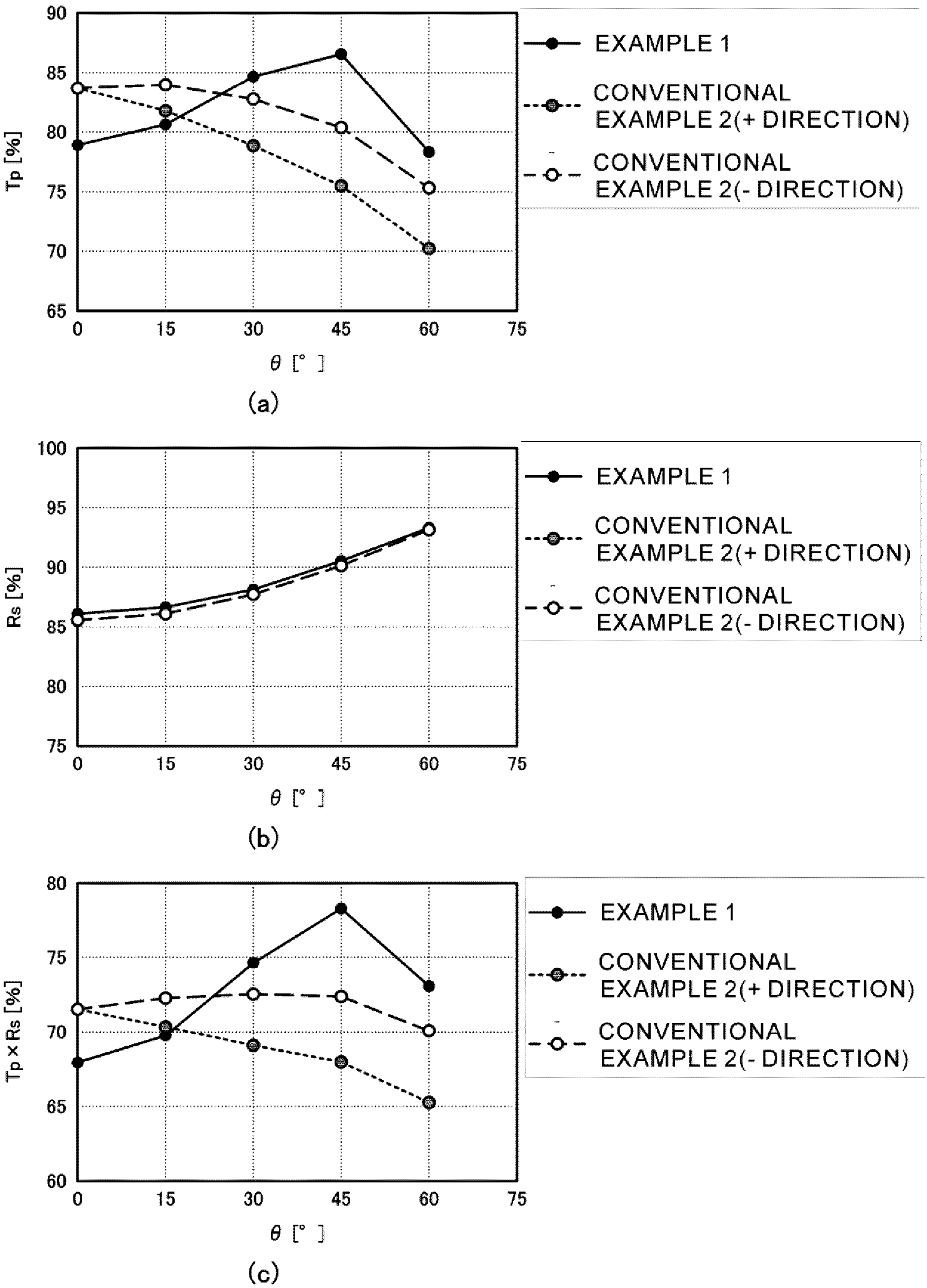
Tp [%]
θ [° ]
(a)
Rs [%]
θ [° ]
(b)
Tp × Rs [%]
θ [° ]
(c)
EXAMPLE 1
CONVENTIONAL EXAMPLE 2(+ DIRECTION)
CONVENTIONAL EXAMPLE 2(- DIRECTION)

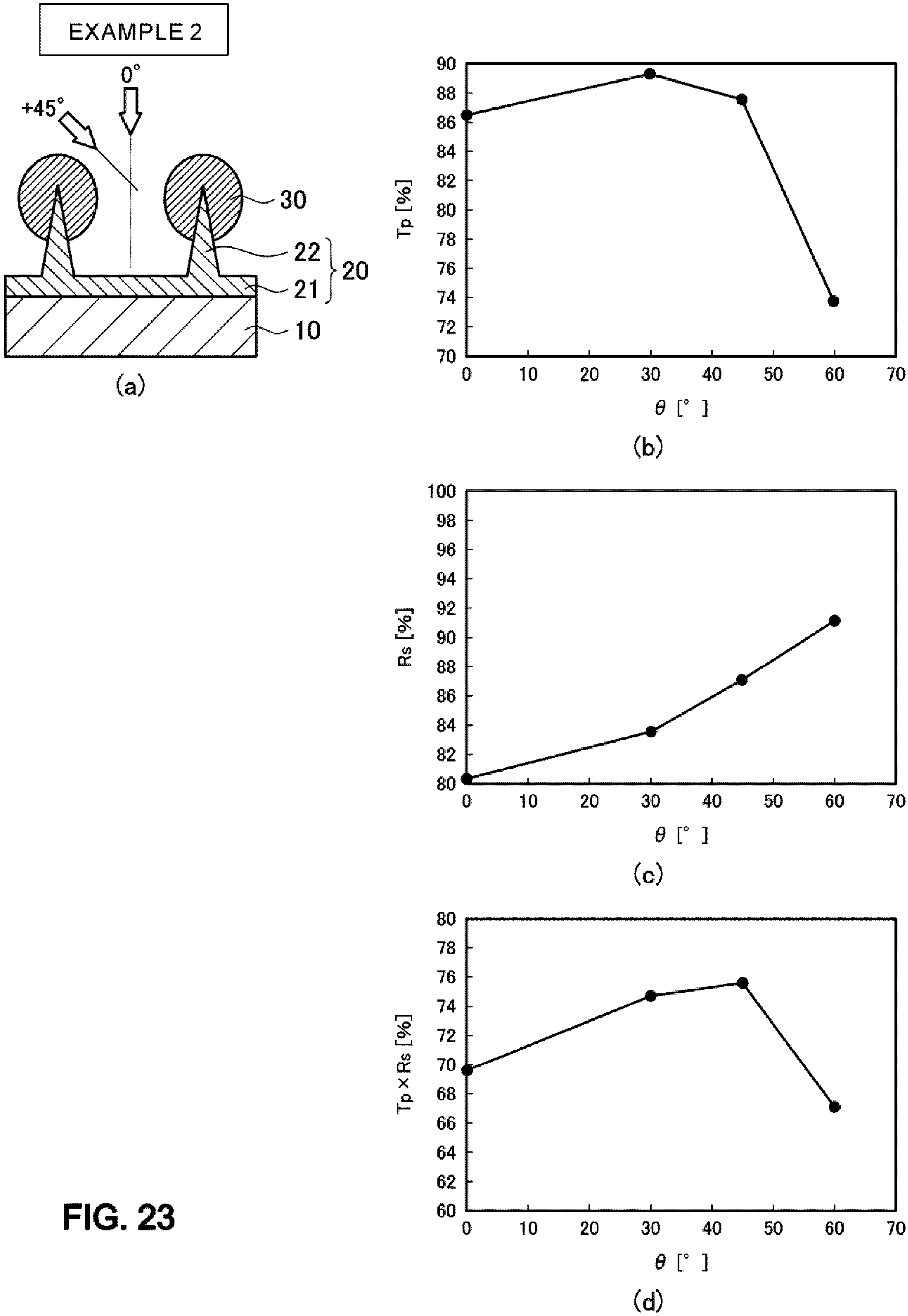


FIG. 23

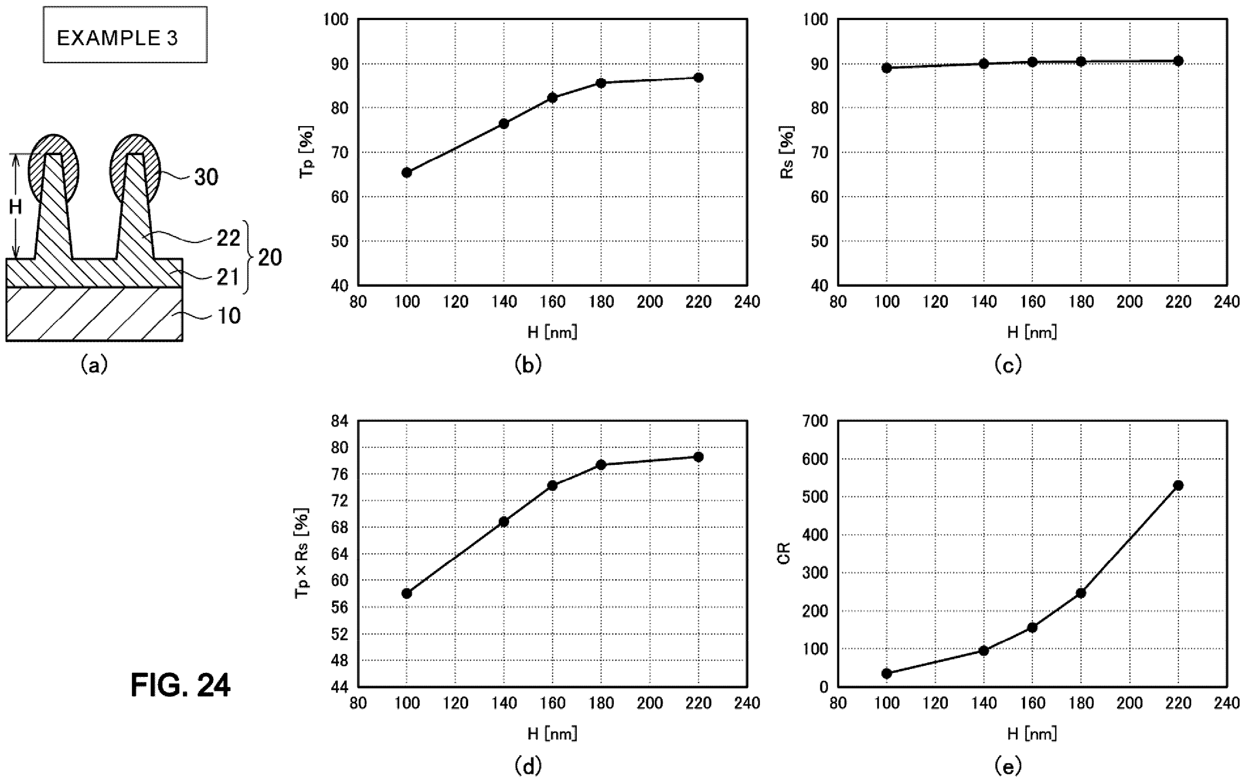


FIG. 24

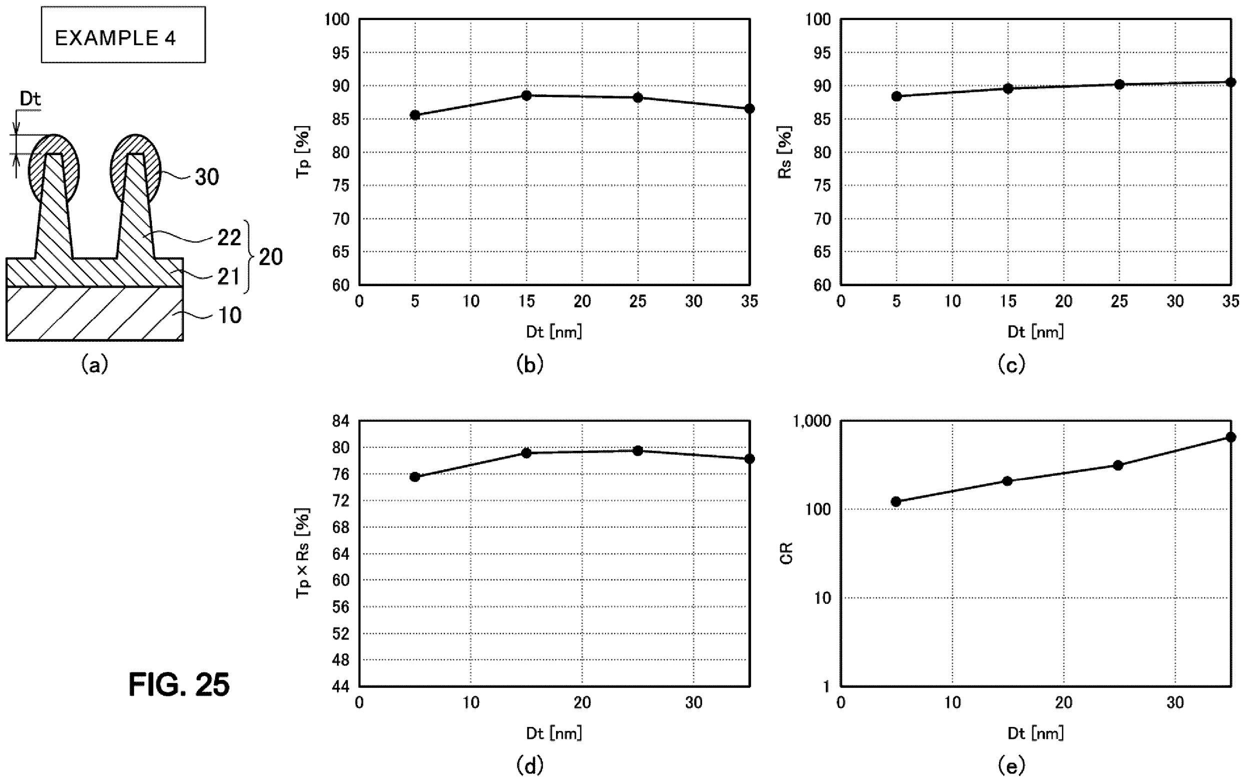
EXAMPLE 4
Dt
30
22
20
21
10
(a)
100
95
90
85
80
75
70
65
60
Tp [%]
0 5 10 15 20 25 30 35
Dt [nm]
(b)
Rs [%]
Dt [nm]
(c)
84
80
76
72
68
64
60
56
52
48
44
Tp×Rs [%]
0 10 20 30
Dt [nm]
(d)
1,000
100
10
1
CR
Dt [nm]
(e)

FIG. 25

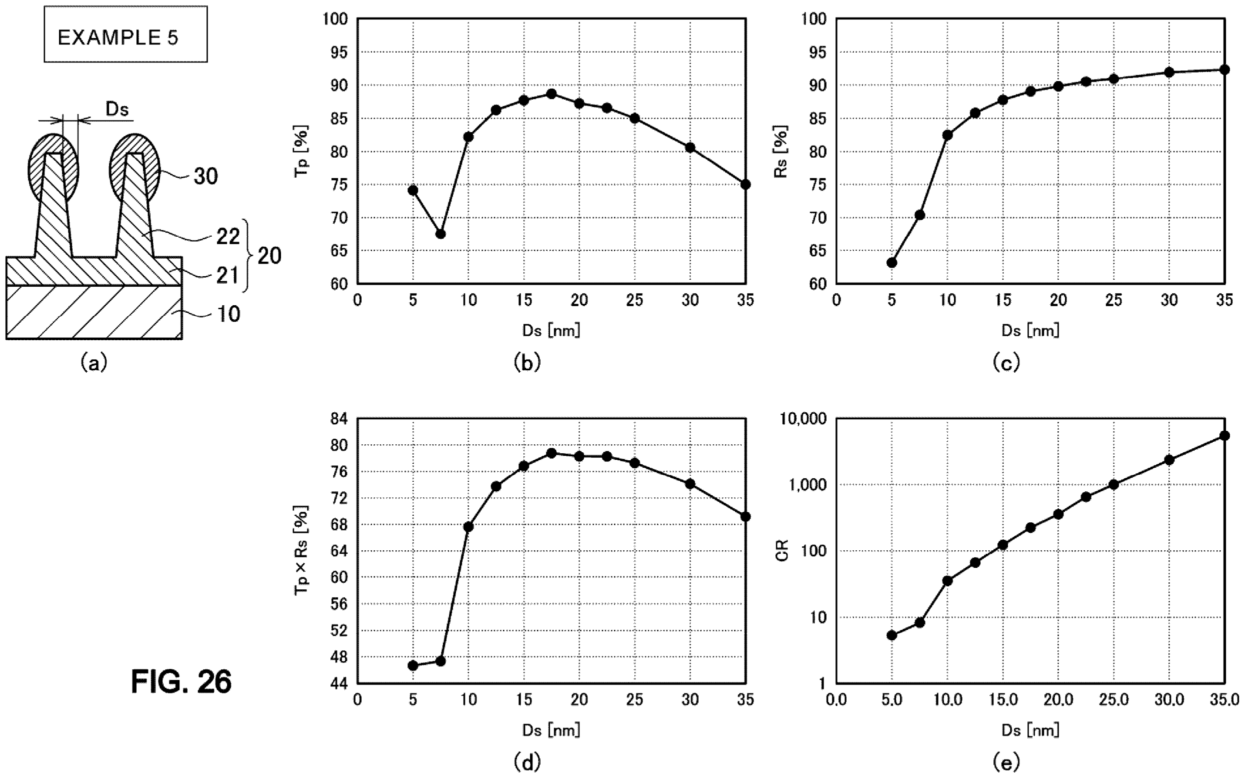
EXAMPLE 5
Ds
30
22
20
21
10
(a)
Tp [%]
Ds [nm]
(b)
Rs [%]
Ds [nm]
(c)
Tp × Rs [%]
Ds [nm]
(d)
CR
Ds [nm]
(e)

FIG. 26

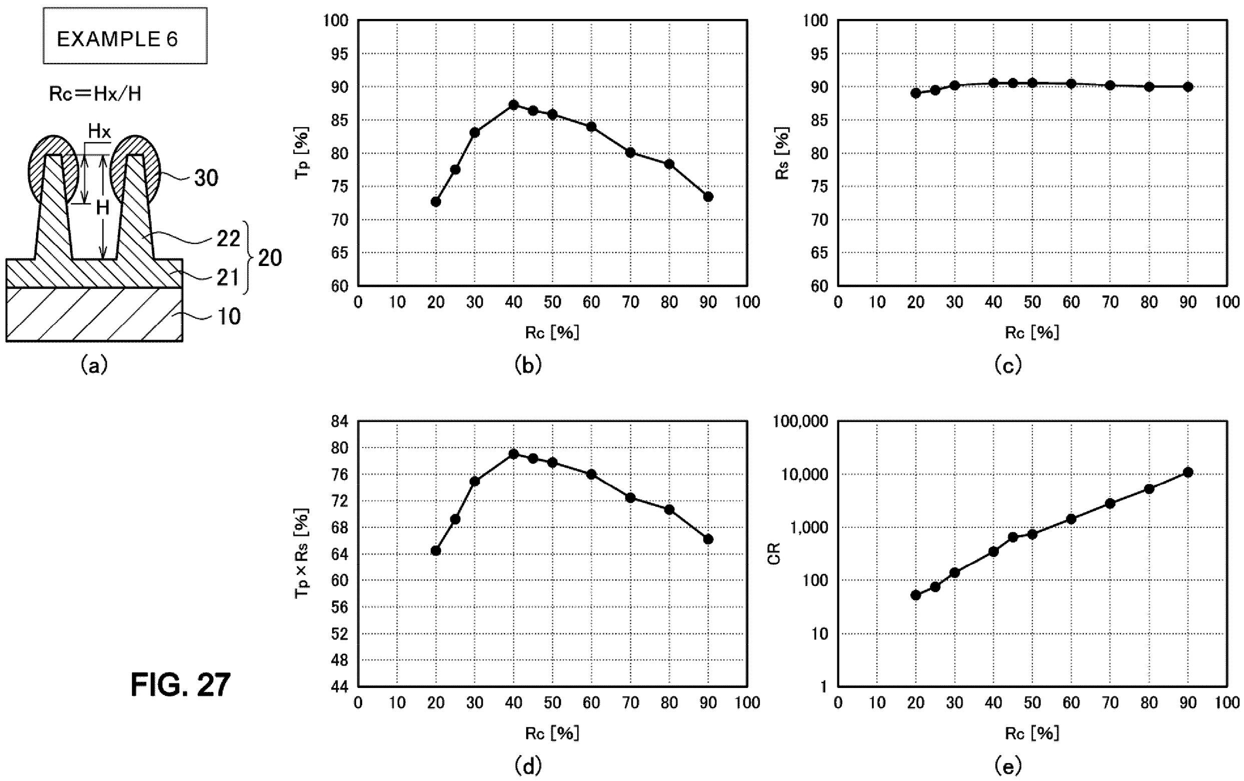


FIG. 27

FIG. 28

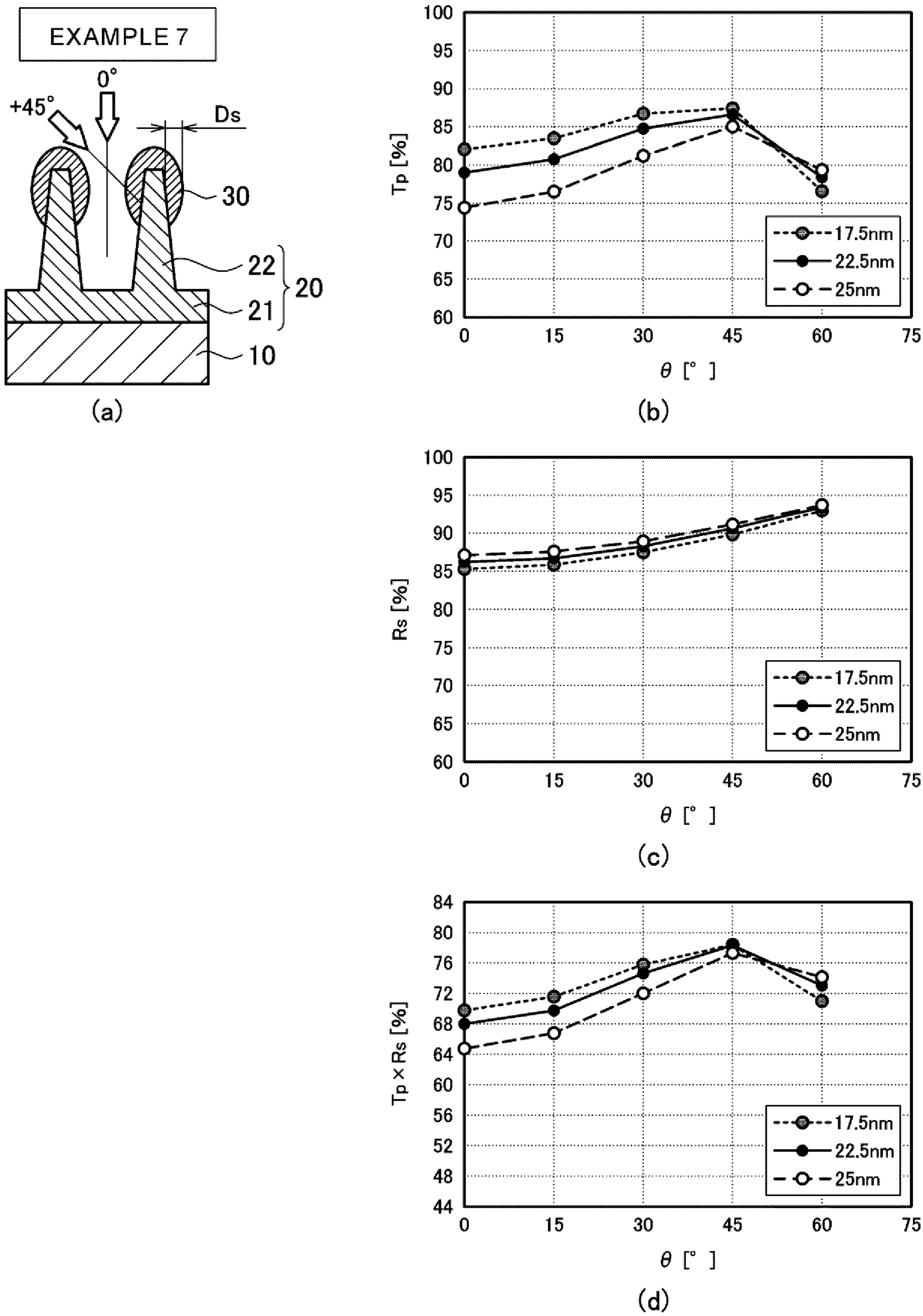
EXAMPLE 7
0°
+45°
Ds
30
22
20
21
10
(a)
Tp [%]
θ [° ]
17.5nm
22.5nm
25nm
(b)
Rs [%]
θ [° ]
17.5nm
22.5nm
25nm
(c)
Tp × Rs [%]
θ [° ]
17.5nm
22.5nm
25nm
(d)

FIG. 29

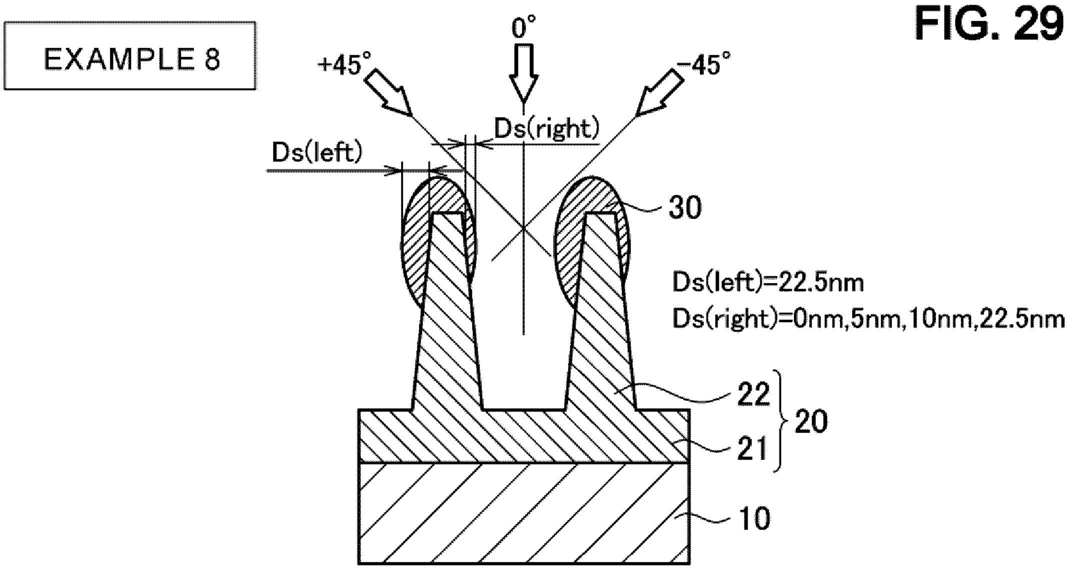
EXAMPLE 8
0°
+45°
-45°
Ds(right)
Ds(left)
30
Ds(left)=22.5nm
Ds(right)=0nm,5nm,10nm,22.5nm
22
20
21
10

(a)

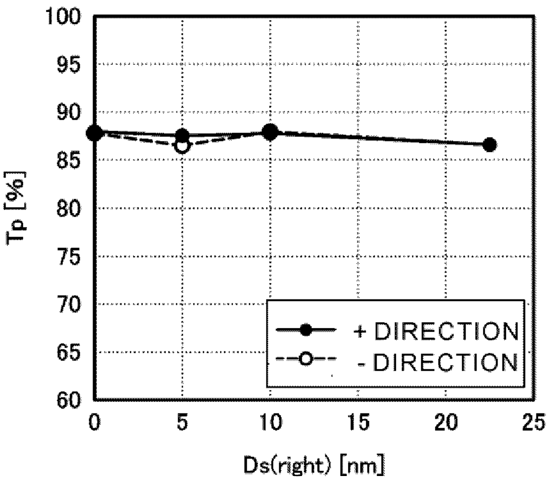
Tp [%]
Ds(right) [nm]
+ DIRECTION
- DIRECTION

(b)

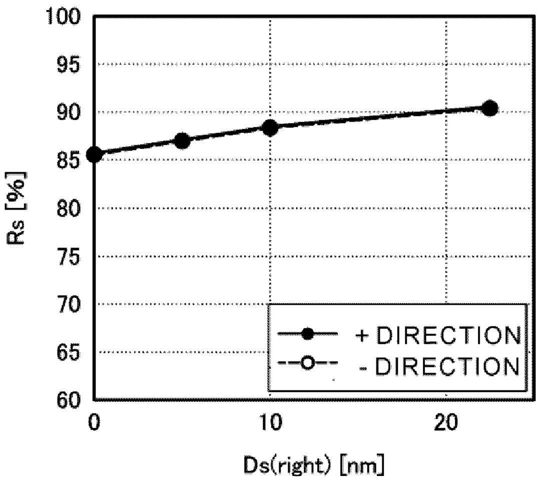
Rs [%]
Ds(right) [nm]
+ DIRECTION
- DIRECTION

(c)

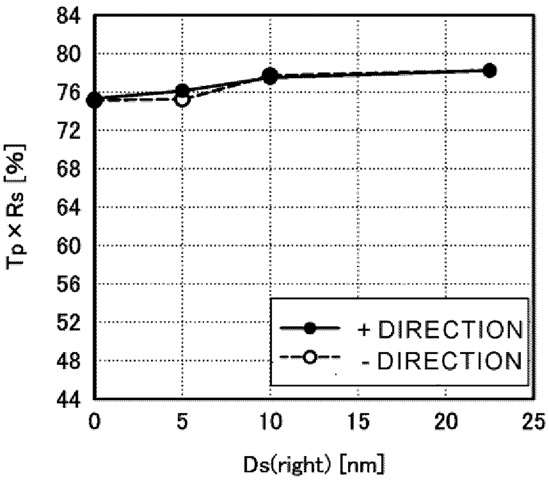
Tp × Rs [%]
Ds(right) [nm]
+ DIRECTION
- DIRECTION

(d)

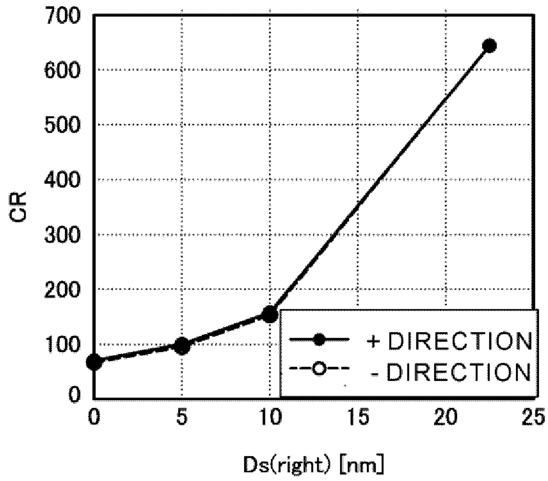
CR
Ds(right) [nm]
+ DIRECTION
- DIRECTION

(e)

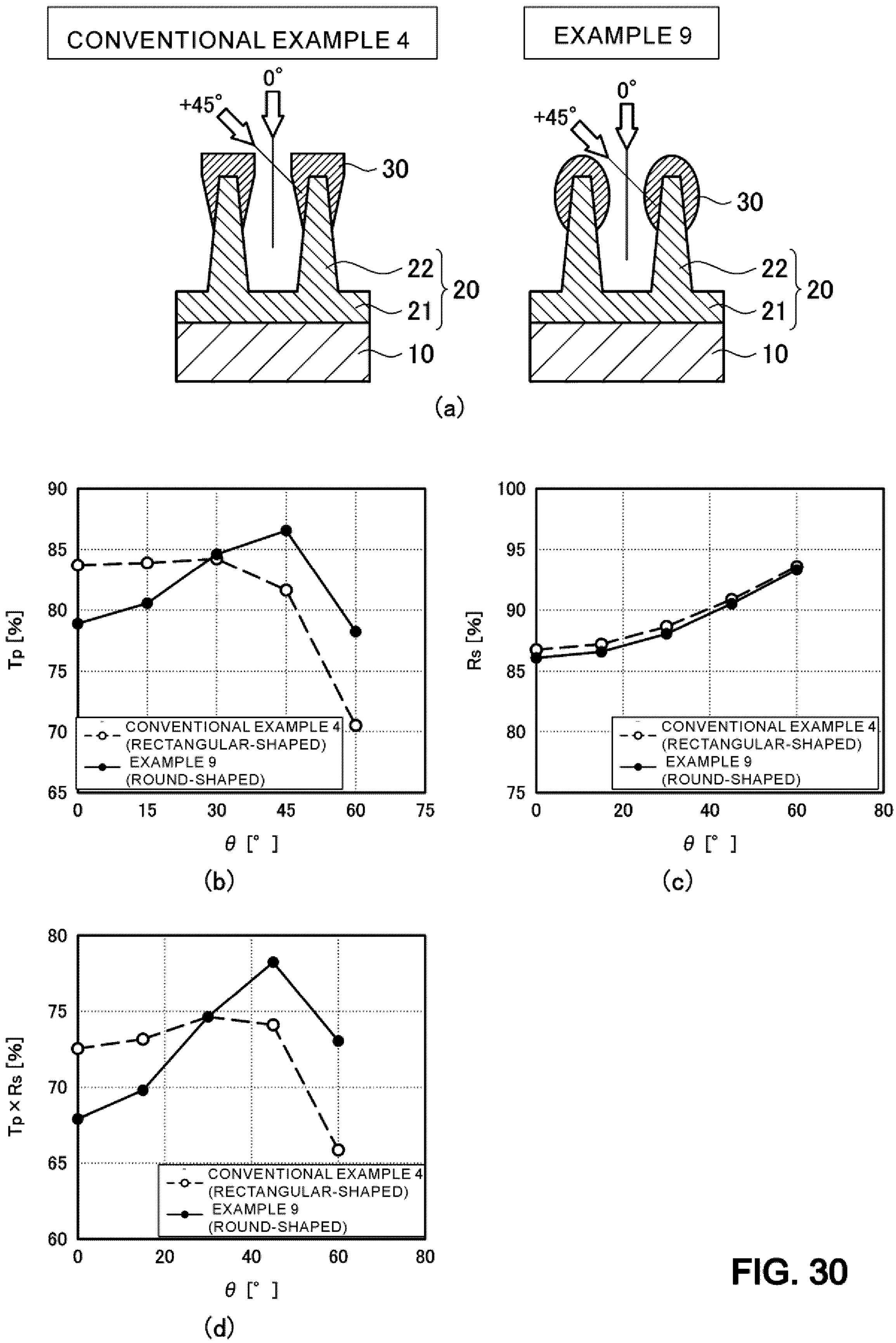
CONVENTIONAL EXAMPLE 4
EXAMPLE 9
0°
+45°
30
22
21
20
10
(a)
Tp [%]
θ [° ]
CONVENTIONAL EXAMPLE 4 (RECTANGULAR-SHAPED)
EXAMPLE 9 (ROUND-SHAPED)
(b)
Rs [%]
(c)
Tp × Rs [%]
(d)

FIG. 30

FIG. 31

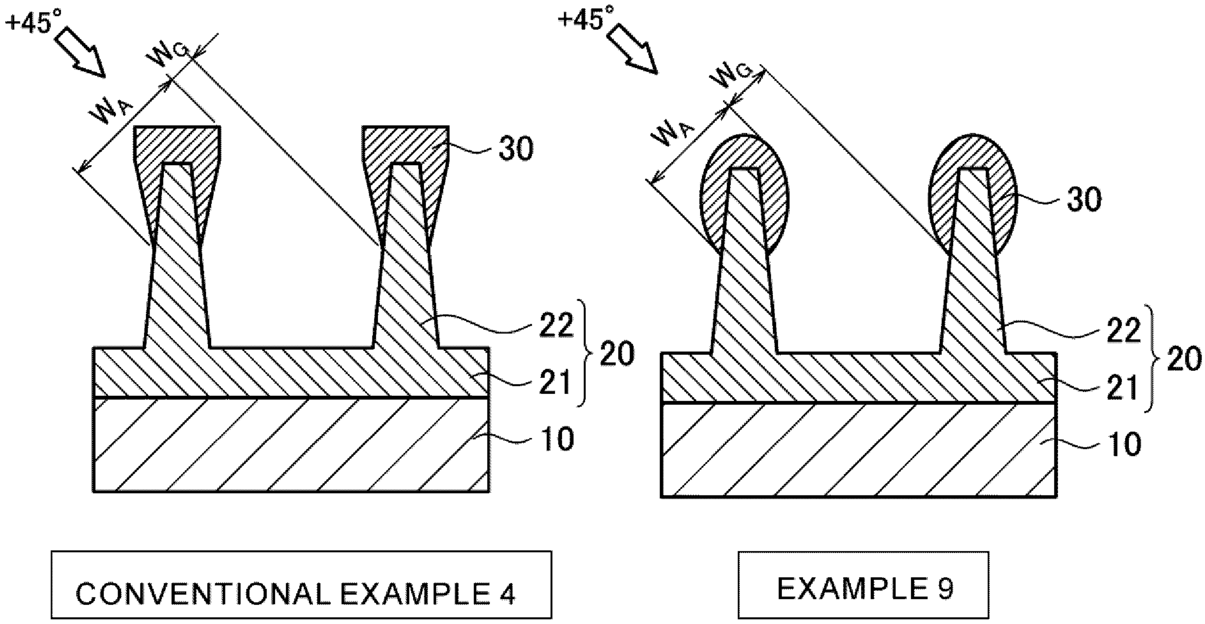
+45°
$W_G$
$W_A$
30
22
20
21
10
CONVENTIONAL EXAMPLE 4
+45°
$W_G$
$W_A$
30
22
20
21
10
EXAMPLE 9

FIG. 32

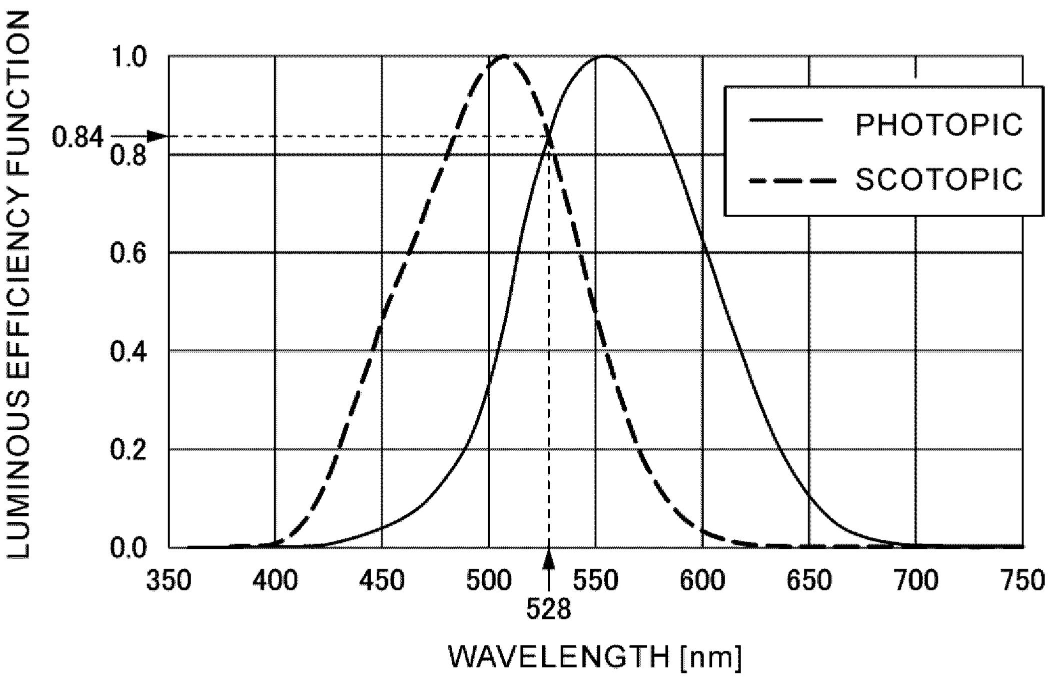
LUMINOUS EFFICIENCY FUNCTION
1.0
0.84
0.8
0.6
0.4
0.2
0.0
350
400
450
500
528
550
600
650
700
750
WAVELENGTH [nm]
PHOTOPIC
SCOTOPIC

## INTERNATIONAL SEARCH REPORT

International application No.
**PCT/JP2023/046189**

### A. CLASSIFICATION OF SUBJECT MATTER

***C08F 220/20***(2006.01)i; ***C08F 220/18***(2006.01)i; ***G02B 5/30***(2006.01)i
FI: C08F220/20; C08F220/18; G02B5/30

According to International Patent Classification (IPC) or to both national classification and IPC

### B. FIELDS SEARCHED

Minimum documentation searched (classification system followed by classification symbols)

C08F220/20; C08F220/18; G02B5/30

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

CAplus/REGISTRY (STN)

### C. DOCUMENTS CONSIDERED TO BE RELEVANT

| Category* | Citation of document, with indication, where appropriate, of the relevant passages | Relevant to claim No. |
|---|---|---|
| X | WO 2017/047692 A1 (HITACHI MAXELL LTD.) 23 March 2017 (2017-03-23) claims, paragraphs [0030]-[0033], [0076], table 2 | 1-15 |
| X | JP 2012-092312 A (SEKISUI CHEMICAL CO., LTD.) 17 May 2012 (2012-05-17) claims, paragraph [0036], examples 11-12 | 1-15 |
| A | JP 2021-173982 A (NITTO DENKO CORPORATION) 01 November 2021 (2021-11-01) | 1-15 |
| A | JP 2021-143263 A (MAXELL HOLDINGS LTD.) 24 September 2021 (2021-09-24) | 1-15 |
| A | JP 2012-033550 A (FUJIFILM CORPORATION) 16 February 2012 (2012-02-16) | 1-15 |
| A | JP 2012-216700 A (FUJIFILM CORPORATION) 08 November 2012 (2012-11-08) | 1-15 |
| A | JP 2022-111986 A (SANYO CHEMICAL INDUSTRIES, LTD.) 01 August 2022 (2022-08-01) | 1-15 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 February 2024** | **05 March 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (July 2022)

**INTERNATIONAL SEARCH REPORT**
**Information on patent family members**

International application No.
**PCT/JP2023/046189**

| Patent document cited in search report | Publication date (day/month/year) | Patent family member(s) | Publication date (day/month/year) |
|---|---|---|---|
| WO 2017/047692 A1 | 23 March 2017 | US 2018/0265720 A1<br>claims, paragraphs [0036]-[0041], [0098], table 2<br>EP 3351366 A1<br>CN 108025492 A | |
| JP 2012-092312 A | 17 May 2012 | (Family: none) | |
| JP 2021-173982 A | 01 November 2021 | WO 2021/220729 A1<br>TW 202146547 A<br>CN 115461660 A<br>KR 10-2023-0002535 A | |
| JP 2021-143263 A | 24 September 2021 | (Family: none) | |
| JP 2012-033550 A | 16 February 2012 | (Family: none) | |
| JP 2012-216700 A | 08 November 2012 | WO 2012/137672 A1 | |
| JP 2022-111986 A | 01 August 2022 | (Family: none) | |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2018125559 A
- JP 4824068 B